# EUROPEAN PATENT APPLICATION

(11) **EP 4 738 695 A1**
(43) Date of publication of application: **06.05.2026**
(21) Application number: 24831017.9
(22) Date of filing: 28.06.2024
(51) Int. Cl.: H02P 29/02, B25F 5/00, A01D 34/00, G01R 31/34, G01D 21/02

(54) **ELECTRIC WORKING VEHICLE, ELECTRIC GARDEN OPERATION VEHICLE AND ELECTRIC RIDE-ON MOWER**

(30) Priority: 28.06.2023 CN 202310773365; 31.10.2023 CN 202311426810; 31.10.2023 CN 202311423869
(71) Applicant: Jiangsu Dongcheng M&E Tools Co., Ltd., Nantong, Jiangsu 226244 (CN)
(72) Inventor: WANG, Haodong, Nantong, Jiangsu 226244 (CN)
(74) Representative: Potter Clarkson
(86) International application number: PCT/CN2024/102507
(87) International publication number: WO 2025/002390

(57) **Abstract**

Provided in the embodiments of the present description are an electric working vehicle, an electric garden operation vehicle and an electric ride-on mower, which can accurately identify a sudden change in a heavy load in a timely manner and take a corresponding control measure, thereby improving the stability of a whole machine, and optimizing the application experience of a user. The electric working vehicle comprises: a functional electric motor, which has a plurality of operation parameters, and a plurality of control policies correspondingly matching the plurality of operation parameters; and a heavy-load identification unit, which is configured to select from among the plurality of operation parameters a target operation parameter which does not match the currently used first control policy for monitoring, and to determine according to the target operation parameter and/or a change situation of the target operation parameter whether the functional electric motor enters a heavy-load state. In response to determining that the functional electric motor enters the heavy-load state, a heavy-load control unit controls and adjusts the functional electric motor, such that the functional electric motor exits the heavy-load state.

## Description

### FIELD

The present disclosure relates to the technical field of vehicle engineering, and particularly to an electric vehicle, an electric garden vehicle, and an electric riding lawn mower.

### BACKGROUND

Compared to traditional fuel-powered lawn mowers, battery-powered lawn mowers offer the advantages of all-weather zero emissions, zero fuel consumption, low noise, and simple maintenance due to the absence of gasoline, engine oil, air filters, spark plugs, fuel storage, etc. In battery-powered lawn mowers, an electric motor replaces the fuel engine as the power source, providing power to the drive wheel motor and the mowing motor. Battery-powered lawn mowers can independently control different drive wheel motors to achieve straight-line travel, reversing, turning, and zero-turn steering, thereby reducing the structural complexity of the entire machine and enabling more flexible control.

During operation, variations in actual grass density can affect the operational load of the lawn mower. A sudden change from sparse to dense grass conditions often causes the load on the mowing motor to abruptly become a heavy load. Consequently, the output power, operating current, and other parameters of the mowing motor may increase instantaneously, potentially leading to motor damage due to overcurrent or triggering an overcurrent protection shutdown. This situation can seriously impact the overall machine stability and the user experience.

### SUMMARY

In view of the above, embodiments of the present disclosure provide an electric work vehicle, an electric garden work vehicle, and an electric riding lawn mower, which can promptly and accurately identify sudden heavy-load conditions and take corresponding control measures, thereby enhancing overall machine stability and optimizing user experience.

In an aspect, an embodiment of the present disclosure provides an electric vehicle. The electric vehicle includes: a motor, a collection module configured to collect at least one mechanical parameter and at least one electrical parameter of the motor, the mechanical parameter including a rotational speed parameter, a sector time parameter, or a torque parameter, and the electrical parameter including a bus current parameter, a phase current parameter, a bus voltage parameter, a power parameter, a freewheeling time parameter, or a duty cycle parameter; a detection module configured to process the mechanical parameter and the electrical parameter of the motor based on a target calculation formula, and generate a target value, the target calculation formula including at least a ratio, a slope of the ratio, or a difference of the ratio; and a determination module configured to determine whether the motor is in a heavy load state based on the target value and a predetermined target threshold, and determine, when the target value fails to meet the predetermined target threshold, that the motor is in the heavy load state, the predetermined target threshold having a correspondence with the target calculation formula.

Optionally, the rotational speed parameter includes: a rotational speed, a rotational speed difference, or a slope of a rotational speed curve. The sector time parameter includes: a sector time, a sector time difference, or a slope of a sector time curve. The torque parameter includes: torque, a torque difference, or a slope of a torque curve. The bus current parameter includes: a bus current, a bus current difference, or a slope of a bus current curve. The phase current parameter includes: a phase current, a phase current difference, or a slope of a phase current curve. The bus voltage parameter includes: a bus voltage, a bus voltage difference, or a slope of a bus voltage curve. The power parameter includes: power, a power difference, or a slope of a power curve. The freewheeling time parameter includes: freewheeling time, a freewheeling time difference, or a slope of a freewheeling time curve. The duty cycle parameter includes: a duty cycle parameter, a duty cycle parameter difference, or a slope of a duty cycle parameter curve. The target value is a ratio between the mechanical parameter and the electrical parameter that have the same type.

Optionally, the target calculation formula includes: calculating a ratio between the mechanical parameter and the electrical parameter of the motor, or a ratio between different electrical parameters of the motor. The target value is the ratio. The determination module is further configured to: compare the ratio with the predetermined target threshold, and determine, when the ratio fails to meet the predetermined target threshold, that the motor is in the heavy load state.

Optionally, the target calculation formula includes: calculating a ratio between the mechanical parameter and the electrical parameter of the motor, or a ratio between different electrical parameters of the motor, and calculating a ratio value of the ratio to a predetermined ratio. The target value is the ratio value. The determination module is further configured to: compare the ratio value with the predetermined target threshold, and determine, when the ratio value fails to meet the predetermined target threshold, that the motor is in the heavy load state.

Optionally, the target calculation formula includes: calculating a ratio between the mechanical parameter and the electrical parameter of the motor, or a ratio between different electrical parameters of the motor, and calculating a difference of the ratio within a predetermined time period. The target value is the difference. The determination module is further configured to: compare the difference with the predetermined target threshold, and determine, when the difference fails to meet the predetermined target threshold, that the motor is in the heavy load state.

Optionally, the target calculation formula includes: calculating a ratio between the mechanical parameter and the electrical parameter of the motor, or a ratio between different electrical parameters of the motor, and obtaining a slope of a curve of the ratio. The target value is the slope. The determination module is further configured to: compare the slope with the predetermined target threshold, and determine, when the slope fails to meet the predetermined target threshold, that the motor is in the heavy load state.

Optionally, the motor includes: a first gear, a second gear, and a third gear with progressively increasing output capacities. The predetermined target threshold is the same when the motor is in the first gear, the second gear, and the third gear. Alternatively, the predetermined target threshold decreases progressively when the motor is in the first gear, the second gear, and the third gear. Alternatively, the predetermined target threshold increases progressively when the motor is in the first gear, the second gear, and the third gear.

Optionally, the predetermined target threshold is determined based on sampling time, and the predetermined target threshold decreases as a sampling time interval decreases. The sampling time interval is a time interval for obtaining two adjacent mechanical parameters or two adjacent electrical parameters.

Optionally, the electric vehicle further includes a control module configured to adjust, in response to the motor being in the heavy load state, the mechanical parameter or electrical parameter of the motor, to reduce an operating efficiency of the motor until the motor exits the heavy load state.

In another aspect, an embodiment of the present disclosure provides a method for detecting a heavy load state applied to an electric vehicle. The method includes: collecting at least one mechanical parameter and at least one electrical parameter of the motor, the mechanical parameter including a rotational speed parameter, a sector time parameter, or a torque parameter, and the electrical parameter including a bus current parameter, a phase current parameter, a bus voltage parameter, a power parameter, a freewheeling time parameter, or a duty cycle parameter; processing the mechanical parameter and the electrical parameter of the motor based on a target calculation formula, and generating a target value, the target calculation formula including at least a ratio, a slope of the ratio, or a difference of the ratio; and determining whether the motor is in a heavy load state based on the target value and a predetermined target threshold, and determining, when the target value fails to meet the predetermined target threshold, that the motor is in the heavy load state, the predetermined target threshold having a correspondence with the target calculation formula.

In another aspect, an embodiment of the present disclosure further provides an electric work vehicle, including: a frame; a functional mechanism attached to the frame, including a functional motor and an output assembly driven by the functional motor to perform a functional operation; a controller assembly configured to control an operating state of the functional motor.

The functional motor has a plurality of operating parameters. The controller assembly has a plurality of control strategies corresponding to the plurality of operating parameters for the functional motor.

The controller assembly includes: a heavy load identification unit and a heavy load control unit.

The heavy load identification unit is configured to select a target operating parameter from the plurality of operating parameters, and determine whether the functional motor enters a heavy load state based on the target operating parameter and/or a change of the target operating parameter.

The target operating parameter does not correspond to a first control strategy among the plurality of control strategies that is currently adopted by the controller assembly for the functional motor.

The heavy load control unit is configured to select, in response to determining that the functional motor enters the heavy load state, a second control strategy from the plurality of control strategies, and control the functional motor based on the second control strategy to cause the functional motor to exit the heavy load state.

Optionally, the plurality of operating parameters of the functional motor include a rotational speed parameter, an electrical parameter, a power parameter, a torque parameter, and a PWM duty cycle parameter.

The plurality of control strategies corresponding to the plurality of operating parameters include a rotational speed closed-loop control strategy, a current closed-loop control strategy, a power closed-loop control strategy, a torque closed-loop control strategy, and a PWM duty cycle open-loop control strategy.

Optionally, the heavy load identification unit being configured to select a target operating parameter from the plurality of operating parameters, and determine whether the functional motor enters a heavy load state based on the target operating parameter and/or a change of the target operating parameter includes: the heavy load identification unit being configured to select, in response to the rotational speed parameter not corresponding to the first control strategy, the rotational speed parameter as the target operating parameter.

The heavy load identification unit is further configured to monitor the rotational speed parameter and determine whether the functional motor enters the heavy load state based on the rotational speed parameter and/or a change of the rotational speed parameter.

Optionally, the rotational speed parameter includes a motor rotational speed parameter.

The heavy load identification unit being configured to monitor the rotational speed parameter and determine whether the functional motor enters the heavy load state based on the rotational speed parameter and/or a change of the rotational speed parameter includes: the heavy load identification unit being configured to determine whether the motor rotational speed parameter is greater than or equal to a corresponding predetermined motor rotational speed parameter threshold during an operation of the functional motor; and determine, in response to the motor rotational speed parameter being greater than or equal to the corresponding predetermined motor rotational speed parameter threshold, that the functional motor enters the heavy load state.

Optionally, the motor rotational speed parameter includes a motor rotational speed, a motor rotational speed difference, and a motor rotational speed change rate.

The motor rotational speed difference refers to a difference in the motor rotational speed of the functional motor between two adjacent moments.

The motor rotational speed change rate characterizes a change trend of the motor rotational speed of the functional motor at a corresponding moment.

The heavy load identification unit being configured to determine whether the motor rotational speed parameter is greater than or equal to a corresponding predetermined motor rotational speed parameter threshold during an operation of the functional motor includes: the heavy load identification unit being configured to obtain at least one motor rotational speed parameter, and determine whether the at least one motor rotational speed parameter is less than or equal to the corresponding predetermined motor rotational speed parameter threshold.

Optionally, the rotational speed parameter includes a motor sector time parameter.

The heavy load identification unit being configured to monitor the rotational speed parameter and determine whether the functional motor enters the heavy load state based on the rotational speed parameter and/or a change of the rotational speed parameter includes: the heavy load identification unit being configured to determine whether the motor sector time parameter is greater than or equal to a corresponding predetermined motor sector time parameter threshold during an operation of the functional motor; and determine, in response to the motor sector time parameter being greater than or equal to the corresponding predetermined motor sector time parameter threshold, that the functional motor enters the heavy load state.

Optionally, the motor sector time parameter includes motor sector time, a motor sector time difference, and a motor sector time change rate.

An electrical cycle of the functional motor includes a plurality of sectors, and the motor sector time refers to a duration of each of the plurality of sectors.

The motor sector time difference is a difference between motor sector time corresponding to two adjacent moments.

The motor sector time change rate characterizes a change trend of the motor sector time.

The heavy load identification unit being configured to determine whether the motor sector time parameter is greater than or equal to a corresponding predetermined motor sector time parameter threshold during an operation of the functional motor includes: the heavy load identification unit being configured to obtain at least one motor sector time parameter and determine whether the at least one motor sector time parameter is greater than or equal to the corresponding predetermined motor sector time parameter threshold.

Optionally, the heavy load identification unit being configured to select a target operating parameter from the plurality of operating parameters, and determine whether the functional motor enters a heavy load state based on the target operating parameter and/or a change of the target operating parameter includes: the heavy load identification unit being configured to select, in response to the electrical parameter not corresponding to the first control strategy, the electrical parameter as the target operating parameter.

The heavy load identification unit is further configured to monitor the electrical parameter and determine whether the functional motor enters the heavy load state based on the electrical parameter and/or a change of the electrical parameter.

Optionally, the heavy load identification unit being configured to monitor the electrical parameter and determine whether the functional motor enters the heavy load state based on the electrical parameter and/or a change of the electrical parameter includes: the heavy load identification unit being configured to determine whether the electrical parameter is greater than or equal to a corresponding predetermined electrical parameter threshold during an operation of the functional motor; and determine, in response to the electrical parameter being greater than or equal to the corresponding predetermined electrical parameter threshold, that the functional motor enters the heavy load state.

Optionally, the electrical parameter includes a bus current parameter.

The bus current parameter including a bus current, a bus current difference, and a bus current change rate.

The bus current difference refers to a difference in the bus current of the functional motor between two adjacent moments.

The bus current change rate characterizes a change trend of the bus current of the functional motor at a corresponding moment.

The heavy load identification unit being configured to determine whether the electrical parameter is greater than or equal to a corresponding predetermined electrical parameter threshold during an operation of the functional motor includes: the heavy load identification unit being configured to obtain at least one bus current parameter, and determine whether the at least one bus current parameter is greater than or equal to the corresponding predetermined electrical parameter threshold.

Optionally, the electrical parameter includes a phase current parameter.

The phase current parameter includes a phase current, a phase current difference, and a phase current change rate.

The phase current difference refers to a difference in the phase current of the functional motor between two adjacent moments.

The phase current change rate characterizes a change trend of the phase current of the functional motor at a corresponding moment.

The heavy load identification unit being configured to determine whether the electrical parameter is greater than or equal to a corresponding predetermined electrical parameter threshold during an operation of the functional motor includes: the heavy load identification unit being configured to obtain at least one phase current parameter, and determine whether the at least one phase current parameter is greater than or equal to the corresponding predetermined electrical parameter threshold.

Optionally, the electrical parameter includes a bus voltage parameter.

The bus voltage parameter includes a bus voltage drop, a bus voltage drop difference, and a bus voltage drop change rate.

The bus voltage drop refers to a decrease value of a bus voltage during the operation of the functional motor compared with a bus voltage before operation.

The bus voltage drop difference refers to a difference in the bus voltage drop of the functional motor between two adjacent moments.

The bus voltage drop change rate characterizes a change trend of the bus voltage drop of the functional motor at a corresponding moment.

The heavy load identification unit being configured to determine whether the electrical parameter is greater than or equal to a corresponding predetermined electrical parameter threshold during an operation of the functional motor includes: the heavy load identification unit being configured to obtain at least one bus voltage parameter, and determine whether the at least one bus voltage parameter is greater than or equal to the corresponding predetermined electrical parameter threshold.

Optionally, the electrical parameter includes a conducting phase voltage parameter.

The conducting phase voltage parameter includes a conducting phase voltage drop, a conducting phase voltage drop difference, and a conducting phase voltage drop change rate.

The conducting phase voltage drop refers to a relative value of a change in the conducting phase voltage of the functional motor within a commutation cycle.

The conducting phase voltage drop difference refers to a difference between conducting phase voltage drops corresponding to different commutation cycles of the functional motor.

The conducting phase voltage drop change rate characterizes a change trend of the conducting phase voltage drop of the functional motor.

The heavy load identification unit being configured to determine whether the electrical parameter is greater than or equal to a corresponding predetermined electrical parameter threshold during an operation of the functional motor includes: the heavy load identification unit being configured to obtain at least one conducting phase voltage parameter, and determine whether the at least one conducting phase voltage parameter is greater than or equal to the corresponding predetermined electrical parameter threshold.

Optionally, the electrical parameter includes a freewheeling time parameter.

The freewheeling time parameter includes freewheeling time of the functional motor during commutation, a freewheeling time difference, and a freewheeling time change rate.

The freewheeling time difference refers to a difference in freewheeling time between different commutation cycles of the functional motor.

The freewheeling time change rate characterizes a change trend of the freewheeling time of the functional motor.

The heavy load identification unit being configured to determine whether the electrical parameter is greater than or equal to a corresponding predetermined electrical parameter threshold during an operation of the functional motor includes: the heavy load identification unit being configured to obtain at least one freewheeling time parameter, and determine whether the at least one freewheeling time parameter is greater than or equal to the corresponding predetermined electrical parameter threshold.

Optionally, the heavy load identification unit being configured to select a target operating parameter from the plurality of operating parameters, and determine whether the functional motor enters a heavy load state based on the target operating parameter and/or a change of the target operating parameter includes: the heavy load identification unit being configured to select, in response to the power parameter not corresponding to the first control strategy, the power parameter as the target operating parameter.

The heavy load identification unit is further configured to monitor the power parameter and determine whether the functional motor enters the heavy load state based on the power parameter and/or a change of the power parameter.

Optionally, the heavy load identification unit being configured to monitor the power parameter and determine whether the functional motor enters the heavy load state based on the power parameter and/or a change of the power parameter includes: the heavy load identification unit being configured to determine whether the power parameter is greater than or equal to a corresponding predetermined power parameter threshold during an operation of the functional motor; and determine, in response to the power parameter being greater than or equal to the corresponding predetermined power parameter threshold, that the functional motor enters the heavy load state.

Optionally, the power parameter includes motor power, a motor power difference, and a motor power change rate.

The motor power difference refers to a difference in the motor power of the functional motor between two adjacent moments.

The motor power change rate characterizes a change trend of the motor power of the functional motor at a corresponding moment.

The heavy load identification unit being configured to determine whether the power parameter is greater than or equal to a corresponding predetermined motor power parameter threshold during an operation of the functional motor includes: the heavy load identification unit being configured to obtain at least one power parameter, and determine whether the at least one power parameter is greater than or equal to the corresponding predetermined power parameter threshold.

Optionally, the heavy load identification unit being configured to select a target operating parameter from the plurality of operating parameters, and determine whether the functional motor enters a heavy load state based on the target operating parameter and/or a change of the target operating parameter includes: the heavy load identification unit being configured to select, in response to the torque parameter not corresponding to the first control strategy, the torque parameter as the target operating parameter.

The heavy load identification unit is further configured to monitor the torque parameter and determine whether the functional motor enters the heavy load state based on the torque parameter and/or a change of the torque parameter.

Optionally, the heavy load identification unit being configured to monitor the torque parameter and determine whether the functional motor enters the heavy load state based on the torque parameter and/or a change of the torque parameter includes: the heavy load identification unit being configured to determine whether the torque parameter is greater than or equal to a corresponding predetermined torque parameter threshold during an operation of the functional motor; and determine, in response to the torque parameter being greater than or equal to the corresponding predetermined torque parameter threshold, that the functional motor enters the heavy load state.

Optionally, the torque parameter includes motor torque, a motor torque difference, and a motor torque change rate.

The motor torque difference refers to a difference in the motor torque of the functional motor between two adjacent moments.

The motor torque change rate characterizes a change trend of the motor torque of the functional motor at a corresponding moment.

The heavy load identification unit being configured to determine whether the torque parameter is greater than or equal to a corresponding predetermined torque parameter threshold during an operation of the functional motor includes: the heavy load identification unit being configured to obtain at least one torque parameter, and determine whether the at least one torque parameter is greater than or equal to the corresponding predetermined torque parameter threshold.

Optionally, the heavy load identification unit being configured to select the target operating parameter from the plurality of operating parameters, and determine whether the functional motor enters the heavy load state based on the target operating parameter and/or a change of the target operating parameter includes: the heavy load identification unit being configured to select, in response to the PWM duty cycle parameter not corresponding to the first control strategy, the PWM duty cycle parameter as the target operating parameter.

The heavy load identification unit is further configured to monitor the PWM duty cycle parameter and determine whether the functional motor enters the heavy load state based on the PWM duty cycle parameter and/or a change of the PWM duty cycle parameter.

Optionally, the heavy load identification unit being configured to monitor the PWM duty cycle parameter and determine whether the functional motor enters the heavy load state based on the PWM duty cycle parameter and/or a change of the PWM duty cycle parameter includes: the heavy load identification unit being configured to determine whether the PWM duty cycle parameter is greater than or equal to a corresponding predetermined duty cycle parameter threshold during an operation of the functional motor; and determine, in response to the PWM duty cycle parameter being greater than or equal to the corresponding predetermined duty cycle parameter threshold, that the functional motor enters the heavy load state.

Optionally, the PWM duty cycle parameter includes a duty cycle of a corresponding control signal of the functional motor, a duty cycle difference, and a duty cycle change rate.

The duty cycle difference refers to a difference in a duty cycle of the functional motor between two adjacent moments.

The duty cycle change rate characterizes a change trend of the duty cycle of the functional motor at a corresponding moment.

The heavy load identification unit being configured to determine whether the duty cycle parameter is greater than or equal to a corresponding predetermined duty cycle parameter threshold during an operation of the functional motor includes: the heavy load identification unit being configured to obtain at least one PWM duty cycle parameter, and determine whether the at least one PWM duty cycle parameter is greater than or equal to the corresponding predetermined duty cycle parameter threshold.

Optionally, the heavy load identification unit being configured to select the target operating parameter from the plurality of operating parameters, and determine whether the functional motor enters the heavy load state based on the target operating parameter and/or a change of the target operating parameter includes: the heavy load identification unit being configured to select, in response to both the rotational speed parameter and the electrical parameter not corresponding to the first control strategy, the rotational speed parameter and the electrical parameter as target operating parameters.

The heavy load identification unit is further configured to monitor the rotational speed parameter and the electrical parameter, determine a current-to-speed ratio parameter based on a ratio of the electrical parameter to the rotational speed parameter, and determine whether the functional motor enters the heavy load state based on the current-to-speed ratio parameter and/or a change of the current-to-speed ratio parameter.

Optionally, the rotational speed parameter includes a motor rotational speed parameter. The current-to-speed ratio parameter refers to a ratio of the electrical parameter to the motor rotational speed parameter.

The heavy load identification unit being configured to determine whether the functional motor enters the heavy load state based on the current-to-speed ratio parameter and/or a change of the current-to-speed ratio parameter includes: the heavy load identification unit being configured to determine whether the current-to-speed ratio parameter is greater than or equal to a corresponding predetermined current-to-speed ratio parameter threshold during an operation of the functional motor; and determine, in response to the current-to-speed ratio parameter being greater than or equal to the corresponding predetermined current-to-speed ratio parameter threshold, that the functional motor enters the heavy load state.

Optionally, the rotational speed parameter includes a motor sector time parameter. The current-to-speed ratio parameter refers to a ratio of the electrical parameter to the motor sector time parameter.

The heavy load identification unit being configured to determine whether the functional motor enters the heavy load state based on the current-to-speed ratio parameter and/or a change of the current-to-speed ratio parameter includes: the heavy load identification unit being configured to determine whether the current-to-speed ratio parameter is less than or equal to a corresponding predetermined current-to-speed ratio parameter threshold during an operation of the functional motor; and determine, in response to the current-to-speed ratio parameter being less than or equal to the corresponding predetermined current-to-speed ratio parameter threshold, that the functional motor enters the heavy load state.

Optionally, the current-to-speed ratio parameter includes a current-to-speed ratio, a current-to-speed ratio difference, and a current-to-speed ratio change rate.

The current-to-speed ratio refers to the ratio of the electrical parameter to the rotational speed parameter. The current-to-speed ratio difference refers to a difference in the current-to-speed ratio between two adjacent moments.

The current-to-speed ratio change rate characterizes a change trend of the current-to-speed ratio at a corresponding moment.

The heavy load identification unit being configured to determine whether the current-to-speed ratio parameter is greater than or equal to a corresponding predetermined current-to-speed ratio parameter threshold during an operation of the functional motor includes: the heavy load identification unit being configured to obtain at least one current-to-speed ratio parameter, and determine whether the at least one current-to-speed ratio parameter is greater than or equal to the corresponding predetermined current-to-speed ratio parameter threshold.

Optionally, the heavy load identification unit being configured to select the target operating parameter from the plurality of operating parameters, and determine whether the functional motor enters the heavy load state based on the target operating parameter and/or a change of the target operating parameter includes: the heavy load identification unit being configured to select, in response to both the rotational speed parameter and the power parameter not corresponding to the first control strategy, the rotational speed parameter and the power parameter as target operating parameters.

The heavy load identification unit is further configured to monitor the rotational speed parameter and the power parameter, determine a power-to-speed ratio parameter based on a ratio of the power parameter to the rotational speed parameter, and determine whether the functional motor enters the heavy load state based on the power-to-speed ratio parameter and/or a change of the power-to-speed ratio parameter.

Optionally, the rotational speed parameter includes a motor rotational speed parameter, and the power-to-speed ratio parameter refers to a ratio of the power parameter to the motor rotational speed parameter.

The heavy load identification unit being configured to determine whether the functional motor enters the heavy load state based on the power-to-speed ratio parameter and/or a change of the power-to-speed ratio parameter includes: the heavy load identification unit being configured to determine whether the power-to-speed ratio parameter is greater than or equal to a corresponding predetermined power-to-speed ratio parameter threshold during an operation of the functional motor; and determine, in response to the power-to-speed ratio parameter being greater than or equal to the corresponding predetermined power-to-speed ratio parameter threshold, that the functional motor enters the heavy load state.

Optionally, the rotational speed parameter includes a motor sector time parameter, and the power-to-speed ratio parameter refers to a ratio of the power parameter to the motor sector time parameter.

The heavy load identification unit being configured to determine whether the functional motor enters the heavy load state based on the power-to-speed ratio parameter and/or a change of the power-to-speed ratio parameter includes: the heavy load identification unit being configured to determine whether the power-to-speed ratio parameter is less than or equal to a corresponding predetermined power-to-speed ratio parameter threshold during an operation of the functional motor; and determining, in response to the power-to-speed ratio parameter being less than or equal to the corresponding predetermined power-to-speed ratio parameter threshold, that the functional motor enters the heavy load state.

Optionally, the power-to-speed ratio parameter includes a power-to-speed ratio, a power-to-speed ratio difference, and a power-to-speed ratio change rate.

The power-to-speed ratio refers to a ratio of the power parameter to the rotational speed parameter.

The power-to-speed ratio difference refers to a difference in the power-to-speed ratio between two adjacent moments.

The power-to-speed ratio change rate characterizes a change trend of the power-to-speed ratio at a corresponding moment.

The heavy load identification unit being configured to determine whether the power-to-speed ratio parameter is greater than or equal to a corresponding predetermined power-to-speed ratio parameter threshold during an operation of the functional motor includes: the heavy load identification unit being configured to obtain at least one power-to-speed ratio parameter, and determine whether the at least one power-to-speed ratio parameter is greater than or equal to the corresponding predetermined power-to-speed ratio parameter threshold.

Optionally, the heavy load identification unit being configured to select the target operating parameter from the plurality of operating parameters, and determine whether the functional motor enters the heavy load state based on the target operating parameter and/or a change of the target operating parameter includes: the heavy load identification unit being configured to select, in response to both the rotational speed parameter and the torque parameter not corresponding to the first control strategy, the rotational speed parameter and the torque parameter as target operating parameters.

The heavy load identification unit is further configured to monitor the rotational speed parameter and the torque parameter, determine a torque-to-speed ratio parameter based on a ratio of the torque parameter to the rotational speed parameter, and determine whether the functional motor enters the heavy load state based on the torque-to-speed ratio parameter and/or a change of the torque-to-speed ratio parameter.

Optionally, the rotational speed parameter includes a motor rotational speed parameter. The torque-to-speed ratio parameter refers to a ratio of the torque parameter to the motor rotational speed parameter.

The heavy load identification unit being configured to determine whether the functional motor enters the heavy load state based on the torque-to-speed ratio parameter and/or a change of the torque-to-speed ratio parameter includes: the heavy load identification unit being configured to determine whether the torque-to-speed ratio parameter is greater than or equal to a corresponding predetermined torque-to-speed ratio parameter threshold during an operation of the functional motor; and determine, in response to the torque-to-speed ratio parameter being greater than or equal to the corresponding predetermined torque-to-speed ratio parameter threshold, that the functional motor enters the heavy load state.

Optionally, the rotational speed parameter includes a motor sector time parameter. The torque-to-speed ratio parameter refers to a ratio of the torque parameter to the motor sector time parameter.

The heavy load identification unit being configured to determine whether the functional motor enters the heavy load state based on the torque-to-speed ratio parameter and/or a change of the torque-to-speed ratio parameter includes: the heavy load identification unit being configured to determine whether the torque-to-speed ratio parameter is less than or equal to a corresponding predetermined torque-to-speed ratio parameter threshold during an operation of the functional motor; and determine, in response to the torque-to-speed ratio parameter being less than or equal to the corresponding predetermined torque-to-speed ratio parameter threshold, that the functional motor enters the heavy load state.

Optionally, the torque-to-speed ratio parameter includes a torque-to-speed ratio, a torque-to-speed ratio difference, and a torque-to-speed ratio change rate.

The torque-to-speed ratio refers to a ratio of the torque parameter to the rotational speed parameter.

The torque-to-speed ratio difference refers to a difference in the torque-to-speed ratio between two adjacent moments.

The torque-to-speed ratio change rate is used to characterize a change trend of the torque-to-speed ratio at a corresponding moment.

The heavy load identification unit being configured to determine whether the torque-to-speed ratio parameter is greater than or equal to a corresponding predetermined torque-to-speed ratio parameter threshold during an operation of the functional motor includes: the heavy load identification unit being configured to obtain at least one torque-to-speed ratio parameter, and determine whether the at least one torque-to-speed ratio parameter is greater than or equal to the corresponding predetermined torque-to-speed ratio parameter threshold.

Optionally, the heavy load identification unit being configured to select the target operating parameter from the plurality of operating parameters, and determine whether the functional motor enters the heavy load state based on the target operating parameter and/or a change of the target operating parameter includes: the heavy load identification unit being configured to select, in response to both the rotational speed parameter and the PWM duty cycle parameter not corresponding to the first control strategy, the rotational speed parameter and the PWM duty cycle parameter as target operating parameters.

The heavy load identification unit is further configured to monitor the rotational speed parameter and the PWM duty cycle parameter, determine a duty-cycle-to-speed ratio parameter based on a ratio of the PWM duty cycle parameter to the rotational speed parameter, and determine whether the functional motor enters the heavy load state based on the duty-cycle-to-speed ratio parameter and/or a change of the duty-cycle-to-speed ratio parameter.

Optionally, the rotational speed parameter includes a motor rotational speed parameter. The duty-cycle-to-speed ratio parameter refers to a ratio of the PWM duty cycle parameter to the motor rotational speed parameter.

The heavy load identification unit being configured to determine whether the functional motor enters the heavy load state based on the duty-cycle-to-speed ratio parameter and/or a change of the duty-cycle-to-speed ratio parameter includes: the heavy load identification unit being configured to determine whether the duty-cycle-to-speed ratio parameter is greater than or equal to a corresponding predetermined duty-cycle-to-speed ratio parameter threshold during an operation of the functional motor; and determine, in response to the duty-cycle-to-speed ratio parameter being greater than or equal to the corresponding predetermined duty-cycle-to-speed ratio parameter threshold, that the functional motor enters the heavy load state.

Optionally, the rotational speed parameter includes a motor sector time parameter. The duty-cycle-to-speed ratio parameter refers to a ratio of the PWM duty cycle parameter to the motor sector time parameter.

The heavy load identification unit being configured to determine whether the functional motor enters the heavy load state based on the duty-cycle-to-speed ratio parameter and/or a change of the duty-cycle-to-speed ratio parameter includes: the heavy load identification unit being configured to determine whether the duty-cycle-to-speed ratio parameter is less than or equal to a corresponding predetermined duty-cycle-to-speed ratio parameter threshold during an operation of the functional motor; and determine, in response to the duty-cycle-to-speed ratio parameter being less than or equal to the corresponding predetermined duty-cycle-to-speed ratio parameter threshold, that the functional motor enters the heavy load state.

Optionally, the duty-cycle-to-speed ratio parameter includes a duty-cycle-to-speed ratio, a duty-cycle-to-speed ratio difference, and a duty-cycle-to-speed ratio change rate.

The duty-cycle-to-speed ratio refers to a ratio of the PWM duty cycle parameter to the rotational speed parameter.

The duty-cycle-to-speed ratio difference refers to a difference in the duty-cycle-to-speed ratio between two adjacent moments.

The duty-cycle-to-speed ratio change rate characterizes a change trend of the duty-cycle-to-speed ratio at a corresponding moment.

The heavy load identification unit being configured to determine whether the duty-cycle-to-speed ratio parameter is greater than or equal to a corresponding predetermined duty-cycle-to-speed ratio parameter threshold during an operation of the functional motor includes: the heavy load identification unit being configured to obtain at least one duty-cycle-to-speed ratio parameter, and determine whether the at least one duty-cycle-to-speed ratio parameter is greater than or equal to the corresponding predetermined duty-cycle-to-speed ratio parameter threshold.

Optionally, the heavy load identification unit being configured to select the target operating parameter from the plurality of operating parameters, and determine whether the functional motor enters a heavy load state based on the target operating parameter and/or a change of the target operating parameter includes: the heavy load identification unit being configured to select, in response to both the electrical parameter and the PWM duty cycle parameter not corresponding to the first control strategy, the electrical parameter and the PWM duty cycle parameter as target operating parameters.

The heavy load identification unit is further configured to monitor the electrical parameter and the PWM duty cycle parameter, determine a duty-cycle-to-current ratio parameter based on a ratio of the PWM duty cycle parameter to the electrical parameter, and determine whether the functional motor enters the heavy load state based on the duty-cycle-to-current ratio parameter and/or a change of the duty-cycle-to-current ratio parameter.

Optionally, the heavy load identification unit being configured to determine whether the functional motor enters the heavy load state based on the duty-cycle-to-current ratio parameter and/or a change of the duty-cycle-to-current ratio parameter includes: the heavy load identification unit being configured to determine whether the duty-cycle-to-current ratio parameter is greater than or equal to a corresponding predetermined duty-cycle-to-current ratio parameter threshold during an operation of the functional motor; and determine, in response to the duty-cycle-to-current ratio parameter being greater than or equal to the corresponding predetermined duty-cycle-to-current ratio parameter threshold, that the functional motor enters the heavy load state.

Optionally, the duty-cycle-to-current ratio parameter includes a duty-cycle-to-current ratio, a duty-cycle-to-current ratio difference, and a duty-cycle-to-current ratio change rate.

The duty-cycle-to-current ratio refers to a ratio of the PWM duty cycle parameter to the electrical parameter.

The duty-cycle-to-current ratio difference refers to a difference in the duty-cycle-to-current ratio between two adjacent moments.

The duty-cycle-to-current ratio change rate characterizes a change trend of the duty-cycle-to-current ratio at a corresponding moment.

The heavy load identification unit being configured to determine whether the duty-cycle-to-current ratio parameter is greater than or equal to the corresponding predetermined duty-cycle-to-current ratio parameter threshold during the operation of the functional motor includes: the heavy load identification unit being configured to obtain at least one duty-cycle-to-current ratio parameter, and determine whether the at least one duty-cycle-to-current ratio parameter is greater than or equal to the corresponding predetermined duty-cycle-to-current ratio parameter threshold.

Optionally, the heavy load identification unit being configured to select the target operating parameter from the plurality of operating parameters, and determine whether the functional motor enters the heavy load state based on the target operating parameter and/or a change of the target operating parameter includes: the heavy load identification unit being configured to select, in response to both the power parameter and the PWM duty cycle parameter not corresponding to the first control strategy, the power parameter and the PWM duty cycle parameter as target operating parameters.

The heavy load identification unit is further configured to monitor the power parameter and the PWM duty cycle parameter, determine a duty-cycle-to-power ratio parameter based on a ratio of the PWM duty cycle parameter to the power parameter, and determine whether the functional motor enters the heavy load state based on the duty-cycle-to-power ratio parameter and/or a change of the duty-cycle-to-power ratio parameter.

Optionally, the heavy load identification unit being configured to determine whether the functional motor enters the heavy load state based on the duty-cycle-to-power ratio parameter and/or a change of the duty-cycle-to-power ratio parameter includes: determining whether the duty-cycle-to-power ratio parameter is greater than or equal to a corresponding predetermined duty-cycle-to-power ratio parameter threshold during an operation of the functional motor; and determining, in response to the duty-cycle-to-power ratio parameter being greater than or equal to the corresponding predetermined duty-cycle-to-power ratio parameter threshold, that the functional motor enters the heavy load state.

Optionally, the duty-cycle-to-power ratio parameter includes a duty-cycle-to-power ratio, a duty-cycle-to-power ratio difference, and a duty-cycle-to-power ratio change rate.

The duty-cycle-to-power ratio refers to a ratio of the PWM duty cycle parameter to the power parameter.

The duty-cycle-to-power ratio difference refers to a difference in the duty-cycle-to-power ratio between two adjacent moments.

The duty-cycle-to-power ratio change rate characterizes a change trend of the duty-cycle-to-power ratio at a corresponding moment.

The heavy load identification unit being configured to determine whether the duty-cycle-to-power ratio parameter is greater than or equal to a corresponding predetermined duty-cycle-to-power ratio parameter threshold during an operation of the functional motor includes: the heavy load identification unit being configured to obtain at least one duty-cycle-to-power ratio parameter, and determine whether the at least one duty-cycle-to-power ratio parameter is greater than or equal to the corresponding predetermined duty-cycle-to-power ratio parameter threshold.

Optionally, the heavy load identification unit being configured to select the target operating parameter from the plurality of operating parameters, and determine whether the functional motor enters the heavy load state based on the target operating parameter and/or a change of the target operating parameter includes: the heavy load identification unit being configured to select, in response to both the torque parameter and the PWM duty cycle parameter not corresponding to the first control strategy, the torque parameter and the PWM duty cycle parameter as target operating parameters.

The heavy load identification unit is further configured to monitor the torque parameter and the PWM duty cycle parameter, determine a duty-cycle-to-torque ratio parameter based on a ratio of the PWM duty cycle parameter to the torque parameter, and determine whether the functional motor enters the heavy load state based on the duty-cycle-to-torque ratio parameter and/or a change of the duty-cycle-to-torque ratio parameter.

Optionally, the heavy load identification unit being configured to determine whether the functional motor enters the heavy load state based on the duty-cycle-to-torque ratio parameter and/or a change of the duty-cycle-to-torque ratio parameter includes: the heavy load identification unit being configured to determine whether the duty-cycle-to-torque ratio parameter is greater than or equal to a corresponding predetermined duty-cycle-to-torque ratio parameter threshold during an operation of the functional motor; and determine, in response to the duty-cycle-to-torque ratio parameter being greater than or equal to the corresponding predetermined duty-cycle-to-torque ratio parameter threshold, that the functional motor enters the heavy load state.

Optionally, the duty-cycle-to-torque ratio parameter includes a duty-cycle-to-torque ratio, a duty-cycle-to-torque ratio difference, and a duty-cycle-to-torque ratio change rate.

The duty-cycle-to-torque ratio refers to a ratio of the PWM duty cycle parameter to the torque parameter.

The duty-cycle-to-torque ratio difference refers to a difference in the duty-cycle-to-torque ratio between two adjacent moments.

The duty-cycle-to-torque ratio change rate characterizes a change trend of the duty-cycle-to-torque ratio at a corresponding moment.

The heavy load identification unit being configured to determine whether the duty-cycle-to-torque ratio parameter is greater than or equal to a corresponding predetermined duty-cycle-to-torque ratio parameter threshold during an operation of the functional motor includes: the heavy load identification unit being configured to obtain at least one duty-cycle-to-torque ratio parameter, and determine whether the at least one duty-cycle-to-torque ratio parameter is greater than or equal to the corresponding predetermined duty-cycle-to-torque ratio parameter threshold.

Optionally, the heavy load control unit being configured to select the second control strategy from the plurality of control strategies, and control the functional motor based on the second control strategy includes: the heavy load control unit being configured to control, in response to the second control strategy being the same as the first control strategy, the operating parameter corresponding to the second control strategy to decrease to a target value. The target value is smaller than a value of the operating parameter corresponding to the second control strategy under a normal operating state of the functional motor.

Optionally, the heavy load control unit being configured to select the second control strategy from the plurality of control strategies, and control the functional motor based on the second control strategy includes: the heavy load control unit being configured to control, in response to the second control strategy being different from the first control strategy, the operating parameter corresponding to the second control strategy to decrease to a target value. The target value is smaller than or equal to an upper limit threshold of the operating parameter corresponding to the second control strategy under a normal operating state of the functional motor.

In another aspect, an embodiment of the present disclosure further provides an electric garden work vehicle, including: a frame; a functional mechanism attached to the frame, including a functional motor and an output assembly driven by the functional motor to perform a specific functional operation; a controller assembly configured to control an operating state of the functional motor.

The functional motor has a plurality of operating parameters, and the controller assembly has a plurality of control strategies corresponding to the plurality of operating parameters of the functional motor.

The controller assembly includes a heavy load identification unit and a heavy load control unit.

The heavy load identification unit is configured to: select a target operating parameter from the plurality of operating parameters; and determine whether the functional motor enters a heavy load state based on the target operating parameter and/or a change of the target operating parameter.

The target operating parameter does not correspond to a first control strategy currently adopted by the controller assembly for the functional motor.

The heavy load control unit is configured to: select, in response to determining that the functional motor enters the heavy load state, a second control strategy from the plurality of control strategies; and control the functional motor based on the second control strategy to cause the functional motor to exit the heavy load state.

In another aspect, an embodiment of the present disclosure further provides an electric riding lawn mower, including: a frame; a carrying mechanism disposed on the frame and configured to carry a user; a mowing mechanism attached to the frame, including a mowing motor and a cutting blade assembly driven by the mowing motor to perform a mowing operation; a controller assembly configured to control an operating state of the mowing motor.

The mowing motor has a plurality of operating parameters, and the controller assembly has a plurality of control strategies corresponding to the plurality of operating parameters of the mowing motor.

The controller assembly includes a heavy load identification unit and a heavy load control unit.

The heavy load identification unit is configured to: select a target operating parameter from the plurality of operating parameters; and determine whether the mowing motor enters a heavy load state based on the target operating parameter and/or a change of the target operating parameter.

The target operating parameter does not correspond to a first control strategy currently adopted by the controller assembly for the mowing motor.

The heavy load control unit is configured to: select, in response to determining that the mowing motor enters the heavy load state, a second control strategy from the plurality of control strategies; and control the mowing motor based on the second control strategy to cause the mowing motor to exit the heavy load state.

As can be seen from the above, the electric work vehicle, electric garden work vehicle, and electric riding lawn mower provided by one or more embodiments of the present disclosure have the following beneficial technical effects:

In the electric work vehicle, electric garden work vehicle, and electric riding lawn mower, the heavy load identification unit in the controller assembly monitors one or a plurality of operating parameters related to the functional motor, and determines whether the functional motor enters a heavy load state based on the operating parameter(s) and/or changes in the operating parameter(s). Upon determining that the functional motor enters the heavy load state, the heavy load control unit in the controller assembly selects an appropriate control strategy according to the situation and promptly adjusts and controls the functional motor to make it exit the heavy load state. This approach enables precise and sensitive identification of sudden heavy-load changes in the motor, further facilitates a rapid response to such changes, timely adjustment of the control strategy, and maintains the motor system in a normal operating state, thereby enhancing overall machine stability and work efficiency, and optimizing the user experience.

### BRIEF DESCRIPTION OF THE DRAWINGS

The features, aspects, and advantages of the present disclosure will become better understood when the following detailed description is read with reference to the accompanying drawings in which like characters represent like parts throughout the drawings.
FIG. 1 is a schematic circuit diagram of a first electric vehicle according to an optional embodiment of the present disclosure.
FIG. 2 is a schematic circuit diagram of a second electric vehicle according to an optional embodiment of the present disclosure.
FIG. 3 is a module diagram of an electric vehicle according to an optional embodiment of the present disclosure.
FIG. 4 is a schematic diagram of sector time according to an optional embodiment of the present disclosure.
FIG. 5 is a flowchart corresponding to a first electric vehicle according to an optional embodiment of the present disclosure.
FIG. 6 is a flowchart corresponding to a second electric vehicle according to an optional embodiment of the present disclosure.
FIG. 7 is a flowchart corresponding to a third electric vehicle according to an optional embodiment of the present disclosure.
FIG. 8 is a flowchart corresponding to a fourth electric vehicle according to an optional embodiment of the present disclosure.
FIG. 9 is a graph corresponding to a first electric vehicle according to an optional embodiment of the present disclosure.
FIG. 10 is a graph corresponding to a second electric vehicle according to an optional embodiment of the present disclosure.
FIG. 11 is a graph corresponding to a third electric vehicle according to an optional embodiment of the present disclosure.
FIG. 12 is a graph corresponding to a fourth electric vehicle according to an optional embodiment of the present disclosure.
FIG. 13 is a graph corresponding to a third electric vehicle according to an optional embodiment of the present disclosure.
FIG. 14 is a graph corresponding to f a fourth electric vehicle according to an optional embodiment of the present disclosure.
FIG. 15 is a schematic structural diagram of an electric work vehicle according to an embodiment of the present disclosure.
FIG. 16 is a schematic structural diagram of an electric work vehicle according to an embodiment of the present disclosure.
FIG. 17 is a functional block diagram of a controller assembly in an electric work vehicle according to an embodiment of the present disclosure.
FIG. 18 is a schematic diagram of a method for a heavy load identification unit selecting a rotational speed parameter as a target operating parameter for heavy load determination in an electric work vehicle according to an embodiment of the present disclosure.
FIG. 19 is a schematic diagram of a method for a heavy load identification unit determining heavy load by using a motor rotational speed parameter in an electric work vehicle according to an embodiment of the present disclosure.
FIG. 20 is a schematic diagram of a heavy load identification unit determining a heavy load mutation based on a motor rotational speed threshold in an electric work vehicle according to an embodiment of the present disclosure.
FIG. 21 is a schematic diagram of a heavy load identification unit determining a heavy load mutation based on a motor rotational speed difference threshold in an electric work vehicle according to an embodiment of the present disclosure.
FIG. 22 is a schematic diagram of a heavy load identification unit determining a heavy load mutation based on a motor rotational speed rate-of-change threshold in an electric work vehicle according to an embodiment of the present disclosure.
FIG. 23 is a schematic diagram of a method for a heavy load identification unit determining heavy load by using a motor sector time parameter in an electric work vehicle according to an embodiment of the present disclosure.
FIG. 24 is a schematic diagram of a heavy load identification unit determining a heavy load mutation based on a motor sector time threshold in an electric work vehicle according to an embodiment of the present disclosure.
FIG. 25 is a schematic diagram of a heavy load identification unit determining a heavy load mutation based on a motor sector time difference threshold in an electric work vehicle according to an embodiment of the present disclosure.
FIG. 26 is a schematic diagram of a heavy load identification unit determining a heavy load mutation based on a motor sector time rate-of-change threshold in an electric work vehicle according to an embodiment of the present disclosure.
FIG. 27 is a schematic diagram of a method for a heavy load identification unit selecting an electrical parameter as a target operating parameter for heavy load determination in an electric work vehicle according to an embodiment of the present disclosure.
FIG. 28 is a schematic diagram of a method for a heavy load identification unit determining heavy load based on an electrical parameter in an electric work vehicle according to an embodiment of the present disclosure.
FIG. 29 is a schematic diagram of a heavy load identification unit determining a heavy load mutation based on a bus current threshold in an electric work vehicle according to an embodiment of the present disclosure.
FIG. 30 is a schematic diagram of a heavy load identification unit determining a heavy load mutation based on a bus current difference threshold in an electric work vehicle according to an embodiment of the present disclosure.
FIG. 31 is a schematic diagram of a heavy load identification unit determining a heavy load mutation based on a bus current rate-of-change threshold in an electric work vehicle according to an embodiment of the present disclosure.
FIG. 32 is a schematic diagram of a heavy load identification unit determining a heavy load mutation based on a bus voltage drop threshold in an electric work vehicle according to an embodiment of the present disclosure.
FIG. 33 is a schematic diagram of a heavy load identification unit determining a heavy load mutation based on a conducting phase voltage drop threshold in an electric work vehicle according to an embodiment of the present disclosure.
FIG. 34 is a schematic diagram of freewheeling time of a functional motor during operation in an electric work vehicle according to an embodiment of the present disclosure.
FIG. 35 is a schematic diagram of a method for a heavy load identification unit selecting a power parameter as a target operating parameter for heavy load determination in an electric work vehicle according to an embodiment of the present disclosure.
FIG. 36 is a schematic diagram of a method for a heavy load identification unit determining heavy load based on a power parameter in an electric work vehicle according to an embodiment of the present disclosure.
FIG. 37 is a schematic diagram of a method for a heavy load identification unit selecting a torque parameter as a target operating parameter for heavy load determination in an electric work vehicle according to an embodiment of the present disclosure.
FIG. 38 is a schematic diagram of a method for a heavy load identification unit determining heavy load based on a torque parameter in an electric work vehicle according to an embodiment of the present disclosure.
FIG. 39 is a schematic diagram of a method for a heavy load identification unit selecting a PWM duty cycle parameter as a target operating parameter for heavy load determination in an electric work vehicle according to an embodiment of the present disclosure.
FIG. 40 is a schematic diagram of a method for a heavy load identification unit determining heavy load based on a PWM duty cycle parameter in an electric work vehicle according to an embodiment of the present disclosure.
FIG. 41 is a schematic diagram of a method for a heavy load identification unit selecting a rotational speed parameter and an electrical parameter as target operating parameters for heavy load determination in an electric work vehicle according to an embodiment of the present disclosure.
FIG. 42 is a schematic diagram of a method for a heavy load identification unit determining heavy load based on a motor rotational speed parameter and an electrical parameter in an electric work vehicle according to an embodiment of the present disclosure.
FIG. 43 is a schematic diagram of a heavy load identification unit determining a heavy load mutation based on a current-to-speed ratio threshold in an electric work vehicle according to an embodiment of the present disclosure.
FIG. 44 is a schematic diagram of a method for a heavy load identification unit determining heavy load based on a motor sector time parameter and an electrical parameter in an electric work vehicle according to an embodiment of the present disclosure.
FIG. 45 is a schematic diagram of a heavy load identification unit determining a heavy load mutation based on a current-to-speed ratio threshold in an electric work vehicle according to an embodiment of the present disclosure.
FIG. 46 is a schematic diagram of a heavy load identification unit determining a heavy load mutation based on a current-to-speed ratio difference threshold in an electric work vehicle according to an embodiment of the present disclosure.
FIG. 47 is a schematic diagram of a heavy load identification unit determining a heavy load mutation based on a current-to-speed ratio difference threshold in an electric work vehicle according to an embodiment of the present disclosure.
FIG. 48 is a schematic diagram of a heavy load identification unit determining a heavy load mutation based on a current-to-speed ratio rate-of-change threshold in an electric work vehicle according to an embodiment of the present disclosure.
FIG. 49 is a schematic diagram of a heavy load identification unit determining a heavy load mutation based on a current-to-speed ratio rate-of-change threshold in an electric work vehicle according to an embodiment of the present disclosure.
FIG. 50 is a schematic diagram of a method for a heavy load identification unit selecting a rotational speed parameter and a power parameter as target operating parameters for heavy load determination in an electric work vehicle according to an embodiment of the present disclosure.
FIG. 51 is a schematic diagram of a method for a heavy load identification unit determining heavy load based on a motor rotational speed parameter and a power parameter in an electric work vehicle according to an embodiment of the present disclosure.
FIG. 52 is a schematic diagram of a method for a heavy load identification unit determining heavy load based on a motor sector time parameter and a power parameter in an electric work vehicle according to an embodiment of the present disclosure.
FIG. 53 is a schematic diagram of a method for a heavy load identification unit selecting a rotational speed parameter and a torque parameter as target operating parameters for heavy load determination in an electric work vehicle according to an embodiment of the present disclosure.
FIG. 54 is a schematic diagram of a method for a heavy load identification unit determining heavy load based on a motor rotational speed parameter and a torque parameter in an electric work vehicle according to an embodiment of the present disclosure.
FIG. 55 is a schematic diagram of a method for a heavy load identification unit determining heavy load based on a motor sector time parameter and a torque parameter in an electric work vehicle according to an embodiment of the present disclosure.
FIG. 56 is a schematic diagram of a method for a heavy load identification unit selecting a rotational speed parameter and a PWM duty cycle parameter as target operating parameters for heavy load determination in an electric work vehicle according to an embodiment of the present disclosure.
FIG. 57 is a schematic diagram of a method for a heavy load identification unit determining heavy load based on a motor rotational speed parameter and a PWM duty cycle parameter in an electric work vehicle according to an embodiment of the present disclosure.
FIG. 58 is a schematic diagram of a method for a heavy load identification unit determining heavy load based on a motor sector time parameter and a PWM duty cycle parameter in an electric work vehicle according to an embodiment of the present disclosure.
FIG. 59 is a schematic diagram of a method for a heavy load identification unit selecting an electrical parameter and a PWM duty cycle parameter as target operating parameters for heavy load determination in an electric work vehicle according to an embodiment of the present disclosure.
FIG. 60 is a schematic diagram of a method for a heavy load identification unit determining heavy load based on a duty-cycle-to-current ratio in an electric work vehicle according to an embodiment of the present disclosure.
FIG. 61 is a schematic diagram of a method for a heavy load identification unit selecting a power parameter and a PWM duty cycle parameter as target operating parameters for heavy load determination in an electric work vehicle according to an embodiment of the present disclosure.
FIG. 62 is a schematic diagram of a method for a heavy load identification unit determining heavy load based on a duty-cycle-to-power ratio in an electric work vehicle according to an embodiment of the present disclosure.
FIG. 63 is a schematic diagram of a method for a heavy load identification unit selecting a torque parameter and a PWM duty cycle parameter as target operating parameters for heavy load determination in an electric work vehicle according to an embodiment of the present disclosure.
FIG. 64 is a schematic diagram of a method for a heavy load identification unit determining heavy load based on a duty-cycle-to-torque ratio in an electric work vehicle according to an embodiment of the present disclosure.
FIG. 65 is a logic block diagram of applying PWM duty cycle open-loop control to a functional motor in an electric work vehicle according to an embodiment of the present disclosure.
FIG. 66 is a schematic diagram of a heavy load control unit reducing a duty cycle by using a linear reduction method in an electric work vehicle according to an embodiment of the present disclosure.
FIG. 67 is a schematic diagram of a heavy load control unit reducing a duty cycle by using a curvilinear reduction method in an electric work vehicle according to an embodiment of the present disclosure.
FIG. 68 is a schematic diagram of bus current change when the heavy load control unit switches from a PWM duty cycle open-loop control strategy to a current closed-loop control strategy in an electric work vehicle according to an embodiment of the present disclosure.
FIG. 69 is a schematic diagram of motor rotational speed change when the heavy load control unit switches from a PWM duty cycle open-loop control strategy to a rotational speed closed-loop control strategy in an electric work vehicle according to an embodiment of the present disclosure.
FIG. 70 is a schematic diagram of motor power change when the heavy load control unit switches from a PWM duty cycle open-loop control strategy to a power closed-loop control strategy in an electric work vehicle according to an embodiment of the present disclosure.
FIG. 71 is a schematic diagram of motor torque change when the heavy load control unit switches from a PWM duty cycle open-loop control strategy to a torque closed-loop control strategy in an electric work vehicle according to an embodiment of the present disclosure.
FIG. 72 is a logic block diagram of applying rotational speed closed-loop control to a functional motor in an electric work vehicle according to an embodiment of the present disclosure.
FIG. 73 is a schematic diagram of a heavy load control unit reducing the motor rotational speed by using a linear reduction method in an electric work vehicle according to an embodiment of the present disclosure.
FIG. 74 is a schematic diagram of a heavy load control unit reducing the motor rotational speed by using a curvilinear reduction method in an electric work vehicle according to an embodiment of the present disclosure.
FIG. 75 is a schematic diagram of bus current change when the heavy load control unit switches from a rotational speed closed-loop control strategy to a current closed-loop control strategy in an electric work vehicle according to an embodiment of the present disclosure.
FIG. 76 is a schematic diagram of duty cycle change when the heavy load control unit switches from a rotational speed closed-loop control strategy to a PWM duty cycle open-loop control strategy in an electric work vehicle according to an embodiment of the present disclosure.
FIG. 77 is a schematic diagram of motor power change when the heavy load control unit switches from a rotational speed closed-loop control strategy to a power closed-loop control strategy in an electric work vehicle according to an embodiment of the present disclosure.
FIG. 78 is a schematic diagram of motor torque change when the heavy load control unit switches from a rotational speed closed-loop control strategy to a torque closed-loop control strategy in an electric work vehicle according to an embodiment of the present disclosure.

### DETAILED DESCRIPTION OF THE EMBODIMENTS

To make the objectives, technical solutions, and advantages of the embodiments of the present disclosure clearer, the technical solutions in the embodiments of the present disclosure will be described clearly and completely below with reference to the accompanying drawings in the embodiments of the present disclosure. Obviously, the described embodiments are part, rather than all of the embodiments of the present disclosure. Based on the embodiments of the present disclosure, all other embodiments obtained by persons of ordinary skill in the art without making creative efforts shall fall within the protection scope of the present disclosure.

Compared to traditional fuel-powered lawn mowers, battery-powered lawn mowers offer the advantages of all-weather zero emissions, zero fuel consumption, low noise, and simple maintenance due to the absence of gasoline, engine oil, air filters, spark plugs, fuel storage, etc. In battery-powered lawn mowers, the fuel engine in the power system is replaced by an electric motor, which is capable of independently control the drive wheel motors to achieve straight-line travel, reversing, turning, and zero-turn steering, thereby reducing the structural complexity of the entire machine and enabling more flexible control.

During operation, the working load of the mowing motor varies significantly. Under sparse and short grass conditions, the load is very small, whereas under tall and dense grass conditions, the load becomes very heavy. In practical working conditions, the transition from sparse to dense grass is not always gradual, and can be abrupt. The motor load suddenly becomes a heavy load when moving from sparse grass directly into dense grass. On the other hand, after prolonged operation, the mowing deck inevitably accumulates a large amount of grass debris. This debris mixed with newly cut dense grass causes the overall machine load to continuously increase. Continuous operation in the heavy load range makes the system exceptionally sensitive to sudden load changes. A common scenario under these conditions is that a slight, sudden increase in load can trigger the system's overload protection.

If the controller's protection current threshold is set too high or the delay time is too long, protection lag can occur. This may cause the power device to operate beyond its Safe Operating Area (SOA) for an extended period, leading to burnout, most typically from overcurrent damage. Even if the power device is not damaged, the substantial current surge imposes significant stress on the motor itself, which is destructive. Over time, the motor stator may burn out, or the rotor magnets may demagnetize. Conversely, if the controller sets the protection current threshold too low or the response time too short, the protection becomes very sensitive, making it less likely for the power device to be damaged. However, this also means the system is highly prone to shutdown under the aforementioned heavy load mutation conditions, severely affecting the user's work experience.

In response to the above problems, an electric work vehicle, an electric garden work vehicle, and an electric riding lawn mower are provided according to the embodiments of the present disclosure. Based on the plurality of control strategies applicable to the motor, various operating parameters associated with the motor are monitored. The load variation of the motor is determined according to an operating parameter among the operating parameters and/or a change in the parameter among the operating parameters. This approach enables precise and sensitive identification of sudden heavy-load changes in the motor, facilitates a rapid response to such heavy load mutations, allows for timely adjustment of the control strategy, and maintains the motor system in a normal operating state. Consequently, it enhances overall machine stability and work efficiency, and optimizes the user experience.

The embodiments of the present disclosure will be described in detail below with reference to the accompanying drawings. However, those of ordinary skill in the art can understand that many technical details are provided in the various embodiments of the present disclosure to facilitate a better understanding for the reader. Nevertheless, the technical solutions claimed in the present disclosure can be achieved even without these technical details and based on various changes and modifications to the following embodiments.

Based on the above-described objective, an embodiment of the present disclosure provides an electric vehicle.

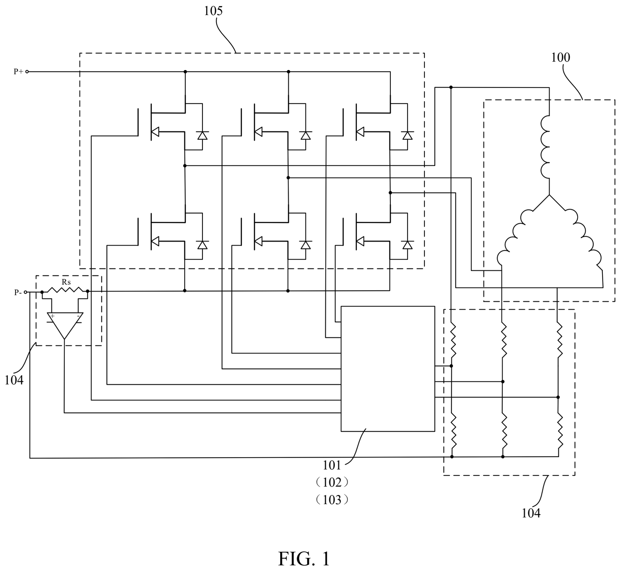

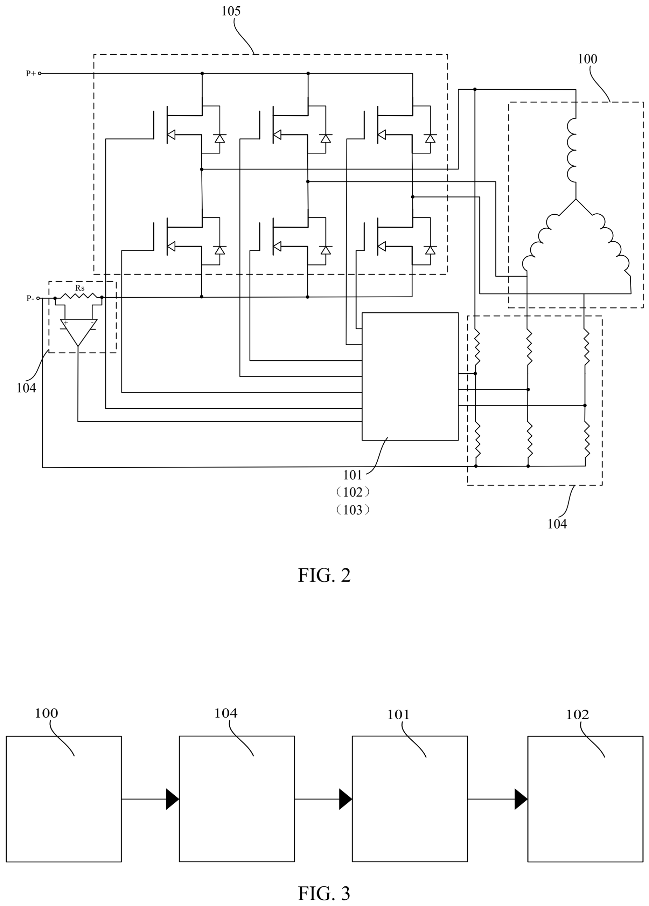

Reference is made to FIG. 1 to FIG. 3, where FIG. 1 is a first circuit diagram of an electric vehicle according to an embodiment of the present disclosure, FIG. 2 is a second circuit diagram of an electric vehicle according to an embodiment of the present disclosure; and FIG. 3 is a module diagram of an electric vehicle according to an embodiment of the present disclosure.

In some embodiments, the electric vehicle may include a motor 100.

The electric vehicle may include a collection module 104 configured to collect at least two mechanical parameters and at least two electrical parameters of the motor. The mechanical parameter includes a rotational speed parameter, a sector time parameter, or a torque parameter. The electrical parameter includes a bus current parameter, a phase current parameter, a bus voltage parameter, a power parameter, a freewheeling time parameter, or a duty cycle parameter.

The electric vehicle may further include a detection module 101 configured to process different mechanical parameters of the motor 100, or different electrical parameters of the motor 100 based on a target calculation formula, and generate a target value. The target calculation formula includes at least a ratio, a slope of the ratio, or a difference of the ratio.

The electric vehicle may include a determination module 102 configured to determine whether the motor 100 is in a heavy load state based on the target value and a predetermined target threshold, and determine, when the target value fails to meet the predetermined target threshold, that the motor 100 is in the heavy load state. The predetermined target threshold has a correspondence with the target calculation formula.

In the embodiments of the specification, the collection module 104 obtains the mechanical parameters or electrical parameters of the motor, for the detection module 101 to generate the target value. The detection module 101 processes different mechanical parameters or electrical parameters of the motor 100 based on the target calculation formula, to obtain the target value, for the determination module 102 to determine whether the motor 100 is in the heavy load state. In addition, the ratio of different mechanical parameters or different electrical parameters can, on the one hand, more easily reflect whether the motor 100 is in the heavy load state, on the other hand, simplify calculation of the ratio, freeing up computing power of the detection module 101. Also, a more accurate determination of whether the motor 100 is in the heavy load state is achieved by providing the ratio of the mechanical parameter to the electrical parameter.

In some embodiments, the motor 100 is configured to drive the electric vehicle to operate. Taking the electric vehicle being a lawn mower as an example, the motor 100 may be configured to drive a cutter blade to rotate.

In some embodiments, the rotational speed parameter includes: a rotational speed, a rotational speed difference, or a slope of a rotational speed curve; the sector time parameter includes: a sector time, a sector time difference, or a slope of a sector time curve; the torque parameter includes: torque, a torque difference, or a slope of a torque curve; the bus current parameter includes: a bus current, a bus current difference, or a slope of a bus current curve; the phase current parameter includes: a phase current, a phase current difference, or a slope of a phase current curve; the bus voltage parameter includes: a bus voltage, a bus voltage difference, or a slope of a bus voltage curve; the power parameter includes: power, a power difference, or a slope of a power curve; the freewheeling time parameter includes: freewheeling time, a freewheeling time difference, or a slope of a freewheeling time curve; and the duty cycle parameter includes: a duty cycle parameter, a duty cycle parameter difference, or a slope of a duty cycle parameter curve. The ratio between different mechanical parameters or the ratio between different electrical parameters is a ratio between parameters that have the same type.

It should be understood that, the ratio between parameters that have the same type refers to a ratio of a parameter to another parameter, or a ratio of a difference to another difference, or a ratio of a slope to another slope. For example, it may be a ratio of the rotational speed to the sector time, or a ratio of the rotational speed difference to the sector time difference, or a ratio of a rotational speed slope to a sector time slope, etc. The ratio between different mechanical parameters may be either a ratio of a first mechanical parameter to a second mechanical parameter or a ratio of the second mechanical parameter to the first mechanical parameter. Similarly, the ratio between different electrical parameters may be either a ratio of a first electrical parameter to a second electrical parameter or a ratio of the second electrical parameter to the first electrical parameter. It should be noted that, the above-described first mechanical parameter, second mechanical parameter, first electrical parameter, and second electrical parameter are merely used to refer to different parameters, rather than imposing any limitations on the different parameters.

Various mechanical parameters and electrical parameters are described below.

In some embodiments, the rotational speed is obtained by sampling the rotational speed of the motor 100.

The rotational speed difference ΔNₖ is obtained by subtracting the rotational speed Nₖ₋₁ obtained at the previous moment from the rotational speed Nₖ obtained at the current moment. The rotational speed difference may be an absolute value, that is, the obtained ΔNₖ is a positive number, which can facilitate subsequent calculation of the ratio.

The slope of the rotational speed curve is obtained by obtaining the rotational speeds N₀, N₁, N₂...Nₖ at the moments t₀, t₁, t₂...tₖ ,performing linear fitting on N₀, N₁, N₂...Nₖ by using Formula (3): k = (EtN - Et*EN) / [Et² - (Et)²] ,and obtaining the slope k of the obtained curve, where EtN represents the mathematical expectation of a product of the sampling moment t and the rotational speed, Et represents the mathematical expectation of the sampling moment t, EN represents the mathematical expectation of the rotational speed, Et² represents the mathematical expectation of the square of the sampling moment t, and (Et)² represents the square of the mathematical expectation of the sampling moment t. Assuming that Δt₀ = t₁ - t₀, Δt₁ = t₂ - t₁..., Δtₖ = tₖ₊₁ - tₖ, for the convenience of software calculation, it is generally designed as follows: Δt₀ = Δt₁ = ... = Δtₖ. Therefore, the above-described formula can be simplified as follows: k = [N*Σ(t*N) - Σt*ΣN] / [N*Σt2 - Σt*Σt], where N is a positive integer, * represents obtaining the product, and Δt₀, Δt₁...Δtₖ represent the time differences between two adjacent moments.

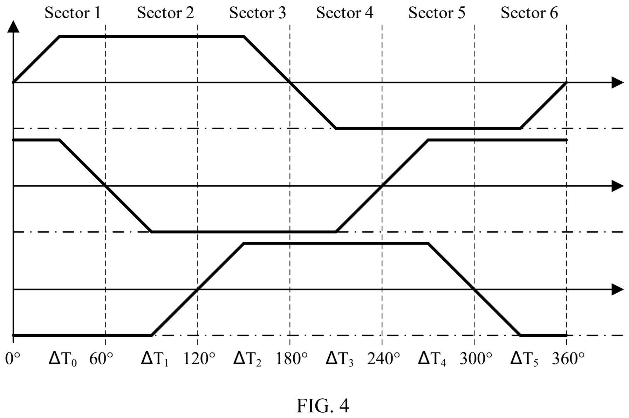

Reference is made to FIG. 4, which is a schematic diagram of sector time according to an embodiment of the present disclosure.

In some embodiments, the sector time may be obtained by sampling the sector time of the motor 100. It should be understood that, taking the motor 100 being a three-phase brushless direct current motor 100 or a three-phase permanent magnet synchronous motor 100 as an example, an electrical cycle of the three-phase brushless direct current motor 100 or the three-phase permanent magnet synchronous motor 100 is 360°, which is generally divided into 6 sectors, with each sector corresponding to an electrical angle of 60°. Taking a brushless direct current motor 100 driven by square waves as an example, the sectors are as illustrated in FIG. 4. When the motor 100 operates stably, the duration (Δt₀, Δt₁, Δt₂, Δt₃, Δt₄, Δt₅) of each sector in the 360° electrical cycle is relatively close to each other. However, when the load changes drastically, the sector time may also change abruptly.

The sector time difference ΔSₖ is obtained by subtracting the sector time Sₖ₋₁ obtained at the previous moment from the sector time Sₖ obtained at the current moment. The sector time difference may be an absolute value, that is, the obtained ΔSₖ is a positive number, which can facilitate subsequent calculation of the ratio.

The slope of the sector time curve is obtained by obtaining the sector time S₀, S₁, S₂...Sₖ at the moments t₀, t₁, t₂...tₖ, performing linear fitting on S₀, S₁, S₂...Sₖ by using formula (3): k = (EtS - Et*ES) / [Et² - (Et)²], and obtaining the slope k of the obtained curve, where, EtS represents the mathematical expectation of a product of the sampling moment t and the sector time, Et represents the mathematical expectation of the sampling moment t, ES represents the mathematical expectation of the sector time, Et² represents the mathematical expectation of the square of the sampling moment t, and (Et)² represents the square of the mathematical expectation of the sampling moment t. Assuming that Δt₀ = t₁ - t₀, Δt₁ = t₂ - t₁..., Δtₖ = tₖ₊₁ - tₖ, for the convenience of software calculation, it is generally designed as follows: Δt₀=Δt₁= ... =Δtₖ. Therefore, the above-described formula can be simplified as follows: k = [S*Σ(t*S) -Σt*ΣS] / [S*Σt² -Σt*Σt], where S is a positive integer, * represents a mathematical operation of obtaining a product, and Δt₀, Δt₁...Δtₖ represent the time differences between two adjacent moments.

In some embodiments, the torque may be obtained by sampling the torque of the motor 100.

The torque difference ΔAₖ is obtained by subtracting the torque Aₖ₋₁ obtained at the previous moment from the torque Aₖ obtained at the current moment. The torque difference may be an absolute value, that is, the obtained ΔAₖ is a positive number, which can facilitate subsequent calculation of the ratio.

The slope of the torque curve is obtained by obtaining the torques A₀, A₁, A₂...Aₖ at the moments t₀, t₁, t₂...tₖ, performing linear fitting on A₀, A₁, A₂...Aₖ by using formula (3): k = (EtA - Et*EA) / [Et² - (Et)²] , and obtaining the slope k of the obtained curve, where, EtA represents the mathematical expectation of a product of the sampling moment t and the torque, Et represents the mathematical expectation of the sampling moment t, EA represents the mathematical expectation of the torque, Et² represents the mathematical expectation of the square of the sampling moment t, and (Et)² represents the square of the mathematical expectation of the sampling moment t. Assuming that Δt₀ = t₁ - t₀, Δt₁ = t₂ - t₁..., Δtₖ = tₖ₊₁ - tₖ, for the convenience of software calculation, it is generally designed as follows: Δt₀=Δt₁= ... =Δtₖ. Therefore, the above-described formula can be simplified as follows: k = [A*Σ(t*A) -Σt*ΣA] / [A*Σt² -Σt*Σt], where A is a positive integer, * represents a mathematical operation of obtaining a product, and Δt₀, Δt₁...Δtₖ represent the time differences between two adjacent moments.

In some embodiments, the bus current may be a current flowing through Rs as shown in FIG. 2.

The bus current difference ΔBₖ is obtained by subtracting the bus current Bₖ₋₁ obtained at the previous moment from the bus current Bₖ obtained at the current moment. The bus current difference may be an absolute value, that is, the obtained ΔBₖ is a positive number, which can facilitate subsequent calculation of the ratio.

The slope of the bus current curve is obtained by obtaining the bus currents B₀, B₁, B₂...Bₖ at the moments t₀, t₁, t₂...tₖ, performing linear fitting on B₀, B₁, B₂...Bₖ by using formula (3): k = (EtB - Et*EB) / [Et² - (Et)²] , and obtaining the slope k of the obtained curve, where, EtB represents the mathematical expectation of a product of the sampling moment t and the bus current, Et represents the mathematical expectation of the sampling moment t, EB represents the mathematical expectation of the bus current, Et² represents the mathematical expectation of the square of the sampling moment t, and (Et)² represents the square of the mathematical expectation of the sampling moment t. Assuming that Δt₀ = t₁ - t₀, Δt₁ = t₂ - t₁..., Δtₖ = tₖ₊₁ - tₖ, for the convenience of software calculation, it is generally designed as follows: Δt₀=Δt₁= ... =Δtₖ. Therefore, the above-described formula can be simplified as follows: k = [B*Σ(t*B) -Σt*ΣB] / [B*Σt² -Σt*Σt], where B is a positive integer, and Δt₀, Δt₁...Δtₖ represent the time differences between two adjacent moments.

In some embodiments, the phase current of the motor 100 has alternating current characteristics. The phase current may be obtained by connecting current sensors to different output terminals of the motor 100 for sampling, or may be obtained by connecting sampling resistors.

The phase current difference ΔCₖ is obtained by subtracting the phase current Cₖ₋₁ obtained at the previous moment from the phase current Cₖ obtained at the current moment. The phase current difference may be an absolute value, that is, the obtained ΔCₖ is a positive number, which can facilitate subsequent calculation of the ratio.

The slope of the phase current curve is obtained by obtaining the phase currents C₀, C₁, C₂...Cₖ at the moments t₀, t₁, t₂...tₖ, performing linear fitting on C₀, C₁, C₂...Cₖ by using formula (3): k = (EtC - Et*EC) / [Et² - (Et)²], and obtaining the slope k of the obtained curve, where, EtC represents the mathematical expectation of a product of the sampling moment t and the phase current, Et represents the mathematical expectation of the sampling moment t, EC represents the mathematical expectation of the phase current, Et² represents the mathematical expectation of the square of the sampling moment t, and (Et)² represents the square of the mathematical expectation of the sampling moment t. Assuming that Δt₀ = t₁ - t₀, Δt₁ = t₂ - t₁..., Δtₖ = tₖ₊₁ - tₖ, for the convenience of software calculation, it is generally designed as follows Δt₀=Δt₁= ... =Δtₖ. Therefore, the above-described formula can be simplified as follows: k = [C*Σ(t*C) -Σt*ΣC] / [C*Σt² -Σt*Σt], where C is a positive integer, and Δt₀, Δt₁...Δtₖ represent the time differences between two adjacent moments.

In some embodiments, the bus voltage of the motor 100 may be a voltage between P+ and P-. The relative voltage drop increases as the load increases, and vice versa. In the electric vehicle powered by a battery pack, the drop in a terminal voltage of the battery pack becomes more significant as the load increases. The terminal voltage corresponds to the bus voltage, and the bus voltage reflects the terminal voltage of the battery pack. The battery pack herein may refer to the battery pack of the electric vehicle.

The bus voltage difference ΔDₖ is obtained by subtracting the bus voltage Dₖ₋₁ obtained at the previous moment from the bus voltage Dₖ obtained at the current moment. The bus voltage difference may be an absolute value, that is, the obtained ΔDₖ is a positive number, which can facilitate subsequent calculation of the ratio.

The slope of the bus voltage curve is obtained by obtaining the bus voltages D₀, D₁, D₂...Dₖ at the moments t₀, t₁, t₂...tₖ, performing linear fitting on D₀, D₁, D₂...Dₖ by using formula (3): k = (EtD - Et*ED) / [Et² - (Et)²], and obtaining the slope of the obtained curve, where, EtD represents the mathematical expectation of a product of the sampling moment t and the bus voltage, Et represents the mathematical expectation of the sampling moment t, ED represents the mathematical expectation of the bus voltage, Et² represents the mathematical expectation of the square of the sampling moment t, and (Et)² represents the square of the mathematical expectation of the sampling moment t. Assuming that Δt₀ = t₁ - t₀, Δt₁ = t₂ - t₁..., Δtₖ = tₖ₊₁ - tₖ, for the convenience of software calculation, it is generally designed as follows Δt₀=Δt₁= ... =Δtₖ. Therefore, the above-described formula can be simplified as follows: k = [D*Σ(t*D) -Σt*ΣD] / [D*Σt² -Σt*Σt], where D is a positive integer, * represents a mathematical operation of obtaining a product, and Δt₀, Δt₁...Δtₖ represent the time differences between two adjacent moments.

In some embodiments, the power is obtained by: P = U*I*p, where U represents a bus voltage at a direct current input side, I represents the bus current, p represents a power factor, and p at the direct current side is always equal to 1; or, U represents a phase voltage at an output side, I represents the phase current, p represents the power factor, and p is less than or equal to 1.

The power difference and the slope of the power curve may refer to the above-described descriptions of the difference and slope, and thus details thereof will be omitted below.

In some embodiments, the freewheeling time may be directly obtained by using a timer. The timer is activated at each commutation to calculate the freewheeling time. The freewheeling time can characterize a load magnitude. The freewheeling time becomes longer as the load increases.

The freewheeling time difference and the slope of the freewheeling time curve can refer to the above-described descriptions of the difference and slope, and thus details thereof will be omitted below.

In some embodiments, the duty cycle may be set as desired. The duty cycle may be obtained by measuring a percentage of a duration during which the circuit is switched on relative to an entire circuit operating cycle. The rotational speed becomes higher as the duty cycle increases.

The duty cycle difference and the slope of the duty cycle curve can refer to the above-described descriptions of the difference and slope, and thus details thereof will be omitted below.

In some embodiments, the ratios of different mechanical parameters to different electrical parameters may be a ratio between parameters that have the same type among the above-described parameters, such as the ratio between the rotational speed and the sector time, the ratio between the rotational speed difference and the sector time difference, or the ratio between the slope of the rotational speed and the slope of the sector time.

It should be understood that, as the load increases, the rotational speed decreases, the sector time increases, the torque decreases, the bus current increases, the phase current increases, the bus voltage decreases, the power increases, the freewheeling time increases, and the duty cycle decreases. That is, the rotational speed is negatively correlated with the sector time, the rotational speed is positively correlated with the torque, the sector time is negatively correlated the torque, the bus current is positively correlated with the phase current, the bus current is negatively correlated with the bus voltage, and the bus current is positively correlated with the power. The ratios of negatively correlated parameters make extraction of ratio parameters easier, which can more easily provide feedback on whether the motor 100 is in the heavy load state. In contrast, the ratios of positively correlated parameters can simplify a calculation process of the detection module 101, which can free up the computing power of the detection module 101. The ratios of other different mechanical parameters and electrical parameters can refer to the above-described descriptions, and thus details thereof will be omitted below.

As illustrated in FIG. 1 to 3, FIG. 1 is a schematic circuit diagram of a first electric vehicle according to an embodiment of the present disclosure; FIG. 2 is a schematic circuit diagram of a second electric vehicle according to an embodiment of the present disclosure; and FIG. 3 is a schematic module diagram of an electric vehicle according to an embodiment of the present disclosure.

As illustrated in FIG. 1, the motor 100 may include a brushless motor, the collection module 104 may include a back electromotive force collection module including several sampling resistors, and the determination module 102 and the control module 103 may be integrated into a main control chip.

The electric vehicle may further include a plurality of power devices MOSFET105.

As illustrated in FIG. 2, when current parameters need to be collected, a current sampling module may also be added. The current sampling module may include a sampling resistor and an operational amplifier.

As illustrated in FIG. 5, FIG. 9, and FIG. 10, FIG. 5 is a first flowchart according to an embodiment of the present disclosure. Performing open-loop/closed-loop control based on a current control strategy of the entire motor 100 refers to performing, based on the obtained ratio parameter, control by selecting a control method corresponding to a parameter other than the obtained parameter. Taking the obtained ratio being the ratio between the rotational speed and the sector time as an example, the motor 100 is controlled to be in a second operating state by controlling any parameter other than the rotational speed and the sector time, for example, by fixing the torque of the motor 100 to a certain parameter, or by fixing the power to a certain parameter.

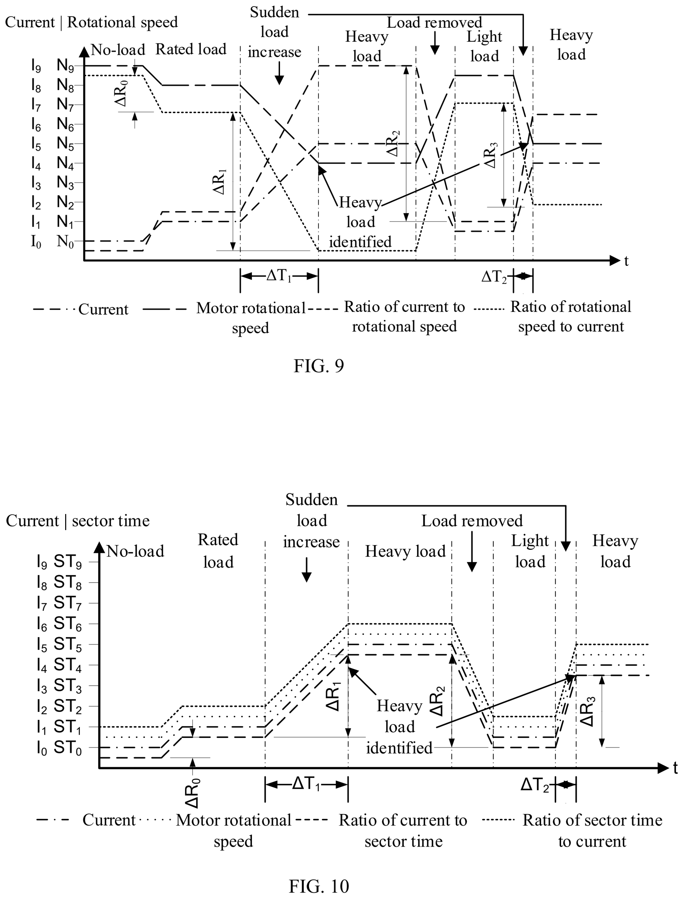

FIG. 9 is a graph plotted using a current/rotational speed as parameters, and FIG. 10 is a graph plotted using a current/ sector time as parameters. As can be seen from FIG. 9 and FIG. 10, the motor 100 is determined to be in the heavy load state subsequent to the ratio abruptly changing to a predetermined target threshold.

In some embodiments, the determination module 102 is further configured to: compare the ratio with the predetermined target threshold, and determine, when the ratio fails to meet the predetermined target threshold, that the motor is in the heavy load state.

Taking the rotational speed and sector time as an example, it is determined whether the current ratio Rₖ (a ratio of the rotational speed to the sector time or a ratio of the sector time to the rotational speed) is less than or equal to (for the ratio of the rotational speed to the sector time) or greater than or equal to (for the ratio of the sector time to the rotational speed) a certain predetermined ratio threshold R_{T}. If the current ratio Rₖ is less than or equal to (for the ratio of the rotational speed to the sector time) or greater than or equal to (for the ratio of the sector time to the rotational speed) the certain predetermined ratio threshold R_{T}, it is determined that the load has entered a heavy load operating region.

Furthermore, a time constraint condition may also be added. When the current ratio Rₖ (the ratio of the rotational speed to the sector time or the ratio of the sector time to the rotational speed) is less than or equal to (for the ratio of the rotational speed to the sector time) or greater than or equal to (for the ratio of the sector time to the rotational speed) the certain predetermined ratio threshold R_{T} within a predetermined duration ΔT (e.g., 0.01 second to 10 seconds), it is determined that the load has entered the heavy load operating region.

Furthermore, the above added time constraint may be segmented into X predetermined durations ΔTₓ. For example, x=4, ΔT₀=10 seconds, ΔT₁=1 second, ΔT₂=0.1 second, ΔT₃=0.01 second. When the current ratio Rₖ (the ratio of the rotational speed to the sector time or the ratio of sector time to the rotational speed) is less than or equal to (for the ratio of the rotational speed to the sector time) or greater than or equal to (for the ratio of sector time to the rotational speed) the predetermined ratio threshold R_{T0} within ΔT₀ (10 seconds), and/or the current ratio Rₖ (the ratio of the rotational speed to the sector time or the ratio of sector time to the rotational speed) is less than or equal to (for the ratio of the rotational speed to the sector time) or greater than or equal to (for the ratio of sector time to the rotational speed) the predetermined ratio threshold R₁₁ within ΔT₁ (1 second), and/or the current ratio Rₖ (the ratio of the rotational speed to the sector time or the ratio of sector time to the rotational speed) is less than or equal to (for the ratio of the rotational speed to the sector time) or greater than or equal to (for the ratio of sector time to the rotational speed) the predetermined ratio threshold R_{T2} within ΔT₂ (0.1 second), and/or the current ratio Rₖ (the ratio of the rotational speed to the sector time or the ratio of sector time to the rotational speed) is less than or equal to (for the ratio of the rotational speed to the sector time) or greater than or equal to (for the ratio of sector time to the rotational speed) the predetermined ratio threshold R₁₃ within ΔT₃ (0.01 second), it is determined that the load has entered the heavy load operating region. In addition, R_{T0} to R_{T3} may satisfy R_{T0}≥R_{T1}≥R_{T2}≥R_{T3}, or R_{T0}≤ R_{T1}≤ R_{T2}≤ R_{T3}.

It should be noted that, the predetermined ratio herein may be a range with an upper limit and a lower limit, and may also be based on a threshold determination where the ratio is greater than or less than a certain value. For example, when the obtained ratio of different mechanical parameters is greater than a certain value, the motor 100 may be considered to be in the heavy load state; and when the ratio of different mechanical parameters is less than a certain value, the motor 100 may be considered to be in the heavy load state.

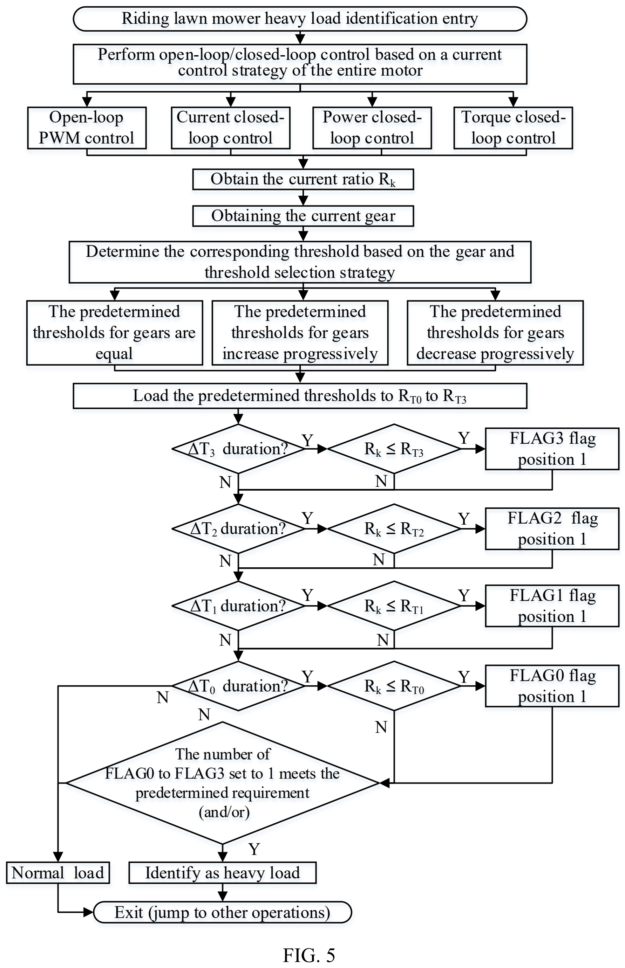

As illustrated in FIG. 5, in some embodiments, the motor 100 includes a first gear, a second gear, and a third gear with progressively increasing output capacities. The predetermined target threshold is the same when the motor 100 is in the first gear, the second gear, and the third gear. Alternatively, the predetermined target threshold decreases progressively when the motor 100 is in the first gear, the second gear, and the third gear. Alternatively, the predetermined target threshold increases progressively when the motor 100 is in the first gear, the second gear, and the third gear.

The predetermined target threshold is the same when the motor 100 is in the first gear, the second gear, and the third gear. For example, the predetermined target threshold when the motor 100 is in the first gear ranges from 0.5 to 0.8, the predetermined target threshold when the motor 100 is in the second gear ranges from 0.5 to 0.8, and the predetermined target threshold when the motor 100 in the third gear ranges from 0.5 to 0.8. However, the ratios obtained when the motor 100 is in the first gear, the second gear, and the third gear may be different, but all obtained ratios are compared with the same predetermined target threshold.

The predetermined target threshold decreases progressively when the motor 100 is in the first gear, the second gear, and the third gear, that is, the predetermined target threshold is highest in the first gear and lowest in the third gear. However, the output capacity is weakest in the first gear and strongest in the third gear.

For example, with reference to Table 1 below, when the motor 100 is in the first gear, the predetermined target threshold ranges from 0.5 to 0.8; when the motor 100 is in the second gear, the predetermined target threshold ranges from 0.8 to 1.2; and when the motor 100 is in the third gear, the predetermined target threshold ranges from 1.2 to 1.6. When determining the heavy load state, it is first determined that which gear the motor 100 is currently in. Taking the ratio being 0.9 as an example, when the motor 100 is in the first gear, it is determined that the motor 100 is in the heavy load state; when the motor 100 is in the second gear, it is determined that the motor 100 is in a normal state; and when the motor 100 is in the third gear, it is determined that motor 100 is in the heavy load state.

**Table 1**

| | ΔT₀ | ΔT₁ | ΔT₂ | ΔT₃ |
|---|---|---|---|---|
| First gear | 0.8 | 0.7 | 0.6 | 0.5 |
| Second gear | 1.2 | 1.1 | 1.0 | 0.9 |
| Third gear | 1.6 | 1.5 | 1.4 | 1.3 |

The predetermined target threshold increases progressively when the motor 100 is in the first gear, the second gear, and the third gear. That is, the predetermined target threshold is lowest in the first gear and highest in the third gear, while the output capacity is weakest in the first gear and strongest in the third gear. In other embodiments, the output capacity may also be strongest in the first gear and weakest in the third gear.

For example, with reference to Table 2 below, when the motor 100 is in the first gear, the predetermined target threshold ranges from 1.2 to 1.6; when the motor 100 is in the second gear, the predetermined target threshold ranges from 0.8 to 1.2; and when the motor 100 is in the third gear, the predetermined target threshold ranges from 0.5 to 0.8. When determining the heavy load state, it is first determined that which gear the motor 100 is currently in. Taking the ratio being 0.9 as an example, when the motor 100 is in the first gear, it is determined that the motor 100 is in the heavy load state; when the motor 100 is in the second gear, it is determined that the motor 100 is in the normal state; and when the motor 100 is in the third gear, it is determined that motor 100 is in the heavy load state.

**Table 2**

| | ΔT₀ | ΔT₁ | ΔT₂ | ΔT₃ |
|---|---|---|---|---|
| First gear | 1.6 | 1.5 | 1.4 | 1.3 |
| Second gear | 1.2 | 1.1 | 1.0 | 0.9 |
| Third gear | 0.8 | 0.7 | 0.6 | 0.5 |

It should be understood that, setting the predetermined target threshold to be the same when the motor 100 is in the first gear, the second gear, and the third gear can reduce complexity of overall parameter setting and facilitate determination of the determination module 102. Setting the predetermined target threshold to decrease progressively when the motor 100 is in the first gear, the second gear, and the third can better aligns with actual usage conditions. For example, when the motor 100 is in the third gear, its output capacity is strongest, that is, the user is less willing to have the motor 100 stop operating. Therefore, the predetermined target threshold can be set to be the lowest when the motor 100 is in the third gear, making it more difficult to enter the heavy load state and preventing the motor 100 from entering the second output state. Setting the predetermined target threshold to increase progressively when the motor 100 is in the first gear, the second gear, and the third gear can ensure that a difficulty level of determining the heavy load state is the same among all gears.

It should be noted that, the above-described descriptions address a situation where the obtained ratio of different mechanical parameters or the obtained ratio of different electrical parameters decreases as the load increases. When the obtained ratio of different mechanical parameters or the obtained ratio of different electrical parameters increases accordingly as the load increases, setting the predetermined target threshold to decrease progressively when the motor 100 is in the first gear, the second gear, and the third gear can ensure that the difficulty level of determining the heavy load state is the same among all gears, and setting the predetermined target threshold to increase progressively when the motor 100 is in the first gear, the second gear, and the third gear can better align with actual usage conditions.

With continued reference to Table 1 and Table 2, ΔT₀ to ΔT₄ represent the sampling time intervals that decrease progressively, ΔT₀ may be 10 seconds, ΔT₁ may be 1 second, ΔT₂ may be 0.1 second, and ΔT₃ may be 0.01 second. In some embodiments, the predetermined target threshold is determined based on the sampling time, and the predetermined target threshold decreases as the sampling time interval decreases. The sampling time interval is the time interval for obtaining two adjacent mechanical parameters or two adjacent electrical parameters. Taking the rotational speed as an example, when the rotational speed is relatively high, the sampling frequency of the rotational speed is much lower than the change frequency of the actual rotational speed, resulting in large fluctuations between the obtained data, or the change rate of the actual rotational speed may already meet application requirements, but the actual calculation and determination fail to identify it. When the rotational speed is relatively low, the sampling frequency of the rotational speed is much higher than the filtering frequency of the rotational speed of the motor 100. The rotational speed sampled at each moment may be the same, which unnecessarily consumes computing resources. When the rotational speed of the motor 100 fluctuates over a small time scale, the calculation results are easy to be interfered, leading to erroneous determination. Therefore, by setting the predetermined target threshold to be smaller when the sampling time interval is shorter and setting the predetermined target threshold to be larger when the sampling time interval is longer, on the one hand, the consumption of the computing resources can be reduced, on the other hand, the accuracy of identifying whether the heavy load state is entered can be improved.

In this case, the predetermined target threshold may refer to the difference between the predetermined target threshold and the target value. The difference decreases as the sampling time interval decreases, which can improve the accuracy of identifying whether the heavy load state is entered.

Taking the ratio of the sector time to the rotational speed as an example, the ratio increases as the load increases. By setting the predetermined target threshold to be smaller when the sampling time interval is shorter, the consumption of computing resources can be reduced, on the other hand, the accuracy of identifying whether the heavy load state is entered can be improved. Taking the ratio of the rotational speed to the sector time as an example, the ratio decreases as the load increases. Therefore, the predetermined target threshold should be set to be larger when the sampling time interval is shorter, to improve the accuracy of identifying whether the heavy load state is entered. In other words, the set predetermined target threshold is also related to the change of the target value. When the target value increases as the load increases, the predetermined target threshold should be set to be smaller when the sampling time interval shorter. When the target value decreases as the load increases, the predetermined target threshold should be set to be larger when the sampling time interval is shorter.

It should be noted that, the data in the above-described tables is an example and represents the predetermined target threshold. It should be understood that, the data in the above-described tables is merely for illustrative purposes. It may be other data or numerical values in other ranges.

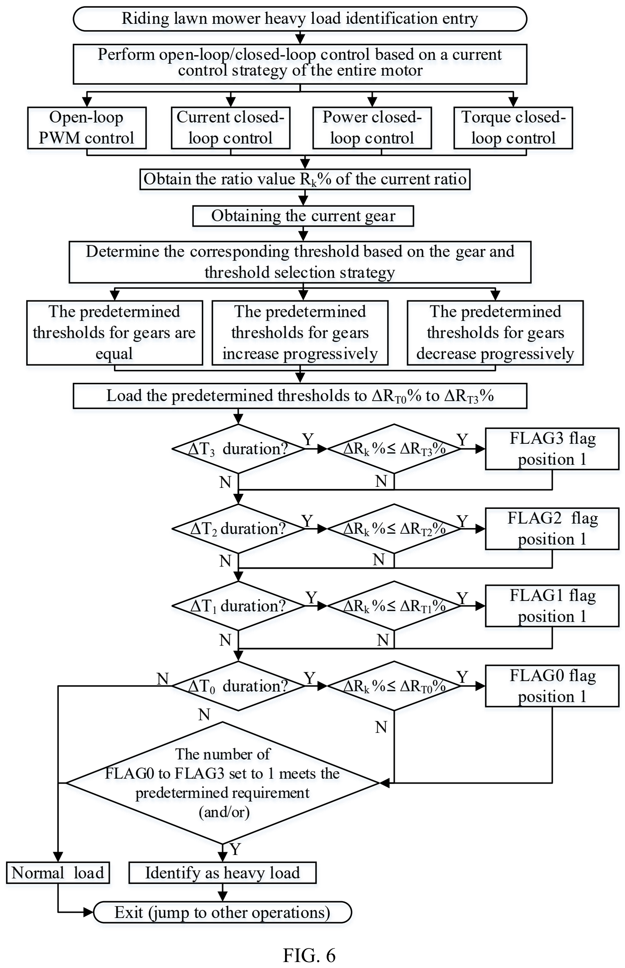

Reference is made to FIG. 6, which is a second flowchart according to an embodiment of the present disclosure.

In some embodiments, the target calculation formula includes: calculating the ratio of different mechanical parameters of the motor 100, or the ratio of different electrical parameters of the motor 100, and calculating a ratio value of the ratio to a predetermined ratio. The target value is the ratio value. The determination module 102 is further configured to: compare the ratio value with the predetermined target threshold, and determine, when the ratio value fails to meet the predetermined target threshold, that the motor 100 is in the heavy load state.

It should be understood that, taking the ratio of the rotational speed to the sector time as an example, the obtained ratio is a ratio of a current rotational speed to current sector time, and the predetermined ratio is a ratio of an expected rotational speed to expected sector time under a normal condition of the motor 100. Comparing the ratio value with the predetermined target threshold can also facilitate determination by the determination module 102 regarding whether the motor 100 is in the heavy load state.

It should be noted that, the predetermined ratio value herein may be a range with an upper limit and a lower limit, and may also be based on a threshold determination where the ratio value is greater than or less than a certain value. For example, when the ratio value of the obtained ratio of different mechanical parameters to the predetermined ratio is greater than a certain value, or the ratio value of the obtained ratio of different electrical parameters to the predetermined ratio is greater than a certain value, the motor 100 may be considered to be in the heavy load state. Similarly, when the ratio value of the obtained ratio of different mechanical parameters to the predetermined ratio is less than a certain value, or the ratio value of the obtained ratio of different electrical parameters to the predetermined ratio is less than a certain value, the motor 100 may also be considered to be in the heavy load state.

As illustrated in FIG. 6, in some embodiments, the motor 100 includes a first gear, a second gear, and a third gear with progressively increasing output capacities. The predetermined target threshold is the same when the motor 100 is in the first gear, the second gear, and the third gear. Alternatively, the predetermined target threshold decreases progressively when the motor 100 is in the first gear, the second gear, and the third gear. Alternatively, the predetermined target threshold increases progressively when the motor 100 is in the first gear, the second gear, and the third gear.

The predetermined target threshold is the same when the motor 100 is in the first gear, the second gear, and the third gear. For example, the predetermined target threshold when the motor 100 is in the first gear ranges from 40% to 60%, the predetermined target threshold when the motor 100 is in the second gear ranges from 40% to 60%, and the predetermined target threshold when the motor 100 in the third gear ranges from 40% to 60%. However, the ratio values obtained when the motor 100 is in the first gear, the second gear, and the third gear may be different, but all obtained ratio values are compared with the same predetermined target threshold.

When the predetermined target threshold decreases progressively when the motor 100 is in the first gear, the second gear, and the third gear, that is, the predetermined target threshold is highest in the first gear and lowest in the third gear, but the output capacity is weakest in the first gear and strongest in the third gear. In other embodiments, the output capacity may also be strongest in the first gear and weakest in the third gear.

For example, with reference to Table 3 below, when the motor 100 is in the first gear, the predetermined target threshold ranges from 30% to 50%; when the motor 100 is in the second gear, the predetermined target threshold ranges from 50% to 70%; and when the motor 100 is in the third gear, the predetermined target threshold ranges from 70% to 90%. When determining the heavy load state, it is first determined that which gear the motor 100 is currently in. Taking the ratio value being 55% as an example, when the motor 100 is in the first gear, it is determined that the motor 100 is in the heavy load state; when the motor 100 is in the second gear, it is determined that the motor 100 is in the normal state; and when the motor 100 is in the third gear, it is determined that motor 100 is in the heavy load state.

**Table 3**

| | ΔT₀ | ΔT₁ | ΔT₂ | ΔT₃ |
|---|---|---|---|---|
| First gear | 45% | 40% | 35% | 30% |
| Second gear | 65% | 60% | 55% | 50% |
| Third gear | 85% | 80% | 75% | 70% |

The predetermined target threshold increases progressively when the motor 100 is in the first gear, the second gear, and the third gear. That is, the predetermined target threshold is lowest in the first gear and highest in the third gear, while the output capacity is weakest in the first gear and strongest in the third gear.

For example, with reference to Table 4 below, when the motor 100 is in the first gear, the predetermined target threshold ranges from 70% to 90%; when the motor 100 is in the second gear, the predetermined target threshold ranges from 50% to 70%; and when the motor 100 is in the third gear, the predetermined target threshold ranges from 30% to 50%. When determining the heavy load state, it is first determined that which gear the motor 100 is currently in. Taking the ratio value being 55% as an example, when the motor 100 is in the first gear, it is determined that the motor 100 is in the heavy load state; when the motor 100 is in the second gear, it is determined that the motor 100 is in the normal state; and when the motor 100 is in the third gear, it is determined that motor 100 is in the heavy load state.

**Table 4**

| | ΔT₀ | ΔT₁ | ΔT₂ | ΔT₃ |
|---|---|---|---|---|
| First gear | 85% | 80% | 75% | 70% |
| Second gear | 65% | 60% | 55% | 50% |
| Third gear | 45% | 40% | 35% | 30% |

It should be understood that, setting the predetermined target threshold to be the same when the motor 100 is in the first gear, the second gear, and the third gear can reduce the complexity of overall parameter setting and facilitate determination of the determination module 102. Setting the predetermined target threshold to decrease progressively when the motor 100 is in the first gear, the second gear, and the third can better aligns with the actual usage conditions. For example, when the motor 100 is in the third gear, its output capacity is strongest, that is, the user is less willing to have the motor 100 stop operating. Therefore, the predetermined target threshold can be set to be the lowest when the motor 100 is in the third gear, making it more difficult to enter the heavy load state and preventing the motor 100 from entering the second output state. Setting the predetermined target threshold to increase progressively when the motor 100 is in the first gear, the second gear, and the third gear can ensure that the difficulty level of determining the heavy load state is the same among all gears.

It should be noted that, the above-described descriptions address the situation where the obtained ratio value of the ratio of different mechanical parameters to the predetermined ratio, or the obtained ratio value of the ratio of different electrical parameters to the predetermined ratio decreases as the load increases. When the obtained ratio value of the ratio of different mechanical parameters to the predetermined ratio, or the obtained ratio value of the ratio of different electrical parameters to the predetermined ratio increases as the load increases, setting the predetermined target threshold to decrease progressively when the motor 100 is in the first gear, the second gear, and the third gear can ensure that the difficulty level of determining the heavy load state is the same among all gears, and setting the predetermined target threshold to increase progressively when the motor 100 is in the first gear, the second gear, and the third gear can better align with the actual usage conditions.

With continued reference to Table 3 and Table 4, ΔT₀ to ΔT₄ represent the sampling time intervals that decrease progressively, ΔT₀ may be 10 seconds, ΔT₁ may be 1 second, ΔT₂ may be 0.1 second, and ΔT₃ may be 0.01 second. In some embodiments, the predetermined target threshold is determined based on the sampling time interval, and the predetermined target threshold decreases as the sampling time interval decreases. The sampling time interval is the time interval for obtaining two adjacent mechanical parameters or two adjacent electrical parameters. Taking the rotational speed as an example, when the rotational speed is relatively high, the sampling frequency of the rotational speed is much lower than the change frequency of the actual rotational speed, resulting in large fluctuations between the obtained data, or the change rate of the actual rotational speed may already meet the application requirements, but the actual calculation and determination fail to identify it. When the rotational speed is relatively low, the sampling frequency of the rotational speed is much higher than the filtering frequency of the rotational speed of the motor 100. The rotational speed sampled at each moment may be the same, which unnecessarily consumes the computing resources. When the rotational speed of the motor 100 fluctuates over the small time scale, the calculation results are easy to be interfered, leading to erroneous determination. Therefore, by setting the predetermined target threshold to be smaller when the sampling time interval is shorter and setting the predetermined target threshold to be larger when the sampling time interval is longer, on the one hand, the consumption of the computing resources can be reduced, on the other hand, the accuracy of identifying whether the heavy load state is entered can be improved.

It should be noted that, the data in the above-described tables is also an example and represents the predetermined target threshold. It should be understood that, the data in the above-described tables is merely for illustrative purposes. It may be other data or numerical values in other ranges.

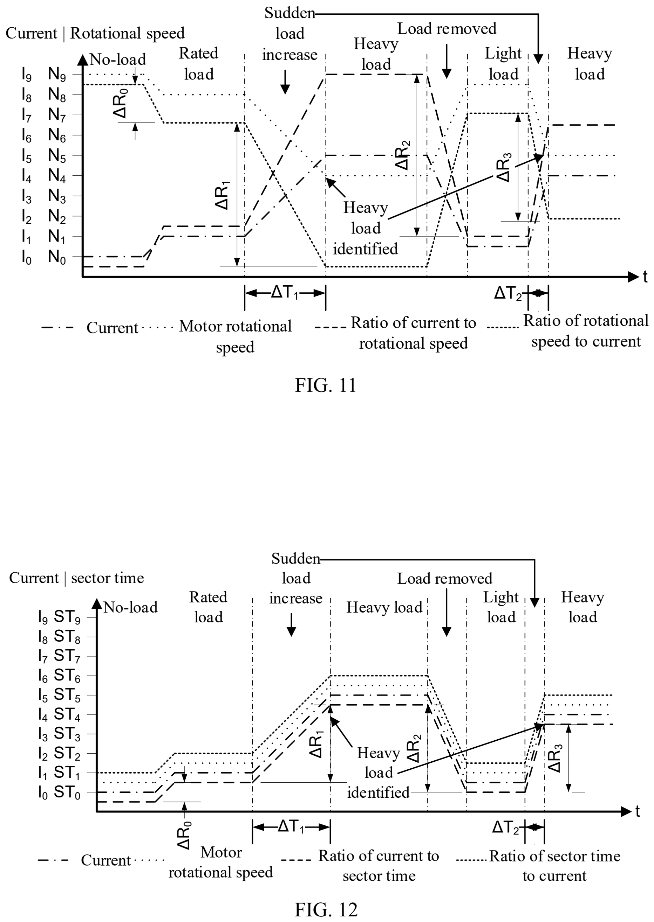

As illustrated in FIG. 7, FIG. 11, and FIG. 12, FIG. 7 is a third flowchart according to an embodiment of the present disclosure, FIG. 11 is a graph plotted using a ratio between a current and a rotational speed as a parameter, and FIG. 12 is a graph plotted using a ratio between a current and a sector time as a parameter. As can be seen from FIG. 11 and FIG. 12, the motor 100 is determined to be in the heavy load state subsequent to the ratio abruptly changing to the predetermined target threshold.

In some embodiments, the target calculation formula includes: calculating the ratio of different mechanical parameters of the motor 100, or the ratio of different electrical parameters of the motor 100, and calculating the difference of the ratio within the predetermined time period. The target value is the difference. The determination module 102 is further configured to: compare the difference with the predetermined target threshold, and determine, when the difference fails to meet the predetermined target threshold, that the motor 100 is in the heavy load state. Comparing the difference with the predetermined target threshold can also facilitate the determination by the determination module 102 regarding whether the motor 100 is in the heavy load state.

Similarly, the difference of the ratio of the rotational speed to the sector time and the difference of the ratio of the sector time to the rotational speed, are taken as an example for illustration (the ideas and methods for the difference of the ratio of other different mechanical parameters or the ratio of different electrical parameters are the same as those for the difference of the ratio of the rotational speed to the sector time and the difference of the ratio of the sector time to the rotational speed).

The difference of the ratio ΔRₖ is obtained by subtracting the ratio Rₖ₋₁ (the ratio of the rotational speed to the sector time and the ratio of the sector time to the rotational speed) obtained at the previous moment from the ratio R_{K} obtained at the current moment. When ΔRₖ is greater than or equal to the predetermined target threshold ΔR, it is determined that the load has entered the heavy load operating region.

Furthermore, the time constraint condition may also be added. When the current difference of the ratio ΔRₖ is greater than or equal to the predetermined target threshold ΔR_{T} within the predetermined duration ΔT (e.g., 0.01 second to 10 seconds), it is determined that the load has entered the heavy load operating region.

Furthermore, the above added time constraint may be segmented into X predetermined durations ΔTₓ. For example, x=4, ΔT₀=10 seconds, ΔT₁=1 second, ΔT₂=0.1 second, ΔT₃=0.01 second. ΔR_{kg} is obtained by subtracting the ratio R_{g} obtained at the previous moment ΔT₀ (10 seconds) from the ratio R_{K} obtained at the current moment, ΔRₖₕ is obtained by subtracting the ratio Rₕ obtained at the previous moment ΔT₁ (1 second) from the ratio Rₖ, ΔRₖᵢ is obtained by subtracting the ratio Rᵢ obtained at the previous moment ΔT₂ (0. 1 second) from the ratio Rₖ, and ΔRₖⱼ is obtained by subtracting the ratio Rⱼ obtained at the previous moment ΔT₃ (0. 01 second) from the ratio Rₖ. When ΔR_{kg} is or greater than or equal to the predetermined ratio threshold ΔR_{T0}, and/or ΔRₖₕ is or greater than or equal to the predetermined ratio threshold ΔR_{T1}, and/or ΔRₖᵢ is or greater than or equal to the predetermined ratio threshold ΔR_{T2}, and/or ΔRₖⱼ is or greater than or equal to the predetermined ratio threshold ΔR_{T3}, it is determined that the load has entered the heavy load operating region. In addition, ΔR_{T0} to ΔR_{T3} may satisfy ΔR_{T0} ≥ΔR_{T1} >ΔR_{T2} ≥ΔR_{T3}, or ΔR_{T0}≤ΔR_{T1} ≤ΔR_{T2} ≤ΔR_{T3}.

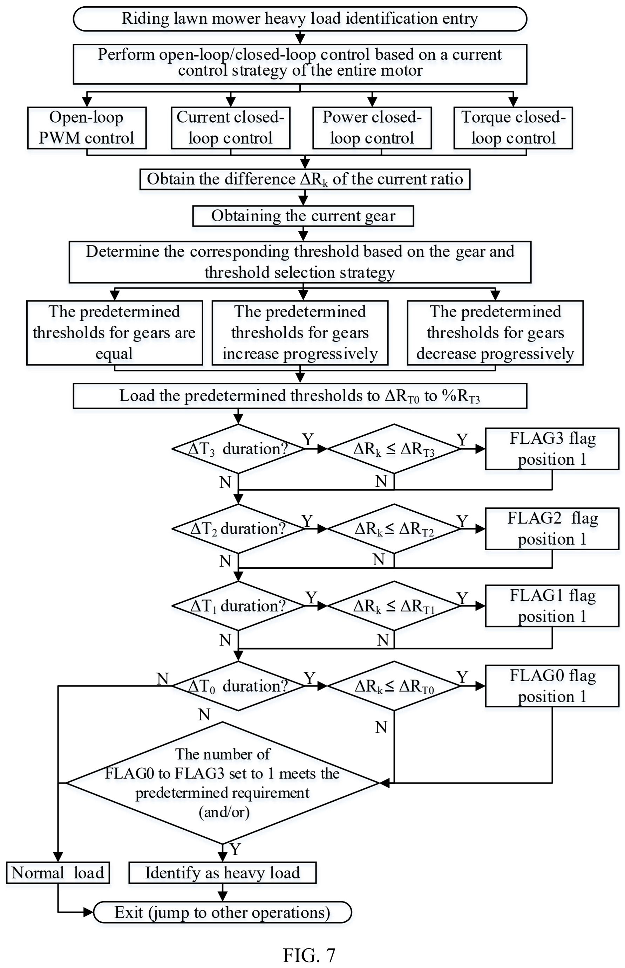

As illustrated in FIG. 7, in some embodiments, the motor 100 includes the first gear, the second gear, and the third gear with progressively increasing output capacities. The predetermined target threshold is the same when the motor 100 is in the first gear, the second gear, and the third gear. Alternatively, the predetermined target threshold decreases progressively when the motor 100 is in the first gear, the second gear, and the third gear. Alternatively, the predetermined target threshold increases progressively when the motor 100 is in the first gear, the second gear, and the third gear.

The predetermined target threshold is the same when the motor 100 is in the first gear, the second gear, and the third gear. For example, the predetermined target threshold when the motor 100 is in the first gear ranges from 0.1 to 0.3, and the predetermined target threshold when the motor 100 is in the second gear ranges from 0.1 to 0.3, and the predetermined target threshold when the motor 100 is in the third gear ranges from 0.1 to 0.3. However, the differences obtained when the motor 100 is in the first gear, the second gear, and the third gear may be different, but all obtained differences are compared with the same predetermined target threshold.

The predetermined target threshold decreases progressively when the motor 100 is in the first gear, the second gear, and the third gear. That is, the predetermined target threshold is highest in the first gear and lowest in the third gear, but the output capacity is weakest in the first gear and strongest in the third gear.

For example, with reference to Table 5 below, when the motor 100 is in the first gear, the predetermined target threshold ranges from 0.1 to 0.3; when the motor 100 is in the second gear, the predetermined target threshold ranges from 0.3 to 0.5; and when the motor 100 is in the third gear, the predetermined target threshold ranges from 0.5 to 0.7. When determining whether the motor 100 is in the heavy load state, it is first determined that which gear the motor 100 is currently in. Taking the difference being 0.4 as an example, when the motor 100 is in the first gear, it is determined that the motor 100 is in the heavy load state; when the motor 100 is in the second gear, it is determined that the motor 100 is in the normal state; and when the motor 100 is in the third gear, it is determined that the motor 100 is in the heavy load state.

**Table 5**

| | ΔT₀ | ΔT₁ | ΔT₂ | ΔT₃ |
|---|---|---|---|---|
| First gear | 0.25 | 0.2 | 0.15 | 0.1 |
| Second gear | 0.45 | 0.4 | 0.35 | 0.3 |
| Third gear | 0.65 | 0.6 | 0.55 | 0.5 |

The predetermined target threshold increases progressively when the motor 100 is in the first gear, the second gear, and the third gear. That is, the predetermined target threshold is lowest in the first gear and highest in the third gear, while the output capacity is weakest in the first gear and strongest in the third gear.

For example, with reference to Table 6 below, when the motor 100 is in the first gear, the predetermined target threshold ranges from 0.5 to 0.7; when the motor 100 is in the second gear, the predetermined target threshold ranges from 0.3 to 0.5; and when the motor 100 is in the third gear, the predetermined target threshold ranges from 0.1 to 0.3. When determining the heavy load state, it is first determined that which gear the motor 100 is currently in. Taking the difference being 0.4 as an example, when the motor 100 is in the first gear, it is determined that the motor 100 is in the heavy load state; when the motor 100 is in the second gear, it is determined that the motor 100 is in the normal state; and when the motor 100 is in the third gear, it is determined that motor 100 is in the heavy load state.

**Table 6**

| | ΔT₀ | ΔT₁ | ΔT₂ | ΔT₃ |
|---|---|---|---|---|
| First gear | 0.65 | 0.6 | 0.55 | 0.5 |
| Second gear | 0.45 | 0.4 | 0.35 | 0.3 |
| Third gear | 0.25 | 0.2 | 0.15 | 0.1 |

It should be understood that, setting the predetermined target threshold to be the same when the motor 100 is in the first gear, the second gear, and the third gear can reduce the complexity of overall parameter setting and facilitate the determination of the determination module 102. Setting the predetermined target threshold to decrease progressively when the motor 100 is in the first gear, the second gear, and the third can better aligns with the actual usage conditions. For example, when the motor 100 is in the third gear, its output capacity is strongest, that is, the user is less willing to have the motor 100 stop operating. Therefore, the predetermined target threshold can be set to be the lowest when the motor 100 is in the third gear, making it more difficult to enter the heavy load state and preventing the motor 100 from entering the second output state. Setting the predetermined target threshold to increase progressively when the motor 100 is in the first gear, the second gear, and the third gear can ensure that the difficulty level of determining the heavy load state is the same among all gears. The difficulty level herein refers to a criterion for determining that the motor 100 enters the heavy load state. In other words, the amplitude and degree of change are the same across the first gear, the second gear, and the third gear.

It should be noted that, the above-described descriptions address the situation where the obtained ratio of different mechanical parameters or the obtained ratio of different electrical parameters decreases as the load increases. When the obtained ratio of different mechanical parameters or the obtained ratio of different electrical parameters increase accordingly as the load increases, setting the predetermined target threshold to decrease progressively when the motor 100 is in the first gear, the second gear, and the third gear can ensure that the difficulty level of determining the heavy load state is the same among all gears, and setting the predetermined target threshold to increase progressively when the motor 100 is in the first gear, the second gear, and the third gear can better align with the actual usage conditions.

With continued reference to Table 5 and Table 6, ΔT₀ to ΔT₄ represent the sampling time intervals that decrease progressively, ΔT₀ may be 10 seconds, ΔT₁ may be 1 second, ΔT₂ may be 0.1 second, and ΔT₃ may be 0.01 second. In some embodiments, the predetermined target threshold is determined based on the sampling time, and the predetermined target threshold decreases as the sampling time interval decreases. The sampling time interval is the time interval for obtaining two adjacent mechanical parameters or two adjacent electrical parameters. Taking the rotational speed as an example, when the rotational speed is relatively high, the sampling frequency of the rotational speed is much lower than the change frequency of the actual rotational speed, resulting in large fluctuations between the obtained data, or the change rate of the actual rotational speed may already meet application requirements, but the actual calculation and determination fail to identify it. When the rotational speed is relatively low, the sampling frequency of the rotational speed is much higher than the filtering frequency of the rotational speed of the motor 100. The rotational speed sampled at each moment may be the same, which unnecessarily consumes computing resources, or when the rotational speed of the motor 100 fluctuates over the small time scale, the calculation results are easy to be interfered, leading to the erroneous determination. Therefore, by setting the predetermined target threshold to be smaller when the sampling time interval is shorter and setting the predetermined target threshold to be larger when the sampling time interval is longer, on the one hand, the consumption of the computing resources can be reduced, on the other hand, the accuracy of identifying whether the heavy load state is entered can be improved.

It should be noted that, the data in the above-described tables is an example and represents the predetermined target threshold. It should be understood that, the data in the above-described tables is merely for illustrative purposes. It may be other data or numerical values in other ranges.

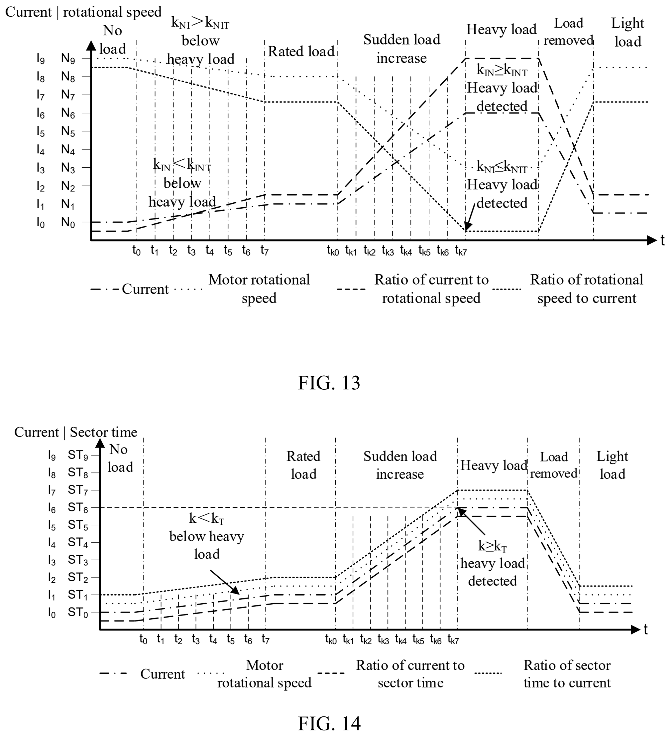

As illustrated in FIG. 8, FIG. 13, and FIG. 14, FIG. 8 is a fourth flowchart according to an embodiment of the present disclosure, FIG. 13 is a slope curve plotted using a current/rotational speed as a parameter, and FIG. 14 is a slope curve plotted using a current/sector time as a parameter. As can be seen from FIG. 13 and FIG. 14, the motor 100 is determined to be in the heavy load state subsequent to the slope of the curve of the ratio abruptly changing to the predetermined target threshold.

In some embodiments, the target calculation formula includes: calculating the ratio of different mechanical parameters of the motor 100, or the ratio of different electrical parameters of the motor 100, and calculating the slope of the curve of the ratio. The target value is the slope. The determination module 102 is further configured to compare the slope with the predetermined target threshold, and determine, when the slope fails to meet the predetermined target threshold, that the motor 100 is in the heavy load state.

The slopes of the curves of the ratio of the rotational speed to the sector time and the ratio of the sector time to the rotational speed are taken as an example (the ideas and methods for the slope of the curve of the ratio of other different mechanical parameters or the ratio of different electrical parameters are the same as those for the slope of the curve of the ratio between the rotational speed and the sector time). The slope of the corresponding curve is obtained by obtaining the ratios R₀, R₁, R₂...Rₖ at the moments t₀, t₁, t₂...tₖ and performing linear fitting on R₀, R₁, R₂...Rₖ by using Formula (15): k = (Eti - Et*Ei) / [Et² - (Et)²], and obtaining the slop k of the obtained curve, where Etr represents the mathematical expectation of a product of the sampling moment t and the ratio, Et represents the mathematical expectation of the sampling moment t, Er represents the mathematical expectation of the ratio, Et² represents the mathematical expectation of the square of the sampling moment t, and (Et)² represents the square of the mathematical expectation of the sampling moment t. Assuming that Δt₀ = t₁ - t₀, Δt₁ = t₂ - t₁..., Δtₖ = tₖ₊₁ - tₖ, for the convenience of software calculation, it is generally designed as follows: Δt₀ = Δt₁ = ... = Δtₖ. Therefore, the above-described formula can be simplified as follows: k = [n*Σ(t*r) - Σt*Σr] / [N*Σt² - Σt*Σt], where n is a positive integer. To further simplify the calculation process and reduce software computational overhead, n in the above-described simplified formula can be set to 2^{m}, and m is a positive integer. When m=1, the above-described formula degenerates into the difference of the above-described ratios. When the slope k is greater than or equal to (for the ratio of the sector time to the rotational speed) the predetermined slope threshold k_{T}, or less than or equal to (for the ratio of the rotational speed to the sector time) the predetermined slope threshold k_{T}, it is determined that the load has entered the heavy load operation region.

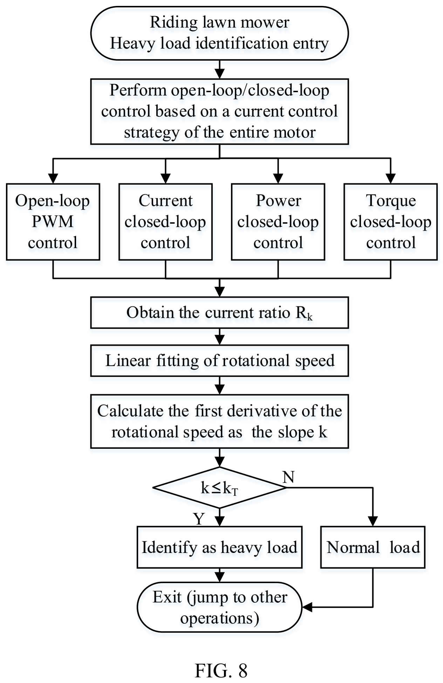

As illustrated in FIG. 8, in some embodiments, the motor 100 includes the first gear, the second gear, and the third gear with progressively increasing output capacities. The predetermined target threshold is the same when the motor is in the first gear, the second gear, and the third gear. Alternatively, the predetermined target threshold decreases progressively when the motor is in the first gear, the second gear, and the third gear. Alternatively, the predetermined target threshold increases progressively when the motor is in the first gear, the second gear, and the third gear.

The predetermined target threshold is the same when the motor 100 is in the first gear, the second gear, and the third gear. For example, the predetermined target threshold when the motor 100 is in the first gear ranges from 1 to 3, the predetermined target threshold when the motor 100 is in the second gear ranges from 1 to 3, and the predetermined target threshold when the motor 100 is in the third gear ranges from 1 to 3. However, the differences obtained when the motor 100 is in the first gear, the second gear, and the third gear may be different, but all obtained differences are compared with the same predetermined target threshold.

The predetermined target threshold decreases progressively when the motor 100 is in the first gear, the second gear, and the third gear. That is, the predetermined target threshold is highest in the first gear and lowest in the third gear, while the output capacity is weakest in the first gear and strongest in the third gear.

For example, with reference to Table 7 below, when the motor 100 is in the first gear, the predetermined target threshold ranges from 1 to 3; when the motor 100 is in the second gear, the predetermined target threshold ranges from 3 to 5; and when the motor 100 is in the third gear, the predetermined target threshold ranges from 5 to 7. When determining whether the motor 100 is in the heavy load state, it is first determined that which gear the motor 100 is currently in. Taking the difference being 4 as an example, when the motor 100 is in the first gear, it is determined that the motor 100 is in the heavy load state; when the motor 100 is in the second gear, it is determined that the motor 100 is in the normal state; and when the motor 100 is in the third gear, it is determined that the motor 100 is in the heavy load state.

**Table 7**

| | ΔT₀ | ΔT₁ | ΔT₂ | ΔT₃ |
|---|---|---|---|---|
| First gear | 2.5 | 2 | 1.5 | 1 |
| Second gear | 4.5 | 4 | 3.5 | 3 |
| Third gear | 6.5 | 6 | 5.5 | 5 |

The predetermined target threshold increases progressively when the motor 100 is in the first gear, the second gear, and the third gear. That is, the predetermined target threshold is lowest in the first gear and highest in the third gear, while the output capacity is weakest in the first gear and strongest in the third gear.

For example, with reference to Table 8 below, when the motor 100 is in the first gear, the predetermined target threshold ranges from 5 to 7; when the motor 100 is in the second gear, the predetermined target threshold ranges from 3 to 5; and when the motor 100 is in the third gear, the predetermined target threshold ranges from 1 to 3. When determining the heavy load state, it is first determined that which gear the motor 100 is currently in. Taking the difference being 4 as an example, when the motor 100 is in the first gear, it is determined that the motor 100 is in the heavy load state; when the motor 100 is in the second gear, it is determined that the motor 100 is in the normal state; and when the motor 100 is in the third gear, it is determined that motor 100 is in the heavy load state.

**Table 8**

| | ΔT₀ | ΔT₁ | ΔT₂ | ΔT₃ |
|---|---|---|---|---|
| First gear | 6.5 | 6 | 5.5 | 5 |
| Second gear | 4.5 | 4 | 3.5 | 3 |
| Third gear | 2.5 | 2 | 1.5 | 1 |

It should be understood that, setting the predetermined target threshold to be the same when the motor 100 is in the first gear, the second gear, and the third gear can reduce the complexity of overall parameter setting and facilitate the determination of the determination module 102. Setting the predetermined target threshold to decrease progressively when the motor 100 is in the first gear, the second gear, and the third can better aligns with the actual usage conditions. For example, when the motor 100 is in the third gear, its output capacity is strongest, that is, the user is less willing to have the motor 100 stop operating. Therefore, the predetermined target threshold can be set to be the lowest when the motor 100 is in the third gear, making it more difficult to enter the heavy load state and preventing the motor 100 from entering the second output state. Setting the predetermined target threshold to increase progressively when the motor 100 is in the first gear, the second gear, and the third gear can ensure that the difficulty level of determining the heavy load state is the same among all gears. The difficulty level herein refers to the criterion for determining that the motor 100 enters the heavy load state. In other words, the amplitude and degree of change are the same across the first gear, the second gear, and the third gear.

It should be noted that, the above-described descriptions address the situation where the obtained ratios of different mechanical parameters and different electrical parameters decrease as the load increases. When the obtained ratios of different mechanical parameters and different electrical parameters increase accordingly as the load increases, setting the predetermined target threshold to decrease progressively when the motor 100 is in the first gear, the second gear, and the third gear can ensure that the difficulty level of determining the heavy load state is the same among all gears, and setting the predetermined target threshold to increase progressively when the motor 100 is in the first gear, the second gear, and the third gear can better align with the actual usage conditions.

With continued reference to Table 7 and Table 8, ΔT₀ to ΔT₄ represent the sampling time intervals that decrease progressively, ΔT₀ may be 10 seconds, ΔT₁ may be 1 second, ΔT₂ may be 0.1 second, and ΔT₃ may be 0.01 second. In some embodiments, the predetermined target threshold can be determined based on the sampling time, and the predetermined target threshold decreases as the sampling time interval decreases. The sampling time interval is the time interval for obtaining two adjacent mechanical parameters or two adjacent electrical parameters. Taking the rotational speed as an example, when the rotational speed is relatively high, the sampling frequency of the rotational speed is much lower than the change frequency of the actual rotational speed, resulting in large fluctuations between the obtained data, or the change rate of the actual rotational speed may already meet the application requirements, but the actual calculation and determination fail to identify it. When the rotational speed is relatively low, the sampling frequency of the rotational speed is much higher than the filtering frequency of the rotational speed of the motor 100. The rotational speed sampled at each moment may be the same, which unnecessarily consumes the computing resources, or when the rotational speed of the motor 100 fluctuates over the small time scale, the calculation results are easy to be interfered, leading to the erroneous determination. Therefore, by setting the predetermined target threshold to be smaller when the sampling time interval is shorter and setting the predetermined target threshold to be larger when the sampling time interval is longer, on the one hand, the consumption of the computing resources can be reduced, on the other hand, the accuracy of identifying whether the heavy load state is entered can be improved.

It should be noted that, the data in the above-described tables is an example and represents the predetermined target threshold. It should be understood that, the data in the above-described tables is merely for illustrative purposes. It may be other data or numerical values in other ranges.

In some embodiments, the determination module 102 may be configured to, prior to obtaining the slope of the ratio of different mechanical parameters or the slope of the ratio of different electrical parameters: perform filtering on the obtained ratio of different mechanical parameters or the obtained ratio of different electrical parameters.

In some embodiments, the filtering methods mainly include: fixed-window filtering, sliding window filtering, arithmetic mean filtering, extreme value removal average filtering, median filtering, etc. Different algorithms can be combined, such as fixed-window arithmetic mean filtering and sliding window median filtering, in such a manner that the above-described ratios R₀, R₁, R₂...Rₖ are the values obtained subsequent to filtering. When adopting fixed-window filtering series of methods, the values of Δt₀, Δt₁, Δt₂, ..., Δtₖ are the sampling time intervals of X ratios. For example, when a ratio is obtained every 1 ms, and X is preset to 8, the filtered value is calculated every 8 ms, and Δt₀=Δt₁=Δt₂=Δtₖ=8 ms. When adopting sliding window filtering series of methods under the same predetermined conditions, Δt₀=Δt₁=Δt₂=Δtₖ=1 ms. Subsequent to each fixed-window filtering or sliding window filtering being completed, the slope k is calculated using the above-described method for obtaining the slope of the ratio, that is, a first derivative of the ratio with respect to unit time.

It should be understood that, the fixed-window filtering method includes obtaining a ratio every X ms, and obtaining a total of n values. For example, a ratio is obtained every 1 ms with 8 ratios collected in total, and the obtained ratios are grouped into sets of 8 each time. The sliding window filtering method includes obtaining a ratio every X ms, and obtaining a total of n ratios. However, the next set of ratios consists of the last n-1 ratios from the previous set combined with a newly obtained ratio. For example, a ratio is obtained every 1 ms with 8 ratios collected in total, and the ratio obtained in the next 1 ms, along with the last 7 ratios from the previous set, forms a new group of ratios. The arithmetic mean filtering method includes obtaining the arithmetic mean of each set of ratios. The extreme value removal average filtering method includes removing n maximum values and n minimum values subsequent to obtaining each set of ratios. The median filtering method includes taking the median of each set of ratios subsequent to obtaining each set of ratios.

Furthermore, if a ratio range of the motor 100 is relatively large, the values of Δt₀, Δt₁, Δt₂... Δtₖ can be dynamically adjusted based on the current ratio of the motor 100. This is because, if Δt₀, Δt₁, Δt₂... Δtₖ are too small, the sampling frequency of the ratio is much higher than the filtering frequency of the ratio of the motor 100 when the ratio of the motor 100 is relatively low, such that the ratio sampled at each moment may be the same, which unnecessarily consumes computing resources, or the calculation results are easy to be interfered when the ratio of the motor 100 fluctuates at the small time scale, leading to the erroneous determination. If Δt₀, Δt₁, Δt₂... Δtₖ are too large, the sampling frequency of the ratio is much lower than the change frequency of the actual ratio when the ratio of the motor 100 is relatively high, such that the obtained data fluctuates greatly, or the change rate of the actual ratio may have met the application requirements, but fails to be identified by the actual calculation and determination. Therefore, the adjustment rule for Δt₀, Δt₁, Δt₂... Δtₖ is that the time interval is adjusted to be relatively small when the ratio is relatively high, and the time interval is adjusted to be relatively large when the ratio is relatively low. There are three methods for adjusting this time interval. The first method is to adjust the sampling time interval of the above-described ratio of 1 ms, for example, adjusting it to 0.5 ms or 2 ms. In this case, under the fixed-window filtering method, Δt₀=Δt₁=Δt₂=Δtₖ=4 ms or 16 ms; and under the sliding window filtering method, Δt₀=Δt₁=Δt₂=Δtₖ=0.5 ms or 2 ms. The second method is to adjust the window length (the number of sampling points X), for example, adjusting it to x=4 or x=16. In this case, under the fixed-window filtering method, Δt₀=Δt₁=Δt₂=Δtₖ=4 ms or 16 ms; and under the sliding window filtering method, Δt₀=Δt₁=Δt₂=Δtₖ, which is still equal to 1 ms. The third method is to adjust the sampling time interval of the ratio and the window length (the number of sampling points X) simultaneously. In addition, since the ratio drops rapidly when the load changes abruptly, Δt₀, Δt₁, Δt₂... Δtₖ are not adjusted during this process. Adjustments are only made subsequent to the ratio having stabilized for a period of time.

Furthermore, subsequent to each fixed-window filtering or sliding window filtering, the slope is obtained using the above-described method for obtaining the slope. In this way, a set of k₁, k₂, k₃...kₖ can be obtained. The corresponding slope k', which is expressed using the formula: k' = (Etk - Et*Ek) / [Et² - (Et)²], is obtained by performing linear fitting on k₁, k₂, k₃...kₖ. In the formula, Etk represents the mathematical expectation of a product of the moment t at which each slope of the ratio is obtained and the slope of the ratio, Et represents the mathematical expectation of the moment t at which each slope of the ratio is obtained, Ek represents the mathematical expectation of the slope of the ratio, Et² represents the mathematical expectation of the square of the moment t at which each slope of the ratio is obtained, and (Et)² represents the square of the mathematical expectation of the moment t at which each slope of the ratio is obtained.

Since the time intervals for obtaining k₁, k₂, k₃...kₖ are equal, Δ_{t'0}, Δ_{t'1}, Δ_{t'2}... Δ_{t'k} are also equal. Therefore, the above-described formula may be simplified as follows: k' = [n'*Σ(t*k) - Σt*Σk] / [n'*Σt² - Σt*Σt], where n' is a positive integer. To further simplify the calculation process and reduce software computational overhead, n' in the simplified formula can be set to 2^{m'}, where m' is a positive integer. When the slope k' is greater than or equal to (for the ratio of the current to the rotational speed) or less than or equal to (for the ratio of the rotational speed to the current) the predetermined slope threshold k'_{T}, it is determined that the load has entered the heavy load operating region. The slope k' herein is the second derivative of the ratio with respect to unit time.

It should be noted that, the above description is given by taking two mechanical parameters or two electrical parameters of the motor as examples. In practice, a plurality of mechanical parameters or a plurality of electrical parameters of the motor can also be collected by the collection module, and the detection module can also calculate the ratios among the plurality of mechanical parameters or the plurality of electrical parameters.

As illustrated in FIG. 1 and FIG. 2, in some embodiments, the electric vehicle may further include a control module 103 configured to adjust, in response to the motor being in the heavy load state, the mechanical parameter or electrical parameter of the motor 100, to reduce an operating efficiency of the motor 100 until the motor 100 exits the heavy load state. The mechanical parameter or electrical parameter of the motor 100 can be controlled by the control module 103, which can prevent the motor 100 from stopping and can avoid damage to components in the electric vehicle. In this way, the user comfort is improved while enhancing reliability of the electric vehicle. As an example, the control module 103 controls the rotational speed of the motor 100. When the determination module 102 determines that the motor 100 is in the heavy load state, the motor 100 is prevented from continuing to operate at its initial rotational speed by reducing the rotational speed of the motor 100, avoiding the damage to the components in the electric vehicle.

It should be noted that, the operating efficiency herein may refer to the mowing capacity of the electric vehicle. The mowing capacity refers to the weight of grass that is cut per unit time, or the area of lawn that is mowed per unit time, etc.

In some embodiments, the control module 103 may be integrated into the same chip as the detection module 101 and the determination module 102.

In some embodiments, the mechanical parameter or electrical parameter of the motor 100 adjusted by the control module 103 is different from the mechanical parameter or electrical parameter of the motor 100 collected by the collection module 104, avoiding mutual interference between the control module 103 and the collection module 104.

In the embodiments of present disclosure, the collection module 104 collects the mechanical parameter or electrical parameter of the motor, for the detection module 101 to generate the target value. The detection module 101 processes different mechanical parameters or different electrical parameters of the motor 100 based on the target calculation formula to obtain the target value for the determination module 102 to determine whether the motor 100 is in the heavy load state. In addition, the ratio of different mechanical parameters or different electrical parameters can, on the one hand, more easily provide feedback on whether the motor 100 is in the heavy load state, on the other hand, simplify the calculation of the entire ratio, freeing up the computing power of the detection module 101. Also, providing the ratio of the mechanical parameter to electrical parameter can more accurately determine whether the motor 100 is in the heavy load state.

Another embodiment of the present disclosure further provides a method for detecting a heavy load state. This method can be implemented by the electric vehicle according to all or part of the above-described embodiments. The method for detecting the heavy load state according to another embodiment of the present disclosure will be described below. It should be noted that the same or corresponding parts as those in the above-described embodiments may be referred to the corresponding descriptions in the above-described embodiments, and thus details thereof will be omitted hereafter.

In some embodiments, the method for detecting the heavy load state according to the embodiments of this specification may include: collecting at least two mechanical parameters or at least two electrical parameters of the motor. The at least two mechanical parameters include a rotational speed parameter, a sector time parameter, or a torque parameter. The at least two electrical parameters include a bus current parameter, a phase current parameter, a bus voltage parameter, a power parameter, a freewheeling time parameter, or a duty cycle parameter.

The method for detecting the heavy load state according to the embodiments of the present disclosure may further include: processing different mechanical parameters or different electrical parameters of the motor based on a target calculation formula, and generating a target value. The target calculation formula includes at least a ratio, a slope of the ratio, or a difference of the ratio.

The method for detecting the heavy load state according to the embodiments of the present disclosure may further include: determining whether the motor is in a heavy load state based on the target value and a predetermined target threshold, and determining, when the target value fails to meet the predetermined target threshold, that the motor is in the heavy load state. The predetermined target threshold has a correspondence with the target calculation formula.

In the embodiments of the present disclosure, different mechanical parameters or electrical parameters of the motor are collected to generate the target value, and the mechanical parameters or electrical parameters of the motor are processed based on the target calculation formula to obtain the target value, which can facilitate determination on whether the motor is in the heavy load state. In addition, the ratio of the mechanical parameters or electrical parameters can, on the one hand, more easily provide feedback on whether the motor 100 is in the heavy load state, on the other hand, simplify the calculation of the entire ratio. Also, providing the ratio of the mechanical parameters or electrical parameters can more accurately determine whether the motor 100 is in the heavy load state.

Based on the same objective, in an aspect, an embodiment of the present disclosure provides an electric work vehicle.

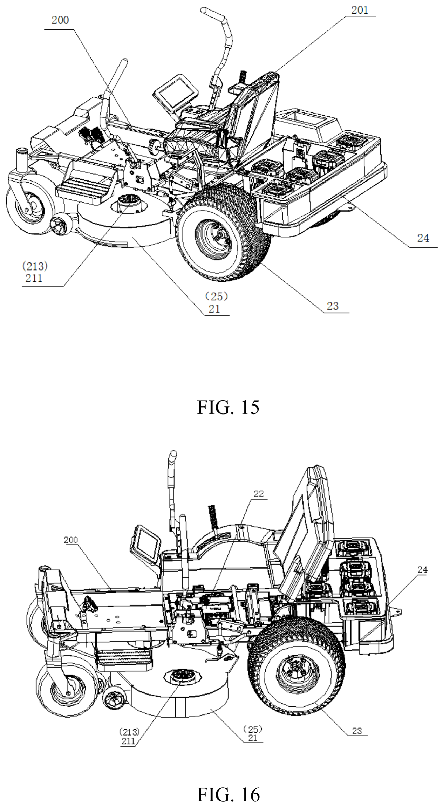

As shown in FIGS. 15 to 17, an electric work vehicle provided by one or more embodiments of the present disclosure includes: a frame 200, and a functional mechanism 21 and a drive mechanism 23 connected to the frame.

The frame 200 extends at least partially parallel to the front-rear direction. A carrying mechanism 201 may be disposed on the frame 200. The carrying mechanism 201 is configured to carry an operator of the electric work vehicle and may include at least one of a seat or a standing platform. FIG. 15 exemplarily shows only the case where the carrying mechanism 201 includes a seat. The seat or the standing platform is for the working user to sit or stand on. That is, the electric work vehicle may provide a riding work mode or a standing work mode. Furthermore, the structures of the seat and the standing platform may be flexibly switched, meaning the work mode of the electric work vehicle can be flexibly switched between the riding work mode and the standing work mode according to the actual needs of the working user. A hand-operated component may further be disposed on the frame 200. Based on the hand-operated component, the electric work vehicle can also provide a walk-behind work mode.

The functional mechanism 21 is attached to the frame 200 and includes a functional motor 211 and an output assembly driven by the functional motor 211 to perform a functional operation. It is understandable that the functional mechanism 21 may include a plurality of output assemblies, and the plurality of output assemblies are driven by at least one functional motor 211.

The drive mechanism 23 is configured to enable the electric work vehicle to travel within garden scenarios such as lawns, gardens, fences, greens, or other road surfaces. It includes a drive motor and a drive wheel driven by the drive motor. During the travel of the electric work vehicle, the functional mechanism 21 performs corresponding functional operations in an orderly manner under the control of the controller assembly 22.

As shown in FIG. 15, the electric work vehicle further includes a power system 24. The power system 24 is configured to supply power to the functional mechanism 21 and the drive mechanism 23.

The power system 24 is disposed on the frame 200 and detachably connected to the frame 200. The power system 24 includes a plurality of battery units. The plurality of battery units may be at least one of a first specification battery pack and a second specification battery pack. The specification differences between the first specification battery pack and the second specification battery pack include, but are not limited to, differences in battery pack capacity, voltage, internal resistance, weight, size, energy density, cell type, state of charge information, battery health status information, etc.

In some embodiments, the difference between the first specification battery pack and the second specification battery pack lies in the capacity. The capacity of the first specification battery pack is greater than the capacity of the second specification battery pack. The second specification battery pack is configured to power handheld garden tools. For example, the second specification battery pack may power garden tools such as grass trimmers, pruners, blowers, chain saws, etc. Additionally, the second specification battery pack may also power torque output tools such as electric drills, electric hammers, etc.; power sawing tools such as circular saws, jigsaws, reciprocating saws, etc.; or power grinding tools such as angle grinders, sanders, etc.

In some embodiments, the difference between the first specification battery pack and the second specification battery pack lies in the type of cells used. For example, the first specification battery pack and the second specification battery pack may use lithium iron phosphate cells and ternary lithium cells, respectively. In an implementation, the plurality of battery units in the power system may use nickel-cadmium battery cells, lead-acid battery cells, graphene cells, etc.

The use of at least one of the first specification battery pack and the second specification battery pack as the plurality of battery units in the power system 24 allows the electric work vehicle to be compatible with battery packs of different specifications. This meets the requirements for high-power work while also being adaptable to handheld electric garden tools, making the working methods of the operator more flexible.

In some embodiments, the functional mechanism 21 is configured to perform a mowing function. The functional mechanism 21 includes a mowing motor 213 and a mowing element driven by the mowing motor 213. The functional mechanism 21 may include one or more mowing elements, and the one or more mowing elements are driven by at least one mowing motor 213.

It is understandable that, in some embodiments, the output assembly in the functional mechanism 21 may be replaced with other functional components, such as components for snow removal, snow blowing, snow plowing, flushing, etc. Those skilled in the art should be able to adaptively replace various functional components without creative effort, all of which should fall within the protection scope of this embodiment.

In the electric work vehicle, a controller assembly 22 is provided corresponding to the functional mechanism 21. The controller assembly 22 is configured to control an operating state of the functional motor 211. As shown in FIG. 16, the controller assembly 22 may be integrated into the vehicle's integrated controller system of the electric work vehicle or may be independently arranged. The control chip used in the controller assembly 22 may be, for example, a Microcontroller Unit (MCU), an Advanced RISC Machine (ARM), etc.

The functional motor 211 has a plurality of operating parameters. When controlling the functional motor 211, the controller assembly 22 may use a plurality of control strategies respectively corresponding to the plurality of operating parameters.

The plurality of operating parameters of the functional motor 211 may include, for example, a rotational speed parameter, an electrical parameter, a power parameter, a torque parameter, and a PWM duty cycle parameter.

Corresponding to the aforementioned plurality of operating parameters, the plurality of control strategies applicable to the controller assembly 22 are respectively a rotational speed closed-loop control strategy, a current closed-loop control strategy, a power closed-loop control strategy, a torque closed-loop control strategy, and a PWM duty cycle open-loop control strategy.

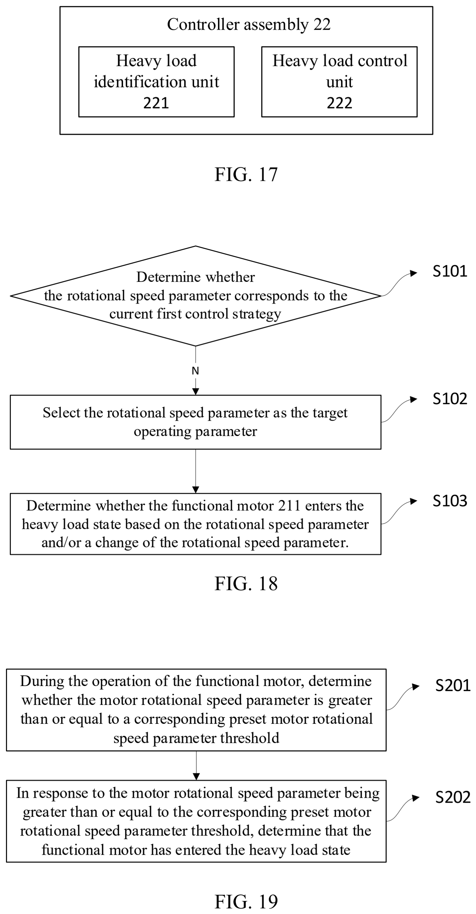

As shown in FIG. 17, in some embodiments, the controller assembly 22 includes a heavy load identification unit 221 and a heavy load control unit 222.

The heavy load identification unit 221 is configured to select a target operating parameter from the plurality of operating parameters, and determine whether the functional motor enters a heavy load state based on the target operating parameter and/or a change of the target operating parameter.

The target operating parameter does not correspond to a first control strategy currently adopted by the controller assembly 22 for the functional motor 211. For example, when the first control strategy currently adopted by the controller assembly 22 is the rotational speed closed-loop control strategy, an operating parameter other than the rotational speed parameter is selected as the target operating parameter. For example, if the first control strategy currently adopted by the controller assembly 22 is not the torque closed-loop control strategy, the torque parameter may be selected as the target operating parameter.

It is understandable that there are a plurality of operating parameters that do not correspond to the current first control strategy. The heavy load identification unit 221 may select one or more operating parameters as the target operating parameter(s) for monitoring.

When a heavy load mutation occurs during the operation of the functional motor 211, the load torque suddenly increases, and parameters such as motor speed, motor power, duty cycle, and related electrical parameters fluctuate and change correspondingly. The heavy load identification unit 221 monitors one or more operating parameters related to the functional motor 211 and can accurately and sensitively detect and identify the load mutation condition of the motor based on the one or more operating parameters and/or the change(s) in the one or more operating parameters, thereby determining whether the functional motor 211 enters the heavy load state.

In response to the heavy load identification unit 221 identifying that the functional motor 211 enters the heavy load state, the heavy load control unit 222 in the controller assembly 22 may select a second control strategy to control the functional motor 211. For example, the functional motor 211 may be controlled to exit the heavy load state by reducing the duty cycle, reducing the speed, reducing or maintaining the current, reducing or maintaining the power, reducing or maintaining the torque, etc. The second control strategy may be the same as the first control strategy or different from the first control strategy.

In the electric work vehicle, the heavy load identification unit 221 in the controller assembly 22 monitors one or more operating parameters related to the functional motor 211 and determines whether the functional motor 211 enters the heavy load state based on the one or more operating parameters and/or the change(s) in the one or more operating parameters. In response to the determination that the functional motor 211 enters the heavy load state, the heavy load control unit 222 in the controller assembly 22 selects an appropriate control strategy according to the situation and promptly adjusts the functional motor 211 to cause the functional motor 211 to exit the heavy load state. This approach enables precise and sensitive identification of heavy load mutations in the motor, further facilitates a rapid response to heavy load mutations, allows for timely adjustment of the control strategy, maintains the motor system in a normal operating state, thereby enhancing overall machine stability and work efficiency, and optimizing the user experience.

As shown in FIG. 18, in an electric work vehicle according to one or more embodiments of the present disclosure, the heavy load identification unit being configured to select a target operating parameter from the plurality of operating parameters and determine whether the functional motor enters a heavy load state based on the target operating parameter and/or a change of the target operating parameter includes the heavy load identification unit being configured to perform following steps S101 to S103.

S101: Determine whether the rotational speed parameter corresponds to the current first control strategy.

S102: In response to the rotational speed parameter not corresponding to the first control strategy, select the rotational speed parameter as the target operating parameter.

The control strategy corresponding to the rotational speed parameter is the rotational speed closed-loop control strategy. If the control strategy currently adopted by the controller assembly 22 for the functional motor 211 is a non-rotational-speed closed-loop control strategy, such as a current closed-loop control strategy, a power closed-loop control strategy, a torque closed-loop control strategy, or a PWM duty cycle open-loop control strategy, the heavy load identification unit 221 may select the rotational speed parameter as the target operating parameter.

The target operating parameter is determined based on the current first control strategy. If the first control strategy is a non-rotational-speed closed-loop control strategy, the heavy load identification unit 221 may select the rotational speed parameter as the target operating parameter.

S103: Determine whether the functional motor 211 enters the heavy load state based on the rotational speed parameter and/or a change of the rotational speed parameter. The heavy load identification unit 221 selects the rotational speed parameter as the target operating parameter and further monitors the rotational speed parameter. The change of the rotational speed parameter may include, for example, a difference obtained by comparing the rotational speed parameter at different time instants, a rate of increase or decrease of the rotational speed parameter, etc.

As shown in FIG. 19, in an electric work vehicle according to one or more embodiments of the present disclosure, the rotational speed parameter includes a motor rotational speed parameter. The method for the heavy load identification unit 221 to determine whether the functional motor 211 enters the heavy load state based on the rotational speed parameter and/or the change of the rotational speed parameter includes following steps S201 to S202.

At step S201, during the operation of the functional motor, it is determined whether the motor rotational speed parameter is greater than or equal to a corresponding preset motor rotational speed parameter threshold.

The motor rotational speed parameter includes a motor rotational speed, a motor rotational speed difference, and a motor rotational speed rate of change of the functional motor 211. The preset motor rotational speed parameter threshold corresponding to the motor rotational speed is a motor rotational speed threshold. The preset motor rotational speed parameter threshold corresponding to the motor rotational speed difference is a motor rotational speed difference threshold. The preset motor rotational speed parameter threshold corresponding to the motor rotational speed rate of change is a motor rotational speed rate-of-change threshold.

The motor rotational speed may be acquired by sampling a rotational speed of the functional motor 211.

The motor rotational speed difference refers to a difference in the motor rotational speed of the functional motor 211 at two adjacent moments. In some embodiments, the motor rotational speed difference ΔNₖ may be obtained by obtaining the difference between the motor rotational speed Nₖ acquired at the current moment and the motor rotational speed Nk-1 acquired at the previous moment. The motor rotational speed difference may be an absolute value, meaning the obtained ΔNₖ is positive, thereby facilitating subsequent calculations.

The motor rotational speed rate of change characterizes the trend of change of the motor rotational speed of the functional motor at predetermined moments. The motor rotational speed rate of change may include the first derivative and/or the second derivative of the motor rotational speed as a function of time.

In some embodiments, motor rotational speeds acquired at a plurality of moments may be fitted to obtain a motor rotational speed curve, and the slope of the motor rotational speed curve may be determined as the motor rotational speed rate of change. The slope of the motor rotational speed curve is the first derivative of the motor rotational speed. In other embodiments, the slope of the slope of the motor rotational speed curve may be determined as the motor rotational speed rate of change. The slope of the slope of the motor rotational speed curve is the second derivative of the motor rotational speed.

In some embodiments, the method for the heavy load identification unit 221 to determine whether the motor rotational speed parameter is greater than or equal to the corresponding preset motor rotational speed parameter threshold includes:

acquiring at least one motor rotational speed parameter and determining whether the at least one motor rotational speed parameter is smaller than or equal to the corresponding preset motor rotational speed parameter threshold.

The heavy load identification unit 221 may acquire one motor rotational speed parameter, such as the motor rotational speed, compare the motor rotational speed parameter with the corresponding preset motor rotational speed parameter threshold, such as the motor rotational speed threshold, and determine the magnitude relationship between the motor rotational speed parameter and the corresponding motor rotational speed parameter threshold.

The heavy load identification unit 221 may acquire two motor rotational speed parameters, such as the motor rotational speed and the motor rotational speed difference, compare the two motor rotational speed parameters with corresponding two preset motor rotational speed parameter thresholds, such as the motor rotational speed threshold and the motor rotational speed difference threshold, and determine the magnitude relationship between the two motor rotational speed parameters and their respective preset motor rotational speed parameter thresholds.

The heavy load identification unit 221 may acquire the aforementioned three motor rotational speed parameters, compare the three motor rotational speed parameters with the corresponding three preset motor rotational speed parameter thresholds, and determine the magnitude relationship between the three motor rotational speed parameters and their respective preset motor rotational speed parameter thresholds.

At step S202, in response to the motor rotational speed parameter being greater than or equal to the corresponding preset motor rotational speed parameter threshold, it is determined that the functional motor enters the heavy load state.

It should be noted that the heavy load identification unit 221 monitors and analyzes the corresponding operating parameters during the operation of the functional motor 211. The term "operation process" here refers to the stable execution of corresponding functional operations, excluding phases where operating parameters change due to active user control. Active user control of the functional motor 211, at phases such as a rotational speed gear switching phase, a speed increase phase at the beginning of operation, and a speed decrease phase near the end of operation, etc., causes significant changes in the operation of the functional motor 211. Therefore, the operation process described in the embodiments of the present disclosure does not include the aforementioned phases.

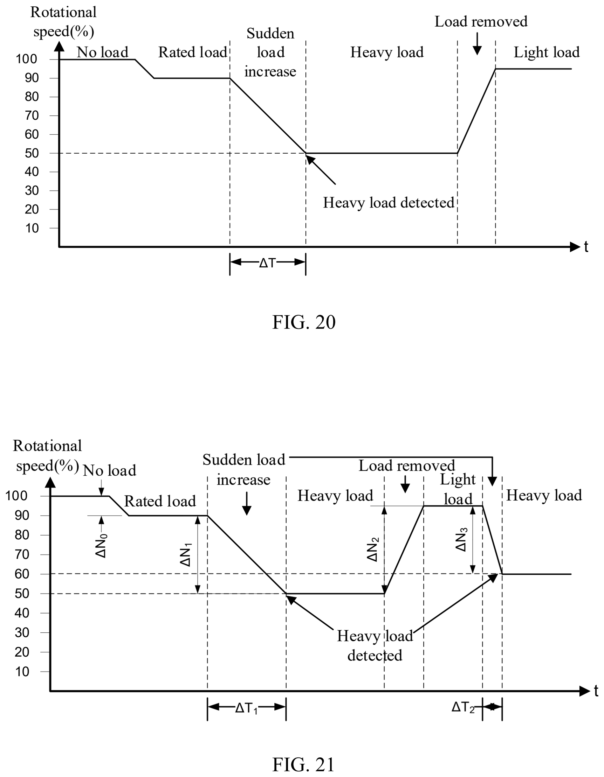

The motor rotational speed is taken as an example, as shown in FIG. 20, which is a schematic diagram of determining a heavy load mutation based on a motor rotational speed threshold during the operation of the functional motor 211.

The heavy load identification unit 221 may determine whether the current motor rotational speed Nₖ of the functional motor 211 is smaller than or equal to a corresponding motor rotational speed threshold N_{T}. In response to the determination that the current motor rotational speed Nₖ of the functional motor 211 is smaller than or equal to the corresponding motor rotational speed threshold N_{T}, it is determined that the functional motor 211 enters the heavy load state.

Furthermore, a time limit condition may be added. in response to the current rotational speed Nₖ being smaller than or equal to the preset rotational speed threshold NT within a preset time interval ΔT, which may be, for example, 0.01 to 10 seconds, it is determined that the load has entered the heavy load operating region.

Further, the aforementioned time limit may be segmented by presetting X ΔTₓ time intervals. For example, X=4, ΔT₀=10 seconds, ΔT₁=1 second, ΔT₂=0.1 seconds, ΔT₃=0.01 seconds. When the rotational speed Nₖ is smaller than or equal to N_{T0} within ΔT₀ (10 seconds), and/or the current rotational speed Nₖ is smaller than or equal to N_{T1} within ΔT₁ (1 second), and/or the current rotational speed Nₖ is smaller than or equal to N_{T2} within ΔT₂ (0.1 seconds), and/or the current rotational speed Nₖ is smaller than or equal to N_{T3} within ΔT₃ (0.01 seconds), it is determined that the load has entered the heavy load operating region. N_{T0}~N_{T3} satisfy the relational expression (1) :N_{T0} ≥ N_{T1} ≥ N_{T2} ≥ N_{T3}, or N_{T0} ≤ N_{T1} ≤ N_{T2} ≤ N_{T3}.

It is understandable that the functional motor 211 is set with different rotational speed gears. For example, under no-load conditions, the low-gear rotational speed is 2800 RPM, the medium-gear rotational speed is 3000 RPM, and the high-gear rotational speed is 3200 RPM. The motor rotational speed threshold may be set for different rotational speed gears and may be set as an absolute value or a proportional value.

For the case where the threshold is set as an absolute value, examples are as follows.
(1) The rotational speed thresholds for all gears are the same within the same time interval condition.

The low-gear rotational speed threshold is 1500 RPM, the medium-gear rotational speed threshold is 1500 RPM, and the high-gear rotational speed threshold is 1500 RPM. After adding the time limit condition, the rotational speed thresholds for the same gear under different time intervals are shown in Table 9 below.

**Table 9**

| Rotational Speed Thresholds | ΔT₀ | ΔT₁ | ΔT₂ | ΔT₃ |
|---|---|---|---|---|
| Low-Gear NT | 1900 | 1500 | 1200 | 1000 |
| Medium-Gear NT | 1900 | 1500 | 1200 | 1000 |
| High-Gear NT | 1900 | 1500 | 1200 | 1000 |

(2) The rotational speed thresholds for different gears are different under the same time interval condition:
The rotational speed threshold is positively correlated with gears. The low-gear rotational speed threshold is 1300 RPM, the medium-gear rotational speed threshold is 1400 RPM, and the high-gear rotational speed threshold is 1500 RPM. After adding the time limit condition, the rotational speed thresholds for the same gear in different time intervals are shown in Table 10 below.

**Table 10**

| Rotational Speed Thresholds | ΔT₀ | ΔT₁ | ΔT₂ | ΔT₃ |
|---|---|---|---|---|
| Low-Gear NT | 1600 | 1300 | 1100 | 1000 |
| Medium-Gear NT | 1700 | 1400 | 1200 | 1100 |
| High-Gear NT | 1800 | 1500 | 1300 | 1200 |

In another embodiment, the rotational speed threshold is negatively correlated with gears. The low-gear rotational speed threshold is 1550 RPM, the medium-gear rotational speed threshold is 1450 RPM, and the high-gear rotational speed threshold is 1350 RPM. After adding the time limit condition, the rotational speed thresholds for the same gear in different time intervals are shown in Table 11 below.

**Table 11**

| Rotational Speed Thresholds | ΔT₀ | ΔT₁ | ΔT₂ | ΔT₃ |
|---|---|---|---|---|
| Low-Gear NT | 1750 | 1550 | 1350 | 1150 |
| Medium-Gear NT | 1650 | 1450 | 1250 | 1050 |
| High-Gear NT | 1550 | 1350 | 1150 | 950 |

Examples for the case where the threshold is set as a proportional value are as follows.
(1) The proportional value is the same for all gears under the same time interval condition. The proportional value is fixed at 50%. The low-gear rotational speed threshold is 1400 RPM, the medium-gear rotational speed threshold is 1500 RPM, and the high-gear rotational speed threshold is 1600 RPM. After adding the time limit condition, the rotational speed thresholds for the same gear in different time intervals are shown in Table 12 below.

**Table 12**

| Rotational Speed Thresholds | ΔT₀ | ΔT₁ | ΔT₂ | ΔT₃ |
|---|---|---|---|---|
| Low-Gear NT | 1540 | 1400 | 1260 | 1120 |
| Medium-Gear NT | 1650 | 1500 | 1350 | 1200 |
| High-Gear NT | 1760 | 1600 | 1440 | 1280 |

(2) The proportional values for different gears are different under the same time interval condition:
The proportional value is positively correlated with the gear. The low-gear proportional value is 45%, with a low-gear rotational speed threshold of 1260 RPM; the medium-gear proportional value is 50%, with a medium-gear rotational speed threshold of 1500 RPM; the high-gear proportional value is 55%, with a high-gear rotational speed threshold of 1760 RPM. After adding the time limit condition, the rotational speed thresholds for the same gear in different time intervals are shown in Table 13 below.

**Table 13**

| Rotational Speed Thresholds | ΔT₀ | ΔT₁ | ΔT₂ | ΔT₃ |
|---|---|---|---|---|
| Low-Gear NT | 1400 | 1260 | 1120 | 980 |
| Medium-Gear NT | 1650 | 1500 | 1350 | 1200 |
| High-Gear NT | 1920 | 1760 | 1600 | 1440 |

The proportional value is negatively correlated with the gear. The low-gear proportional value is 55%, with a low-gear rotational speed threshold of 1540 RPM; the medium-gear proportional value is 50%, with a medium-gear rotational speed threshold of 1500 RPM; the high-gear proportional value is 45%, with a high-gear rotational speed threshold of 1440 RPM. After adding the time limit condition, the rotational speed thresholds for the same gear in different time intervals are shown in Table 14 below.

**Table 14**

| Rotational Speed Thresholds | ΔT₀ | ΔT₁ | ΔT₂ | ΔT₃ |
|---|---|---|---|---|
| Low-Gear NT | 1680 | 1540 | 1400 | 1260 |
| Medium-Gear NT | 1650 | 1500 | 1350 | 1200 |
| High-Gear NT | 1600 | 1440 | 1280 | 1120 |

The motor rotational speed difference is taken as an example, as shown in FIG. 21, which is a schematic diagram of determining a heavy load mutation based on a motor rotational speed difference threshold during the operation of the functional motor 211.

The motor rotational speed difference is obtained by calculating the difference between the rotational speed Nₖ acquired at the current moment and the rotational speed Nₖ₋₁ acquired at the previous moment, and is denoted by ΔNₖ. The rotational speed difference may be an absolute value, meaning the obtained ΔNₖ is positive, thereby facilitating subsequent calculations.

The heavy load identification unit 221 may calculate the difference between the motor rotational speed Nₖ acquired at the current moment and the motor rotational speed Nₖ₋₁ acquired at the previous moment to obtain the motor rotational speed difference ΔNₖ. In response to ΔNₖ being smaller than or equal to a preset motor rotational speed difference threshold ΔN_{T}, it is determined that the functional motor 211 enters the heavy load state.

Furthermore, a time limit condition can be added. In response to the current rotational speed difference ΔNₖ being smaller than or equal to the rotational speed difference threshold ΔN_{T} within a preset time interval ΔT, which may be for example 0.01 to 10 seconds, it is determined that the load has entered the heavy load operating region.

Further, the aforementioned time limit may be segmented by presetting X ΔTₓ time intervals. For example, X=4, ΔT₀=10 seconds, ΔT₁=1 second, ΔT₂=0.1 seconds, ΔT₃=0.01 seconds. The difference between the rotational speed Nₖ acquired at the current moment and the rotational speed N_{g} acquired at a moment ΔT₀ (10 seconds) earlier is calculated to obtain ΔN_{kg}; the difference between Nₖ and the rotational speed Nₕ obtained at a moment ΔT₁ (1 second) earlier is calculated to obtain ΔNₖₕ; the difference between Nₖ and the rotational speed Nᵢ obtained at a moment ΔT₂ (0.1 seconds) earlier is calculated to obtain ΔNₖᵢ; the difference between Nₖ and the rotational speed Nⱼ obtained at a moment ΔT3 (0.01 seconds) earlier is calculated to obtain ΔNₖⱼ. If ΔN_{kg} is smaller than or equal to the preset rotational speed difference threshold ΔN_{T0}, and/or ΔNₖₕ is smaller than or equal to the preset rotational speed difference threshold ΔN_{T1}, and/or ΔNₖᵢ is smaller than or equal to the preset rotational speed difference threshold ΔN_{T2}, and/or ΔNₖⱼ is smaller than or equal to the preset rotational speed difference threshold ΔN_{T3}, then it is determined that the load has entered the heavy load operating region. ΔN_{T0}~ΔN_{T3} satisfy relational expression (2): ΔN_{T0} ≥ ΔN_{T1} ≥ ΔN_{T2} ≥ ΔN_{T3}.

The motor rotational speed threshold may be set for different rotational speed gears and may be set as an absolute value or a proportional value.

Examples for the case where the threshold is set as an absolute value are as follows.
(1) The thresholds for the rotational speed difference are the same for respective gears under the same time interval condition. For example, the preset fixed difference is 1500 RPM. After adding the time limit condition, the rotational speed difference thresholds for the same gear in different time intervals are shown in Table 15 below.

**Table 15**

| Rotational Speed Difference Thresholds | ΔT₀ | ΔT₁ | ΔT₂ | ΔT₃ |
|---|---|---|---|---|
| Low-Gear ΔNT | 1900 | 1500 | 1200 | 1000 |
| Medium-Gear ΔNT | 1900 | 1500 | 1200 | 1000 |
| High-Gear ΔNT | 1900 | 1500 | 1200 | 1000 |

(2) The thresholds for the rotational speed difference are not the same for respective gears under the same time interval condition:
The rotational speed difference threshold is positively correlated to the gear. The low-gear rotational speed difference is 1400 RPM, the medium-gear rotational speed difference is 1500 RPM, and the high-gear rotational speed difference is 1600 RPM. After adding the time limit condition, the rotational speed difference thresholds for the same gear in different time intervals are shown in Table 16 below.

**Table 16**

| Rotational Speed Difference Thresholds | ΔT₀ | ΔT₁ | ΔT₂ | ΔT₃ |
|---|---|---|---|---|
| Low-Gear ΔNT | 1600 | 1300 | 1100 | 1000 |
| Medium-Gear ΔNT | 1700 | 1400 | 1200 | 1100 |
| High-Gear ΔNT | 1800 | 1500 | 1300 | 1200 |

The rotational speed difference threshold is negatively correlated to the gear. The low-gear rotational speed difference is 1550 RPM, the medium-gear rotational speed difference is 1500 RPM, and the high-gear rotational speed difference is 1450 RPM. After adding the time limit condition, the rotational speed difference thresholds for the same gear in different time intervals are shown in Table 17 below.

**Table 17**

| Rotational Speed Difference Thresholds | ΔT₀ | ΔT₁ | ΔT₂ | ΔT₃ |
|---|---|---|---|---|
| Low-Gear ΔNT | 1850 | 1550 | 1350 | 1250 |
| Medium-Gear ΔNT | 1800 | 1500 | 1300 | 1200 |
| High-Gear ΔNT | 1750 | 1450 | 1250 | 1150 |

Examples for the case where the threshold is set as a proportional value are as follows
(1) The same proportional value is set for respective gears under the same time interval condition: The ratio is fixed at 50%. After adding the time limit condition, the rotational speed difference thresholds for the same gear in different time intervals are shown in Table 18 below.

**Table 18**

| Rotational Speed Difference Thresholds | ΔT₀ | ΔT₁ | ΔT₂ | ΔT₃ |
|---|---|---|---|---|
| Low-Gear ΔNT | 1680 | 1400 | 1260 | 1120 |
| Medium-Gear ΔNT | 1800 | 1500 | 1350 | 1200 |
| High-Gear ΔNT | 1920 | 1600 | 1440 | 1280 |

(2) The proportional values for different gears are different under the same time interval condition:
The proportional value is positively correlated with the gear - The low-gear proportional value is 45%, with a low-gear rotational speed difference of 1260 RPM; the medium-gear proportional value is 50%, with a medium-gear rotational speed difference of 1500 RPM; the high-gear proportional value is 55%, with a high-gear rotational speed difference of 1760 RPM. After adding the time limit condition, the rotational speed difference thresholds for the same gear in different time intervals are shown in Table 19 below.

**Table 19**

| Rotational Speed Difference Thresholds | ΔT₀ | ΔT₁ | ΔT₂ | ΔT₃ |
|---|---|---|---|---|
| Low-Gear ΔNT | 1400 | 1260 | 1120 | 980 |
| Medium-Gear ΔNT | 1650 | 1500 | 1350 | 1200 |
| High-Gear ΔNT | 1920 | 1760 | 1600 | 1440 |

The proportional value is negatively correlated with the gear - The low-gear proportional value is 55%, with a low-gear rotational speed difference of 1540 RPM; the medium-gear proportional value is 50%, with a medium-gear rotational speed difference of 1500 RPM; the high-gear ratio is 45%, with a high-gear rotational speed difference of 1440 RPM. After adding the time limit condition, the rotational speed difference thresholds for the same gear in different time intervals are shown in Table 20 below.

**Table 20**

| Rotational Speed Difference Thresholds | ΔT₀ | ΔT₁ | ΔT₂ | ΔT₃ |
|---|---|---|---|---|
| Low-Gear ΔNT | 1680 | 1540 | 1400 | 1260 |
| Medium-Gear ΔNT | 1650 | 1500 | 1350 | 1200 |
| High-Gear ΔNT | 1600 | 1440 | 1280 | 1120 |

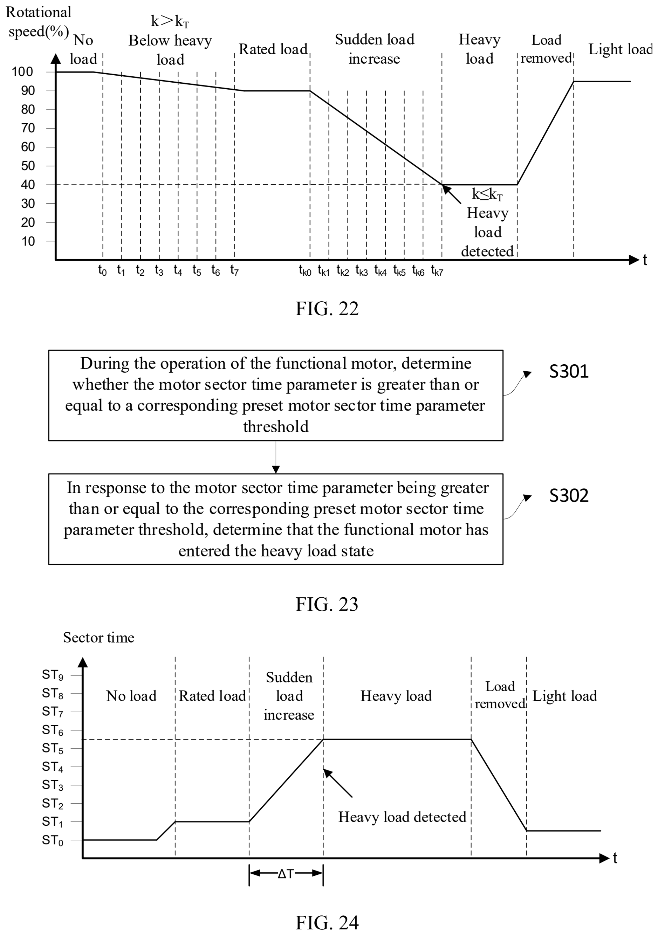

The motor rotational speed rate of change is taken as an example, as shown in FIG. 22, which is a schematic diagram of determining a heavy load mutation based on a motor rotational speed rate-of-change threshold during the operation of the functional motor 211.

The heavy load identification unit 221 may determine whether the current motor rotational speed rate of change of the functional motor 211 is smaller than or equal to a corresponding preset motor rotational speed rate-of-change threshold. In response to the current motor rotational speed rate of change of the functional motor 211 being smaller than or equal to a corresponding preset motor rotational speed rate-of-change threshold, it is determined that the functional motor 211 enters the heavy load state.

For example, the heavy load identification unit 221 may acquire motor rotational speeds N₀, N₁, N₂...Nₖ at time instants t₀, t₁, t₂...tₖ, perform linear fitting on N₀, N₁, N₂...Nₖ, and obtain the corresponding curve slope k. The calculation equation is: k = (Etn - Et*En) / [Et² - (Et)²].

Etn represents the mathematical expectation of the product of a sampling time instant t and a rotational speed, Et represents the mathematical expectation of the sampling time instant t, En represents the mathematical expectation of the rotational speed, Et² represents the mathematical expectation of the square of the sampling time t, and (Et)² represents the square of the mathematical expectation of the sampling time instant t.

Assuming Δt₀ = t₁-t₀, Δt₁ = t₂-t₁..., Δtₖ = tₖ₊₁-tₖ, for the convenience of software calculation, it is generally designed that Δt₀ = Δt₁ = ... = Δtₖ. Therefore, the above equation may be simplified to: k = [n*Σ(t*n) - Σt*Σn] / [n*Σt² - Σt*Σt], where n is a positive integer. To further simplify the calculation process and reduce software computational overhead, n in the simplified formula can be set to 2^{m}, where m is a positive integer.

When the slope k is smaller than or equal to the preset slope threshold k_{T}, it is determined that the load has entered the heavy load operating region.

Furthermore, to achieve better determination results, a rotational speed filtering method may be added based on the above. The main filtering methods added include: fixed window filtering, sliding window filtering, arithmetic mean filtering, extreme value removal mean filtering, median filtering, etc. Different algorithms can be combined to obtain, for example, fixed window arithmetic mean filtering, sliding window median filtering, etc. Thus, the aforementioned rotational speeds N₀, N₁, N₂...Nₖ are values obtained after filtering. In this way, when using fixed window filtering series methods, the values of Δt₀, Δt₁, Δt₂...Δtₖ are X rotational speed sampling intervals. For example, if the rotational speed is acquired every 1ms and X=8 is preset, a filtered value is calculated every 8ms, and Δt₀=Δt₁=Δt₂=Δtₖ=8ms; when using sliding window filtering series methods under the same preset conditions, Δt₀=Δt₁=Δt₂=Δtₖ=1ms. After each fixed window filtering or sliding window filtering is completed, formula (3) is used to calculate the slope k, which is the first derivative value of the motor rotational speed with respect to unit time.

Furthermore, if the rotational speed range of the motor operation is relatively large, the values of Δt₀, Δt₁, Δt₂...Δtₖ may be dynamically adjusted according to the current motor rotational speed. This is because if Δt₀, Δt₁, Δt₂...Δtₖ is too small, when the motor rotational speed is relatively low, the rotational speed sampling frequency is much higher than the motor rotational speed filtering frequency, and the rotational speeds sampled at different moments might be the same, unnecessarily consuming computing resources, or when the motor rotational speed fluctuates on a small time scale, it can easily interfere with the calculation results, causing misjudgment. If Δt₀, Δt₁, Δt₂...Δtₖ is too large, when the motor rotational speed is relatively high, the rotational speed sampling frequency is much lower than the actual rotational speed change frequency, resulting in large fluctuations between the obtained data, or it might be that the actual rotational speed change rate already meets the application requirements, but the actual calculation and judgment fail to identify it. Therefore, the adjustment rule for Δt₀, Δt₁, Δt₂...Δtₖ is: when the rotational speed is relatively high, the time interval is relatively small; when the rotational speed is relatively low, the time interval is relatively large. There are three methods for adjusting this time interval. The first is to adjust the aforementioned 1ms rotational speed sampling interval, for example, adjust it to 0.5ms or 2ms. In this case, under fixed window filtering series methods, Δt₀=Δt₁=Δt₂=Δtₖ=4ms or 16ms; under sliding window filtering series methods, Δt₀=Δt₁=Δt₂=Δtₖ=0.5ms or 2ms. The second method is to adjust the window length (number of sample points X), for example, adjust it to X=4 or X=16. In this case, under fixed window filtering series methods, Δt₀=Δt₁=Δt₂=Δtₖ=4ms or 16ms; under sliding window filtering series methods, Δt₀=Δt₁=Δt₂=Δtₖ still equals 1ms. The third method is to simultaneously adjust the rotational speed sampling interval and the window length (number of sample points X). Additionally, since the speed drop caused by a sudden load change is also relatively fast, during this process, Δt₀, Δt₁, Δt₂...Δtₖ will not be adjusted; adjustment only occurs after the rotational speed has stabilized for a period of time.

Furthermore, after each fixed window filtering or sliding window filtering, the slope is calculated again, to obtain a set of k₀, k₁, k₂...kₖ. Linear fitting is performed again on k₀, k₁, k₂...kₖ to obtain the corresponding slope k'. The calculation equation is: k' = (Etk - Et*Ek) / [Et² - (Et)²].

Herein, Etk represents the mathematical expectation of the product of the time instant t of each acquired rotational speed slope and the rotational speed slope, Et represents the mathematical expectation of the time instant t of each acquired rotational speed slope, Ek represents the mathematical expectation of the rotational speed slope, Et² represents the mathematical expectation of the square of the time instant t of each acquired rotational speed slope, and (Et)² represents the square of the mathematical expectation of the sampling time instant t.

Since the time intervals for acquisitions of k₀, k₁, k₂...kₖ are equal, Δt'₀, Δt'₁, Δt'₂...Δt'ₖ are also equal. Therefore, the above equation may be simplified to: k' = [n'*Σ(t*k) - Σt*Σk] / [n'*Σt² - Σt*Σt], where n' is a positive integer. To further simplify the calculation process and reduce software computational overhead, n' in the simplified equation may be set to 2^{m'}, where m' is a positive integer. When the slope k' is smaller than or equal to the preset slope threshold k'_{T}, it is determined that the load has entered the heavy load operating region. Here, the slope k' is the second derivative of the motor rotational speed with respect to unit time.

For the case where the first derivative of the motor rotational speed is determined as the motor rotational speed rate of change, the heavy load identification unit 221 compares the motor rotational speed rate of change with the corresponding preset rotational speed first derivative threshold. If the motor rotational speed rate of change is smaller than or equal to the preset rotational speed first derivative threshold, it may be determined that the functional motor 211 enters the heavy load state.

For the case where the second derivative of the motor rotational speed is determined as the motor rotational speed rate of change, the heavy load identification unit 221 compares the motor rotational speed rate of change with the corresponding preset rotational speed second derivative threshold. If the motor rotational speed rate of change is smaller than or equal to the preset rotational speed second derivative threshold, it may be determined that the functional motor 211 enters the heavy load state.

In some embodiments, the heavy load identification unit 221 may acquire a plurality of motor rotational speed parameters and compare the plurality of motor rotational speed parameters with their respective preset motor rotational speed parameter thresholds to determine whether the plurality of motor rotational speed parameters are smaller than or equal to the respective preset motor rotational speed parameter thresholds.

For example, the motor rotational speed is compared with the corresponding preset motor rotational speed threshold, and the motor rotational speed difference is compared with the corresponding preset motor rotational speed difference threshold. In response to the motor rotational speed being smaller than or equal to the preset motor rotational speed threshold, and the motor rotational speed difference being smaller than or equal to the preset motor rotational speed difference threshold, it is determined that the functional motor 211 enters the heavy load state.

For example, the motor rotational speed, the motor rotational speed difference, and the motor rotational speed rate of change are compared with the corresponding preset motor rotational speed threshold, preset motor rotational speed difference threshold, and preset motor rotational speed rate-of-change threshold, respectively. In response to the motor rotational speed, the motor rotational speed difference, and the motor rotational speed rate of change all being smaller than or equal to the corresponding preset motor rotational speed threshold, preset motor rotational speed difference threshold, and preset motor rotational speed rate-of-change threshold, respectively, it may be determined that the functional motor 211 enters the heavy load state.

As shown in FIG. 23, in an electric work vehicle according to one or more embodiments of the present disclosure, the rotational speed parameter includes a motor sector time parameter. The method for the heavy load identification unit 221 to determine whether the functional motor enters the heavy load state based on the rotational speed parameter and/or the change of the rotational speed parameter includes the following steps S301 to S302.

At step S301, during the operation of the functional motor, it is determined whether the motor sector time parameter is greater than or equal to a corresponding preset motor sector time parameter threshold.

The motor sector time parameter includes a motor sector time, a motor sector time difference, and a motor sector time rate of change of the functional motor 211. The corresponding preset motor sector time parameter thresholds include a motor sector time threshold, a motor sector time difference threshold, and a motor sector time rate-of-change threshold, respectively.

The electrical cycle of the functional motor 211 includes a plurality of sectors. The motor sector time refers to the duration of each sector. As illustrated in FIG. 4, FIG. 4 is a schematic diagram of a sector time according to an embodiment of the present disclosure. The functional motor 211 may be a three-phase brushless direct current motor or a three-phase permanent magnet synchronous motor. The electrical cycle of the motor (360°) may be divided into a plurality of sectors. Generally, the electrical cycle is evenly divided into 6 sectors, each spanning 60 electrical degrees. The motor sector time refers to the motor operating duration for each sector. As illustrated in FIG. 4, taking a square-wave driven brushless DC motor as an example, when the functional motor 211 runs steadily, the time for respective sectors (Δt₀, Δt₁, Δt₂, Δt₃, Δt₄, Δt₅) of the 360° electrical cycle is relatively close to each other. However, when the load changes drastically, the corresponding motor sector time also undergoes a sudden change.

The motor sector time difference refers to the difference between the motor sector time at two adjacent moments. In some embodiments, the heavy load identification unit 221 may calculate the difference between the sector time Sₖ acquired at the current moment and the sector time Sₖ₋₁ acquired at the previous moment to obtain ΔSₖ. The sector time difference may be an absolute value, meaning the obtained ΔSₖ is positive, thereby facilitating subsequent calculations.

The motor sector time rate of change characterizes the trend of change of the motor sector time. The motor sector time rate of change may include the first derivative and/or the second derivative of the motor sector time as a function of time.

In some embodiments, the motor sector time acquired at a plurality of moments may be fitted to obtain a motor sector time curve, and the slope of the motor sector time curve may be taken as the motor sector time rate of change. The slope of the motor sector time curve is the first derivative of the motor sector time. In other embodiments, the slope of the slope of the motor sector time curve may be taken as the motor sector time rate of change. The slope of the slope of the motor sector time curve is the second derivative of the motor sector time.

In some embodiments, the method for the heavy load identification unit 221 to determine whether the motor sector time parameter is greater than or equal to the corresponding preset motor sector time parameter threshold includes:

Acquiring at least one motor sector time parameter and determining whether the at least one motor sector time parameter is greater than or equal to the corresponding preset motor sector time parameter threshold.

The heavy load identification unit 221 may acquire one motor sector time parameter, such as the motor sector time, compare this motor sector time parameter with the corresponding preset motor sector time parameter threshold, such as the motor sector time threshold, and determine the magnitude relationship between the motor sector time parameter and the corresponding motor sector time parameter threshold.

The heavy load identification unit 221 may acquire two motor sector time parameters, such as the motor sector time and the motor sector time difference, compare these two motor sector time parameters with the corresponding two preset motor sector time parameter thresholds, such as the motor sector time threshold and the motor sector time difference threshold, and determine the magnitude relationship between the two motor sector time parameters and their respective preset motor sector time parameter thresholds.

The heavy load identification unit 221 may acquire the aforementioned three motor sector time parameters, compare the three motor sector time parameters with the corresponding three preset motor sector time parameter thresholds, and determine the magnitude relationship between the three motor sector time parameters and their respective preset motor sector time parameter thresholds.

At step S302, in response to the motor sector time parameter being greater than or equal to the corresponding preset motor sector time parameter threshold, it is determined that the functional motor enters the heavy load state.

The motor sector time is taken as an example, as shown in FIG. 24, which is a schematic diagram of determining a heavy load mutation based on a motor sector time threshold during the operation of the functional motor 211.

The heavy load identification unit 221 may determine whether the current sector time Sₖ is greater than or equal to a preset sector time threshold S_{T}. In response to the current sector time Sₖ being greater than or equal to the preset sector time threshold S_{T}, it is determined that the functional motor 211 enters the heavy load state.

Furthermore, a time limit condition may be added. In response to the current sector time Sₖ being greater than or equal to the preset sector time threshold S_{T} within a preset time interval ΔT, which may be for example, 0.01 to 10 seconds, it is determined that the load has entered the heavy load operating region.

Further, the aforementioned time limit may be segmented by presetting X ΔTₓ time intervals. For example, setting X=4, ΔT₀=10 seconds, ΔT₁=1 second, ΔT₂=0.1 seconds, ΔT₃=0.01 seconds. In response to the current sector time Sₖ being greater than or equal to S_{T0} within ΔT₀ (10 seconds), and/or the current sector time Sₖ being greater than or equal to S_{T1} within ΔT₁ (1 second), and/or the current sector time Sₖ being greater than or equal to S_{T2} within ΔT₂ (0.1 seconds), and/or the current sector time Sₖ being greater than or equal to S_{T3} within ΔT₃ (0.01 seconds), it is determined that the load has entered the heavy load operating region. ST₀~ST₃ satisfy relational expression (5): ST₀ ≤ ST₁ ≤ ST₂ ≤ ST₃, or ST₀ ≥ ST₁ ≥ ST₂ ≥ ST₃.

The motor sector time threshold may be set for different rotational speed gears and may be set as an absolute value or a proportional value.

Examples for the case where the threshold is set as an absolute value are as follows.
(1) The sector time thresholds are the same for all gears under the same time interval condition.

The low-gear sector time threshold is 6667 (µs)/p, the medium-gear sector time threshold is 6667/p, and the high-gear sector time threshold is 6667/p, where p is the number of motor pole pairs. After adding the time limit condition, the motor sector time thresholds for the same gear in different time intervals are shown in Table 21 below.

**Table 21**

| Sector Threshold (µs) | ΔT₀ | ΔT₁ | ΔT₂ | ΔT₃ |
|---|---|---|---|---|
| Low-Gear | 5263/p | 6667/p | 8333/p | 10000/p |
| Medium-Gear | 5263/p | 6667/p | 8333/p | 10000/p |
| High-Gear | 5263/p | 6667/p | 8333/p | 10000/p |

(2) The sector time thresholds are different for respective gears under the same time interval condition.

The sector time threshold is negatively correlated with the gear. The low-gear sector time threshold is 7692/p, the medium-gear sector time threshold is 7143/p, and the high-gear sector time threshold is 6667/p, where p is the number of motor pole pairs. After adding the time limit condition, the sector time thresholds for the same gear in different time intervals are shown in Table 22 below.

**Table 22**

| Sector Threshold (µs) | ΔT₀ | ΔT₁ | ΔT₂ | ΔT₃ |
|---|---|---|---|---|
| Low-Gear | 6250/p | 7692/p | 9091/p | 10000/p |
| Medium-Gear | 5882/p | 7143/p | 8333/p | 9091/p |
| High-Gear | 5556/p | 6667/p | 7692/p | 8333/p |

In another embodiment, the sector time threshold is positively correlated with the gear. The low-gear sector time threshold is 6452/p, the medium-gear sector time threshold is 6897/p, and the high-gear sector time threshold is 7407/p, where p is the number of motor pole pairs. After adding the time limit condition, the sector time thresholds for the same gear under different time intervals are shown in Table 23 below.

**Table 23**

| Sector Threshold (µs) | ΔT₀ | ΔT₁ | ΔT₂ | ΔT₃ |
|---|---|---|---|---|
| Low-Gear | 5714/p | 6452/p | 7407/p | 8696/p |
| Medium-Gear | 6061/p | 6897/p | 8000/p | 9524/p |
| High-Gear | 6452/p | 7407/p | 8696/p | 10526/p |

Examples for the case where the threshold is set as a proportional value are as follows.
(1) The proportional values are the same for all gears under the same time interval condition.

The proportional value is fixed at 50%. The low-gear sector time threshold is 7143/p, the medium-gear sector time threshold is 6667/p, and the high-gear sector time threshold is 6250/p, where p is the number of motor pole pairs. After adding the time limit condition, the sector time thresholds for the same gear in different time intervals are shown in Table 24 below.

**Table 24**

| Sector Threshold (µs) | ΔT₀ | ΔT₁ | ΔT₂ | ΔT₃ |
|---|---|---|---|---|
| Low-Gear | 6494/p | 7143/p | 7937/p | 8929/p |
| Medium-Gear | 6061/p | 6667/p | 7407/p | 8333/p |
| High-Gear | 5682/p | 6250/p | 6944/p | 7813/p |

(2) The proportional values for different gears are different under the same time interval condition:
The proportional value is positively correlated with the gear. The low-gear proportional value is 45%, with a low-gear sector time threshold of 7937/p; the medium-gear proportional value is 50%, with a medium-gear sector time threshold of 6667/p; the high-gear proportional value is 55%, with a high-gear sector time threshold of 5682/p, where p is the number of motor pole pairs. After adding the time limit condition, the sector time thresholds for the same gear in different time intervals are shown in Table 25 below.

**Table 25**

| Sector Threshold (µs) | ΔT₀ | ΔT₁ | ΔT₂ | ΔT₃ |
|---|---|---|---|---|
| Low-Gear | 7143/p | 7937/p | 8929/p | 10204/p |
| Medium-Gear | 6061/p | 6667/p | 7407/p | 8333/p |
| High-Gear | 5208/p | 5682/p | 6250/p | 6944/p |

In another embodiment, the proportional value is negatively correlated with the gear. The low-gear proportional value is 55%, with a low-gear sector time threshold of 6494/p; the medium-gear proportional value is 50%, with a medium-gear sector time threshold of 6667/p; the high-gear ratio is 45%, with a high-gear sector time threshold of 6944/p, where p is the number of motor pole pairs. After adding the time limit condition, the sector time thresholds for the same gear in different time intervals are shown in Table 26 below.

**Table 26**

| Sector Threshold (µs) | ΔT₀ | ΔT₁ | ΔT₂ | ΔT₃ |
|---|---|---|---|---|
| Low-Gear | 5952/p | 6494/p | 7143/p | 7937/p |
| Medium-Gear | 6061/p | 6667/p | 7407/p | 8333/p |
| High-Gear | 6250/p | 6944/p | 7813/p | 8929/p |

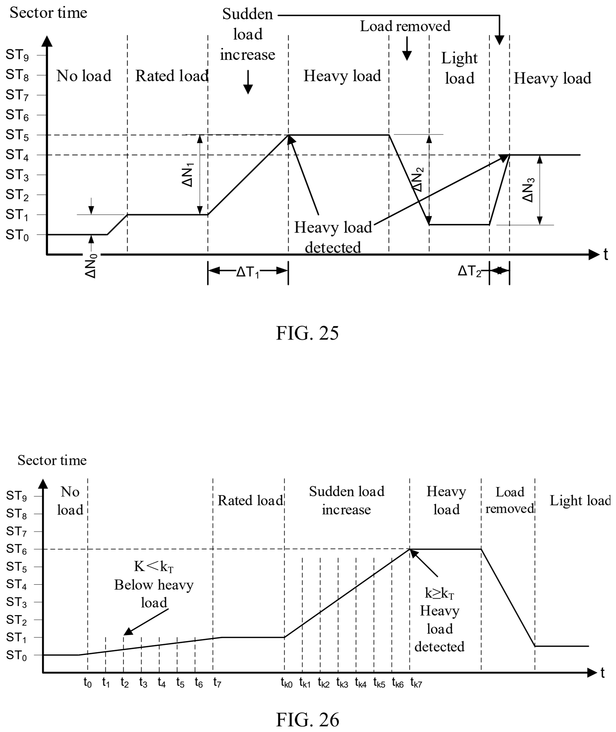

The motor sector time difference is taken as an example, as shown in FIG. 25, which is a schematic diagram of determining a heavy load mutation based on a motor sector time difference threshold during the operation of the functional motor 211.

The heavy load identification unit 221 may calculate the difference between the motor sector time Sₖ acquired at the current moment and the motor sector time Sₖ₋₁ acquired at the previous moment to obtain ΔSₖ. In response to ΔSₖ being greater than or equal to a preset sector time difference threshold ΔS_{T}, it is determined that the functional motor 211 enters the heavy load state.

Furthermore, a time limit condition may be added. In response to the current sector time difference ΔSₖ being greater than or equal to the sector time difference threshold ΔS_{T} within a preset time interval ΔT, which may be, for example, 0.01 to 10 seconds, it is determined that the load has entered the heavy load operating region.

Further, the aforementioned time limit may be segmented by presetting X ΔTₓ time intervals. For example, X=4, ΔT₀=10 seconds, ΔT₁=1 second, ΔT₂=0.1 seconds, ΔT₃=0.01 seconds. The difference between the sector time Sₖ acquired at the current moment and the sector time S_{g} acquired at a moment ΔT₀ (10 seconds) earlier is calculated to obtain ΔS_{kg}; the difference between Sₖ and the sector time Sₕ acquired at a moment, ΔT₁ (1 second) earlier is calculated to obtain ΔSₖₕ; the difference between Sₖ and the sector time Sᵢ acquired at a moment ΔT₂ (0.1 seconds) earlier is calculated to obtain ΔSₖᵢ; the difference between Sₖ and the sector time Sⱼ acquired at a moment ΔT3 (0.01 seconds) earlier is calculated to obtain ΔSₖⱼ. In response to ΔS_{kg} being greater than or equal to the preset sector time difference threshold ΔS_{T0}, and/or ΔSₖₕ being greater than or equal to the preset sector time difference threshold ΔS_{T1}, and/or ΔSₖᵢ being greater than or equal to the preset sector time difference threshold ΔS_{T2}, and/or ΔSₖⱼ being greater than or equal to the preset sector time difference threshold ΔS_{T3}, it is determined that the load has entered the heavy load operating region. ΔS_{T0}~ΔS_{T3} satisfy relational expression (6): ΔS_{T0} ≤ ΔS_{T1} ≤ ΔS_{T2} ≤ ΔS_{T3}.

The motor sector time difference threshold may be set for different rotational speed gears and may be set as an absolute value or a proportional value.

Examples for the case where the threshold is set as an absolute value are as follows.
(1) The sector time difference thresholds are the same for respective gears under the same time interval condition.

For example, the preset fixed difference is 6667/p, where p is the number of motor pole pairs. After adding the time limit condition, the motor sector time difference thresholds for the same gear in different time intervals are shown in Table 27 below.

**Table 27**

| Sector Difference (µs) | ΔT₀ | ΔT₁ | ΔT₂ | ΔT₃ |
|---|---|---|---|---|
| Low-Gear ΔST | 5263/p | 6667/p | 8333/p | 10000/p |
| Medium-Gear ΔST | 5263/p | 6667/p | 8333/p | 10000/p |
| High-Gear ΔST | 5263/p | 6667/p | 8333/p | 10000/p |

(2) The sector time difference thresholds are different for respective gears under the same time interval condition.

The sector time difference threshold is negatively correlated to the gear. The low-gear sector time difference threshold is 7692/p, the medium-gear sector time difference threshold is 7143/p, and the high-gear sector time difference threshold is 6667/p, where p is the number of motor pole pairs. After adding the time limit condition, the motor sector time difference thresholds for the same gear in different time intervals are shown in Table 28 below.

**Table 28**

| Sector Difference (µs) | ΔT₀ | ΔT₁ | ΔT₂ | ΔT₃ |
|---|---|---|---|---|
| Low-Gear ΔST | 6250/p | 7692/p | 9091/p | 10000/p |
| Medium-Gear ΔST | 5882/p | 7143/p | 8333/p | 9091/p |
| High-Gear ΔST | 5556/p | 6667/p | 7692/p | 8333/p |

In another embodiment, the sector time difference threshold is positively correlated with the gear. The low-gear sector time difference threshold is 6452/p, the medium-gear sector time difference threshold is 6667/p, and the high-gear sector time difference threshold is 6897/p, where p is the number of motor pole pairs. After adding the time limit condition, the motor sector time difference thresholds for the same gear in different time intervals are shown in Table 29 below.

**Table 29**

| Sector Difference (µs) | ΔT₀ | ΔT₁ | ΔT₂ | ΔT₃ |
|---|---|---|---|---|
| Low-Gear ΔST | 5405/p | 6452/p | 7407/p | 8000/p |
| Medium-Gear ΔST | 5556/p | 6667/p | 7692/p | 8333/p |
| High-Gear ΔST | 5714/p | 6897/p | 8000/p | 8696/p |

Examples for the case where the threshold is set as a proportional value are as follows.
(1) The proportional value is the same for respective gears under the same time interval condition.

The proportional value is fixed at 50%. After adding the time limit condition, the motor sector time difference thresholds for the same gear in different time intervals are shown in Table 30 below.

**Table 30**

| Sector Difference (µs) | ΔT₀ | ΔT₁ | ΔT₂ | ΔT₃ |
|---|---|---|---|---|
| Low-Gear ΔST | 5952/p | 7143/p | 7937/p | 8929/p |
| Medium-Gear ΔST | 5556/p | 6667/p | 7407/p | 8333/p |
| High-Gear ΔST | 5208/p | 6250/p | 6944/p | 7813/p |

(2) The proportional values for different gears are different under the same time interval condition.

The proportional value is positively correlated with the gear. The low-gear proportional value is 45%, with a low-gear sector time difference threshold of 7143/p; the medium-gear proportional value is 50%, with a medium-gear sector time difference threshold of 6667/p; the high-gear proportional value is 55%, with a high-gear sector time difference threshold of 5682/p, where p is the number of motor pole pairs. After adding the time limit condition, the motor sector time difference thresholds for the same gear under different time intervals are shown in Table 31 below.

**Table 31**

| Sector Difference (µs) | ΔT₀ | ΔT₁ | ΔT₂ | ΔT₃ |
|---|---|---|---|---|
| Low-Gear ΔST | 7143/p | 7937/p | 8929/p | 10204/p |
| Medium-Gear ΔST | 6061/p | 6667/p | 7407/p | 8333/p |
| High-Gear ΔST | 5208/p | 5682/p | 6250/p | 6944/p |

In another embodiment, the proportional value is negatively correlated with the gear. The low-gear proportional value is 55%, with a low-gear sector time difference threshold of 6494/p; the medium-gear proportional value is 50%, with a medium-gear sector time difference threshold of 6667/p; the high-gear proportional value is 45%, with a high-gear sector time difference threshold of 6944/p, where p is the number of motor pole pairs. After adding the time limit condition, the motor sector time difference thresholds for the same gear in different time intervals are shown in Table 32 below.

**Table 32**

| Sector Difference (µs) | ΔT₀ | ΔT₁ | ΔT₂ | ΔT₃ |
|---|---|---|---|---|
| Low-Gear ΔST | 5952/p | 6494/p | 7143/p | 7937/p |
| Medium-Gear ΔST | 6061/p | 6667/p | 7407/p | 8333/p |
| High-Gear ΔST | 6250/p | 6944/p | 7813/p | 8929/p |

The motor sector time rate of change is taken as an example, as shown in FIG. 26, which is a schematic diagram of determining a heavy load mutation based on a motor rotational speed rate-of-change threshold during the operation of the functional motor 211.

The heavy load identification unit 221 may acquire motor sector times S₀, S₁, S₂...Sₖ at time instants t₀, t₁, t₂...tₖ, perform linear fitting on S₀, S₁, S₂...Sₖ, and obtain the corresponding curve slope k according to the following equation: k = (Ets - Et*Es) / [Et² - (Et)²].

Ets represents the mathematical expectation of the product of the sampling time instant t and the sector time, Et represents the mathematical expectation of the sampling time instant t, Es represents the mathematical expectation of the sector time, Et² represents the mathematical expectation of the square of the sampling time instant t, and (Et)² represents the square of the mathematical expectation of the sampling time instant t.

Assuming Δt₀ = t₁-t₀, Δt₁ = t₂-t₁..., Δtₖ = tₖ+1-tₖ, for the convenience of software calculation, it is generally designed that Δt₀ = Δt₁ = ... = Δtₖ. Therefore, the above equation may be simplified to: k = [n*Σ(t*s) - Σt*Σs] / [n*Σt² - Σt*Σt], where n is a positive integer. To further simplify the calculation process and reduce software computational overhead, n in the simplified equation may be set to 2^{m}, where m is a positive integer. When m=1, the above equation degenerates into the sector time difference described in section 1.7.

When the slope k is greater than or equal to the preset slope threshold k_{T}, it is determined that the load has entered the heavy load operating region.

Furthermore, to achieve better determination results, a sector time filtering method may be adopted based on the above. Thus, the aforementioned sector times S₀, S₁, S₂...Sₖ are values obtained after filtering. In this way, when using fixed window filtering series methods, values of Δt₀, Δt₁, Δt₂...Δtₖ are sampling intervals of X pieces of sector time. For example, when the sector time is acquired every 1ms and X=8 is preset, a filtered value is calculated every 8ms, and Δt₀=Δt₁=Δt₂=Δtₖ=8ms; when using sliding window filtering series methods under the same preset conditions, Δt₀=Δt₁=Δt₂=Δtₖ=1ms. After each fixed window filtering or sliding window filtering is completed, equation (7) is used to calculate the slope k, which is the first derivative value of the sector time with respect to unit time.

Furthermore, when the sector time range of the motor operation is relatively large, the values of Δt₀, Δt₁, Δt₂...Δtₖ may be dynamically adjusted according to the current motor sector time. This is because when Δt₀, Δt₁, Δt₂...Δtₖ is too small, and the motor sector time is relatively low, the sector time sampling frequency is much higher than the motor sector time filtering frequency, and the sector time sampled at each moment might be the same, unnecessarily consuming computing resources, or when the motor sector time fluctuates on a small time scale, it can easily interfere with the calculation results, causing misjudgment. When Δt₀, Δt₁, Δt₂...Δtₖ is too large, and the motor sector time is relatively high, the sector time sampling frequency is much lower than the actual sector time change frequency, resulting in large fluctuations between the obtained data, or it might be that the actual sector time rate of change already meets the application requirements, but the actual calculation and judgment fail to identify it. Therefore, the adjustment rule for Δt₀, Δt₁, Δt₂...Δtₖ is: when the sector time is relatively high, the time interval is relatively small; when the sector time is relatively low, the time interval is relatively large. There are three methods for adjusting this time interval. The first is to adjust the aforementioned 1ms sector time sampling interval, for example, adjust it to 0.5ms or 2ms. In this case, under fixed window filtering series methods, Δt₀=Δt₁=Δt₂=Δtₖ=4ms or 16ms; under sliding window filtering series methods, Δt₀=Δt₁=Δt₂=Δtₖ=0.5ms or 2ms. The second method is to adjust the window length (number of sample points X), for example, adjust it to X=4 or X=16. In this case, under fixed window filtering series methods, Δt₀=Δt₁=Δt₂=Δtₖ=4ms or 16ms; under sliding window filtering series methods, Δt₀=Δt₁=Δt₂=Δtₖ still equals 1ms. The third method is to simultaneously adjust the sector time sampling interval time and the window length (number of sample points X). Additionally, since the sector time drop caused by a sudden load change is also relatively fast, during this process, Δt₀, Δt₁, Δt₂...Δtₖ will not be adjusted, and adjustment will only occur after the sector time has stabilized for a period of time.

Furthermore, after each fixed window filtering or sliding window filtering, the slope is calculated again, thus obtaining a set k₀, k₁, k₂...kₖ. Linear fitting is performed again on k₀, k₁, k₂...kₖ to obtain the corresponding slope k' using the equation: k' = (Etk - Et*Ek) / [Et² - (Et)²].

Here, Etk represents the mathematical expectation of the product of the time instant t of each acquired sector time slope and the sector time slope, Et represents the mathematical expectation of the time instant t of each acquired sector time slope, Ek represents the mathematical expectation of the sector time slope, Et² represents the mathematical expectation of the square of the time instant t of each acquired sector time slope, and (Et)² represents the square of the mathematical expectation of the sampling time instant t.

Since the time intervals for acquisitions of k₀, k₁, k₂...kₖ are equal, Δt'₀, Δt'₁, Δt'₂...Δt'ₖ are also equal. Therefore, the above equation may be simplified to: k' = [n'*Σ(tk) - Σt*Σk] / [n'*Σt² - Σt*Σt], where n' is a positive integer. To further simplify the calculation process and reduce software computational overhead, n' in the simplified equation may be set to 2^{m'}, where m' is a positive integer. When the slope k' is greater than or equal to the preset slope threshold k'_{T}, it is determined that the load has entered the heavy load operating region. Here, the slope k' is the second derivative of the sector time with respect to unit time.

For the case where the first derivative of the motor sector time is determined as the motor sector time rate of change, the heavy load identification unit 221 compares the motor sector time rate of change with the corresponding preset motor sector time first derivative threshold. In response to the motor sector time rate of change being greater than or equal to the preset motor sector time first derivative threshold, it may be determined that the functional motor 211 enters the heavy load state.

For the case where the second derivative of the motor sector time is determined as the motor sector time rate of change, the heavy load identification unit 221 compares the motor sector time rate of change with the corresponding preset motor sector time rate of change second derivative threshold. In response to the motor sector time rate of change being greater than or equal to the preset motor sector time rate of change second derivative threshold, it may be determined that the functional motor 211 enters the heavy load state.

In some embodiments, the heavy load identification unit 221 may acquire a plurality of motor sector time parameters and compare the plurality of motor sector time parameters with their respective preset motor sector time parameter thresholds to determine whether the plurality of motor sector time parameters are smaller than or equal to the corresponding preset motor sector time parameter thresholds, respectively.

For example, the motor sector time is compared with the corresponding preset motor sector time threshold, and the motor sector time difference is compared with the corresponding preset motor sector time difference threshold. In response to the motor sector time being smaller than or equal to the preset motor sector time threshold, and the motor sector time difference being smaller than or equal to the preset motor sector time difference threshold, it is determined that the functional motor 211 enters the heavy load state.

For example, the motor sector time, the motor sector time difference, and the motor sector time rate of change are compared with the corresponding preset motor sector time threshold, preset motor sector time difference threshold, and preset motor sector time rate-of-change threshold, respectively. In response to all the three motor sector time parameters being smaller than or equal to their respective thresholds, it may be determined that the functional motor 211 enters the heavy load state.

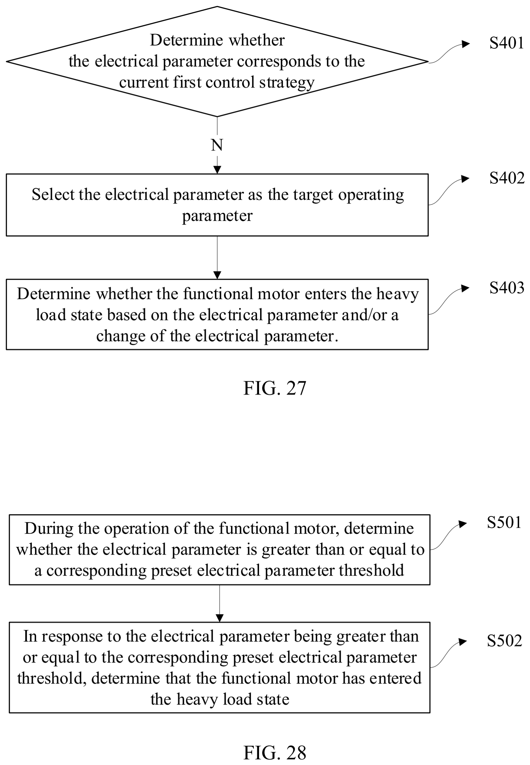

As shown in FIG. 27, in an electric work vehicle according to one or more embodiments of the present disclosure, the heavy load identification unit being configured to select a target operating parameter from the plurality of operating parameters and determine whether the functional motor enters a heavy load state based on the target operating parameter and/or a change of the target operating parameter includes the heavy load identification unit being configured to perform following steps S401 to S403.

S401: Determine whether the electrical parameter corresponds to the current first control strategy.

S402: In response to the electrical parameter not corresponding to the first control strategy, select the electrical parameter as the target operating parameter.

The control strategy corresponding to the electrical parameter is the current closed-loop control strategy. In response to the control strategy currently adopted by the controller assembly 22 for the functional motor 211 being a non-current closed-loop control strategy, such as the rotational speed closed-loop control strategy, the power closed-loop control strategy, the torque closed-loop control strategy, or the PWM duty cycle open-loop control strategy, the heavy load identification unit 221 may select the electrical parameter as the target operating parameter.

Selection of the target operating parameter is actually determined based on the current first control strategy. In response to the first control strategy being a non-current closed-loop control strategy, the heavy load identification unit 221 may select the electrical parameter as the target operating parameter.

S403: Determine whether the functional motor enters the heavy load state based on the electrical parameter and/or a change of the electrical parameter. The heavy load identification unit 221 selects the electrical parameter as the target operating parameter and further monitors the electrical parameter. The change of the electrical parameter may include, for example, a difference obtained by comparing the electrical parameter acquired at different time instants, a rate of increase or decrease of the electrical parameter, etc.

As shown in FIG. 28, in an electric work vehicle according to one or more embodiments of the present disclosure, the method for the heavy load identification unit 221 to determine whether the functional motor 211 enters the heavy load state based on the electrical parameter and/or the change of the electrical parameter includes the following steps S501 and S502.

At step S501, during the operation of the functional motor, it is determined whether the electrical parameter is greater than or equal to a corresponding preset electrical parameter threshold.

At step S502, in response to the electrical parameter being greater than or equal to the corresponding preset electrical parameter threshold, it is determined that the functional motor enters the heavy load state.

In some embodiments, the electrical parameter includes a bus current parameter. The bus current parameter includes a bus current, a bus current difference, and a bus current rate of change. The preset electrical parameter thresholds corresponding to the bus current, the bus current difference, and the bus current rate of change are a bus current threshold, a bus current difference threshold, and a bus current rate-of-change threshold, respectively.

The bus current may be determined by sampling using a current sampling resistor provided in a corresponding control circuit of the functional motor 211, or by sampling using a current sensor provided in the control circuit.

The bus current difference refers to the difference in the bus current of the functional motor at two adjacent moments. The heavy load identification unit 221 may calculate the difference between the bus current Bₖ acquired at a current moment and the bus current Bₖ₋₁ acquired at a previous moment to obtain ΔBₖ. The bus current difference may be an absolute value, meaning the obtained ΔBₖ is a positive number, thereby facilitating subsequent calculations.

The bus current rate of change characterizes the trend of change of the bus current of the functional motor 211 at corresponding moments. The bus current rate of change may include a first derivative and a second derivative of the bus current as a function of time. The rate of change may be obtained by fitting bus current values determined by sampling at a plurality of moments to obtain a bus current change curve, and taking the slope of this change curve as the bus current rate of change. The slope of this change curve is the first derivative of the bus current. In another embodiment, the slope of the slope of the bus current change curve may be taken as the bus current rate of change. The slope of the slope of the change curve is the second derivative of the bus current.

The method for the heavy load identification unit 221 to determine whether the electrical parameter is greater than or equal to the corresponding preset electrical parameter threshold includes: acquiring at least one bus current parameter and determining whether the at least one bus current parameter is greater than or equal to the corresponding preset electrical parameter threshold.

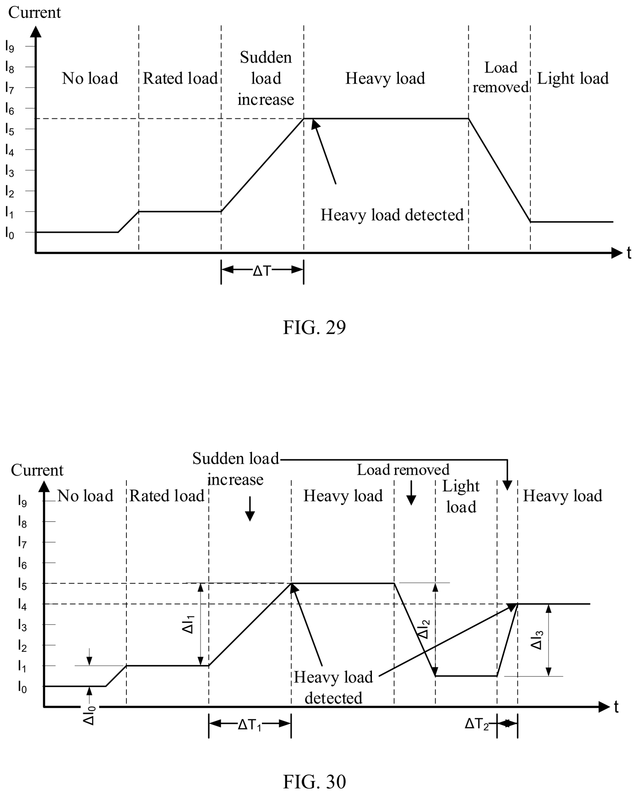

The bus current is taken as an example, as shown in FIG. 29, which is a schematic diagram of determining a heavy load mutation based on a bus current threshold during the operation of the functional motor 211.

The heavy load identification unit 221 may determine whether the current bus current Iₖ is greater than or equal to a preset bus current threshold I_{T}. In response to the current bus current Iₖ being greater than or equal to a preset bus current threshold I_{T}, it is determined that the functional motor 211 enters the heavy load state.

Furthermore, a time constraint condition may be added. In response to the current bus current Iₖ being greater than or equal to the preset bus current threshold I_{T} within a preset time interval AT, which may be, for example, 0.01 to 10 seconds, it is determined that the load has entered the heavy load operating region.

Further still, the aforementioned added time constraint may be segmented by presetting X ΔTₓ time intervals. For example, X=4, ΔT₀=10 seconds, ΔT₁=1 second, ΔT₂=0.1 seconds, ΔT₃=0.01 seconds. In response to the current bus current Iₖ being greater than or equal to I_{T0} within ΔT₀ (10 seconds), and/or the current bus current Iₖ being greater than or equal to I_{T1} within ΔT₁ (1 second), and/or the current bus current Iₖ being greater than or equal to IT₂ within ΔT₂ (0.1 seconds), and/or the current bus current Iₖ being greater than or equal to IT₃ within ΔT₃ (0.01 seconds), it is determined that the load has entered the heavy load operating region. I_{T0} to I_{T3} satisfy relational expression (9): I_{T0} ≤ I_{T1} ≤ I_{T2} ≤ I_{T3}.

The bus current threshold may be set for different rotational speed gears and may be set as an absolute value or a proportional value.

Examples for the case where the threshold is set as an absolute value are as follows.
(1) The bus current thresholds are the same for all gears under the same time interval condition.

After adding the time constraint condition, the bus current thresholds for the same gear in different time intervals are shown in Table 33 below.

**Table 33**

| Current Threshold (A) | ΔT₀ | ΔT₁ | ΔT₂ | ΔT₃ |
|---|---|---|---|---|
| Low-Gear | I_{AL0} | I_{AL1} | I_{AL2} | I_{AL3} |
| Medium-Gear | I_{AM0} | I_{AM1} | I_{AM2} | I_{AM3} |
| High-Gear | I_{AH0} | I_{AH1} | I_{AH2} | I_{AH3} |

(2) The bus current thresholds are different for respective gears under the same time interval condition:
The bus current threshold is positively correlated with the gear. After adding the time constraint condition, the bus current thresholds for the same gear in different time intervals are shown in Table 34 below.

**Table 34**

| Current Threshold (A) | ΔT₀ | ΔT₁ | ΔT₂ | ΔT₃ |
|---|---|---|---|---|
| Low-Gear | I_{BL0} | I_{BL1} | I_{BL2} | I_{BL3} |
| Medium-Gear | I_{BM0} | I_{BM1} | I_{BM2} | I_{BM3} |
| High-Gear | I_{BH0} | I_{BH1} | I_{BH2} | I_{BH3} |

In another embodiment, the bus current threshold is negatively correlated with the gear. After adding the time constraint condition, the bus current thresholds for the same gear in different time intervals are shown in Table 35 below.

**Table 34**

| Current Threshold (A) | ΔT₀ | ΔT₁ | ΔT₂ | ΔT₃ |
|---|---|---|---|---|
| Low-Gear | I_{CL0} | I_{CL1} | I_{CL2} | I_{CL3} |
| Medium-Gear | I_{CM0} | I_{CM1} | I_{CM2} | I_{CM3} |
| High-Gear | I_{CH0} | I_{CH1} | I_{CH2} | I_{CH3} |

Examples for the case where the threshold is set as a proportional value are as follows.
(1) The proportional value is the same for all gears under the same time interval condition. After adding the time constraint condition, the bus current thresholds for the same gear in different time intervals are shown in Table 35 below.

**Table 35**

| Current Threshold (A) | ΔT₀ | ΔT₁ | ΔT₂ | ΔT₃ |
|---|---|---|---|---|
| Low-Gear | I_{DL0} | I_{DL1} | I_{DL2} | I_{DL3} |
| Medium-Gear | I_{DM0} | I_{DM1} | I_{DM2} | I_{DM3} |
| High-Gear | I_{DH0} | I_{DH1} | I_{DH2} | I_{DH3} |

(2) The proportional values for different gears are different under the same time interval condition.

The proportional value is positively correlated with the gear. After adding the time constraint condition, the bus current thresholds for the same gear in different time intervals are shown in Table 36 below.

**Table 36**

| Current Threshold (A) | ΔT₀ | ΔT₁ | ΔT₂ | ΔT₃ |
|---|---|---|---|---|
| Low-Gear | I_{EL0} | I_{EL1} | I_{EL2} | I_{EL3} |
| Medium-Gear | I_{EM0} | I_{EM1} | I_{EM2} | I_{EM3} |
| High-Gear | I_{EH0} | I_{EH1} | I_{EH2} | I_{EH3} |

In another embodiment, the proportional value is negatively correlated with the gear. After adding the time constraint condition, the bus current thresholds for the same gear under different time intervals are shown in Table 37 below.

**Table 37**

| Current Threshold (A) | ΔT₀ | ΔT₁ | ΔT₂ | ΔT₃ |
|---|---|---|---|---|
| Low-Gear | I_{FL0} | I_{FL1} | I_{FL2} | I_{FL3} |
| Medium-Gear | I_{FM0} | I_{FM1} | I_{FM2} | I_{FM3} |
| High-Gear | I_{FH0} | I_{FH1} | I_{FH2} | I_{FH3} |

The bus current difference is taken as an example, as shown in FIG. 30, which is a schematic diagram of determining a heavy load mutation based on a bus current difference threshold during the operation of the functional motor 211.

The heavy load identification unit 221 may calculate the difference between the bus current Iₖ acquired at the current moment and the bus current Iₖ₋₁ acquired at the previous moment to obtain ΔIₖ. In response to ΔIₖ being greater than or equal to a preset bus current difference threshold ΔI_{T}, it is determined that the load has entered the heavy load operating region.

Furthermore, a time constraint condition may be added. In response to the current bus current difference ΔIₖ being greater than or equal to the bus current difference threshold ΔI_{T} within a preset time interval AT, which may be, for example, 0.01 to 10 seconds, it is determined that the load has entered the heavy load operating region.

Further still, the aforementioned added time constraint may be segmented by presetting X ΔTx time intervals. For example, X=4, ΔT₀=10 seconds, ΔT₁=1 second, ΔT₂=0.1 seconds, ΔT₃=0.01 seconds. The difference between the bus current Iₖ acquired at the current moment and the bus current I_{g} acquired at the previous moment, ΔT₀ (10 seconds) earlier, is calculated to obtain ΔI_{kg}; the difference between Iₖ and the bus current Iₕ acquired at the previous moment, ΔT₁ (1 second) earlier, is calculated to obtain ΔIₖₕ; the difference between Iₖ and the bus current Iᵢ acquired at the moment ΔT₂ (0.1 seconds) earlier, is calculated to obtain ΔIₖᵢ; the difference between Iₖ and the bus current Iⱼ acquired at the previous moment, ΔT₃ (0.01 seconds) earlier, is calculated to obtain ΔIₖⱼ. In response to ΔI_{kg} being greater than or equal to the preset bus current difference threshold ΔI_{T0}, and/or ΔIₖₕ being greater than or equal to the preset bus current difference threshold ΔI_{T1}, and/or ΔIₖᵢ being greater than or equal to the preset bus current difference threshold ΔI_{T2}, and/or ΔIₖj being greater than or equal to the preset bus current difference threshold ΔI_{T3}, it is determined that the load has entered the heavy load operating region. ΔI_{T0} to ΔI_{T3} satisfy relational expression (10): ΔI_{T0} ≥ ΔI_{T1} ≥ ΔI_{T2} ≥ ΔI_{T3}.

The bus current difference threshold may be set for different rotational speed gears and may be set as an absolute value or a proportional value.

Examples for the case where the threshold is set as an absolute value are as follows.
(1) The thresholds for the bus current difference are the same for respective gears under the same time interval condition.

After adding the time constraint condition, the bus current difference thresholds for the same gear in different time intervals are shown in Table 38 below.

**Table 38**

| Current Difference (A) | ΔT₀ | ΔT₁ | ΔT₂ | ΔT₃ |
|---|---|---|---|---|
| Low-Gear ΔI_{T} | ΔI_{AL0} | ΔI_{AL1} | ΔI_{AL2} | ΔI_{AL3} |
| Medium-GearΔI_{T} | ΔI_{AM0} | ΔI_{AM1} | ΔI_{AM2} | ΔI_{AM3} |
| Medium-GearΔI_{T} | ΔI_{AH0} | ΔI_{AH1} | ΔI_{AH2} | ΔI_{AH3} |

(2) The thresholds for the bus current difference are different for all gears under the same time interval condition.

The bus current difference threshold is positively correlated with the gear. After adding the time constraint condition, the bus current difference thresholds for the same gear in different time intervals are shown in Table 39 below.

**Table 39**

| Current Difference (A) | ΔT₀ | ΔT₁ | ΔT₂ | ΔT₃ |
|---|---|---|---|---|
| Low-Gear ΔI_{T} | ΔI_{BL0} | ΔI_{BL1} | ΔI_{BL2} | ΔI_{BL3} |
| Medium-Gear ΔI_{T} | ΔI_{BM0} | ΔI_{BM1} | ΔI_{BM2} | ΔI_{BM3} |
| Medium-Gear ΔI_{T} | ΔI_{BH0} | ΔI_{BH1} | ΔI_{BH2} | ΔI_{BH3} |

In another embodiment, the bus current difference threshold is negatively correlated with the gear. After adding the time constraint condition, the bus current difference thresholds for the same gear in different time intervals are shown in Table 40 below.

**Table 40**

| Current Difference (A) | ΔT₀ | ΔT₁ | ΔT₂ | ΔT₃ |
|---|---|---|---|---|
| Low-Gear ΔI_{T} | ΔI_{CL0} | ΔI_{CL1} | ΔI_{CL2} | ΔI_{CL3} |
| Medium-Gear ΔI_{T} | ΔI_{CM0} | ΔI_{CM1} | ΔI_{CM2} | ΔI_{CM3} |
| Medium-Gear ΔI_{T} | ΔI_{CH0} | ΔI_{CH1} | ΔI_{CH2} | ΔI_{CH3} |

Examples for the case where the threshold is set as a proportional value are as follows.
(1) The proportional value is the same for respective gears under the same time interval condition.

After adding the time constraint condition, the bus current difference thresholds for the same gear in different time intervals are shown in Table 41 below.

**Table 41**

| Current Difference (A) | ΔT₀ | ΔT₁ | ΔT₂ | ΔT₃ |
|---|---|---|---|---|
| Low-Gear ΔI_{T} | ΔI_{DL0} | ΔI_{DL1} | ΔI_{DL2} | ΔI_{DL3} |
| Medium-GearΔI_{T} | ΔI_{DM0} | ΔI_{DM1} | ΔI_{DM2} | ΔI_{DM3} |
| Medium-GearΔI_{T} | ΔI_{DH0} | ΔI_{DH1} | ΔI_{DH2} | ΔI_{DH3} |

(2) The proportional values for different gears are different under the same time interval condition.

The proportional value is positively correlated to the gear. After adding the time constraint condition, the bus current difference thresholds for the same gear in different time intervals are shown in Table 42 below.

**Table 42**

| Current Difference (A) | ΔT₀ | ΔT₁ | ΔT₂ | ΔT₃ |
|---|---|---|---|---|
| Low-Gear ΔI_{T} | ΔI_{EL0} | ΔI_{EL1} | ΔI_{EL2} | ΔI_{EL3} |
| Medium-Gear ΔI_{T} | ΔI_{EM0} | ΔI_{EM1} | ΔI_{EM2} | ΔI_{EM3} |
| Medium-Gear ΔI_{T} | ΔI_{EH0} | ΔI_{EH1} | ΔI_{EH2} | ΔI_{EH3} |

In another embodiment, the proportional value is negatively correlated with the gear. After adding the time constraint condition, the bus current difference thresholds for the same gear in different time intervals are shown in Table 43 below.

**Table 43**

| Current Difference (A) | ΔT₀ | ΔT₁ | ΔT₂ | ΔT₃ |
|---|---|---|---|---|
| Low-Gear ΔI_{T} | ΔI_{FL0} | ΔI_{FL1} | ΔI_{FL2} | ΔI_{FL3} |
| Medium-Gear ΔI_{T} | ΔI_{FM0} | ΔI_{FM1} | ΔI_{FM2} | ΔI_{FM3} |
| Medium-Gear ΔI_{T} | ΔI_{FH0} | ΔI_{FH1} | ΔI_{FH2} | ΔI_{FH3} |

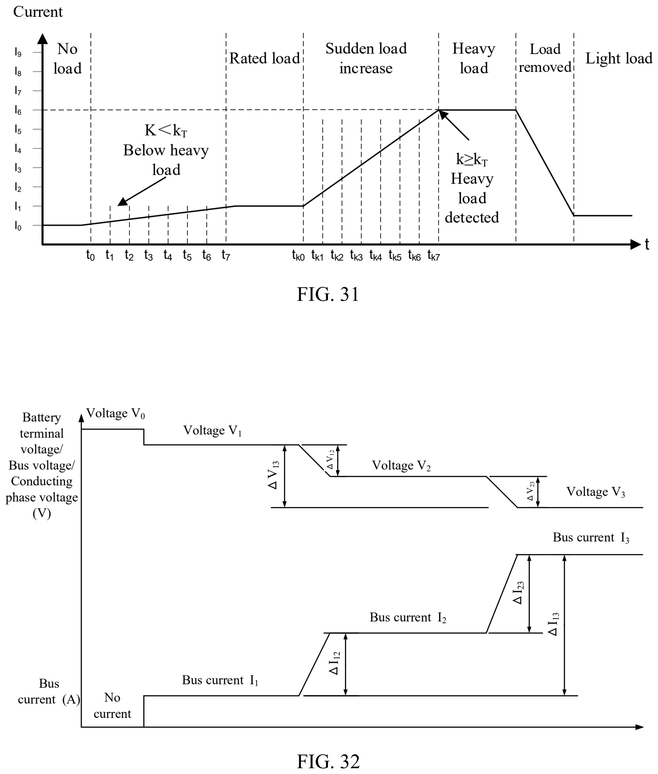

The bus current rate of change is taken as an example, as shown in FIG. 31, which is a schematic diagram for determining a heavy load mutation based on a bus current rate-of-change threshold during the operation of the functional motor 211.

The heavy load identification unit 221 acquires bus currents I₀, I₁, I₂...Iₖ at time instants to, t₁, t₂...tₖ, performs linear fitting on I₀, I₁, I₂...Iₖ, and obtains the corresponding curve slope k using the equation: k = (Eti - Et*Ei) / [Et2 - (Et)²].

Here, Eti represents the mathematical expectation of the product of the sampling time instant t and the bus current, Et represents the mathematical expectation of the sampling time instant t, Ei represents the mathematical expectation of the bus current, Et² represents the mathematical expectation of the square of the sampling time instant t, and (Et)² represents the square of the mathematical expectation of the sampling time instant t.

Assuming Δt₀ = t₁-t₀, Δt₁ = t₂-t₁..., Δtₖ = tₖ₊₁-tₖ, for the convenience of software calculation, it is generally designed that Δt₀ = Δt₁ = ... = Δtₖ. Therefore, the above equation may be simplified to: k = [n*Σ(t*i) - Σt*Σi] / [n*Σt² - Σt*Σt], where n is a positive integer. To further simplify the calculation process and reduce software computational overhead, n in the simplified equation may be set to 2^{m}, where m is a positive integer.

When the slope k is greater than or equal to the preset slope threshold k_{T}, it is determined that the load has entered the heavy load operating region.

Furthermore, to achieve better determination results, a bus current filtering method may be adopted based on the above. Thus, the aforementioned bus currents I₀, I₁, I₂...Iₖ are values obtained after filtering. In this way, when using fixed window filtering series methods, values of Δt₀, Δt₁, Δt₂...Δtₖ are sampling intervals of X pieces of bus current data. For example, when the bus current is acquired every 1ms and X=8 is preset, a filtered value is calculated every 8ms, and Δt₀=Δt₁=Δt₂=Δtₖ=8ms; when using sliding window filtering series methods under the same preset conditions, Δt₀=Δt₁=Δt₂=Δtₖ=1ms. After each fixed window filtering or sliding window filtering is completed, use the above calculation equation to calculate and determine the slope k, which is the first derivative value of the bus current with respect to unit time.

Furthermore, when the bus current range of the motor operation is relatively large, the values of Δt₀, Δt₁, Δt₂...Δtₖ may be dynamically adjusted according to the current motor bus current. This is because when Δt₀, Δt₁, Δt₂...Δtₖ is too small, and the motor bus current is relatively low, the bus current sampling frequency is much higher than the motor bus current filtering frequency, and the bus current sampled at each moment might be the same, unnecessarily consuming computing resources, or when the motor bus current fluctuates on a small time scale, it may easily interfere with the calculation results, causing misjudgment. When Δt₀, Δt₁, Δt₂...Δtₖ is too large, and the motor bus current is relatively high, the bus current sampling frequency is much lower than the actual bus current change frequency, resulting in large fluctuations between the obtained data, or it might be that the actual bus current rate of change already meets the application requirements, but the actual calculation and judgment fail to identify it. Therefore, the adjustment rule for Δt₀, Δt₁, Δt₂...Δtₖ is: when the bus current is relatively high, the time interval is relatively small; when the bus current is relatively low, the time interval is relatively large. There are three methods for adjusting this time interval: The first is to adjust the aforementioned 1ms bus current sampling interval, for example, adjust it to 0.5ms or 2ms. In this case, under fixed window filtering series methods, Δt0=Δt1=Δt2=Δtk=4ms or 16ms; under sliding window filtering series methods, Δt0=Δt1=Δt2=Δtk=0.5ms or 2ms. The second method is to adjust the window length (number of sample points X), for example, adjust it to X=4 or X=16. In this case, under fixed window filtering series methods, Δt0=Δt1=Δt2=Δtk=4ms or 16ms; under sliding window filtering series methods, Δt0=Δt1=Δt2=Δtk still equals 1ms. The third method is to simultaneously adjust the bus current sampling interval time and the window length (number of sample points X). Additionally, since the bus current drop caused by a sudden load change is also relatively fast, during this process, Δt0, Δt₁, Δt₂...Δtₖ are not adjusted, and adjustment will only occur after the bus current has stabilized for a period of time.

Furthermore, after each fixed window filtering or sliding window filtering, the aforementioned calculation equation is used to calculate the slope, thus obtaining a set k₀, k₁, k₂...kₖ. Linear fitting is performed again on k₀, k₁, k₂...kₖ to obtain the corresponding slope k' using the equation: k' = (Etk - Et*Ek) / [Et2 - (Et)²].

Here, Etk represents the mathematical expectation of the product of the time instant t of each acquired bus current slope and the bus current slope, Et represents the mathematical expectation of the time instant t of each acquired bus current slope, Ek represents the mathematical expectation of the bus current slope, Et² represents the mathematical expectation of the square of the time instant t of each acquired bus current slope, and (Et)² represents the square of the mathematical expectation of the sampling time instant t.

Since the time intervals for acquisitions of k₀, k₁, k₂...kₖ are equal, Δt'₀, Δt'₁, Δt'₂...Δt'ₖ are also equal. Therefore, the above equation may be simplified to: k' = [n'*Σ(tk) - Σt*Σk] / [n'*Σt² - Σt*Σt], where n' is a positive integer. To further simplify the calculation process and reduce software computational overhead, n' in the simplified equation may be set to 2^{m'}, where m' is a positive integer. When the slope k' is greater than or equal to the preset slope threshold k'_{T}, it is determined that the load has entered the heavy load operating region. Here, the slope k' is the second derivative of the bus current with respect to unit time.

For the case where the first derivative of the bus current is determined as the bus current rate of change, the heavy load identification unit 221 compares the bus current rate of change with the corresponding preset bus current first derivative threshold. in response to the bus current rate of change being smaller than or equal to the preset bus current first derivative threshold, it may be determined that the functional motor 211 enters the heavy load state.

For the case where the second derivative of the bus current is selected as the bus current rate of change, the heavy load identification unit 221 compares the bus current rate of change with the corresponding preset bus current second derivative threshold. In response to the bus current rate of change being smaller than or equal to the preset bus current second derivative threshold, it may be determined that the functional motor 211 enters the heavy load state.

In some embodiments, the heavy load identification unit 221 may acquire a plurality of bus current parameters and compare the plurality of bus current parameters with their respective preset bus current parameter thresholds to determine whether the plurality of bus current parameters are smaller than or equal to the corresponding preset bus current parameter thresholds, respectively.

For example, the bus current is compared with the corresponding preset bus current threshold, and the bus current difference is compared with the corresponding preset bus current difference threshold. In response to the bus current being greater than or equal to the preset bus current threshold, and the bus current difference being greater than or equal to the preset bus current difference threshold, it is determined that the functional motor 211 enters the heavy load state.

For example, the bus current, the bus current difference, and the bus current rate of change are compared with the corresponding preset bus current threshold, preset bus current difference threshold, and preset bus current rate-of-change threshold, respectively. In response to all the three bus current parameters being greater than or equal to their respective thresholds, it may be determined that the functional motor 211 enters the heavy load state.

In some embodiments, the electrical parameter includes a phase current parameter. The phase current parameter includes a phase current, a phase current difference, and a phase current rate of change. The preset electrical parameter thresholds corresponding to the phase current, the phase current difference, and the phase current rate of change are a phase current threshold, a phase current difference threshold, and a phase current rate-of-change threshold, respectively.

The phase current refers to the current of the conducting phase of the functional motor 211. A current sensor or a current sampling resistor may be used to sample and determine the phase current. Considering the AC characteristics of the phase current, the amplitude, peak-to-peak value, or root mean square (RMS) of the conducting phase current may be determined as the phase current.

The phase current may be determined by sampling using a current sampling resistor provided in the corresponding control circuit of the functional motor 211, or by sampling using a current sensor provided in the control circuit.

The phase current difference refers to the difference in the phase current of the functional motor at two adjacent moments. The heavy load identification unit 221 may calculate the difference between the phase current Cₖ acquired at the current moment and the phase current Cₖ₋₁ acquired at the previous moment to obtain ΔCₖ. The phase current difference may be an absolute value, meaning the obtained ΔCₖ is a positive number, thereby facilitating subsequent calculations.

The phase current rate of change characterizes the trend of change of the phase current of the functional motor 211 at corresponding moments. The phase current rate of change may include a first derivative and a second derivative of the phase current as a function of time. The rate of change may be obtained by fitting phase current values determined by sampling at a plurality of moments to obtain a phase current change curve, and taking the slope of this change curve as the phase current rate of change. The slope of this change curve is the first derivative of the phase current. In another embodiment, the slope of the slope of the phase current change curve may be taken as the phase current rate of change. The slope of the slope of the change curve is the second derivative of the phase current.

In some embodiments, the method for the heavy load identification unit 221 to determine whether the electrical parameter is greater than or equal to the corresponding preset electrical parameter threshold includes: acquiring at least one phase current parameter and determining whether the at least one phase current parameter is greater than or equal to the corresponding preset electrical parameter threshold.

In some embodiments, the heavy load identification unit 221 may acquire a plurality of phase current parameters and compare the plurality of phase current parameters with their respective preset phase current parameter thresholds to determine whether the multiple phase current parameters are greater than or equal to the corresponding preset phase current parameter thresholds, respectively.

For example, the phase current is compared with the corresponding preset phase current threshold, and the phase current difference is compared with the corresponding preset phase current difference threshold. In response to the phase current being greater than or equal to the preset phase current threshold, and the phase current difference being greater than or equal to the preset phase current difference threshold, it is determined that the functional motor 211 enters the heavy load state.

For example, the phase current, the phase current difference, and the phase current rate of change are compared with the corresponding preset phase current threshold, preset phase current difference threshold, and preset phase current rate-of-change threshold, respectively. In response to all the three phase current parameters being greater than or equal to their respective thresholds, it may be determined that the functional motor 211 enters the heavy load state.

In some embodiments, the electrical parameter includes a bus voltage parameter. The bus voltage parameter includes a bus voltage drop, a bus voltage drop difference, and a bus voltage drop rate of change. The preset electrical parameter thresholds corresponding to the bus voltage drop, the bus voltage drop difference, and the bus voltage drop rate of change are a bus voltage drop threshold, a bus voltage drop difference threshold, and a bus voltage drop rate-of-change threshold, respectively.

The bus voltage drop refers to the relative value of the voltage drop on the bus side of the functional motor 211, i.e., the drop value of the bus voltage during the operation of the functional motor 211 compared to the bus voltage before starting work.

The bus voltage drop difference refers to the difference in the bus voltage drop of the functional motor at two adjacent moments.

The bus voltage drop rate of change characterizes the trend of change of the bus voltage drop of the functional motor 211 at corresponding moments. The bus voltage drop rate of change may include a first derivative and a second derivative of the bus voltage drop as a function of time. The rate of change may be obtained by fitting bus voltage drop values determined by sampling at a plurality of moments to obtain a bus voltage drop change curve, and taking the slope of this change curve as the bus voltage drop rate of change. The slope of this change curve is the first derivative of the bus voltage drop. In another embodiment, the slope of the slope of the bus voltage drop change curve may be taken as the bus voltage drop rate of change. The slope of the slope of the change curve is the second derivative of the bus voltage drop.

In some embodiments, the method for the heavy load identification unit 221 to determine whether the electrical parameter is greater than or equal to the corresponding preset electrical parameter threshold includes: acquiring at least one bus voltage parameter and determining whether the at least one bus voltage parameter is greater than or equal to the corresponding preset electrical parameter threshold.

In some embodiments, the heavy load identification unit 221 may acquire a plurality of bus voltage parameters and compare the plurality of bus voltage parameters with their respective preset bus voltage parameter thresholds to determine whether the plurality of bus voltage parameters are greater than or equal to the corresponding preset bus voltage parameter thresholds, respectively.

For example, the bus voltage drop is compared with the corresponding preset bus voltage drop threshold, and the bus voltage drop difference is compared with the corresponding preset bus voltage drop difference threshold. In response to the bus voltage drop being greater than or equal to the preset bus voltage drop threshold, and the bus voltage drop difference being greater than or equal to the preset bus voltage drop difference threshold, it is determined that the functional motor 211 enters the heavy load state.

For example, the bus voltage drop, the bus voltage drop difference, and the bus voltage drop rate of change are compared with the corresponding preset bus voltage drop threshold, preset bus voltage drop difference threshold, and preset bus voltage drop rate-of-change threshold, respectively. In response to all the three bus voltage parameters being greater than or equal to their respective thresholds, it may be determined that the functional motor 211 enters the heavy load state.

The bus voltage drop is taken as an example, as shown in FIG. 32, which is a schematic diagram of determining a heavy load mutation based on a bus voltage drop threshold during the operation of the functional motor 211.

The heavy load identification unit 221 may determine the load condition based on the relative change of the voltage on the bus side. A greater load corresponds to a greater relative voltage drop, and vice versa. In battery-powered electric work vehicles, a greater load corresponds to a more obvious drop of the terminal voltage of the battery pack. The terminal voltage corresponds to the bus voltage, and the bus voltage may reflect the battery pack terminal voltage. The relationship between the bus voltage and the current is shown in FIG. 32.

In some embodiments, the electrical parameter includes a conducting phase voltage parameter. The conducting phase voltage parameter includes a conducting phase voltage drop, a conducting phase voltage drop difference, and a conducting phase voltage drop rate of change. The preset electrical parameter thresholds corresponding to the conducting phase voltage drop, the conducting phase voltage drop difference, and the conducting phase voltage drop rate of change are a conducting phase voltage drop threshold, a conducting phase voltage drop difference threshold, and a conducting phase voltage drop rate-of-change threshold, respectively.

The conducting phase voltage drop refers to the relative value of the voltage drop on the bus side of the functional motor 211, i.e., the drop value of the bus voltage during the operation of the functional motor 211 compared to the bus voltage before starting work.

The conducting phase voltage drop difference refers to the difference in the conducting phase voltage drop of the functional motor at two adjacent moments.

The conducting phase voltage drop rate of change characterizes the trend of change of the conducting phase voltage drop of the functional motor 211 at corresponding moments. The conducting phase voltage drop rate of change may include a first derivative and a second derivative of the conducting phase voltage drop as a function of time. The rate of change may be obtained by fitting conducting phase voltage drops determined by sampling at a plurality of moments to obtain a conducting phase voltage drop change curve, and determining the slope of this change curve as the conducting phase voltage drop rate of change. The slope of this change curve is the first derivative of the conducting phase voltage drop. In another embodiment, the slope of the slope of the conducting phase voltage drop change curve may be determined as the conducting phase voltage drop rate of change. The slope of the slope of the change curve is the second derivative of the conducting phase voltage drop.

In some embodiments, the method for the heavy load identification unit 221 to determine whether the electrical parameter is greater than or equal to the corresponding preset electrical parameter threshold includes: acquiring at least one conducting phase voltage parameter and determining whether the at least one conducting phase voltage parameter is greater than or equal to the corresponding preset electrical parameter threshold.

In some embodiments, the heavy load identification unit 221 may acquire a plurality of conducting phase voltage parameters and compare the plurality of conducting phase voltage parameters with their respective preset conducting phase voltage parameter thresholds to determine whether the plurality of conducting phase voltage parameters are greater than or equal to the corresponding preset conducting phase voltage parameter thresholds, respectively.

For example, the conducting phase voltage drop is compared with the corresponding preset conducting phase voltage drop threshold, and the conducting phase voltage drop difference is compared with the corresponding preset conducting phase voltage drop difference threshold. In response to the conducting phase voltage drop being greater than or equal to the preset conducting phase voltage drop threshold, and the conducting phase voltage drop difference being greater than or equal to the preset conducting phase voltage drop difference threshold, it is determined that the functional motor 211 enters the heavy load state.

For example, the conducting phase voltage drop, the conducting phase voltage drop difference, and the conducting phase voltage drop rate of change are compared with the corresponding preset conducting phase voltage drop threshold, preset conducting phase voltage drop difference threshold, and preset conducting phase voltage drop rate-of-change threshold, respectively. In response to all the three conducting phase voltage parameters being greater than or equal to their respective thresholds, it may be determined that the functional motor 211 enters the heavy load state.

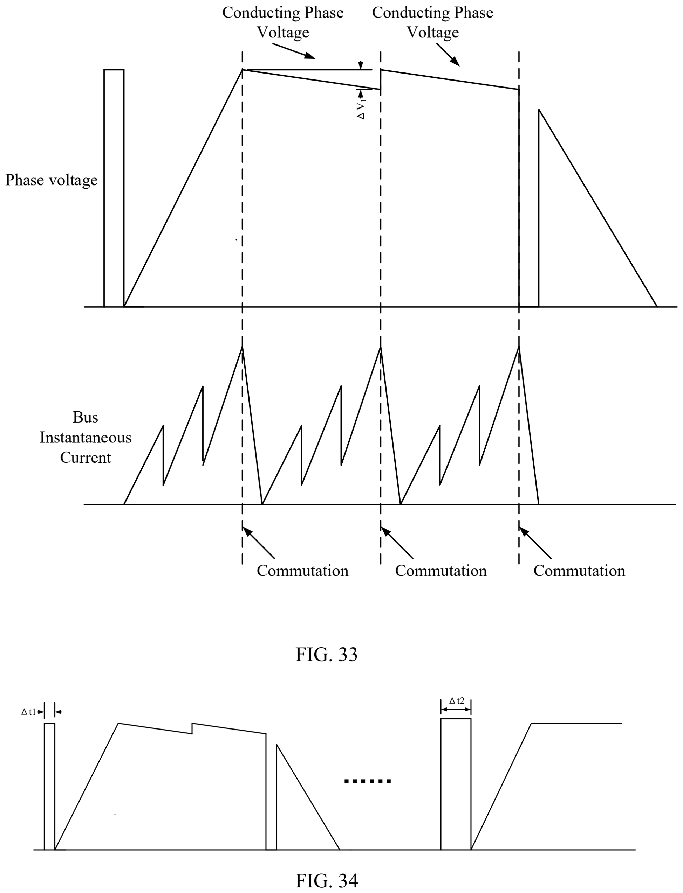

The conducting phase voltage drop is taken as an example, as shown in FIG. 33, which is a schematic diagram of determining a heavy load mutation based on a conducting phase voltage drop threshold during the operation of the functional motor 211.

The heavy load identification unit 221 may determine based on the relative value of the voltage change of the conducting phase within one commutation cycle. When the load increases, the instantaneous current (bus instantaneous current or phase instantaneous current) will increase, causing the phase voltage to change within one commutation cycle. The magnitude of the voltage change is the conducting phase voltage drop. As shown in FIG. 33, ΔV₁ represents the conducting phase voltage drop. The heavy load identification unit 221 compares the conducting phase voltage drop with the corresponding preset conducting phase voltage drop threshold. In response to the conducting phase voltage drop being greater than or equal to the conducting phase voltage drop difference, it may be determined that the functional motor 211 enters the heavy load state.

In some embodiments, the electrical parameter includes a freewheeling time parameter. The freewheeling time parameter includes freewheeling time, a freewheeling time difference, and a freewheeling time rate of change. The preset electrical parameter thresholds corresponding to the freewheeling time, the freewheeling time difference, and the freewheeling time rate of change are a freewheeling time threshold, a freewheeling time difference threshold, and a freewheeling time rate-of-change threshold, respectively.

The freewheeling time may be directly measured by a timer. The timer is started at each commutation to calculate the freewheeling time. The freewheeling time may characterize the load size, where a larger load corresponds to longer freewheeling time.

The freewheeling time difference refers to the difference in the freewheeling time of the functional motor at two adjacent moments.

The freewheeling time rate of change characterizes the trend of change of the freewheeling time of the functional motor 211 at corresponding moments. The freewheeling time rate of change may include a first derivative and a second derivative of the freewheeling time as a function of time. The rate of change may be obtained by fitting freewheeling time values determined by sampling at a plurality of moments to obtain a freewheeling time change curve, and taking the slope of this change curve as the freewheeling time rate of change. The slope of this change curve is the first derivative of the freewheeling time. In another embodiment, the slope of the slope of the freewheeling time change curve may be taken as the freewheeling time rate of change. The slope of the slope of the change curve is the second derivative of the freewheeling time.

In some embodiments, the method for the heavy load identification unit 221 to determine whether the electrical parameter is greater than or equal to the corresponding preset electrical parameter threshold includes: acquiring at least one freewheeling time parameter and determining whether the at least one freewheeling time parameter is greater than or equal to the corresponding preset electrical parameter threshold.

In some embodiments, the heavy load identification unit 221 may acquire a plurality of freewheeling time parameters and compare the plurality of freewheeling time parameters with their respective preset freewheeling time parameter thresholds to determine whether the plurality of freewheeling time parameters are greater than or equal to the corresponding preset freewheeling time parameter thresholds, respectively.

For example, the freewheeling time is compared with the corresponding preset freewheeling time threshold, and the freewheeling time difference is compared with the corresponding preset freewheeling time difference threshold. In response to the freewheeling time being greater than or equal to the preset freewheeling time threshold, and the freewheeling time difference being greater than or equal to the preset freewheeling time difference threshold, it is determined that the functional motor 211 enters the heavy load state.

For example, the freewheeling time, the freewheeling time difference, and the freewheeling time rate of change are compared with the corresponding preset freewheeling time threshold, preset freewheeling time difference threshold, and preset freewheeling time rate-of-change threshold, respectively. In response to all the three freewheeling time parameters being greater than or equal to their respective thresholds, it may be determined that the functional motor 211 enters the heavy load state.

The freewheeling time is taken as an example, as shown in FIG. 34, which is a schematic diagram of the freewheeling time during the operation of the functional motor 211 is provided. The freewheeling time of the functional motor 211 during commutation can characterize the load size. A larger load corresponds to longer freewheeling time, and vice versa. As shown in FIG. 34, Δt₁, Δt₂ represent the freewheeling time. The heavy load identification unit 221 compares the freewheeling time with the corresponding preset freewheeling time threshold. In response to determining that the freewheeling time being greater than or equal to the freewheeling time threshold, it may be determined that the functional motor 211 enters the heavy load state.

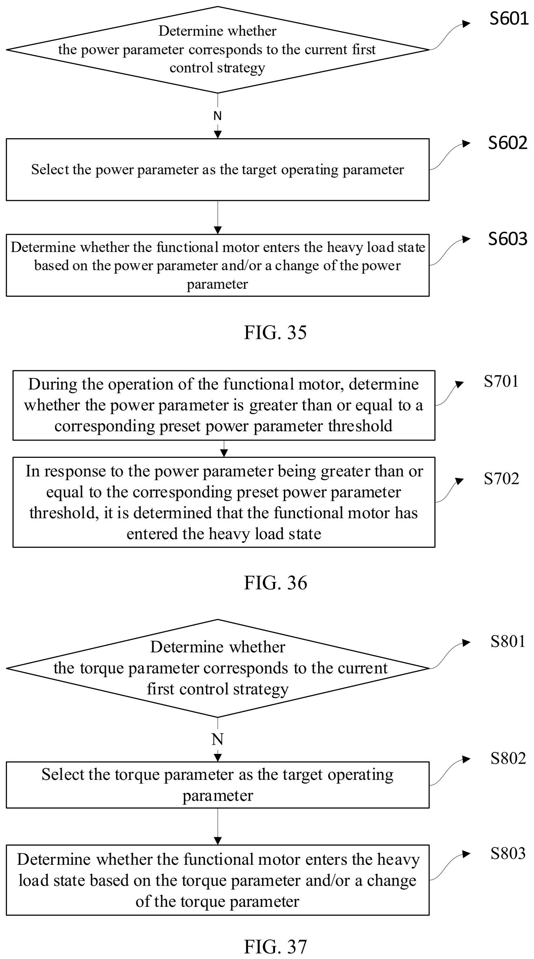

As shown in FIG. 35, in an electric work vehicle according to one or more embodiments of the present disclosure, the heavy load identification unit being configured to select a target operating parameter from the plurality of operating parameters and determine whether the functional motor enters a heavy load state based on the target operating parameter and/or a change of the target operating parameter includes the heavy load identification unit being configured to perform following steps S601 to S603.

S601: Determine whether the power parameter corresponds to the current first control strategy.

S602: In response to the power parameter not corresponding to the first control strategy, select the power parameter as the target operating parameter.

The control strategy corresponding to the power parameter is the power closed-loop control strategy. In response to the control strategy currently adopted by the controller assembly 22 for the functional motor 211 being a non-power closed-loop control strategy, such as the rotational speed closed-loop control strategy, the current closed-loop control strategy, the torque closed-loop control strategy, or the PWM duty cycle open-loop control strategy, the heavy load identification unit 221 may select the power parameter as the target operating parameter.

Selection of the target operating parameter is determined based on the current first control strategy. In response to the first control strategy being a non-power closed-loop control strategy, the heavy load identification unit 221 may select the power parameter as the target operating parameter.

S603: Determine whether the functional motor enters the heavy load state based on the power parameter and/or a change of the power parameter. The heavy load identification unit 221 selects the power parameter as the target operating parameter and further monitors the power parameter. The change of the power parameter may include, for example, a difference obtained by comparing the power parameter acquired at different time instants, a rate of increase or decrease of the power parameter, etc.

As shown in FIG. 36, in an electric work vehicle according to one or more embodiments of the present disclosure, the method for the heavy load identification unit 221 to determine whether the functional motor 211 enters the heavy load state based on the electrical parameter and/or a change of the electrical parameter includes following steps S701 and S702.

At step S701, during the operation of the functional motor, it is determined whether the power parameter is greater than or equal to a corresponding preset power parameter threshold.

At step S702, in response to the power parameter being greater than or equal to the corresponding preset power parameter threshold, it is determined that the functional motor enters the heavy load state.

In some embodiments, the power parameter includes motor power, a motor power difference, and a motor power rate of change. The preset electrical parameter thresholds corresponding to the motor power, the motor power difference, and the motor power rate of change are a motor power threshold, a motor power difference threshold, and a motor power rate-of-change threshold, respectively.

The heavy load identification unit 221 may calculate the motor power of the functional motor 211 based on the bus voltage and bus current output from the corresponding DC side of the functional motor 211.

The motor power difference refers to the difference in the motor power of the functional motor at two adjacent moments.

The motor power rate of change characterizes the trend of change of the motor power of the functional motor 211 at corresponding moments. The motor power rate of change may include a first derivative and a second derivative of the motor power as a function of time. The rate of change may be obtained by fitting motor power values determined by sampling at a plurality of moments to obtain a motor power change curve, and taking the slope of this change curve as the motor power rate of change. The slope of this change curve is the first derivative of the motor power. In another embodiment, the slope of the slope of the motor power change curve may be taken as the motor power rate of change. The slope of the slope of the change curve is the second derivative of the motor power.

The method for the heavy load identification unit 221 to determine whether the electrical parameter is greater than or equal to the corresponding preset electrical parameter threshold includes: acquiring at least one power parameter and determining whether the at least one power parameter is greater than or equal to the corresponding preset power parameter threshold.

In some embodiments, the heavy load identification unit 221 may acquire a plurality of power parameters and compare the plurality of power parameters with their respective preset power parameter thresholds to determine whether the plurality of power parameters are greater than or equal to the corresponding preset power parameter thresholds, respectively.

For example, the motor power is compared with the corresponding preset motor power threshold, and the motor power difference is compared with the corresponding preset motor power difference threshold. In response to the motor power being greater than or equal to the preset motor power threshold, and the motor power difference being greater than or equal to the preset motor power difference threshold, it is determined that the functional motor 211 enters the heavy load state.

For example, the motor power, the motor power difference, and the motor power rate of change are compared with the corresponding preset motor power threshold, preset motor power difference threshold, and preset motor power rate-of-change threshold, respectively. In response to all the three power parameters being greater than or equal to their respective thresholds, it may be determined that the functional motor 211 enters the heavy load state.

As shown in FIG. 37, in an electric work vehicle according to one or more embodiments of the present disclosure, the heavy load identification unit being configured to select a target operating parameter from the plurality of operating parameters and determine whether the functional motor enters a heavy load state based on the target operating parameter and/or a change of the target operating parameter includes the heavy load identification unit being configured to perform following steps S801 to S803.

S801: Determine whether the torque parameter corresponds to the current first control strategy.

S802: In response to the torque parameter not corresponding to the first control strategy, select the torque parameter as the target operating parameter.

The control strategy corresponding to the torque parameter is the torque closed-loop control strategy. In response to the control strategy currently adopted by the controller assembly 22 for the functional motor 211 being a non-torque closed-loop control strategy, such as the rotational speed closed-loop control strategy, the power closed-loop control strategy, the current closed-loop control strategy, or the PWM duty cycle open-loop control strategy, the heavy load identification unit 221 may select the torque parameter as the target operating parameter.

Selection of the target operating parameter is determined based on the current first control strategy. In response to the first control strategy being a non-torque closed-loop control strategy, the heavy load identification unit 221 may select the torque parameter as the target operating parameter.

S803: Determine whether the functional motor enters the heavy load state based on the torque parameter and/or a change of the torque parameter. The heavy load identification unit 221 selects the torque parameter as the target operating parameter and further monitors the torque parameter. The change of the torque parameter may include, for example, a difference obtained by comparing the torque parameter acquired at different time instants, a rate of increase or decrease of the torque parameter, etc.

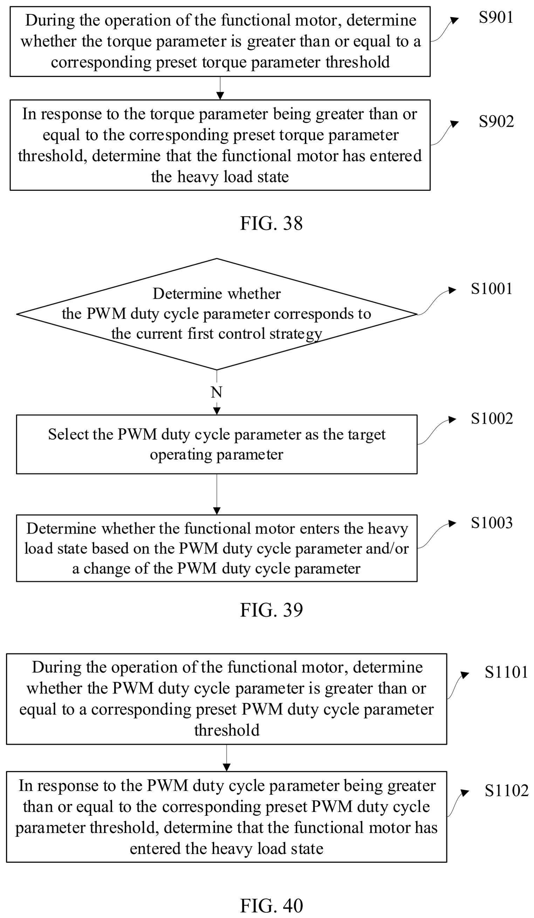

As shown in FIG. 38, in an electric work vehicle according to one or more embodiments of the present disclosure, the method for the heavy load identification unit 221 to determine whether the functional motor 211 enters the heavy load state based on the torque parameter and/or the change of the torque parameter includes following steps S901 to S902.

At step S901, during the operation of the functional motor, it is determined whether the torque parameter is greater than or equal to a corresponding preset torque parameter threshold.

At step S902, in response to the torque parameter being greater than or equal to the corresponding preset torque parameter threshold, it is determined that the functional motor enters the heavy load state.

In some embodiments, the torque parameter includes a motor torque, a motor torque difference, and a motor torque rate of change. The preset torque parameter thresholds corresponding to the motor torque, the motor torque difference, and the motor torque rate of change are a motor torque threshold, a motor torque difference threshold, and a motor torque rate-of-change threshold, respectively.

The motor torque difference refers to the difference in the motor torque of the functional motor at two adjacent moments.

The motor torque rate of change characterizes the trend of change of the motor torque of the functional motor 211 at corresponding moments. The motor torque rate of change may include a first derivative and a second derivative of the motor torque as a function of time. The rate of change may be obtained by fitting the motor torque values determined by sampling at a plurality of moments to obtain a motor torque change curve, and taking the slope of this change curve as the motor torque rate of change. The slope of this change curve is the first derivative of the motor torque. In another embodiment, the slope of the slope of the motor torque change curve may be taken as the motor torque rate of change. The slope of the slope of the change curve is the second derivative of the motor torque.

The method for the heavy load identification unit 221 to determine whether the torque parameter is greater than or equal to the corresponding preset torque parameter threshold includes: acquiring at least one motor torque parameter and determining whether the at least one motor torque parameter is greater than or equal to the corresponding preset torque parameter threshold.

In some embodiments, the heavy load identification unit 221 may acquire a plurality of torque parameters and compare the plurality of torque parameters with their respective preset torque parameter thresholds to determine whether the plurality of torque parameters are greater than or equal to the corresponding preset torque parameter thresholds, respectively.

For example, the motor torque is compared with the corresponding preset motor torque threshold, and the motor torque difference is compared with the corresponding preset motor torque difference threshold. In response to the motor torque being greater than or equal to the preset motor torque threshold, and the motor torque difference being greater than or equal to the preset motor torque difference threshold, it is determined that the functional motor 211 enters the heavy load state.

For example, the motor torque, the motor torque difference, and the motor torque rate of change are compared with the corresponding preset motor torque threshold, preset motor torque difference threshold, and preset motor torque rate-of-change threshold, respectively. In response to all the three torque parameters being greater than or equal to their respective thresholds, it may be determined that the functional motor 211 enters the heavy load state.

As shown in FIG. 39, in an electric work vehicle according to one or more embodiments of the present disclosure, the heavy load identification unit being configured to select a target operating parameter from the plurality of operating parameters and determine whether the functional motor enters a heavy load state based on the target operating parameter and/or a change of the target operating parameter includes the heavy load identification unit being configured to perform following steps S1001 to S1003.

S1001: Determine whether the PWM duty cycle parameter corresponds to the current first control strategy.

S1002: In response to the PWM duty cycle parameter not corresponding to the first control strategy, select the PWM duty cycle parameter as the target operating parameter.

The control strategy matching the PWM duty cycle parameter is the PWM duty cycle open-loop control strategy. In response to the control strategy currently adopted by the controller assembly 22 for the functional motor 211 being a non-PWM duty cycle open-loop control strategy, such as the rotational speed closed-loop control strategy, the current closed-loop control strategy, the torque closed-loop control strategy, or the power closed-loop control strategy, the heavy load identification unit 221 may select the PWM duty cycle parameter as the target operating parameter.

Selection of the target operating parameter is determined based on the current first control strategy. In response to the first control strategy being a non-PWM duty cycle open-loop control strategy, the heavy load identification unit 221 may select the PWM duty cycle parameter as the target operating parameter.

S1003: Determine whether the functional motor enters the heavy load state based on the PWM duty cycle parameter and/or a change of the PWM duty cycle parameter. The heavy load identification unit 221 selects the PWM duty cycle parameter as the target operating parameter and further monitors the PWM duty cycle parameter. The change of the PWM duty cycle parameter may include, for example, a difference obtained by comparing the PWM duty cycle parameter acquired at different time instants, a rate of increase or decrease of the PWM duty cycle parameter, etc.

As shown in FIG. 40, in an electric work vehicle according to one or more embodiments of the present disclosure, the method for the heavy load identification unit 221 to determine whether the functional motor 211 enters the heavy load state based on the electrical parameter and/or a change of the electrical parameter includes following steps S1101 to S1102.

At step S1101, during the operation of the functional motor, it is determined whether the PWM duty cycle parameter is greater than or equal to a corresponding preset PWM duty cycle parameter threshold.

At step S1102, in response to the PWM duty cycle parameter being greater than or equal to the corresponding preset PWM duty cycle parameter threshold, it is determined that the functional motor enters the heavy load state.

In some embodiments, the PWM duty cycle parameter includes the duty cycle of the corresponding control signal of the functional motor, the duty cycle difference, and the duty cycle rate of change. The preset duty cycle parameter thresholds corresponding to the duty cycle, the duty cycle difference, and the duty cycle rate of change are a duty cycle threshold, a duty cycle difference threshold, and a duty cycle rate-of-change threshold, respectively.

The duty cycle refers to the duty cycle of the PWM control signal for the functional motor 211.

The duty cycle difference refers to the difference in the duty cycle of the functional motor 211 at two adjacent moments.

The duty cycle rate of change characterizes the trend of change of the duty cycle of the functional motor 211 at corresponding moments. The duty cycle rate of change may include a first derivative and a second derivative of the duty cycle as a function of time. The rate of change may be obtained by fitting duty cycle values determined by sampling at a plurality of moments to obtain a duty cycle change curve, and taking the slope of this change curve as the duty cycle rate of change. The slope of this change curve is the first derivative of the duty cycle. In another embodiment, the slope of the slope of the duty cycle change curve may be taken as the duty cycle rate of change. The slope of the slope of the change curve is the second derivative of the duty cycle.

The method for the heavy load identification unit 221 to determine whether the PWM duty cycle parameter is greater than or equal to the corresponding preset duty cycle parameter threshold includes: acquiring at least one PWM duty cycle parameter and determining whether the at least one PWM duty cycle parameter is greater than or equal to the corresponding preset duty cycle parameter threshold.

In some embodiments, the heavy load identification unit 221 may acquire a plurality of PWM duty cycle parameters and compare the plurality of PWM duty cycle parameters with their respective preset duty cycle parameter thresholds to determine whether the plurality of PWM duty cycle parameters are greater than or equal to the corresponding preset duty cycle parameter thresholds, respectively.

For example, the duty cycle is compared with the corresponding preset duty cycle threshold, and the duty cycle difference is compared with the corresponding preset duty cycle difference threshold. In response to the duty cycle being greater than or equal to the preset duty cycle threshold, and the duty cycle difference being greater than or equal to the preset duty cycle difference threshold, it is determined that the functional motor 211 enters the heavy load state.

For example, the duty cycle, the duty cycle difference, and the duty cycle rate of change are compared with the corresponding preset duty cycle threshold, preset duty cycle difference threshold, and preset duty cycle rate-of-change threshold, respectively. In response to all the three PWM duty cycle parameters being greater than or equal to their respective thresholds, it may be determined that the functional motor 211 enters the heavy load state.

In the aforementioned embodiments, the heavy load identification unit 221 selects one type of operating parameter from the plurality of operating parameters as the target operating parameter and determines whether the functional motor 211 enters the heavy load state based on the target operating parameter and/or the change of the target operating parameter. In further embodiments, the heavy load identification unit 221 may select a plurality of operating parameters that do not match the current first control strategy as target operating parameters and determine whether the functional motor 211 enters the heavy load state based on the ratio of the plurality of selected operating parameters and the change of the ratio.

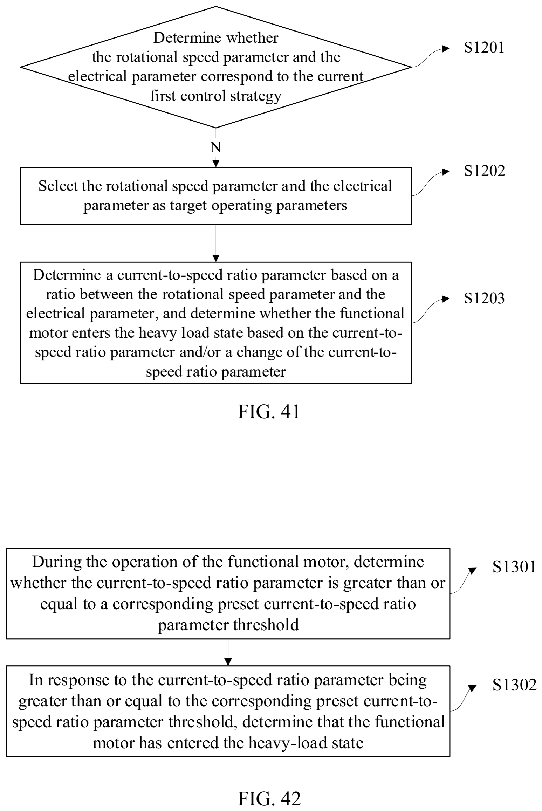

As shown in FIG. 41, in an electric work vehicle according to one or more embodiments of the present disclosure, the heavy load identification unit being configured to select a target operating parameter from the plurality of operating parameters and determine whether the functional motor enters a heavy load state based on the target operating parameter and/or a change of the target operating parameter includes the heavy load identification unit being configured to perform following steps S1201 to S1203.

S1201: Determine whether the rotational speed parameter and the electrical parameter correspond to the current first control strategy.

S1202: In response to the rotational speed parameter and the electrical parameter not corresponding to the first control strategy, select the rotational speed parameter and the electrical parameter as target operating parameters.

Selection of the target operating parameters is determined based on the current first control strategy. In response to the first control strategy being a non-rotational-speed closed-loop control strategy and a non-current closed-loop control strategy, the heavy load identification unit 221 may select the rotational speed parameter and the electrical parameter as the target operating parameters.

S1203: Determine a current-to-speed ratio parameter based on a ratio between the rotational speed parameter and the electrical parameter, and determine whether the functional motor enters the heavy load state based on the current-to-speed ratio parameter and/or a change of the current-to-speed ratio parameter.

The change of the current-to-speed ratio parameter may include, for example, a difference obtained by comparing the ratio of the rotational speed parameter to the electrical parameter acquired at different time instants, a rate of increase or decrease, etc.

In some embodiments, the current-to-speed ratio parameter includes a current-to-speed ratio, a current-to-speed ratio difference, and a current-to-speed ratio rate of change. The preset current-to-speed ratio parameter thresholds corresponding to the current-to-speed ratio, the current-to-speed ratio difference, and the current-to-speed ratio rate of change are a current-to-speed ratio threshold, a current-to-speed ratio difference threshold, and a current-to-speed ratio rate-of-change threshold, respectively.

The current-to-speed ratio refers to the ratio of the electrical parameter to the rotational speed parameter. The electrical parameter may include the bus current parameter, the phase current parameter, the bus voltage parameter, the conducting phase voltage parameter, and the freewheeling time parameter. The rotational speed parameter may include the motor rotational speed parameter and the motor sector time parameter.

The current-to-speed ratio difference refers to the difference in the current-to-speed ratio at two adjacent moments.

The current-to-speed ratio rate of change characterizes the trend of change of the current-to-speed ratio at corresponding moments. The current-to-speed ratio rate of change may include a first derivative and a second derivative of the current-to-speed ratio as a function of time. The rate of change may be obtained by fitting current-to-speed ratio values determined by sampling at a plurality of moments to obtain a current-to-speed ratio change curve, and taking the slope of this change curve as the current-to-speed ratio rate of change. The slope of this change curve is the first derivative of the current-to-speed ratio. In another embodiment, the slope of the slope of the current-to-speed ratio change curve may be taken as the current-to-speed ratio rate of change. The slope of the slope of the change curve is the second derivative of the current-to-speed ratio.

In some embodiments, the ratio of the rotational speed parameter to the electrical parameter is determined as the current-to-speed ratio parameter. Those skilled in the art can understand that the ratio of the electrical parameter to the rotational speed parameter may also be taken as the current-to-speed ratio parameter.

As shown in FIG. 42, in an electric work vehicle according to one or more embodiments of the present disclosure, for the case where the motor speed parameter is selected as the speed parameter, the method for the heavy load identification unit 221 to determine whether the functional motor 211 enters the heavy load state based on the current-to-speed ratio parameter and/or the change in the current-to-speed ratio parameter includes following steps S1301 to S1302.

At step S1301, during the operation of the functional motor, it is determined whether the current-to-speed ratio parameter is greater than or equal to a corresponding preset current-to-speed ratio parameter threshold.

At step S1302, in response to the current-to-speed ratio parameter being greater than or equal to the corresponding preset current-to-speed ratio parameter threshold, it is determined that the functional motor enters the heavy load state.

In some embodiments, the ratio of the rotational speed parameter to the electrical parameter is determined as the flow ratio parameter. Those skilled in the art may understand that the ratio of the electrical parameter to the rotational speed parameter may also be used as the flow ratio parameter.

The method for the heavy load identification unit 221 to determine whether the current-to-speed ratio parameter is greater than or equal to the corresponding preset current-to-speed ratio parameter threshold includes: acquiring at least one current-to-speed ratio parameter and determining whether the at least one current-to-speed ratio parameter is greater than or equal to the corresponding preset current-to-speed ratio parameter threshold.

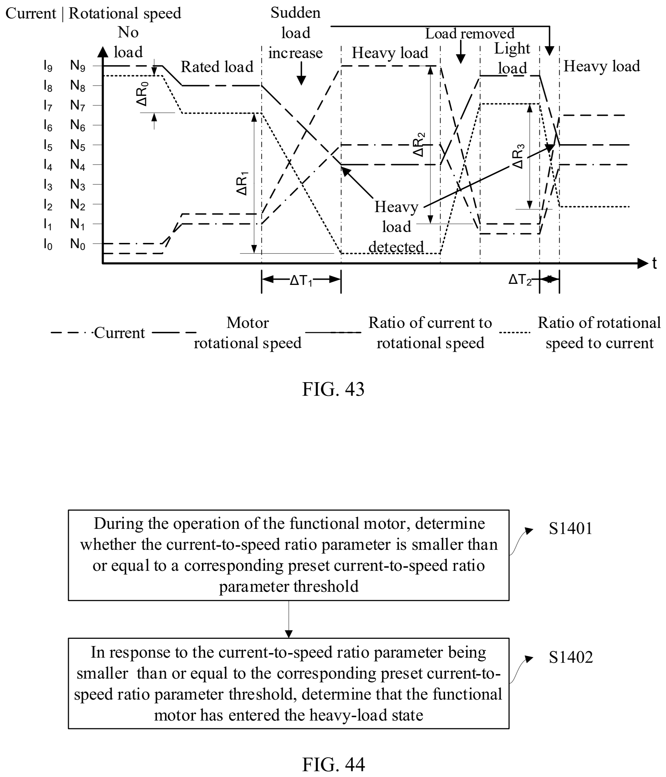

FIG. 43 is a schematic diagram of determining a heavy load mutation based on a current-to-speed ratio threshold during operation of the functional motor 211. Taking the motor speed as the selected rotational speed parameter and the bus current as the selected electrical parameter as an example, the current-to-speed ratio is determined based on the ratio of the motor speed and the bus current. Here, when the ratio of the bus current to the motor speed is used as the current-to-speed ratio, and the current-to-speed ratio is greater than or equal to the corresponding current-to-speed ratio threshold, it may be determined that the functional motor 211 enters the heavy load state; when the ratio of the motor speed to the bus current is determined as the current-to-speed ratio, and the current-to-speed ratio is smaller than or equal to the corresponding current-to-speed ratio threshold, it may be determined that the functional motor 211 enters the heavy load state.

In some embodiments, the heavy load identification unit 221 may acquire a plurality of current-to-speed ratio parameters, compare the plurality of current-to-speed ratio parameters with their respective preset current-to-speed ratio parameter thresholds, and determine whether the plurality of current-to-speed ratio parameters are greater than or equal to the corresponding preset current-to-speed ratio parameter thresholds, respectively.

For example, the current-to-speed ratio is compared with the corresponding preset current-to-speed ratio threshold, and the current-to-speed ratio difference is compared with the corresponding preset current-to-speed ratio difference threshold. In response to the current-to-speed ratio being greater than or equal to the preset current-to-speed ratio threshold, and the current-to-speed ratio difference being greater than or equal to the preset current-to-speed ratio difference threshold, it is determined that the functional motor 211 enters the heavy load state.

For example, the current-to-speed ratio, the current-to-speed ratio difference, and the current-to-speed ratio rate of change are compared with the corresponding preset current-to-speed ratio threshold, preset current-to-speed ratio difference threshold, and preset current-to-speed ratio rate-of-change threshold, respectively. In response to all the three current-to-speed ratio parameters being greater than or equal to their respective thresholds, it may be determined that the functional motor 211 enters the heavy load state.

As shown in FIG. 44, in an electric work vehicle according to one or more embodiments of the present disclosure, for the case where the motor sector time parameter is selected as the speed parameter, the method for the heavy load identification unit 221 to determine whether the functional motor 211 enters the heavy load state based on the current-to-speed ratio parameter and/or the change in the current-to-speed ratio parameter includes following steps S1401 to S1402.

At step S1401, during the operation of the functional motor, it is determined whether the current-to-speed ratio parameter is smaller than or equal to a corresponding preset current-to-speed ratio parameter threshold.

At step S1402, in response to the current-to-speed ratio parameter being smaller than or equal to the corresponding preset current-to-speed ratio parameter threshold, it is determined that the functional motor enters the heavy load state.

Correspondingly, the method for the heavy load identification unit 221 to determine whether the current-to-speed ratio parameter is smaller than or equal to the corresponding preset current-to-speed ratio parameter threshold includes: acquiring at least one current-to-speed ratio parameter and determining whether the at least one current-to-speed ratio parameter is smaller than or equal to the corresponding preset current-to-speed ratio parameter threshold.

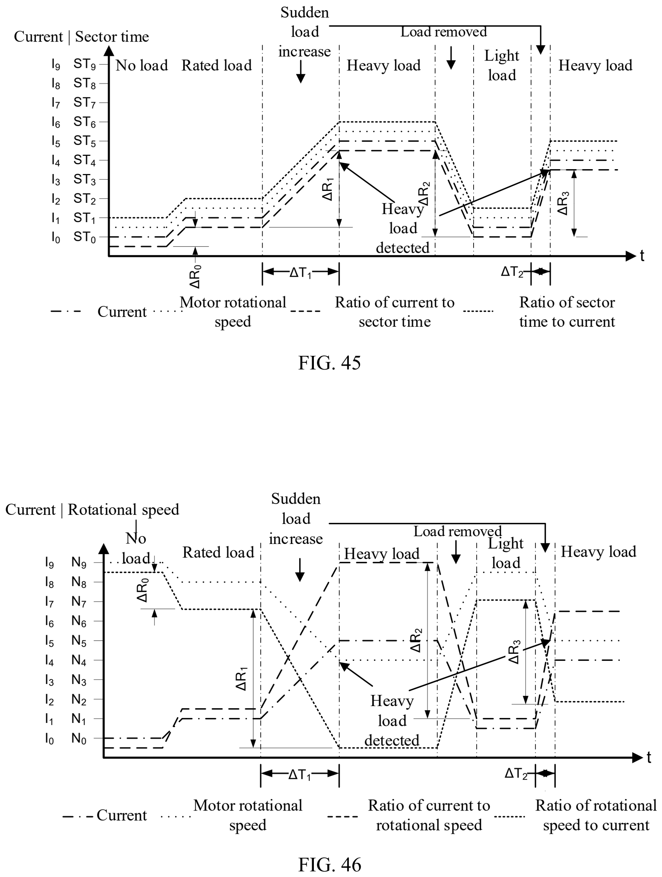

FIG. 45 is a schematic diagram of determining heavy load mutation based on a current-to-speed ratio threshold during operation of the functional motor 211. Taking the motor sector time as the selected rotational speed parameter and the bus current as the selected electrical parameter as an example, the current-to-speed ratio is determined based on the ratio of the motor sector time and the bus current.

The following uses the ratio of bus current to motor speed and the ratio of motor speed to bus current as the current-to-speed ratio to illustrate the method embodiment for determining heavy load mutation. The logic and method for judgment using the ratio of bus current to motor sector time and the ratio of motor sector time to current as the current-to-speed ratio are the same.

The heavy load identification unit 221 may determine whether the current ratio Rₖ (the ratio of the current to the rotational speed or the ratio of the rotational speed to the current) is greater than or equal to (for the ratio of the current to the rotational speed) or smaller than or equal to (for ratio of the rotational speed to the current) a preset ratio threshold R_{T}. In the case of positive determination, it is determined that the load has entered the heavy load operating region.

Furthermore, a time constraint may be added. In response to the current ratio Rₖ (the ratio of the current to the rotational speed or the ratio of the rotational speed to the current) being greater than or equal to (for the ratio of the current to the rotational speed) or smaller than or equal to (for the ratio of the rotational speed to the current) the preset ratio threshold R_{T} within a preset time interval ΔT, which may be 0.01 to 10 seconds, it is determined that the load has entered the heavy load operating region.

Further still, the added time constraint may be segmented by presetting X ΔTx time intervals, for example, X=4, ΔT₀=10 seconds, ΔT₁=1 second, ΔT₂=0.1 second, ΔT₃=0.01 second. When within ΔT₀ (10 seconds) the current ratio Rₖ (the ratio of the current to the rotational speed or the ratio of the rotational speed to the current) is greater than or equal to (for the ratio of the current to the rotational speed) or smaller than or equal to (for the ratio of the rotational speed to the current) R₁₀, and/or within ΔT₁ (1 second) the current ratio Rₖ is greater than or equal to (for the ratio of the current to the rotational speed) or smaller than or equal to (for the ratio of the rotational speed to the current) R_{T1}, and/or within ΔT₂ (0.1 second) the current ratio Rₖ is greater than or equal to (for the ratio of the current to the rotational speed) or smaller than or equal to (for the ratio of the rotational speed to the current) R_{T2}, and/or within ΔT₃ (0.01 second) the current ratio Rₖ is greater than or equal to (for the ratio of the current to the rotational speed) or smaller than or equal to (for the ratio of the rotational speed to the current) R₁₃, it is determined that the load has entered the heavy load operating region. R₁₀ to R₁₃ satisfy the relational expression (13): R_{T0} ≥ R_{T1} ≥ R_{T2} ≥ R_{T3}, or R_{T0} ≤ R_{T1} ≤ R_{T2} ≤ R_{T3}.

The relationship for determining entry into heavy-load between the ratio threshold and the preset rotational speed of each gear also includes the aforementioned time conditions.

The preset current-to-speed ratio threshold corresponding to the current-to-speed ratio may be set as an absolute value or as a proportional value.

For the case where the threshold is set as an absolute value, examples are as follows.
(1) The ratio thresholds for respective gears are the same under the same time interval condition.

After adding the time constraint, the ratio thresholds for the same gear in different time intervals are shown in Table 44 below.

**Table 44**

| Ratio Threshold | ΔT₀ | ΔT1 | ΔT₂ | ΔT₃ |
|---|---|---|---|---|
| Low Gear | R_{AL0} | R_{AL1} | R_{AL2} | R_{AL3} |
| Medium Gear | R_{AM0} | R_{AM1} | R_{AM2} | R_{AM3} |
| High Gear | R_{AH0} | R_{AH1} | R_{AH2} | R_{AH3} |

(2) The ratio thresholds for each gear are different under the same time interval condition.

The ratio threshold is positively correlated with the gear. After adding the time constraint, the ratio thresholds for the same gear in different time intervals are shown in Table 45 below.

**Table 45**

| Ratio Threshold | ΔT₀ | ΔT₁ | ΔT₂ | ΔT₃ |
|---|---|---|---|---|
| Low Gear | R_{BL0} | R_{BL1} | R_{BL2} | R_{BL3} |
| Medium Gear | R_{BM0} | R_{BM1} | R_{BM2} | R_{BM3} |
| High Gear | R_{BH0} | R_{BH1} | R_{BH2} | R_{BH3} |

In another embodiment, the ratio threshold is negatively correlated with the gear. After adding the time constraint, the ratio thresholds for the same gear in different time intervals are shown in Table 46 below.

**Table 46**

| Ratio Threshold | ΔT₀ | ΔT₁ | ΔT₂ | ΔT₃ |
|---|---|---|---|---|
| Low Gear | R_{CL0} | R_{CL1} | R_{CL2} | R_{CL3} |
| Medium Gear | R_{CM0} | R_{CM1} | R_{CM2} | R_{CM3} |
| High Gear | R_{CH0} | R_{CH1} | R_{CH2} | R_{CH3} |

For the case where the threshold is set as a proportional value, examples are as follows.
(1) The proportional values for respective gears are the same within the same time interval condition.

After adding the time constraint, the ratio thresholds for the same gear in different time intervals are shown in Table 47 below.

**Table 47**

| Ratio Threshold | ΔT₀ | ΔT₁ | ΔT₂ | ΔT₃ |
|---|---|---|---|---|
| Low Gear | R_{DL0} | R_{DL1} | R_{DL2} | R_{DL3} |
| Medium Gear | R_{DM0} | R_{DMI} | R_{DM2} | R_{DM3} |
| High Gear | R_{DH0} | R_{DH1} | R_{DH2} | R_{DH3} |

(2) The proportional values for respective gears are different under the same time interval condition.

The proportional value is positively correlated with the gear. After adding the time constraint, the ratio thresholds for the same gear in different time intervals are shown in Table 48 below.

**Table 48**

| Ratio Threshold | ΔT₀ | ΔT₁ | ΔT₂ | ΔT₃ |
|---|---|---|---|---|
| Low Gear | R_{EL0} | R_{EL1} | R_{EL2} | R_{EL3} |
| Medium Gear | R_{EM0} | R_{EM1} | R_{EM2} | R_{EM3} |
| High Gear | R_{EH0} | R_{EH1} | R_{EH2} | R_{EH3} |

In another embodiment, the proportional value is negatively correlated with the gear. After adding the time constraint, the proportional values for the same gear in different time intervals are shown in Table 49 below.

**Table 49**

| Ratio Threshold | ΔT₀ | ΔT₁ | ΔT₂ | ΔT₃ |
|---|---|---|---|---|
| Low Gear | R_{FL0} | R_{FL1} | R_{FL2} | R_{FL3} |
| Medium Gear | R_{FM0} | R_{FM1} | R_{FM2} | R_{FM3} |
| High Gear | R_{FH0} | R_{FH1} | R_{FH2} | R_{FH3} |

FIG. 46 is a schematic diagram of determining a heavy load mutation based on a current-to-speed ratio difference threshold during operation of the functional motor 211. The ratio of the bus current to the motor speed or the ratio of the motor speed to the bus current is used as the current-to-speed ratio. By comparing the current-to-speed ratio difference with the corresponding preset current-to-speed ratio difference threshold, it is determined whether the functional motor 211 enters the heavy load state.

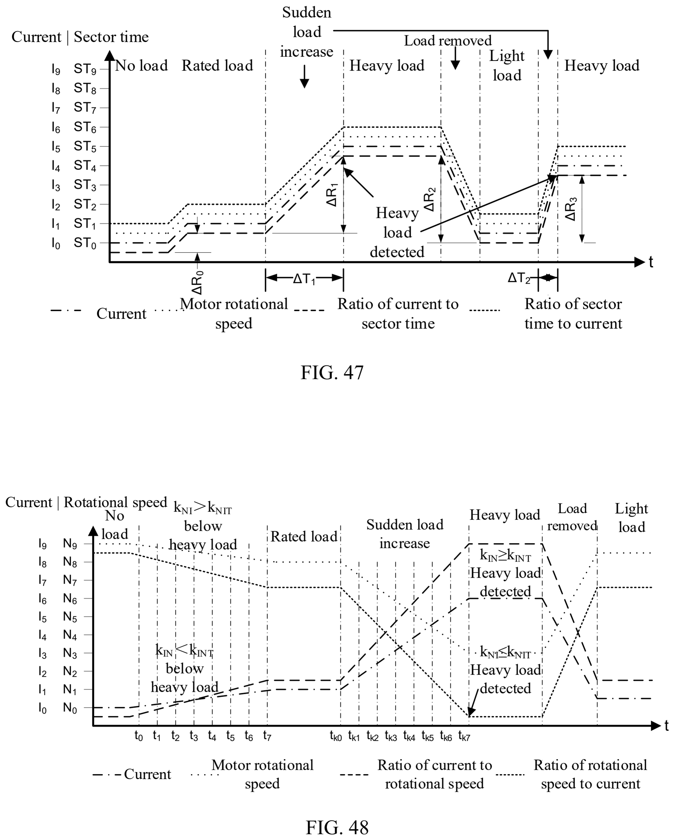

FIG. 47 is a schematic diagram of determining a heavy load mutation based on a current-to-speed ratio difference threshold during operation of the functional motor 211. The ratio of the bus current to the motor sector time or the ratio of the motor sector time to the bus current is used as the current-to-speed ratio. By comparing the current-to-speed ratio difference with the corresponding preset current-to-speed ratio difference threshold, it is determined whether the functional motor 211 enters the heavy load state.

The following uses the ratio of the bus current to the motor speed and the ratio of the motor speed to the bus current as the current-to-speed ratio for explanation.

The heavy load identification unit 221 may calculate the difference ΔRₖ between the ratio Rₖ (the ratio of the current to the rotational speed or the ratio of the rotational speed to the current) acquired at the current moment and the ratio Rₖ₋₁ acquired at the previous moment. If ΔRₖ is greater than or equal to the preset ratio difference threshold ΔR_{T}, it is determined that the load has entered the heavy load operating region.

Furthermore, a time constraint may be added. In response to the current ratio difference ΔRₖ is greater than or equal to the ratio difference threshold ΔR_{T} within a preset time interval AT, which may be, for example, 0.01 to 10 seconds, it is determined that the load has entered the heavy load operating region.

Further still, the added time constraint may be segmented by presetting X ΔTₓ time intervals. For example, X=4, ΔT₀=10 seconds, ΔT₁=1 second, ΔT₂=0.1 second, ΔT₃=0.01 second. The difference ΔR_{kg} between the ratio Rₖ acquired at the current moment and the ratio R_{g} acquired at a moment ΔT0 (10 seconds) earlier is calculated, the difference ΔRₖₕ between Rₖ and the ratio Rₕ acquired at a moment ΔT₁ (1 second) earlier is calculated, the difference ΔRₖᵢ between Rₖ and the ratio Rᵢ acquired at a moment ΔT₂ (0.1 second) earlier is calculated, and the difference ΔRₖⱼ between Rₖ and the ratio Rⱼ acquired at a moment ΔT₃ (0.01 second) earlier is calculated. If ΔR_{kg} is greater than or equal to the preset ratio difference threshold ΔR_{T0}, and/or ΔRₖₕ is greater than or equal to the preset ratio difference threshold ΔR_{T1}, and/or ΔRₖᵢ is greater than or equal to the preset ratio difference threshold ΔR_{T2}, and/or ΔRₖⱼ is greater than or equal to the preset ratio difference threshold ΔR_{T3}, it is determined that the load has entered the heavy load operating region. ΔR_{T0} to ΔR_{T3} satisfy the relational expression (14): ΔR_{T0} ≥ ΔR_{T1} ≥ ΔR_{T2} ≥ ΔR_{T2}.

The relationship for determining entry into heavy load between the ratio difference and the preset ratio for each gear also includes the aforementioned time conditions.

Similarly, the preset current-to-speed ratio threshold corresponding to the current-to-speed ratio may be set as an absolute value or as a proportional value.

FIG. 48 is a schematic diagram of determining a heavy load mutation based on a current-to-speed ratio rate-of-change threshold during operation of the functional motor 211. The ratio of the bus current to the motor speed or the ratio of the motor speed to the bus current is used as the current-to-speed ratio. By comparing the current-to-speed ratio rate of change with the corresponding preset current-to-speed ratio rate-of-change threshold, it is determined whether the functional motor 211 enters the heavy load state.

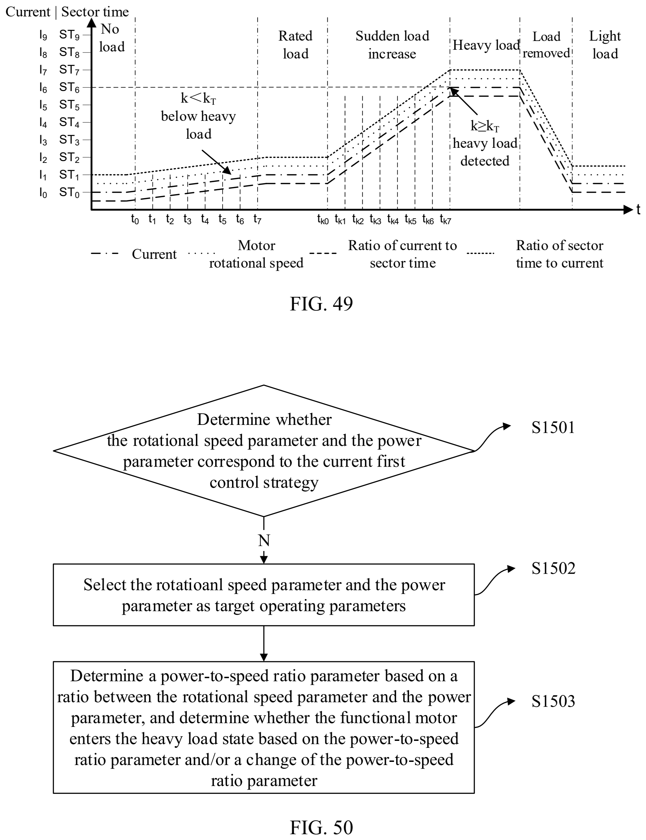

FIG. 49 is a schematic diagram of determining a heavy load mutation based on a current-to-speed ratio rate-of-change threshold during operation of the functional motor 211. The ratio of the bus current to the motor sector time or the ratio of the motor sector time to the bus current is used as the current-to-speed ratio. By comparing the current-to-speed ratio rate of change with the corresponding preset current-to-speed ratio rate-of-change threshold, it is determined whether the functional motor 211 enters the heavy load state.

The following uses the ratio of the bus current to the motor speed and the ratio of the motor speed to the bus current as the current-to-speed ratio for explanation.

The heavy load identification unit 221 may acquire ratios R₀, R₁, R₂...Rₖ at time instants t₀, t₁, t₂...tₖ, perform linear fitting on R₀, R₁, R₂...Rₖ, and obtain the corresponding curve slope k using the equation: k = (Eti - Et*Ei) / [Et² - (Et)²].

Etr represents the mathematical expectation of the product of the sampling time instant t and the ratio r, Et represents the mathematical expectation of the sampling time instant t, Er represents the mathematical expectation of the ratio, Et² represents the mathematical expectation of the square of the sampling time instant t, and (Et)² represents the square of the mathematical expectation of the sampling time instant t.

Assuming Δt₀ = t₁-t₀, Δt₁ = t₂-t₁ ..., Δtₖ = tₖ₊₁-tₖ, for the convenience of software calculation, it is generally designed that Δt₀ = Δt₁ = ... = Δtₖ. Therefore, the above equation may be simplified to: k = [n*Σ(t*r) - Σt*Σr] / [n*Σt² - Σt*Σt], where n is a positive integer. To further simplify the calculation process and reduce software computational overhead, n in this simplified equation may be set to 2^{m}, where m is a positive integer.

When the slope k is greater than or equal to (for the ratio of the current to the rotational speed, k_{IN} ≥ k_{INT} in FIG. 48) or smaller than or equal to (for the ratio of the rotational speed to the current, k_{NI} ≤ k_{NIT} in FIG. 48) the preset slope threshold k_{T}, it is determined that the load has entered the heavy load operating region.

Furthermore, to achieve better determination results, a ratio filtering method may be adopted on the basis of the above. Thus, the aforementioned ratios R₀, R₁, R₂...Rₖ are values obtained after filtering. When using fixed-window filtering series methods, the values of Δt₀, Δt₁, Δt₂...Δtₖ are the time intervals for X ratio samples. For example, if the ratio is acquired every 1ms and X=8 is preset, then a filtered value is calculated every 8ms, so Δt₀=Δt₁=Δt₂=Δtₖ=8ms; when using sliding window filtering series methods, with the same preset conditions, Δt₀=Δt₁=Δt₂=Δtₖ=1ms. After each fixed-window or sliding-window filtering is completed, equation (15) is used to calculate the slope k, which is the first-order derivative value of the ratio with respect to unit time.

Furthermore, when the operating ratio range of the motor is large, the values of Δt0, Δt₁, Δt₂...Δtk may be dynamically adjusted according to the current motor ratio. This is because when Δt₀, Δt₁, Δt₂...Δtₖ are too small, and the motor ratio is relatively low, the ratio sampling frequency is much higher than the motor ratio filtering frequency, and the sampled ratio at each moment might be the same, unnecessarily consuming computing resources, or when the motor ratio fluctuates on a small time scale, it can easily interfere with the calculation results, leading to misjudgment; when Δt₀, Δt₁, Δt₂...Δtₖ are too large, and the motor ratio is relatively high, the ratio sampling is much lower than the actual ratio change frequency, resulting in relatively large fluctuations between the obtained data, or it is possible that the actual ratio rate of change already meets the application requirements, but the actual calculation and judgment fail to identify it. Therefore, the adjustment rule for Δt₀, Δt₁, Δt₂...Δtₖ is: when the ratio is relatively high, the time interval is relatively small; when the ratio is relatively low, the time interval is relatively large. There are three methods for adjusting this time interval: The first is to adjust the aforementioned 1ms ratio sampling interval, for example, adjust it to 0.5ms or 2ms. Thus, under fixed-window filtering series methods, Δt₀=Δt₁=Δt₂=Δtₖ=4ms or 16ms, and under sliding window filtering series methods, Δt₀=Δt₁=Δt₂=Δtₖ=0.5ms or 2ms. The second is to adjust the window length (number of sample points X), for example, adjust to X=4 or X=16. Thus, under fixed-window filtering series methods, Δt₀=Δt₁=Δt₂=Δtₖ=4ms or 16ms, and under sliding window filtering series methods, Δt₀=Δt₁=Δt₂=Δtₖ still equals 1ms. The third is to adjust both the ratio sampling interval time and the window length (number of sample points X) simultaneously. Additionally, since the change in ratio drop caused by a sudden load change is also relatively fast, during this process, Δt₀, Δt₁, Δt₂...Δtₖ will not be adjusted, and adjustment will only occur after the ratio has stabilized for a period of time.

Furthermore, after each fixed-window or sliding-window filtering, the slope is calculated using the above equation, thus obtaining a set of k₀, k₁, k₂...kₖ. Linear fitting is performed again on k₀, k₁, k₂...kₖ to obtain the corresponding slope k' using the equation: k' = (Etk - Et*Ek) / [Et² - (Et)²].

Here, Etk is the mathematical expectation of the product of the time instant t each ratio slope is acquired and the ratio slope k, Et is the mathematical expectation of the time instant t each ratio slope is acquired, Ek is the mathematical expectation of the ratio slope, Et² is the mathematical expectation of the square of the time instant t each ratio slope is acquired, and (Et)² is the square of the mathematical expectation of the sampling time instant t.

Since the time intervals for acquiring k₀, k₁, k₂...kₖ are equal, Δt'₀, Δt'₁, Δt'₂...Δt'ₖ are also equal. Therefore, the above equation may be simplified to: k' = [n'*Σ(t*k) - Σt*Σk] / [n'*Σt² - Σt*Σt], where n' is a positive integer. To further simplify the calculation process and reduce software computational overhead, n' in this simplified equation may be set to 2^m', where m' is a positive integer. When the slope k' is greater than or equal to (for current-to-speed ratio) or smaller than or equal to (for speed-to-current ratio) the preset slope threshold k'_{T}, it is determined that the load has entered the heavy load operating region. Here, the slope k' is the second-order derivative of the ratio with respect to unit time.

As shown in FIG. 50, in an electric work vehicle according to one or more embodiments of the present disclosure, the heavy load identification unit being configured to select a target operating parameter from the plurality of operating parameters, and determine whether the functional motor enters a heavy load state based on the target operating parameter and/or a change of the target operating parameter includes the heavy load identification unit being configured to perform following steps S1501 to S1503.

S1501: Determine whether the rotational speed parameter and the power parameter correspond to the current first control strategy.

S1502: In response to the rotational speed parameter and the power parameter not corresponding to the first control strategy, select the rotational speed parameter and the power parameter as target operating parameters.

Selection of the target operating parameters is based on the current first control strategy. In response to the first control strategy being not a rotational speed closed-loop control strategy and not a power closed-loop control strategy, the heavy load identification unit 221 may select the rotational speed parameter and the power parameter as the target operating parameters.

S1503: Determine a power-to-speed ratio parameter based on a ratio between the rotational speed parameter and the power parameter, and determine whether the functional motor enters the heavy load state based on the power-to-speed ratio parameter and/or a change of the power-to-speed ratio parameter.

The change of the power-to-speed ratio parameter may include, for example, the difference obtained by comparing the ratio of the rotational speed parameter to the power parameter acquired at different time instants, the rate of increase or decrease, etc.

In some embodiments, the power-to-speed ratio parameter includes a power-to-speed ratio, a power-to-speed ratio difference, and a power-to-speed ratio rate of change. The preset power-to-speed ratio parameter thresholds corresponding to the power-to-speed ratio, the power-to-speed ratio difference, and the power-to-speed ratio rate of change are a power-to-speed ratio threshold, a power-to-speed ratio difference threshold, and a power-to-speed ratio rate-of-change threshold, respectively.

The power-to-speed ratio refers to the ratio of the power parameter to the rotational speed parameter. The power parameter may include motor power, a motor power difference, and a motor power rate of change. The rotational speed parameter may include the motor speed parameter and the motor sector time parameter.

The power-to-speed ratio difference refers to the difference in the power-to-speed ratio between two adjacent moments.

The power-to-speed ratio rate of change characterizes the change trend of the power-to-speed ratio at corresponding moments. The power-to-speed ratio rate of change may include a first-order derivative and a second-order derivative of the function of the power-to-speed ratio over time. The change curve of the power-to-speed ratio may be obtained by fitting power-to-speed ratio values determined by sampling at a plurality of moments, and taking the slope of this change curve as the power-to-speed ratio rate of change. The slope of this change curve is the first-order derivative of the power-to-speed ratio. In another embodiment, the slope of the slope of the power-to-speed ratio change curve may be used as the power-to-speed ratio rate of change. The slope of the slope of the change curve is the second-order derivative of the power-to-speed ratio.

In some embodiments, the ratio of the rotational speed parameter to the power parameter is determined as the power-to-speed ratio parameter. Those skilled in the art may understand that the ratio of the power parameter to the rotational speed parameter may also be used as the power-to-speed ratio parameter.

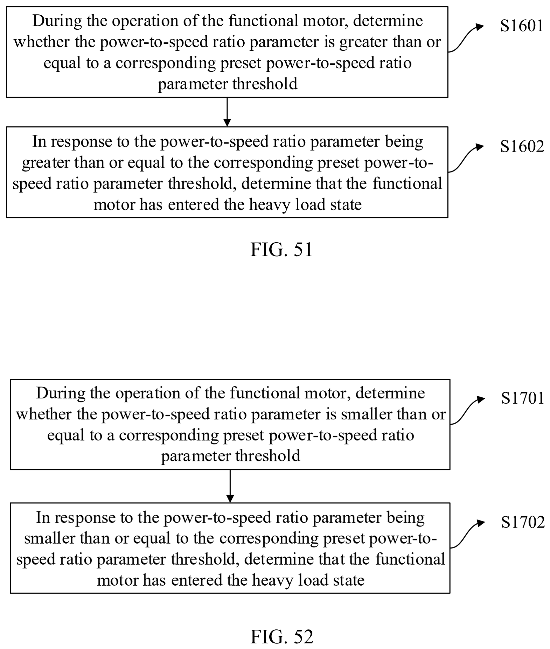

As shown in FIG. 51, in an electric work vehicle according to one or more embodiments of the present disclosure, for the case where the motor speed parameter is selected as the rotational speed parameter, the method for the heavy load identification unit 221 to determine whether the functional motor 211 enters the heavy load state based on the power-to-speed ratio parameter and/or the change of the power-to-speed ratio parameter includes following steps S1601 to S1602.

At step S1601, during the operation of the functional motor, it is determined whether the power-to-speed ratio parameter is greater than or equal to a corresponding preset power-to-speed ratio parameter threshold.

At step S1602, in response to the power-to-speed ratio parameter being greater than or equal to the corresponding preset power-to-speed ratio parameter threshold, it is determined that the functional motor enters the heavy load state.

In some embodiments, the ratio of the rotational speed parameter to the power parameter is determined as the power-to-speed ratio parameter. Those skilled in the art can understand that the ratio of the power parameter to the rotational speed parameter may also be used as the power-to-speed ratio parameter.

The method for the heavy load identification unit 221 to determine whether the power-to-speed ratio parameter is greater than or equal to the corresponding preset power-to-speed ratio parameter threshold includes: acquiring at least one power-to-speed ratio parameter and determining whether the at least one power-to-speed ratio parameter is greater than or equal to the corresponding preset power-to-speed ratio parameter threshold.

Taking the motor speed as the selected rotational speed parameter and the motor power as the selected power parameter as an example, the power-to-speed ratio is determined based on the ratio of the motor speed and the motor power. Here, when the ratio of the motor power to the motor speed is used as the power-to-speed ratio, and the power-to-speed ratio is greater than or equal to the corresponding power-to-speed ratio threshold, it may be determined that the functional motor 211 enters the heavy load state; when the ratio of the motor speed to the motor power is used as the power-to-speed ratio, and the power-to-speed ratio is smaller than or equal to the corresponding power-to-speed ratio threshold, it may be determined that the functional motor 211 enters the heavy load state.

In some embodiments, the heavy load identification unit 221 may acquire a plurality of power-to-speed ratio parameters, compare the plurality of power-to-speed ratio parameters with their respective preset power-to-speed ratio parameter thresholds, and determine whether the plurality of power-to-speed ratio parameters are greater than or equal to the corresponding preset power-to-speed ratio parameter thresholds, respectively.

For example, the power-to-speed ratio is compared with the corresponding preset power-to-speed ratio threshold, and the power-to-speed ratio difference is compared with the corresponding preset power-to-speed ratio difference threshold. If the power-to-speed ratio is greater than or equal to the preset power-to-speed ratio threshold, and the power-to-speed ratio difference is greater than or equal to the preset power-to-speed ratio difference threshold, it is determined that the functional motor 211 enters the heavy load state.

For example, the power-to-speed ratio, the power-to-speed ratio difference, and the power-to-speed ratio rate of change are compared with the corresponding preset power-to-speed ratio threshold, preset power-to-speed ratio difference threshold, and preset power-to-speed ratio rate-of-change threshold, respectively. In response to all the three power-to-speed ratio parameters being greater than or equal to their respective thresholds, it may be determined that the functional motor 211 enters the heavy load state.

As shown in FIG. 52, in an electric work vehicle according to one or more embodiments of the present disclosure, for the case where the motor sector time parameter is selected as the rotational speed parameter, the method for the heavy load identification unit 221 to determine whether the functional motor 211 enters the heavy load state based on the power-to-speed ratio parameter and/or the change of the power-to-speed ratio parameter includes following steps S1701 to S1702.

At step S1701, during operation of the functional motor, it is determined whether the power-to-speed ratio parameter is smaller than or equal to a corresponding preset power-to-speed ratio parameter threshold.

At step S1702, in response to the power-to-speed ratio parameter being smaller than or equal to the corresponding preset power-to-speed ratio parameter threshold, it is determined that the functional motor enters the heavy load state.

Correspondingly, the method for the heavy load identification unit 221 to determine whether the power-to-speed ratio parameter is smaller than or equal to the corresponding preset power-to-speed ratio parameter threshold includes: acquiring at least one power-to-speed ratio parameter and determining whether the at least one power-to-speed ratio parameter is smaller than or equal to the corresponding preset power-to-speed ratio parameter threshold.

In some embodiments, taking the motor sector time as the selected speed parameter and the motor power as the selected power parameter as an example, the power-to-speed ratio is determined based on the ratio of the motor sector time and the motor power.

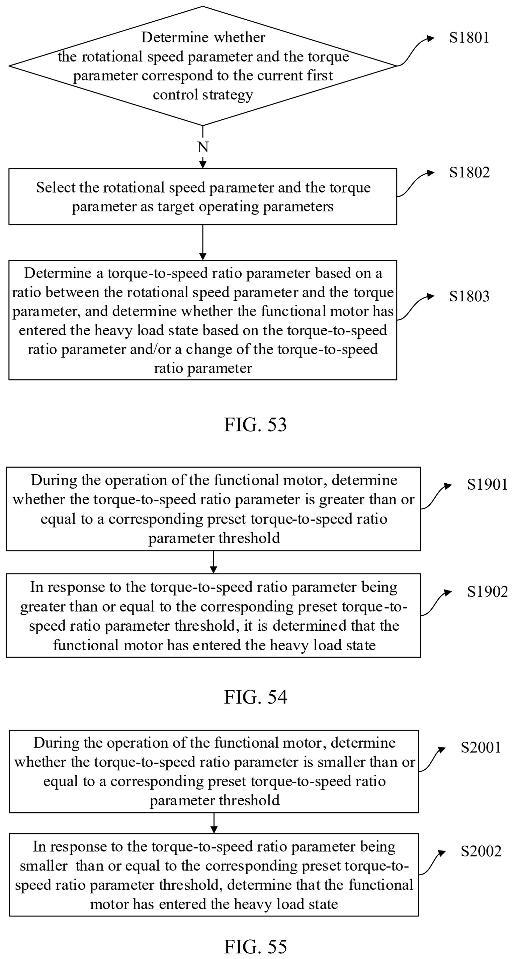

As shown in FIG. 53, in an electric work vehicle according to one or more embodiments of the present disclosure, the heavy load identification unit being configured to select a target operating parameter from the plurality of operating parameters, and determine whether the functional motor enters a heavy load state based on the target operating parameter and/or a change of the target operating parameter includes the heavy load identification unit being configured to perform following steps S1801 to S1803.

S1801: Determine whether the rotational speed parameter and the torque parameter correspond to the current first control strategy.

S1802: In response to the rotational speed parameter and the torque parameter not corresponding to the first control strategy, select the rotational speed parameter and the torque parameter as target operating parameters.

Selection of the target operating parameter is based on the current first control strategy. In response to the first control strategy being not a speed closed-loop control strategy and not a torque closed-loop control strategy, the heavy load identification unit 221 may select the rotational speed parameter and the torque parameter as the target operating parameters.

S1803: Determine a torque-to-speed ratio parameter based on a ratio between the rotational speed parameter and the torque parameter, and determine whether the functional motor enters the heavy load state based on the torque-to-speed ratio parameter and/or a change of the torque-to-speed ratio parameter.

The change of the torque-to-speed ratio parameter may include, for example, a difference obtained by comparing the ratio of the rotational speed parameter to the torque parameter acquired at different time instants, the rate of increase or decrease, etc.

In some embodiments, the torque-to-speed ratio parameter includes a torque-to-speed ratio, a torque-to-speed ratio difference, and a torque-to-speed ratio rate of change. The preset torque-to-speed ratio parameter thresholds corresponding to the torque-to-speed ratio, the torque-to-speed ratio difference, and the torque-to-speed ratio rate of change are a torque-to-speed ratio threshold, a torque-to-speed ratio difference threshold, and a torque-to-speed ratio rate-of-change threshold, respectively.

The torque-to-speed ratio refers to the ratio of the torque parameter to the rotational speed parameter. The torque parameter may include a motor torque, a motor torque difference, and a motor torque rate of change. The rotational speed parameter may include the motor speed parameter and the motor sector time parameter.

The torque-to-speed ratio difference refers to the difference in the torque-to-speed ratio between two adjacent moments.

The torque-to-speed ratio rate of change characterizes the change trend of the torque-to-speed ratio at corresponding moments. The torque-to-speed ratio rate of change may include a first-order derivative and a second-order derivative of the function of the torque-to-speed ratio over time. The change curve of the torque-to-speed ratio may be obtained by fitting torque-to-speed ratio values determined by sampling at a plurality of moments, and taking the slope of this change curve as the torque-to-speed ratio rate of change. The slope of this change curve is the first-order derivative of the torque-to-speed ratio. In another embodiment, the slope of the slope of the torque-to-speed ratio change curve may be used as the torque-to-speed ratio rate of change. The slope of the slope of the change curve is the second-order derivative of the torque-to-speed ratio.

In some embodiments, the ratio of the rotational speed parameter to the torque parameter is determined as the torque-to-speed ratio parameter. Those skilled in the art may understand that the ratio of the torque parameter to the rotational speed parameter may also be used as the torque-to-speed ratio parameter.

As shown in FIG. 54, in an electric work vehicle according to one or more embodiments of the present disclosure, for the case where the motor speed parameter is selected as the rotational speed parameter, the method for the heavy load identification unit 221 to determine whether the functional motor 211enters the heavy load state based on the torque-to-speed ratio parameter and/or the change of the torque-to-speed ratio parameter includes following steps S1901 to S1902.

At step S1901, during the operation of the functional motor, it is determined whether the torque-to-speed ratio parameter is greater than or equal to a corresponding preset torque-to-speed ratio parameter threshold.

At step S1902, in response to the torque-to-speed ratio parameter being greater than or equal to the corresponding preset torque-to-speed ratio parameter threshold, it is determined that the functional motor enters the heavy load state.

In some embodiments, the ratio of the rotational speed parameter to the torque parameter is determined as the torque-to-speed ratio parameter. Those skilled in the art may understand that the ratio of the torque parameter to the rotational speed parameter may also be used as the torque-to-speed ratio parameter.

The method for the heavy load identification unit 221 to determine whether the torque-to-speed ratio parameter is greater than or equal to the corresponding preset torque-to-speed ratio parameter threshold includes: acquiring at least one torque-to-speed ratio parameter and determining whether the at least one torque-to-speed ratio parameter is greater than or equal to the corresponding preset torque-to-speed ratio parameter threshold.

Taking the motor speed as the selected rotational speed parameter and the motor torque as the selected torque parameter as an example, the torque-to-speed ratio is determined based on the ratio of the motor speed and the motor torque. Here, when the ratio of the motor torque to the motor speed is used as the torque-to-speed ratio, and the torque-to-speed ratio is greater than or equal to the corresponding torque-to-speed ratio threshold, it may be determined that the functional motor 211 enters the heavy load state; when the ratio of the motor speed to the motor torque is used as the torque-to-speed ratio, and the torque-to-speed ratio is smaller than or equal to the corresponding torque-to-speed ratio threshold, it may be determined that the functional motor 211 enters the heavy load state.

In some embodiments, the heavy load identification unit 221 may acquire a plurality of torque-to-speed ratio parameters, compare the plurality of torque-to-speed ratio parameters with their respective preset torque-to-speed ratio parameter thresholds, and determine whether the plurality of torque-to-speed ratio parameters are greater than or equal to the corresponding preset torque-to-speed ratio parameter thresholds, respectively.

For example, the torque-to-speed ratio is compared with the corresponding preset torque-to-speed ratio threshold, and the torque-to-speed ratio difference is compared with the corresponding preset torque-to-speed ratio difference threshold. In response to the torque-to-speed ratio being greater than or equal to the preset torque-to-speed ratio threshold, and the torque-to-speed ratio difference being greater than or equal to the preset torque-to-speed ratio difference threshold, it is determined that the functional motor 211 enters the heavy load state.

For example, the torque-to-speed ratio, the torque-to-speed ratio difference, and the torque-to-speed ratio rate of change are compared with the corresponding preset torque-to-speed ratio threshold, preset torque-to-speed ratio difference threshold, and preset torque-to-speed ratio rate-of-change threshold, respectively. In response to all the three torque-to-speed ratio parameters being greater than or equal to their respective thresholds, then it may be determined that the functional motor 211 enters the heavy load state.

As shown in FIG. 55, in an electric work vehicle according to one or more embodiments of the present disclosure, for the case where the motor sector time parameter is selected as the rotational speed parameter, the method for the heavy load identification unit 221 to determine whether the functional motor 211 enters the heavy load state based on the torque-to-speed ratio parameter and/or the change of the torque-to-speed ratio parameter includes following steps S2001 to S2002.

At step S2001, during the operation of the functional motor, it is determined whether the torque-to-speed ratio parameter is smaller than or equal to a corresponding preset torque-to-speed ratio parameter threshold.

At step S2002, in response to the torque-to-speed ratio parameter being smaller than or equal to the corresponding preset torque-to-speed ratio parameter threshold, it is determined that the functional motor enters the heavy load state.

Correspondingly, the method for the heavy load identification unit 221 to determine whether the torque-to-speed ratio parameter is smaller than or equal to the corresponding preset torque-to-speed ratio parameter threshold includes: acquiring at least one torque-to-speed ratio parameter and determining whether the at least one torque-to-speed ratio parameter is smaller than or equal to the corresponding preset torque-to-speed ratio parameter threshold.

In some embodiments, taking the motor sector time as the selected rotational speed parameter and the motor torque as the selected torque parameter as an example, the torque-to-speed ratio is determined based on the ratio of the motor sector time and the motor torque.

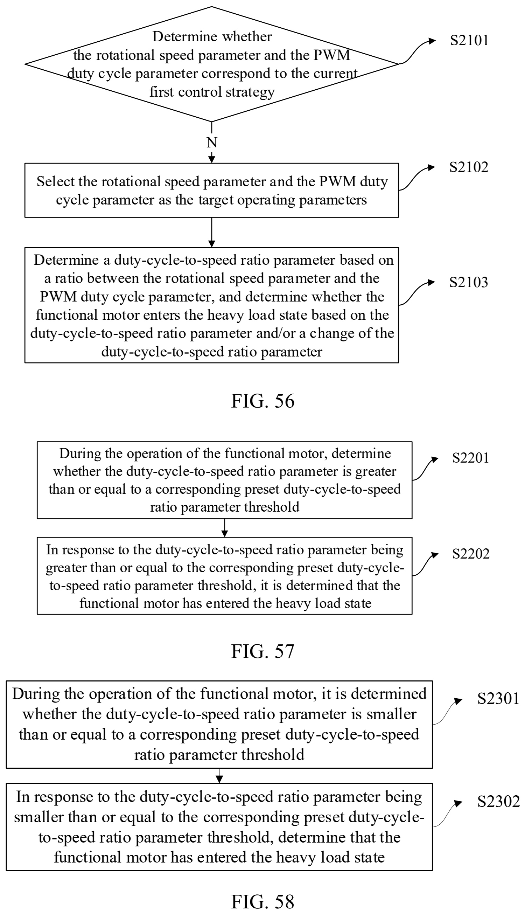

As shown in FIG. 56, in an electric work vehicle according to one or more embodiments of the present disclosure, the heavy load identification unit being configured to select a target operating parameter from the plurality of operating parameters, and determine whether the functional motor enters a heavy load state based on the target operating parameter and/or a change of the target operating parameter includes the heavy load identification unit being configured to perform following steps S2101 to S2103.

S2101: Determine whether the rotational speed parameter and the PWM duty cycle parameter correspond to the current first control strategy.

S2102: In response to the rotational speed parameter and the PWM duty cycle parameter not corresponding to the first control strategy, select the rotational speed parameter and the PWM duty cycle parameter as the target operating parameters.

Selection of the target operating parameters is based on the current first control strategy. In response to the first control strategy being not a rotational speed closed-loop control strategy and not a PWM duty cycle open-loop control strategy, the heavy load identification unit 221 may select the rotational speed parameter and the PWM duty cycle parameter as the target operating parameters.

S2103: Determine a duty-cycle-to-speed ratio parameter based on a ratio between the rotational speed parameter and the PWM duty cycle parameter, and determine whether the functional motor enters the heavy load state based on the duty-cycle-to-speed ratio parameter and/or a change of the duty-cycle-to-speed ratio parameter.

The change of the duty-cycle-to-speed ratio parameter may include, for example, the difference obtained by comparing the ratio of the rotational speed parameter to the PWM duty cycle parameter acquired at different time instants, the rate of increase or decrease, etc.

In some embodiments, the duty-cycle-to-speed ratio parameter includes a duty-cycle-to-speed ratio, a duty-cycle-to-speed ratio difference, and a duty-cycle-to-speed ratio rate of change. The preset duty-cycle-to-speed ratio parameter thresholds corresponding to the duty-cycle-to-speed ratio, the duty-cycle-to-speed ratio difference, and the duty-cycle-to-speed ratio rate of change are a duty-cycle-to-speed ratio threshold, a duty-cycle-to-speed ratio difference threshold, and a duty-cycle-to-speed ratio rate-of-change threshold, respectively.

The duty-cycle-to-speed ratio refers to the ratio of the PWM duty cycle parameter to the rotational speed parameter. The PWM duty cycle parameter may include the duty cycle, the duty cycle difference, and the duty cycle rate of change. The rotational speed parameter may include the motor speed parameter and the motor sector time parameter.

The duty-cycle-to-speed ratio difference refers to the difference in the duty-cycle-to-speed ratio between two adjacent moments.

The duty-cycle-to-speed ratio rate of change characterizes the change trend of the duty-cycle-to-speed ratio at corresponding moments. The duty-cycle-to-speed ratio rate of change may include a first-order derivative and a second-order derivative of the function of the duty-cycle-to-speed ratio over time. The change curve of the duty-cycle-to-speed ratio may be obtained by fitting duty-cycle-to-speed ratio values determined by sampling at a plurality of moments, and taking the slope of this change curve as the duty-cycle-to-speed ratio rate of change. The slope of this change curve is the first-order derivative of the duty-cycle-to-speed ratio. In another embodiment, the slope of the slope of the duty-cycle-to-speed ratio change curve may be used as the duty-cycle-to-speed ratio rate of change. The slope of the slope of the change curve is the second-order derivative of the duty-cycle-to-speed ratio.

In some embodiments, the ratio of the rotational speed parameter to the PWM duty cycle parameter is determined as the duty-cycle-to-speed ratio parameter. Those skilled in the art may understand that the ratio of the PWM duty cycle parameter to the rotational speed parameter may also be used as the duty-cycle-to-speed ratio parameter.

As shown in FIG. 57, in an electric work vehicle according to one or more embodiments of the present disclosure, for the case where the motor speed parameter is selected as the rotational speed parameter, the method for the heavy load identification unit 221 to determine whether the functional motor 211 enters the heavy load state based on the duty-cycle-to-speed ratio parameter and/or the change of the duty-cycle-to-speed ratio parameter includes following steps S2201 to S2202.

At step S2201, during operation of the functional motor, it is determined whether the duty-cycle-to-speed ratio parameter is greater than or equal to a corresponding preset duty-cycle-to-speed ratio parameter threshold.

At step S2202, in response to the duty-cycle-to-speed ratio parameter being greater than or equal to the corresponding preset duty-cycle-to-speed ratio parameter threshold, it is determined that the functional motor enters the heavy load state.

In some embodiments, the ratio of the rotational speed parameter to the PWM duty cycle parameter is determined as the duty-cycle-to-speed ratio parameter. Those skilled in the art may understand that the ratio of the PWM duty cycle parameter to the rotational speed parameter may also be used as the duty-cycle-to-speed ratio parameter.

The method for the heavy load identification unit 221 to determine whether the duty-cycle-to-speed ratio parameter is greater than or equal to the corresponding preset duty-cycle-to-speed ratio parameter threshold includes: acquiring at least one duty-cycle-to-speed ratio parameter and determining whether the at least one duty-cycle-to-speed ratio parameter is greater than or equal to the corresponding preset duty-cycle-to-speed ratio parameter threshold.

Taking the motor speed as the selected rotational speed parameter and the duty cycle as the selected PWM duty cycle parameter as an example, the duty-cycle-to-speed ratio is determined based on the ratio of the motor speed and the duty cycle. Here, when the ratio of the duty cycle to the motor speed is used as the duty-cycle-to-speed ratio, and the duty-cycle-to-speed ratio is greater than or equal to the corresponding duty-cycle-to-speed ratio threshold, it may be determined that the functional motor 211 enters the heavy load state; when the ratio of the motor speed to the duty cycle is used as the duty-cycle-to-speed ratio, and the duty-cycle-to-speed ratio is smaller than or equal to the corresponding duty-cycle-to-speed ratio threshold, it may be determined that the functional motor 211 enters the heavy load state.

In some embodiments, the heavy load identification unit 221 may acquire a plurality of duty-cycle-to-speed ratio parameters, compare the plurality of duty-cycle-to-speed ratio parameters with their respective preset duty-cycle-to-speed ratio parameter thresholds, and determine whether the plurality of duty-cycle-to-speed ratio parameters are greater than or equal to the corresponding preset duty-cycle-to-speed ratio parameter thresholds, respectively.

For example, the duty-cycle-to-speed ratio is compared with the corresponding preset duty-cycle-to-speed ratio threshold, and the duty-cycle-to-speed ratio difference is compared with the corresponding preset duty-cycle-to-speed ratio difference threshold. If the duty-cycle-to-speed ratio is greater than or equal to the preset duty-cycle-to-speed ratio threshold, and the duty-cycle-to-speed ratio difference is greater than or equal to the preset duty-cycle-to-speed ratio difference threshold, it is determined that the functional motor 211 enters the heavy load state.

For example, the duty-cycle-to-speed ratio, the duty-cycle-to-speed ratio difference, and the duty-cycle-to-speed ratio rate of change are compared with the corresponding preset duty-cycle-to-speed ratio threshold, preset duty-cycle-to-speed ratio difference threshold, and preset duty-cycle-to-speed ratio rate-of-change threshold, respectively. In response to all the three duty-cycle-to-speed ratio parameters being greater than or equal to their respective thresholds, then it may be determined that the functional motor 211 enters the heavy load state.

As shown in FIG. 58, in an electric work vehicle according to one or more embodiments of the present disclosure, for the case where the motor sector time parameter is selected as the rotational speed parameter, the method for the heavy load identification unit 221 to determine whether the functional motor 211 enters the heavy load state based on the duty-cycle-to-speed ratio parameter and/or the change of the duty-cycle-to-speed ratio parameter includes following steps S2301 to S2302.

At step S2301, during operation of the functional motor, it is determined whether the duty-cycle-to-speed ratio parameter is smaller than or equal to a corresponding preset duty-cycle-to-speed ratio parameter threshold.

At step S2302, in response to the duty-cycle-to-speed ratio parameter being smaller than or equal to the corresponding preset duty-cycle-to-speed ratio parameter threshold, it is determined that the functional motor enters the heavy load state.

Correspondingly, the method for the heavy load identification unit 221 to determine whether the duty-cycle-to-speed ratio parameter is smaller than or equal to the corresponding preset duty-cycle-to-speed ratio parameter threshold includes: acquiring at least one duty-cycle-to-speed ratio parameter and determining whether the at least one duty-cycle-to-speed ratio parameter is smaller than or equal to the corresponding preset duty-cycle-to-speed ratio parameter threshold.

In some embodiments, taking the motor sector time as the selected rotational speed parameter and the duty cycle as the selected PWM duty cycle parameter as an example, the duty-cycle-to-speed ratio is determined based on the ratio of the motor sector time and the duty cycle.

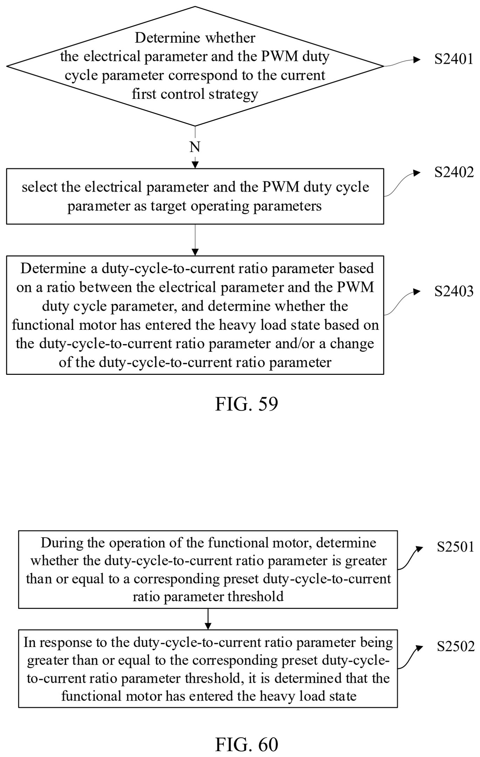

As shown in FIG. 59, in an electric work vehicle according to one or more embodiments of the present disclosure, the heavy load identification unit being configured to select a target operating parameter from the plurality of operating parameters, and determine whether the functional motor enters a heavy load state based on the target operating parameter and/or a change of the target operating parameter includes the heavy load identification unit being configured to perform following steps S2401 to S2403.

S2401: Determine whether the electrical parameter and the PWM duty cycle parameter correspond to the current first control strategy.

S2402: In response to the electrical parameter and the PWM duty cycle parameter not corresponding to the first control strategy, select the electrical parameter and the PWM duty cycle parameter as target operating parameters.

Selection of the target operating parameters is based on the current first control strategy. In response to the first control strategy being not a current closed-loop control strategy and not a PWM duty cycle open-loop control strategy, the heavy load identification unit 221 may select the electrical parameter and the PWM duty cycle parameter as the target operating parameters.

S2403: Determine a duty-cycle-to-current ratio parameter based on a ratio between the electrical parameter and the PWM duty cycle parameter, and determine whether the functional motor enters the heavy load state based on the duty-cycle-to-current ratio parameter and/or a change of the duty-cycle-to-current ratio parameter.

The change of the duty-cycle-to-current ratio parameter may include, for example, a difference obtained by comparing the ratio of the electrical parameter to the PWM duty cycle parameter acquired at different time instants, the rate of increase or decrease, etc.

In some embodiments, the duty-cycle-to-current ratio parameter includes a duty-cycle-to-current ratio, a duty-cycle-to-current ratio difference, and a duty-cycle-to-current ratio rate of change. The preset duty-cycle-to-current ratio parameter thresholds corresponding to the duty-cycle-to-current ratio, the duty-cycle-to-current ratio difference, and the duty-cycle-to-current ratio rate of change are a duty-cycle-to-current ratio threshold, a duty-cycle-to-current ratio difference threshold, and a duty-cycle-to-current ratio rate-of-change threshold, respectively.

The duty-cycle-to-current ratio refers to the ratio of the PWM duty cycle parameter to the electrical parameter. The PWM duty cycle parameter may include the duty cycle, the duty cycle difference, and the duty cycle rate of change. The electrical parameter may include the bus current parameter, the phase current parameter, the bus voltage parameter, the conducting phase voltage parameter, and the freewheeling time parameter.

The duty-cycle-to-current ratio difference refers to the difference in the duty-cycle-to-current ratio between two adjacent moments.

The duty-cycle-to-current ratio rate of change characterizes the change trend of the duty-cycle-to-current ratio at corresponding moments. The duty-cycle-to-current ratio rate of change may include a first-order derivative and a second-order derivative of the function of the duty-cycle-to-current ratio over time. The change curve of the duty-cycle-to-current ratio may be obtained by fitting duty-cycle-to-current ratio values determined by sampling at a plurality of moments, and taking the slope of this change curve as the duty-cycle-to-current ratio rate of change. The slope of this change curve is the first-order derivative of the duty-cycle-to-current ratio. In another embodiment, the slope of the slope of the duty-cycle-to-current ratio change curve may be used as the duty-cycle-to-current ratio rate of change. The slope of the slope of the change curve is the second-order derivative of the duty-cycle-to-current ratio.

In some embodiments, the ratio of the electrical parameter to the PWM duty cycle parameter is determined as the duty-cycle-to-current ratio parameter. Those skilled in the art may understand that the ratio of the PWM duty cycle parameter to the electrical parameter may also be used as the duty-cycle-to-current ratio parameter.

As shown in FIG. 60, in an electric work vehicle according to one or more embodiments of the present disclosure, the method for the heavy load identification unit 221 to determine whether the functional motor 211 enters the heavy load state based on the duty-cycle-to-current ratio parameter and/or the change of the duty-cycle-to-current ratio parameter includes following steps S2501 to S2502.

At step S2501, during the operation of the functional motor, it is determined whether the duty-cycle-to-current ratio parameter is greater than or equal to a corresponding preset duty-cycle-to-current ratio parameter threshold.

At step S2502, in response to the duty-cycle-to-current ratio parameter being greater than or equal to the corresponding preset duty-cycle-to-current ratio parameter threshold, it is determined that the functional motor enters the heavy load state.

In some embodiments, the ratio of the PWM duty cycle parameter to the electrical parameter is determined as the duty-cycle-to-current ratio parameter. Those skilled in the art may understand that the ratio of the electrical parameter to the PWM duty cycle parameter may also be used as the duty-cycle-to-current ratio parameter.

The method for the heavy load identification unit 221 to determine whether the duty-cycle-to-current ratio parameter is greater than or equal to the corresponding preset duty-cycle-to-current ratio parameter threshold includes: acquiring at least one duty-cycle-to-current ratio parameter and determining whether the at least one duty-cycle-to-current ratio parameter is greater than or equal to the corresponding preset duty-cycle-to-current ratio parameter threshold.

Taking the bus current as the selected electrical parameter and the duty cycle as the selected PWM duty cycle parameter as an example, the duty-cycle-to-current ratio is determined based on the ratio of the bus current and the duty cycle. Here, when the ratio of the duty cycle to the bus current is used as the duty-cycle-to-current ratio, and the duty-cycle-to-current ratio is greater than or equal to the corresponding duty-cycle-to-current ratio threshold, it may be determined that the functional motor 211 enters the heavy load state; when the ratio of the bus current to the duty cycle is used as the duty-cycle-to-current ratio, and the duty-cycle-to-current ratio is smaller than or equal to the corresponding duty-cycle-to-current ratio threshold, it may be determined that the functional motor 211 enters the heavy load state.

In some embodiments, the heavy load identification unit 221 may acquire a plurality of duty-cycle-to-current ratio parameters, compare the plurality of duty-cycle-to-current ratio parameters with their respective preset duty-cycle-to-current ratio parameter thresholds, and determine whether the plurality of duty-cycle-to-current ratio parameters are greater than or equal to the corresponding preset duty-cycle-to-current ratio parameter thresholds, respectively.

For example, the duty-cycle-to-current ratio is compared with the corresponding preset duty-cycle-to-current ratio threshold, and the duty-cycle-to-current ratio difference is compared with the corresponding preset duty-cycle-to-current ratio difference threshold. If the duty-cycle-to-current ratio is greater than or equal to the preset duty-cycle-to-current ratio threshold, and the duty-cycle-to-current ratio difference is greater than or equal to the preset duty-cycle-to-current ratio difference threshold, it is determined that the functional motor 211 enters the heavy load state.

For example, the duty-cycle-to-current ratio, the duty-cycle-to-current ratio difference, and the duty-cycle-to-current ratio rate of change are compared with the corresponding preset duty-cycle-to-current ratio threshold, preset duty-cycle-to-current ratio difference threshold, and preset duty-cycle-to-current ratio rate-of-change threshold, respectively. In response to all the three duty-cycle-to-current ratio parameters being greater than or equal to their respective thresholds, it may be determined that the functional motor 211 enters the heavy load state.

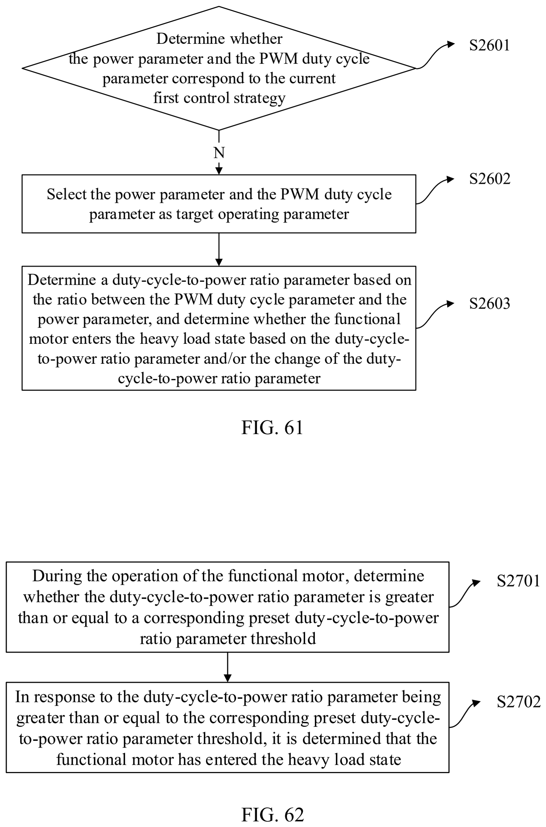

As shown in FIG. 61, in an electric work vehicle according to one or more embodiments of the present disclosure, the heavy load identification unit being configured to select a target operating parameter from the plurality of operating parameters, and determine whether the functional motor enters a heavy load state based on the target operating parameter and/or a change of the target operating parameter includes the heavy load identification unit being configured to perform following steps S2601 to S2603.

S2601: Determine whether the power parameter and the PWM duty cycle parameter correspond to the current first control strategy.

S2602: In response to the power parameter and the PWM duty cycle parameter not corresponding to the first control strategy, select the power parameter and the PWM duty cycle parameter as target operating parameter.

Selection of the target operating parameters is based on the current first control strategy. In response to the first control strategy being not a current closed-loop control strategy and not a PWM duty cycle open-loop control strategy, the heavy load identification unit 221 may select the power parameter and the PWM duty cycle parameter as the target operating parameters.

S2603: Determine a duty-cycle-to-power ratio parameter based on the ratio between the PWM duty cycle parameter and the power parameter, and determine whether the functional motor enters the heavy load state based on the duty-cycle-to-power ratio parameter and/or the change of the duty-cycle-to-power ratio parameter.

The change of the duty-cycle-to-power ratio parameter may include, for example, a difference obtained by comparing the ratio of the PWM duty cycle parameter to the power parameter acquired at different time instants, the rate of increase or decrease, etc.

In some embodiments, the duty-cycle-to-power ratio parameter includes a duty-cycle-to-power ratio, a duty-cycle-to-power ratio difference, and a duty-cycle-to-power ratio rate of change. The preset duty-cycle-to-power ratio parameter thresholds corresponding to the duty-cycle-to-power ratio, the duty-cycle-to-power ratio difference, and the duty-cycle-to-power ratio rate of change are a duty-cycle-to-power ratio threshold, a duty-cycle-to-power ratio difference threshold, and a duty-cycle-to-power ratio rate-of-change threshold, respectively.

The duty-cycle-to-power ratio refers to the ratio of the PWM duty cycle parameter to the power parameter. The PWM duty cycle parameter may include the duty cycle, the duty cycle difference, and the duty cycle rate of change. The power parameter may include the motor power, the motor power difference, and the motor power rate of change.

The duty-cycle-to-power ratio difference refers to the difference in the duty-cycle-to-power ratio between two adjacent moments.

The duty-cycle-to-power ratio rate of change characterizes the change trend of the duty-cycle-to-power ratio at corresponding moments. The duty-cycle-to-power ratio rate of change may include a first-order derivative and a second-order derivative of the function of the duty-cycle-to-power ratio over time. The change curve of the duty-cycle-to-power ratio may be obtained by fitting duty-cycle-to-power ratio values determined by sampling at a plurality of moments, and taking the slope of this change curve as the duty-cycle-to-power ratio rate of change. The slope of this change curve is the first-order derivative of the duty-cycle-to-power ratio. In another embodiment, the slope of the slope of the duty-cycle-to-power ratio change curve may be used as the duty-cycle-to-power ratio rate of change. The slope of the slope of the change curve is the second-order derivative of the duty-cycle-to-power ratio.

In some embodiments, the ratio of the power parameter to the PWM duty cycle parameter is determined as the duty-cycle-to-power ratio parameter. Those skilled in the art may understand that the ratio of the PWM duty cycle parameter to the power parameter may also be used as the duty-cycle-to-power ratio parameter.

As shown in FIG. 62, in an electric work vehicle according to one or more embodiments of the present disclosure, the method for the heavy load identification unit 221 to determine whether the functional motor 211 enters the heavy load state based on the duty-cycle-to-power ratio parameter and/or the change of the duty-cycle-to-power ratio parameter includes following steps S2701 to S2702.

At step S2701, during the operation of the functional motor, it is determined whether the duty-cycle-to-power ratio parameter is greater than or equal to a corresponding preset duty-cycle-to-power ratio parameter threshold.

At step S2702, in response to the duty-cycle-to-power ratio parameter being greater than or equal to the corresponding preset duty-cycle-to-power ratio parameter threshold, it is determined that the functional motor enters the heavy load state.

In some embodiments, the ratio of the PWM duty cycle parameter to the power parameter is determined as the duty-cycle-to-power ratio parameter. Those skilled in the art may understand that the ratio of the power parameter to the PWM duty cycle parameter may also be used as the duty-cycle-to-power ratio parameter.

The method for the heavy load identification unit 221 to determine whether the duty-cycle-to-power ratio parameter is greater than or equal to the corresponding preset duty-cycle-to-power ratio parameter threshold includes: acquiring at least one duty-cycle-to-power ratio parameter and determining whether the at least one duty-cycle-to-power ratio parameter is greater than or equal to the corresponding preset duty-cycle-to-power ratio parameter threshold.

Taking the motor power as the selected power parameter and the duty cycle as the selected PWM duty cycle parameter as an example, the duty-cycle-to-power ratio is determined based on the ratio of the motor power and the duty cycle. Here, when the ratio of the duty cycle to the motor power is used as the duty-cycle-to-power ratio, and the duty-cycle-to-power ratio is greater than or equal to the corresponding duty-cycle-to-power ratio threshold, it may be determined that the functional motor 211 enters the heavy load state; when the ratio of the motor power to the duty cycle is used as the duty-cycle-to-power ratio, and the duty-cycle-to-power ratio is smaller than or equal to the corresponding duty-cycle-to-power ratio threshold, it may be determined that the functional motor 211 enters the heavy load state.

In some embodiments, the heavy load identification unit 221 may acquire a plurality of duty-cycle-to-power ratio parameters, compare the plurality of duty-cycle-to-power ratio parameters with their respective preset duty-cycle-to-power ratio parameter thresholds, and determine whether the plurality of duty-cycle-to-power ratio parameters are greater than or equal to the corresponding preset duty-cycle-to-power ratio parameter thresholds, respectively.

For example, the duty-cycle-to-power ratio is compared with the corresponding preset duty-cycle-to-power ratio threshold, and the duty-cycle-to-power ratio difference is compared with the corresponding preset duty-cycle-to-power ratio difference threshold. In response to the duty-cycle-to-power ratio being greater than or equal to the preset duty-cycle-to-power ratio threshold, and the duty-cycle-to-power ratio difference being greater than or equal to the preset duty-cycle-to-power ratio difference threshold, it is determined that the functional motor 211 enters the heavy load state.

For example, the duty-cycle-to-power ratio, the duty-cycle-to-power ratio difference, and the duty-cycle-to-power ratio rate of change are compared with the corresponding preset duty-cycle-to-power ratio threshold, preset duty-cycle-to-power ratio difference threshold, and preset duty-cycle-to-power ratio rate-of-change threshold, respectively. In response to all the three duty-cycle-to-power ratio parameters are greater than or equal to their respective thresholds, then it may be determined that the functional motor 211 enters the heavy load state.

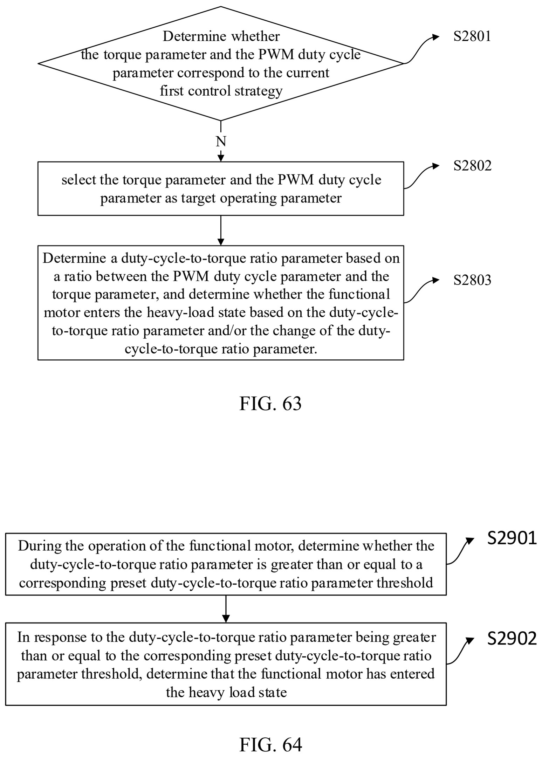

As shown in FIG. 63, in an electric work vehicle provided by one or more embodiments of the present disclosure, the heavy load identification unit being configured to select a target operating parameter from the plurality of operating parameters, and determine whether the functional motor enters a heavy load state based on the target operating parameter and/or a change of the target operating parameter includes the heavy load identification unit being configured to perform following steps S2801 to S2803.

S2801: Determine whether the torque parameter and the PWM duty cycle parameter correspond to the current first control strategy.

S2802: In response to the torque parameter and the PWM duty cycle parameter not corresponding to the first control strategy, select the torque parameter and the PWM duty cycle parameter as target operating parameter.

Selection of the target operating parameters is based on the current first control strategy. In response to the first control strategy being not a current closed-loop control strategy and not a PWM duty cycle open-loop control strategy, the heavy load identification unit 221 may select the torque parameter and the PWM duty cycle parameter as the target operating parameters.

S2803: Determine a duty-cycle-to-torque ratio parameter based on a ratio between the PWM duty cycle parameter and the torque parameter, and determine whether the functional motor enters the heavy load state based on the duty-cycle-to-torque ratio parameter and/or the change of the duty-cycle-to-torque ratio parameter.

The change of the duty-cycle-to-torque ratio parameter may include, for example, a difference obtained by comparing the ratio of the PWM duty cycle parameter to the torque parameter acquired at different time instants, the rate of increase or decrease, etc.

In some embodiments, the duty-cycle-to-torque ratio parameter includes a duty-cycle-to-torque ratio, a duty-cycle-to-torque ratio difference, and a duty-cycle-to-torque ratio rate of change. The preset duty-cycle-to-torque ratio parameter thresholds corresponding to the duty-cycle-to-torque ratio, the duty-cycle-to-torque ratio difference, and the duty-cycle-to-torque ratio rate of change are a duty-cycle-to-torque ratio threshold, a duty-cycle-to-torque ratio difference threshold, and a duty-cycle-to-torque ratio rate-of-change threshold, respectively.

The duty-cycle-to-torque ratio refers to the ratio of the PWM duty cycle parameter to the torque parameter. The PWM duty cycle parameter may include the duty cycle, the duty cycle difference, and the duty cycle rate of change. The torque parameter may include the motor torque, the motor torque difference, and the motor torque rate of change.

The duty-cycle-to-torque ratio difference refers to the difference in the duty-cycle-to-torque ratio between two adjacent moments.

The duty-cycle-to-torque ratio rate of change characterizes the change trend of the duty-cycle-to-torque ratio at corresponding moments. The duty-cycle-to-torque ratio rate of change may include a first-order derivative and a second-order derivative of the function of the duty-cycle-to-torque ratio over time. The change curve of the duty-cycle-to-torque ratio may be obtained by fitting duty-cycle-to-torque ratio values determined by sampling at a plurality of moments, and taking the slope of this change curve as the duty-cycle-to-torque ratio rate of change. The slope of this change curve is the first-order derivative of the duty-cycle-to-torque ratio. In another embodiment, the slope of the slope of the duty-cycle-to-torque ratio change curve may be used as the duty-cycle-to-torque ratio rate of change. The slope of the slope of the change curve is the second-order derivative of the duty-cycle-to-torque ratio.

In some embodiments, the ratio of the torque parameter to the PWM duty cycle parameter is determined as the duty-cycle-to-torque ratio parameter. Those skilled in the art may understand that the ratio of the PWM duty cycle parameter to the torque parameter may also be used as the duty-cycle-to-torque ratio parameter.

As shown in FIG. 64, in an electric work vehicle provided by one or more embodiments of the present disclosure, the method for the heavy load identification unit 221 to determine whether the functional motor 211 enters the heavy load state based on the duty-cycle-to-torque ratio parameter and/or the change of the duty-cycle-to-torque ratio parameter includes following steps S2901 to S2902.

At step S2901, during the operation of the functional motor, it is determined whether the duty-cycle-to-torque ratio parameter is greater than or equal to a corresponding preset duty-cycle-to-torque ratio parameter threshold.

At step S2902, in response to the duty-cycle-to-torque ratio parameter being greater than or equal to the corresponding preset duty-cycle-to-torque ratio parameter threshold, it is determined that the functional motor enters the heavy load state.

In some embodiments, the ratio of the PWM duty cycle parameter to the torque parameter is determined as the duty-cycle-to-torque ratio parameter. Those skilled in the art may understand that the ratio of the torque parameter to the PWM duty cycle parameter may also be used as the duty-cycle-to-torque ratio parameter.

The method for the heavy load identification unit 221 to determine whether the duty-cycle-to-torque ratio parameter is greater than or equal to the corresponding preset duty-cycle-to-torque ratio parameter threshold includes: acquiring at least one duty-cycle-to-torque ratio parameter and determining whether the at least one duty-cycle-to-torque ratio parameter is greater than or equal to the corresponding preset duty-cycle-to-torque ratio parameter threshold.

Taking the motor torque as the selected torque parameter and the duty cycle as the selected PWM duty cycle parameter as an example, the duty-cycle-to-torque ratio is determined based on the ratio of the motor torque and the duty cycle. Here, when the ratio of the duty cycle to the motor torque is used as the duty-cycle-to-torque ratio, and the duty-cycle-to-torque ratio is greater than or equal to the corresponding duty-cycle-to-torque ratio threshold, it may be determined that the functional motor 211 enters the heavy load state; when the ratio of the motor torque to the duty cycle is used as the duty-cycle-to-torque ratio, and the duty-cycle-to-torque ratio is smaller than or equal to the corresponding duty-cycle-to-torque ratio threshold, it may be determined that the functional motor 211 enters the heavy load state.

In some embodiments, the heavy load identification unit 221 may acquire a plurality of duty-cycle-to-torque ratio parameters, compare the plurality of duty-cycle-to-torque ratio parameters with their respective preset duty-cycle-to-torque ratio parameter thresholds, and determine whether the plurality of duty-cycle-to-torque ratio parameters are greater than or equal to their corresponding preset duty-cycle-to-torque ratio parameter thresholds, respectively.

For example, the duty-cycle-to-torque ratio is compared with the corresponding preset duty-cycle-to-torque ratio threshold, and the duty-cycle-to-torque ratio difference is compared with the corresponding preset duty-cycle-to-torque ratio difference threshold. In response to the duty-cycle-to-torque ratio being greater than or equal to the preset duty-cycle-to-torque ratio threshold, and the duty-cycle-to-torque ratio difference being greater than or equal to the preset duty-cycle-to-torque ratio difference threshold, it is determined that the functional motor 211 enters the heavy load state.

For example, the duty-cycle-to-torque ratio, the duty-cycle-to-torque ratio difference, and the duty-cycle-to-torque ratio rate of change are compared with the corresponding preset duty-cycle-to-torque ratio threshold, preset duty-cycle-to-torque ratio difference threshold, and preset duty-cycle-to-torque ratio rate-of-change threshold, respectively. If all the three duty-cycle-to-torque ratio parameters are greater than or equal to their respective thresholds, then it may be determined that the functional motor 211 enters the heavy load state.

In the electric work vehicle, after the heavy load identification unit 221 in the controller assembly 22 identifies and determines that the functional motor 211 enters the heavy load state, the heavy load control unit 222 performs responsive control, selecting a second control strategy to adjust the operating state related to the functional motor 211 to cause the functional motor to exit the heavy load state, thereby avoiding potential impacts of an excessive load on the functional motor 211.

In an electric work vehicle according to one or more embodiments of the present disclosure, the heavy load control unit being configured to control, based on the second control strategy, the functional motor includes:

the heavy load control unit being configured to control, in response to the second control strategy being the same as the first control strategy, the operating parameter corresponding to the second control strategy to decrease to a target value, the target value being smaller than a value of the operating parameter corresponding to the second control strategy under a normal operating state of the functional motor.

In an electric work vehicle according to one or more embodiments of the present disclosure, the heavy load control unit being configured to select a second control strategy from the plurality of control strategies and control, based on the second control strategy, the functional motor includes:

the heavy load control unit being configured to control, in response to the second control strategy being different from the first control strategy, the operating parameter corresponding to the second control strategy to decrease to a target value, the target value being smaller than or equal to an upper limit threshold of the operating parameter corresponding to the second control strategy under the normal operating state of the functional motor.

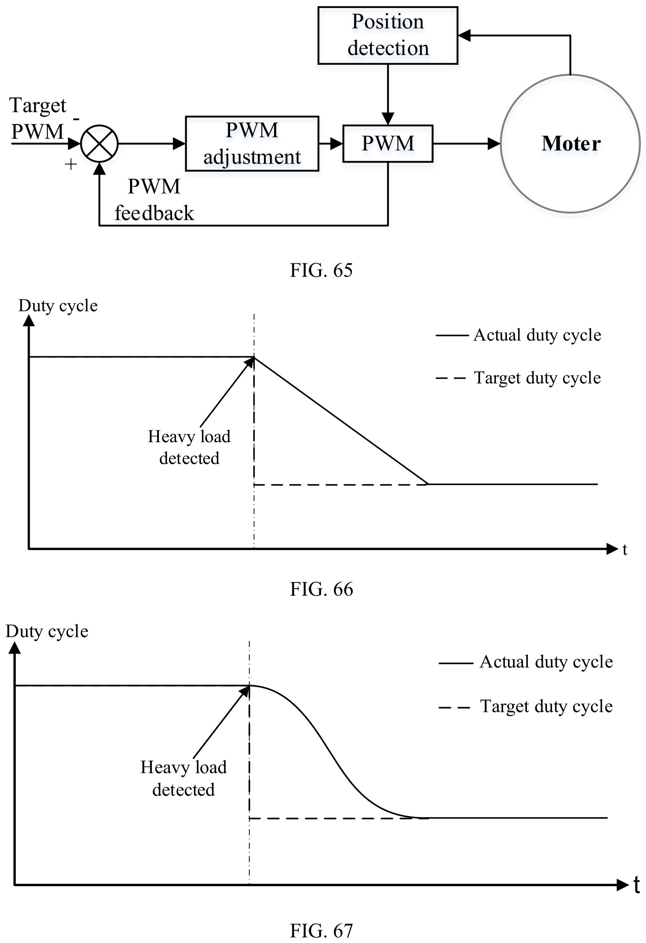

The first control strategy being the PWM duty cycle open-loop control strategy is described as an example. FIG. 65 is a block diagram of the PWM duty cycle open-loop control logic. When the heavy load control unit 222 also selects the PWM duty cycle open-loop control strategy as the second control strategy, assuming the duty cycle set for normal operation of the functional motor 211 is d0, in response to the heavy load identification unit 221 identifying entry into the heavy load state, the heavy load control unit 222 sets the target duty cycle to d1, and d1 < d0.

When reducing the control duty cycle, a linear decrease method or a curved decrease method may be used. FIG. 66 and FIG. 67 are schematic diagrams of duty cycle changes using the linear decrease method and the curved decrease method, respectively, under the control of the heavy load control unit 222.

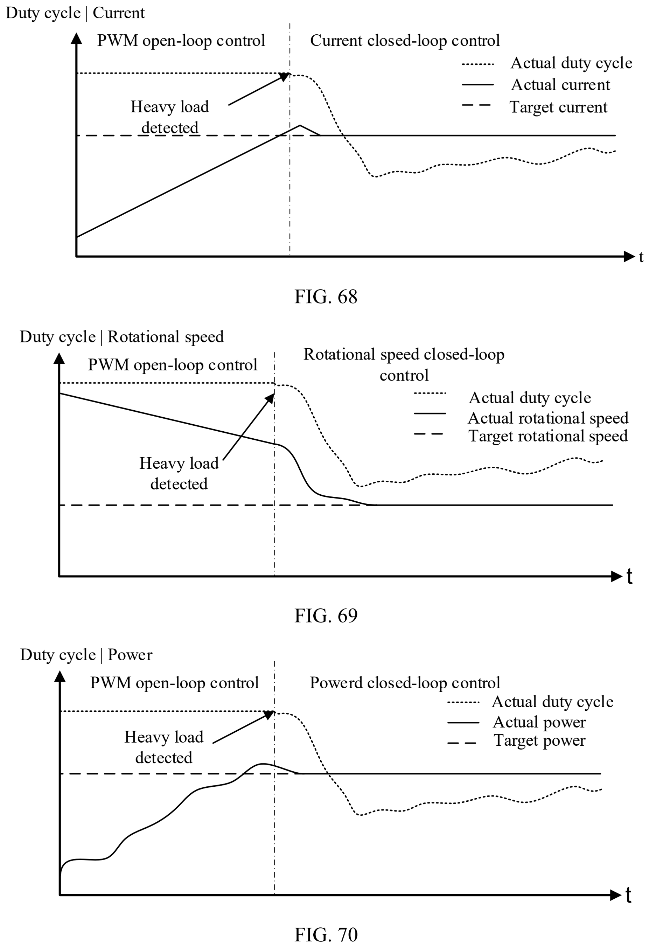

When the heavy load control unit 222 selects a current-speed control strategy as the second control strategy, under this current closed-loop control strategy, the heavy load control unit 222 may reduce the bus current of the functional motor 211 to a target value and maintain it. The target value is less than or equal to the upper limit threshold of the bus current under the normal operating state of the functional motor 211. FIG. 68 is a schematic diagram of bus current change when switching from the PWM duty cycle open-loop control strategy to the current closed-loop control strategy.

When the heavy load control unit 222 selects a speed closed-loop control strategy as the second control strategy, under this speed closed-loop control strategy, the heavy load control unit 222 may reduce the motor speed of the functional motor 211 to a target value and maintain it. This target value is less than or equal to the upper limit threshold of the motor speed under the normal operating state of the functional motor 211. FIG. 69 is a schematic diagram of motor speed change when switching from the PWM duty cycle open-loop control strategy to the rotational speed closed-loop control strategy.

When the heavy load control unit 222 selects a power closed-loop control strategy as the second control strategy, under this power closed-loop control strategy, the heavy load control unit 222 may reduce the motor power of the functional motor 211 to a target value and maintain it. This target value is less than or equal to the upper limit threshold of the motor power under the normal operating state of the functional motor 211. FIG. 70 is a schematic diagram of motor power change when switching from the PWM duty cycle open-loop control strategy to the power closed-loop control strategy.

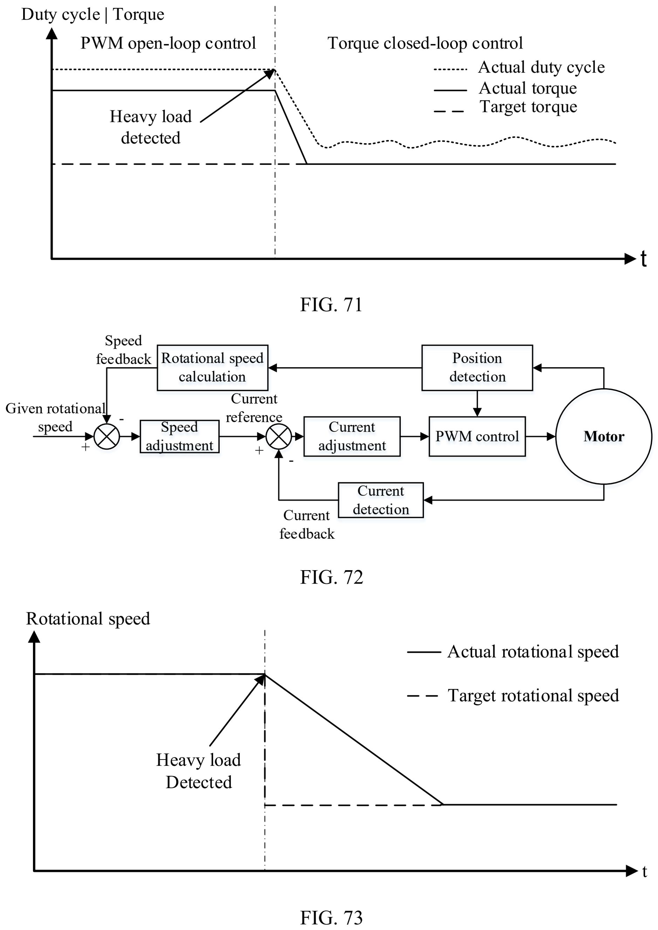

When the heavy load control unit 222 selects a torque closed-loop control strategy as the second control strategy, under this torque closed-loop control strategy, the heavy load control unit 222 may reduce the motor torque of the functional motor 211 to a target value and maintain it. This target value is less than or equal to the upper limit threshold of the motor torque under the normal operating state of the functional motor 211. FIG. 71 is a schematic diagram of motor torque change when switching from the PWM duty cycle open-loop control strategy to the torque closed-loop control strategy.

The first control strategy being a speed closed-loop control strategy is described as an example. FIG. 72 is a block diagram of the rotational speed closed-loop control logic. When the heavy load control unit 222 also selects the rotational speed closed-loop control strategy as the second control strategy, assuming the rotational speed set for normal operation of the functional motor 211 is N₀, in response to the heavy load identification unit 221 identifying entry into the heavy load state, the heavy load control unit 222 sets the target speed to N₁, and N₁ < N₀.

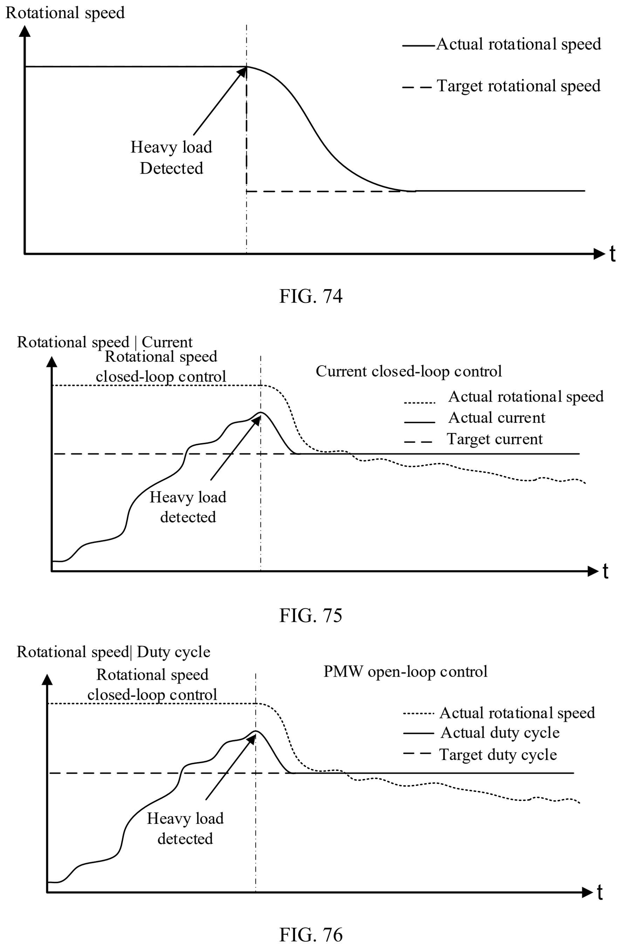

When reducing the motor speed, a linear decrease method or a curved decrease method may be used. FIG. 73 and FIG. 74 are schematic diagrams of motor speed changes using the linear decrease method and the curved decrease method, respectively, under the control of the heavy load control unit 222.

When the heavy load control unit 222 selects a current closed-loop control strategy as the second control strategy, under this current closed-loop control strategy, the heavy load control unit 222 may reduce the bus current of the functional motor 211 to a target value and maintain it. This target value is smaller than or equal to the upper limit threshold of the bus current under the normal operating state of the functional motor 211. FIG. 75 is a schematic diagram of bus current change when switching from the rotational speed closed-loop control strategy to the current closed-loop control strategy.

When the heavy load control unit 222 selects a PWM duty cycle open-loop control strategy as the second control strategy, under this PWM duty cycle open-loop control strategy, the heavy load control unit 222 may reduce the duty cycle of the functional motor 211 to a target value and maintain it. This target value is smaller than or equal to the upper limit threshold of the duty cycle under the normal operating state of the functional motor 211. FIG. 76 is a schematic diagram of duty cycle change when switching from the rotational speed closed-loop control strategy to the PWM duty cycle open-loop control strategy.

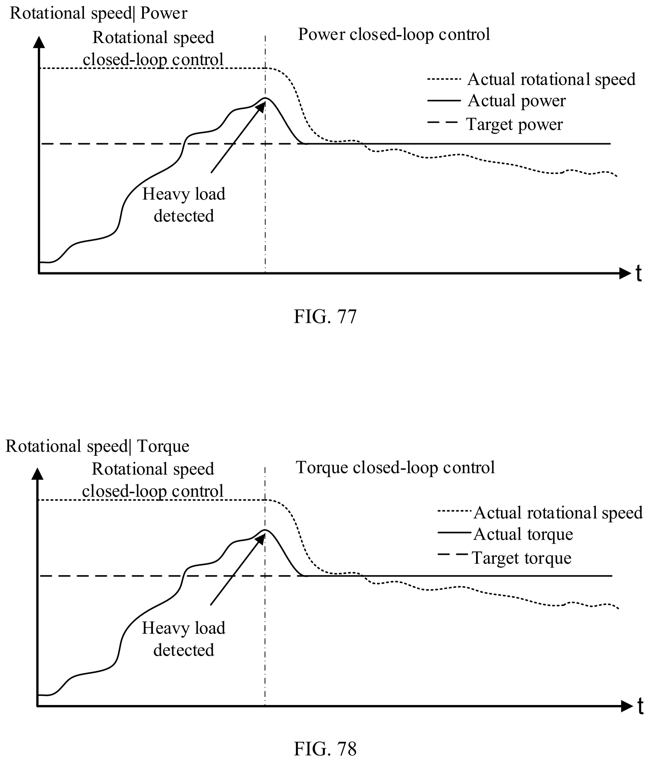

When the heavy load control unit 222 selects a power closed-loop control strategy as the second control strategy, under this power closed-loop control strategy, the heavy load control unit 222 may reduce the motor power of the functional motor 211 to a target value and maintain it. This target value is smaller than or equal to the upper limit threshold of the motor power under the normal operating state of the functional motor 211. FIG. 77 is a schematic diagram of motor power change when switching from the rotational speed closed-loop control strategy to the power closed-loop control strategy.

When the heavy load control unit 222 selects a torque closed-loop control strategy as the second control strategy, under this torque closed-loop control strategy, the heavy load control unit 222 may reduce the motor torque of the functional motor 211 to a target value and maintain it. This target value is smaller than or equal to the upper limit threshold of the motor torque under the normal operating state of the functional motor 211. FIG. 78 is a schematic diagram of motor torque change when switching from the rotational speed closed-loop control strategy to the torque closed-loop control strategy.

Similar to the above embodiments, the first control strategy being a current closed-loop control strategy is described as an example. When the heavy load control unit 222 also selects the current closed-loop control strategy as the second control strategy, assuming the current set for normal operation of the functional motor 211 is I₀, in response to the heavy load identification unit 221 identifying entry into the heavy load state, the heavy load control unit 222 sets the target current to I₁, and I₁ < I₀. When reducing the motor speed, a linear decrease method or a curved decrease method may be used.

When the heavy load control unit 222 selects a speed closed-loop control strategy as the second control strategy, under this speed closed-loop control strategy, the heavy load control unit 222 may reduce the motor speed of the functional motor 211 to a target value and maintain it. This target value is smaller than or equal to the upper limit threshold of the motor speed under the normal operating state of the functional motor 211.

When the heavy load control unit 222 selects a PWM duty cycle open-loop control strategy as the second control strategy, under this PWM duty cycle open-loop control strategy, the heavy load control unit 222 may reduce the duty cycle of the functional motor 211 to a target value and maintain it. This target value is smaller than or equal to the upper limit threshold of the duty cycle under the normal operating state of the functional motor 211.

When the heavy load control unit 222 selects a power closed-loop control strategy as the second control strategy, under this power closed-loop control strategy, the heavy load control unit 222 may reduce the motor power of the functional motor 211 to a target value and maintain it. This target value is smaller than or equal to the upper limit threshold of the motor power under the normal operating state of the functional motor 211.

When the heavy load control unit 222 selects a torque closed-loop control strategy as the second control strategy, under this torque closed-loop control strategy, the heavy load control unit 222 may reduce the motor torque of the functional motor 211 to a target value and maintain it. This target value is smaller than or equal to the upper limit threshold of the motor torque under the normal operating state of the functional motor 211.

The first control strategy being a power closed-loop control strategy is described as an example. When the heavy load control unit 222 also selects the power closed-loop control strategy as the second control strategy, assuming the power set for normal operation of the functional motor 211 is P₀, in response to the heavy load identification unit 221 identifying entry into the heavy load state, the heavy load control unit 222 sets the target power to P₁, and P₁ < P₀. When reducing the motor power, a linear decrease method or a curved decrease method may be used.

When the heavy load control unit 222 selects a speed closed-loop control strategy as the second control strategy, under this speed closed-loop control strategy, the heavy load control unit 222 may reduce the motor power of the functional motor 211 to a target value and maintain it. This target value is smaller than or equal to the upper limit threshold of the motor power under the normal operating state of the functional motor 211.

When the heavy load control unit 222 selects a PWM duty cycle open-loop control strategy as the second control strategy, under this PWM duty cycle open-loop control strategy, the heavy load control unit 222 may reduce the duty cycle of the functional motor 211 to a target value and maintain it. This target value is smaller than or equal to the upper limit threshold of the duty cycle under the normal operating state of the functional motor 211.

When the heavy load control unit 222 selects a current closed-loop control strategy as the second control strategy, under this current closed-loop control strategy, the heavy load control unit 222 may reduce the current of the functional motor 211 to a target value and maintain it. This target value is smaller than or equal to the upper limit threshold of the current under the normal operating state of the functional motor 211.

When the heavy load control unit 222 selects a torque closed-loop control strategy as the second control strategy, under this torque closed-loop control strategy, the heavy load control unit 222 may reduce the motor torque of the functional motor 211 to a target value and maintain it. This target value is smaller than or equal to the upper limit threshold of the motor torque under the normal operating state of the functional motor 211.

The first control strategy being a torque closed-loop control strategy is described as an example. When the heavy load control unit 222 also selects the torque closed-loop control strategy as the second control strategy, assuming the torque set for normal operation of the functional motor 211 is T₀, in response to the heavy load identification unit 221 identifying entry into the heavy load state, the heavy load control unit 222 sets the target torque to T₁, and T₁ < T₀. When reducing the motor torque, a linear decrease method or a curved decrease method may be used.

When the heavy load control unit 222 selects a speed closed-loop control strategy as the second control strategy, under this speed closed-loop control strategy, the heavy load control unit 222 may reduce the motor speed of the functional motor 211 to a target value and maintain it. This target value is smaller than or equal to the upper limit threshold of the motor speed under the normal operating state of the functional motor 211.

When the heavy load control unit 222 selects a PWM duty cycle open-loop control strategy as the second control strategy, under this PWM duty cycle open-loop control strategy, the heavy load control unit 222 may reduce the duty cycle of the functional motor 211 to a target value and maintain it. This target value is smaller than or equal to the upper limit threshold of the duty cycle under the normal operating state of the functional motor 211.

When the heavy load control unit 222 selects a current closed-loop control strategy as the second control strategy, under this current closed-loop control strategy, the heavy load control unit 222 may reduce the current of the functional motor 211 to a target value and maintain it. This target value is smaller or equal to the upper limit threshold of the current under the normal operating state of the functional motor 211.

When the heavy load control unit 222 selects a power closed-loop control strategy as the second control strategy, under this power closed-loop control strategy, the heavy load control unit 222 may reduce the motor power of the functional motor 211 to a target value and maintain it. This target value is smaller than or equal to the upper limit threshold of the motor power under the normal operating state of the functional motor 211.

Based on the same objective, in another aspect, an embodiment of the present disclosure provides an electric motor-powered garden vehicle.

As shown in FIGS. 15 to 17, an electric motor-powered garden vehicle according to one or more embodiments of the present disclosure includes:
a frame 200, and a functional mechanism 21 and a drive mechanism 23 connected to the frame.

The frame 200 extends at least partially parallel to the front-rear direction. A carrying mechanism 201 may be disposed on the frame 200. The carrying mechanism 201 is configured to carry an operator of the electric motor-powered garden vehicle and may include at least one of a seat or a standing platform. FIG. 15 exemplarily shows only the case where the carrying mechanism 201 includes a seat. The seat or the standing platform is for the working user to sit or stand on. That is, the electric motor-powered garden vehicle may provide a ride-on working mode or a stand-on working mode. Furthermore, the structure of the seat and the standing platform may be flexibly switched, meaning the working mode of the electric motor-powered garden vehicle may be flexibly switched between the ride-on working mode and the stand-on working mode according to the actual needs of the working user. The frame 200 may further be provided with a hand-operated component, based on which the electric motor-powered garden vehicle may further provide a walk-behind working mode.

As shown in FIG. 15, the functional mechanism 21 is attached to the frame 200 and includes a functional motor 211 and an output component driven by the functional motor 211 to perform a functional operation. It is understandable that the functional mechanism 21 may include a plurality of the output components, and the plurality of output components may be driven by at least one functional motor 211.

The drive mechanism 23 is configured to cause the electric motor-powered garden vehicle to travel within garden scenarios such as lawns, gardens, fences, greens, or other road surfaces, and includes a drive motor and a drive wheel driven by the drive motor. During the travel of the electric motor-powered garden vehicle, the functional mechanism 21 performs corresponding functional operations in an orderly manner under the control of the controller assembly 22.

As shown in FIG. 15, the electric motor-powered garden vehicle further includes a power system 24 configured to supply power to the functional mechanism 21 and the drive mechanism 23.

The power system 24 is disposed on the frame 200 and detachably connected to the frame 200. The power system 24 includes a plurality of battery units. The plurality of battery units may include at least one of a first specification battery pack or a second specification battery pack. The specification differences between the first specification battery pack and the second specification battery pack include, but are not limited to, differences in battery pack capacity, voltage, internal resistance, weight, size, energy density, cell type, state-of-charge information, battery health status information, etc.

In some embodiments, the difference between the first specification battery pack and the second specification battery pack lies in different battery pack capacities. The capacity of the first specification battery pack is greater than the capacity of the second specification battery pack. The second specification battery pack is configured to provide power for handheld garden tools. For example, the second specification battery pack may power garden tools such as grass trimmers, pruning shears, blowers, chain saws, etc. Furthermore, the second specification battery pack may further power torque-output tools such as electric drills, electric hammers, etc.; power sawing tools such as circular saws, jigsaws, reciprocating saws, etc.; or power grinding tools such as angle grinders, sanders, etc.

In some embodiments, the difference between the first specification battery pack and the second specification battery pack lies in the different types of cells used. For example, the first specification battery pack and the second specification battery pack may use lithium iron phosphate cells and ternary lithium cells, respectively. In another embodiment, the plurality of battery units in the power system may use nickel-cadmium battery cells, lead-acid battery cells, or graphene cells, etc.

The use of the first specification battery pack and/or the second specification battery pack for the plurality of battery units of the power system 24 enables the electric motor-powered garden vehicle to be compatible with battery packs of different specifications, meeting high-power work requirements while also being adaptable to handheld electric garden tools, making the working methods of staff more flexible.

In some embodiments, the functional mechanism 21 is configured to perform a mowing function. The functional mechanism 21 includes a mowing motor 213, and a mowing element driven by the mowing motor 213. The functional mechanism 21 may include one or more mowing elements, and the one or more mowing elements are driven by at least one mowing motor 213.

It is understandable that, in some embodiments, the output component in the functional mechanism 21 may be replaced with another functional component, such as components for snow removal, snow blowing, snow shoveling, flushing, etc. Those skilled in the art should be able to adaptively replace various functional components without creative effort, all of which should fall within the protection scope of this embodiment.

In the electric motor-powered garden vehicle, a controller assembly 22 is provided corresponding to the functional mechanism 21. The controller assembly 22 is configured to control the operating state of the functional motor 211. As shown in FIG. 16, the controller assembly 22 may be set in an integrated controller system of the entire electric motor-powered garden vehicle, or may be set independently. The control chip used in the controller assembly 22 may be, for example, a Microcontroller Unit (MCU), an Advanced RISC Machine (ARM), etc.

The functional motor 211 has a plurality of operating parameters. When the controller assembly 22 controls the functional motor 211, it may select a plurality of control strategies corresponding to the plurality of operating parameters.

The plurality of operating parameters of the functional motor 211 may include, for example, a speed parameter, an electrical parameter, a power parameter, a torque parameter, and a PWM duty cycle parameter.

Corresponding to the plurality of aforementioned operating parameters, the plurality of control strategies that the controller assembly 22 may select are respectively a speed closed-loop control strategy, a current closed-loop control strategy, a power closed-loop control strategy, a torque closed-loop control strategy, and a PWM duty cycle open-loop control strategy.

As shown in FIG. 17, in some embodiments, the controller assembly 22 includes a heavy load identification unit 221 and a heavy load control unit 222.

The heavy load identification unit 221 is configured to select a target operating parameter from the plurality of operating parameters, and determine whether the functional motor enters a heavy load state based on the target operating parameter and/or a change of the target operating parameter.

The target operating parameter does not correspond the first control strategy currently adopted by the controller assembly 22 for the functional motor 211. For example, when the first control strategy currently adopted by the controller assembly 22 is the rotational speed closed-loop control strategy, an operating parameter other than the rotational speed parameter is selected as the target operating parameter. In another embodiment, when the first control strategy currently adopted by the controller assembly 22 is not a torque closed-loop control strategy, the torque parameter may be selected as the target operating parameter.

It is understandable that there are a plurality of operating parameters that do not correspond to the current first control strategy, and the heavy load identification unit 221 may select one or more operating parameters as the target operating parameters for monitoring.

When a heavy load mutation occurs during the operation of the functional motor 211, the load torque suddenly increases, and correspondingly, the motor speed, motor power, duty cycle, and related electrical parameters will fluctuate accordingly. The heavy load identification unit 221 monitors one or more operating parameters related to the functional motor 211, and based on the operating parameters and/or changes in the operating parameters, it may accurately and sensitively detect and identify the load mutation of the motor and determine whether the functional motor 211 enters the heavy load state.

After the heavy load identification unit 221 identifies that the functional motor 211 enters the heavy load state, the heavy load control unit 222 in the controller assembly 22 may select a second control strategy to control the functional motor 211, for example, by reducing the duty cycle, reducing the rotational speed, reducing or maintaining the current, reducing or maintaining the power, reducing or maintaining the torque, etc., to cause the functional motor 211 to exit the heavy load state. The second control strategy may be the same as the first control strategy or different from the first control strategy.

In the electric motor-powered garden vehicle, the heavy load identification unit 221 in the controller assembly 22 monitors one or more operating parameters related to the functional motor 211, and determines whether the functional motor 211 enters the heavy load state based on the operating parameters and/or changes in the operating parameters. In response to determination that the functional motor 211 enters the heavy load state, the heavy load control unit 222 in the controller assembly 22 selects an appropriate control strategy according to the situation to promptly adjust the functional motor 211, causing the functional motor 211 to exit the heavy load state. This method can accurately and sensitively identify heavy load mutations of the motor, further quickly respond to heavy load mutations, promptly adjust the control strategy, and maintain the motor system in a normal operating state, thereby improving the stability and working efficiency of the whole machine and optimizing the user experience.

Based on the same objective, in another aspect, an embodiment of the present disclosure provides an electric ride-on mower.

As shown in FIGS. 15 to 17, an electric ride-on mower according to one or more embodiments of the present disclosure includes:
a frame 200, and a mowing mechanism 25 and a drive mechanism 23 connected to the frame.

The frame 200 extends at least partially parallel to the front-rear direction. A carrying mechanism 201 may be disposed on the frame 200. The carrying mechanism 201 is configured to carry an operator of the electric ride-on mower and may include at least one of a seat or a standing platform. FIG. 15 exemplarily shows only the case where the carrying mechanism 201 includes a seat. The seat or the standing platform is for the working user to sit or stand on. That is, the electric ride-on mower may provide a ride-on working mode or a stand-on working mode. Furthermore, the structure of the seat and the standing platform may be flexibly switched, meaning the working mode of the electric ride-on mower may be flexibly switched between the ride-on working mode and the stand-on working mode according to the actual needs of the working user. The frame 200 may also be provided with a hand-operated component, based on which the electric ride-on mower may also provide a walk-behind working mode.

As shown in FIG. 15, the mowing mechanism 25 is attached to the frame 200 and includes a mowing motor 213 and a mowing element driven by the mowing motor 213 to perform mowing tasks. It is understandable that the mowing mechanism 25 may include a plurality of the mowing elements, and the plurality of mowing elements are driven by at least one mowing motor 213.

The drive mechanism 23 is configured to cause the electric ride-on mower to travel within garden scenarios such as lawns, gardens, fences, greens, or other road surfaces, and includes a drive motor and a drive wheel driven by the drive motor. During the travel of the electric ride-on mower, the mowing mechanism 25 performs corresponding functional operations in an orderly manner under the control of the controller assembly 22.

As shown in FIG. 15, the electric ride-on mower further includes a power system 24 configured to supply power to the mowing mechanism 25 and the drive mechanism 23.

The power system 24 is disposed on the frame 200 and detachably connected to the frame 200. The power system 24 includes a plurality of battery units. The plurality of battery units may include at least one of a first specification battery pack or a second specification battery pack. The specification differences between the first specification battery pack and the second specification battery pack include, but are not limited to, differences in battery pack capacity, voltage, internal resistance, weight, size, energy density, cell type, state-of-charge information, battery health status information, etc.

In some embodiments, the difference between the first specification battery pack and the second specification battery pack lies in different battery pack capacities. The capacity of the first specification battery pack is greater than the capacity of the second specification battery pack. The second specification battery pack is configured to provide power for handheld garden tools. For example, the second specification battery pack may power garden tools such as grass trimmers, pruning shears, blowers, chain saws, etc. Furthermore, the second specification battery pack may also power torque-output tools such as electric drills, electric hammers, etc.; power sawing tools such as circular saws, jigsaws, reciprocating saws, etc.; or power grinding tools such as angle grinders, sanders, etc.

In some embodiments, the difference between the first specification battery pack and the second specification battery pack lies in the different types of cells used. For example, the first specification battery pack and the second specification battery pack may use lithium iron phosphate cells and ternary lithium cells, respectively. The plurality of battery units in the power system may also use nickel-cadmium battery cells, lead-acid battery cells, graphene cells, etc.

The use of the first specification battery pack and/or the second specification battery pack for the plurality of battery units of the power system 24 enables the electric ride-on mower to be compatible with battery packs of different specifications, meeting high-power work requirements while also being adaptable to handheld electric garden tools, making the working methods of staff more flexible.

In some embodiments, the mowing mechanism 25 is configured to perform a mowing function. The mowing mechanism 25 includes a mowing motor 213, and a mowing element driven by the mowing motor 213. The mowing mechanism 25 may include one or more mowing elements, and the one or more mowing elements are driven by at least one mowing motor 213.

It is understandable that, in some embodiments, the mowing element in the mowing mechanism 25 may be replaced with another functional component, such as a component for snow removal, snow blowing, snow shoveling, flushing, etc. Those skilled in the art should be able to adaptively replace various functional components without creative effort, all of which should fall within the protection scope of this embodiment.

In the electric ride-on mower, a controller assembly 22 is provided corresponding to the mowing mechanism 25. The controller assembly 22 is configured to control the operating state of the mowing motor 213. As shown in FIG. 16, the controller assembly 22 may be set in an integrated controller system of the entire electric ride-on mower, or may be set independently. The control chip used in the controller assembly 22 may be, for example, a Microcontroller Unit (MCU), an Advanced RISC Machine (ARM), etc.

The mowing motor 213 has a plurality of operating parameters. When the controller assembly 22 controls the mowing motor 213, it may select a plurality of control strategies corresponding to the plurality of operating parameters.

The plurality of operating parameters of the mowing motor 213 may include, for example, a speed parameter, an electrical parameter, a power parameter, a torque parameter, and a PWM duty cycle parameter.

Corresponding to the plurality of aforementioned operating parameters, the plurality of control strategies that the controller assembly 22 may select are respectively a speed closed-loop control strategy, a current closed-loop control strategy, a power closed-loop control strategy, a torque closed-loop control strategy, and a PWM duty cycle open-loop control strategy.

As shown in FIG. 17, in some embodiments, the controller assembly 22 includes a heavy load identification unit 221 and a heavy load control unit 222.

The heavy load identification unit 221 is configured to select a target operating parameter from the plurality of operating parameters, and determine whether the functional motor enters a heavy load state based on the target operating parameter and/or a change of the target operating parameter.

The target operating parameter does not correspond to the first control strategy currently adopted by the controller assembly 22 for the mowing motor 213. For example, when the first control strategy currently adopted by the controller assembly 22 is the rotational speed closed-loop control strategy, an operating parameter other than the rotational speed parameter is selected as the target operating parameter. When the first control strategy currently adopted by the controller assembly 22 is not a torque closed-loop control strategy, the torque parameter may be selected as the target operating parameter.

It is understandable that there are a plurality of operating parameters that do not match the current first control strategy, and the heavy load identification unit 221 may select one or more operating parameters as the target operating parameters for monitoring.

When a heavy load mutation occurs during the operation of the mowing motor 213, the load torque suddenly increases, and correspondingly, the motor speed, motor power, duty cycle, and related electrical parameters will fluctuate and change accordingly. The heavy load identification unit 221 monitors one or more operating parameters related to the mowing motor 213, and based on the operating parameters and/or changes in the operating parameters, it may accurately and sensitively detect and identify the load mutation of the motor and determine whether it enters the heavy load state.

When the heavy load identification unit 221 identifies that the mowing motor 213 enters the heavy load state, the heavy load control unit 222 in the controller assembly 22 may select a second control strategy to adjust the control of the mowing motor 213, for example, by reducing the duty cycle, reducing the rotational speed, reducing or maintaining the current, reducing or maintaining the power, reducing or maintaining the torque, etc., to make the mowing motor 213 exit the heavy load state. The second control strategy may be the same as the first control strategy or different from the first control strategy.

In the electric ride-on mower, the heavy load identification unit 221 in the controller assembly 22 monitors one or more operating parameters related to the mowing motor 213, and determines whether the mowing motor 213 enters the heavy load state based on the operating parameters and/or changes in the operating parameters. When it is determined that the mowing motor 213 enters the heavy load state, the heavy load control unit 222 in the controller assembly 22 selects an appropriate control strategy according to the situation to promptly adjust the mowing motor 213, causing the mowing motor 213 to exit the heavy load state. This method may accurately and sensitively identify heavy load mutations of the motor, further quickly respond to heavy load mutations, promptly adjust the control strategy, and maintain the motor system in a normal operating state, thereby improving the stability and working efficiency of the whole machine and optimizing the user experience.

It should be noted that the method according to one or more embodiments of the present disclosure may be executed by a single device, such as a computer or a server. In another embodiment, the method according to the embodiments may be applied in a distributed scenario, where a plurality of devices cooperate with each other to complete the method. In such a distributed scenario, one of the plurality of devices may only execute one or more steps of the method according to one or more embodiments of the present disclosure, and the plurality of devices interact with each other to complete the described method.

It should be noted that the specific embodiments of the present disclosure have been described above. Other embodiments are within the scope of the appended claims. In some cases, the actions or steps recorded in the claims may be executed in a different order than in the embodiments and still achieve the desired results. In addition, the processes depicted in the accompanying drawings do not necessarily require the specific order or sequential order shown to achieve the desired results. In certain implementations, multitasking and parallel processing are also possible or may be advantageous.

For the convenience of description, the above device is described by dividing its functions into various modules. Of course, when implementing one or more embodiments of the present disclosure, the functions of each module may be implemented in one or more pieces of software and/or hardware.

The devices of the above embodiments are used to implement the corresponding methods in the foregoing embodiments and have the beneficial effects of the corresponding method embodiments, which are not repeated here.

Those skilled in the art can understand that implementing all or part of the processes in the methods of the above embodiments may be accomplished by instructing relevant hardware through a computer program. The program may be stored in a computer-readable storage medium. When the program is executed, the method according to the embodiments may be implemented. The storage medium may be a magnetic disk, an optical disc, a Read-Only Memory (ROM), a Random Access Memory (RAM), a Flash Memory, a Hard Disk Drive (HDD), a Solid-State Drive (SSD), of a combination of the foregoing.

The systems, devices, modules, or units explained in the above embodiments may be specifically implemented by computer chips or entities, or by products with certain functions. For the convenience of description, the above device is described by dividing its functions into various units. Of course, when implementing the present disclosure, the function of each unit may be implemented in one or more pieces of software and/or hardware.

It should also be noted that the terms "comprise", "include", or any other variants thereof are intended to cover non-exclusive inclusion, so that a process, method, commodity, or device including a series of elements not only includes those elements but also includes other elements not explicitly listed, or elements inherent to such a process, method, commodity, or device. Without further restrictions, an element defined by the phrase "including a..." does not exclude the existence of other identical elements in the process, method, commodity, or device including the element.

Although the present disclosure has been described in conjunction with the specific embodiments thereof, based on the foregoing description, many substitutions, modifications, and variations of these embodiments will be apparent to those of ordinary skill in the art. One or more embodiments of the present disclosure are intended to cover all such substitutions, modifications, and variations that fall within the broad scope of the appended claims. Therefore, any omissions, modifications, equivalent substitutions, improvements, etc., made within the spirit and principles of one or more embodiments of the present disclosure shall fall within the protection scope of the present disclosure.

## Claims

1. An electric vehicle, comprising:
a motor,
a collection module configured to collect at least one mechanical parameter and at least one electrical parameter of the motor, wherein the mechanical parameter comprises a rotational speed parameter, a sector time parameter, or a torque parameter, and the electrical parameter comprises a bus current parameter, a phase current parameter, a bus voltage parameter, a power parameter, a freewheeling time parameter, or a duty cycle parameter;
a detection module configured to process the mechanical parameter and the electrical parameter of the motor based on a target calculation formula, and generate a target value, wherein the target calculation formula comprises at least a ratio, a slope of the ratio, or a difference of the ratio; and
a determination module configured to determine whether the motor is in a heavy load state based on the target value and a predetermined target threshold, and determine, when the target value fails to meet the predetermined target threshold, that the motor is in the heavy load state, wherein the predetermined target threshold has a correspondence with the target calculation formula.

2. The electric vehicle according to claim 1, wherein
the rotational speed parameter comprises: a rotational speed, a rotational speed difference, or a slope of a rotational speed curve;
the sector time parameter comprises: a sector time, a sector time difference, or a slope of a sector time curve;
the torque parameter comprises: torque, a torque difference, or a slope of a torque curve;
the bus current parameter comprises: a bus current, a bus current difference, or a slope of a bus current curve;
the phase current parameter comprises: a phase current, a phase current difference, or a slope of a phase current curve;
the bus voltage parameter comprises: a bus voltage, a bus voltage difference, or a slope of a bus voltage curve;
the power parameter comprises: power, a power difference, or a slope of a power curve;
the freewheeling time parameter comprises: freewheeling time, a freewheeling time difference, or a slope of a freewheeling time curve;
the duty cycle parameter comprises: a duty cycle parameter, a duty cycle parameter difference, or a slope of a duty cycle parameter curve, wherein
the target value is a ratio between the mechanical parameter and the electrical parameter that have a same type.

3. The electric vehicle according to claim 1, wherein target calculation formula comprises: calculating a ratio between the mechanical parameter and the electrical parameter of the motor, or a ratio between different electrical parameters of the motor, wherein the target value is the ratio, and the determination module is further configured to: compare the ratio with the predetermined target threshold, and determine, when the ratio fails to meet the predetermined target threshold, that the motor is in the heavy load state.

4. The electric vehicle according to claim 1, wherein the target calculation formula comprises: calculating a ratio between the mechanical parameter and the electrical parameter of the motor, or a ratio between different electrical parameters of the motor, and calculating a ratio value of the ratio to a predetermined ratio, wherein the target value is the ratio value, and the determination module is further configured to: compare the ratio value with the predetermined target threshold, and determine, when the ratio value fails to meet the predetermined target threshold, that the motor is in the heavy load state.

5. The electric vehicle according to claim 1, wherein the target calculation formula comprises: calculating a ratio between the mechanical parameter and the electrical parameter of the motor, or a ratio between different electrical parameters of the motor, and calculating a difference of the ratio within a predetermined time period, wherein the target value is the difference, and the determination module is further configured to: compare the difference with the predetermined target threshold, and determine, when the difference fails to meet the predetermined target threshold, that the motor is in the heavy load state.

6. The electric vehicle according to claim 1, wherein the target calculation formula comprises: calculating a ratio between the mechanical parameter and the electrical parameter of the motor, or a ratio between different electrical parameters of the motor, and obtaining a slope of a curve of the ratio. wherein the target value is the slope, and the determination module is further configured to: compare the slope with the predetermined target threshold, and determine, when the slope fails to meet the predetermined target threshold, that the motor is in the heavy load state.

7. The electric vehicle according to any one of claims 3 to 6, wherein the motor comprises: a first gear, a second gear, and a third gear with progressively increasing output capacities, wherein the predetermined target threshold is the same when the motor is in the first gear, the second gear, and the third gear, or the predetermined target threshold decreases progressively when the motor is in the first gear, the second gear, and the third gear, or the predetermined target threshold increases progressively when the motor is in the first gear, the second gear, and the third gear.

8. The electric vehicle according to claim 7, wherein the predetermined target threshold is determined based on sampling time, and the predetermined target threshold decreases as a sampling time interval decreases, wherein the sampling time interval is a time interval for obtaining two adjacent mechanical parameters or two adjacent electrical parameters.

9. The electric vehicle according to claim 1, further comprising: a control module configured to adjust, in response to the motor being in the heavy load state, the mechanical parameter or electrical parameter of the motor, to reduce an operating efficiency of the motor until the motor exits the heavy load state.

10. A method for detecting a heavy load state applied to an electric vehicle, wherein the method comprises:
collecting at least one mechanical parameter and at least one electrical parameter of the motor, wherein the mechanical parameter comprises a rotational speed parameter, a sector time parameter, or a torque parameter, and the electrical parameter comprises a bus current parameter, a phase current parameter, a bus voltage parameter, a power parameter, a freewheeling time parameter, or a duty cycle parameter;
processing the mechanical parameter and the electrical parameter of the motor based on a target calculation formula, and generating a target value, wherein the target calculation formula comprising at least a ratio, a slope of the ratio, or a difference of the ratio; and
determining whether the motor is in a heavy load state based on the target value and a predetermined target threshold, and determining, when the target value fails to meet the predetermined target threshold, that the motor is in the heavy load state, wherein the predetermined target threshold has a correspondence with the target calculation formula.

11. An electric vehicle, comprising:
a frame;
a functional mechanism attached to the frame, the functional mechanism comprising a functional motor and an output assembly configured to be driven by the functional motor to perform a function operation; and
a controller assembly configured to control an operating state of the functional motor,
wherein the functional motor has a plurality of operating parameters, and the controller assembly has a plurality of control strategies, the plurality of control strategies corresponding to the plurality of operating parameters of the functional motor,
wherein the controller assembly comprises:
a heavy load identification unit configured to select a target operating parameter from the plurality of operating parameters, and determine whether the functional motor enters a heavy load state based on the target operating parameter and/or a change of the target operating parameter, wherein the target operating parameter does not correspond to a first control strategy among the plurality of control strategies that is currently adopted by the controller assembly for the functional motor; and
a heavy load control unit configured to select, in response to determining that the functional motor enters the heavy load state, a second control strategy from the plurality of control strategies, and control the functional motor based on the second control strategy to exit the heavy load state.

12. The electric vehicle according to claim 11, wherein the plurality of operating parameters of the functional motor comprise a rotational speed parameter, an electrical parameter, a power parameter, a torque parameter, and a PWM duty cycle parameter,
wherein the plurality of control strategies corresponding to the plurality of operating parameters comprise a rotational speed closed-loop control strategy, a current closed-loop control strategy, a power closed-loop control strategy, a torque closed-loop control strategy, and a PWM duty cycle open-loop control strategy.

13. The electric vehicle according to claim 12, wherein the heavy load identification unit being configured to select a target operating parameter from the plurality of operating parameters, and determine whether the functional motor enters a heavy load state based on the target operating parameter and/or a change of the target operating parameter comprises:
the heavy load identification unit being configured to select, in response to the rotational speed parameter not corresponding to the first control strategy, the rotational speed parameter as the target operating parameter,
wherein the heavy load identification unit is further configured to monitor the rotational speed parameter and determine whether the functional motor enters the heavy load state based on the rotational speed parameter and/or a change of the rotational speed parameter.

14. The electric vehicle according to claim 13, wherein the rotational speed parameter comprises a motor rotational speed parameter, wherein
the heavy load identification unit being configured to monitor the rotational speed parameter and determine whether the functional motor enters the heavy load state based on the rotational speed parameter and/or a change of the rotational speed parameter comprises: the heavy load identification unit being configured to:
determine whether the motor rotational speed parameter is greater than or equal to a corresponding predetermined motor rotational speed parameter threshold during an operation of the functional motor; and
determine, in response to the motor rotational speed parameter being greater than or equal to the corresponding predetermined motor rotational speed parameter threshold, that the functional motor enters the heavy load state.

15. The electric vehicle according to claim 14, wherein the motor rotational speed parameter comprises a motor rotational speed, a motor rotational speed difference, and a motor rotational speed change rate;
wherein the motor rotational speed difference is a difference in the motor rotational speed of the functional motor between two adjacent moments; and
the motor rotational speed change rate characterizes a change trend of the motor rotational speed of the functional motor at a corresponding moment; and
wherein the heavy load identification unit being configured to determine whether the motor rotational speed parameter is greater than or equal to a corresponding predetermined motor rotational speed parameter threshold during an operation of the functional motor comprises the heavy load identification unit being configured to:
obtain at least one motor rotational speed parameter, and determine whether the at least one motor rotational speed parameter is less than or equal to the corresponding predetermined motor rotational speed parameter threshold.

16. The electric vehicle according to claim 13, wherein the rotational speed parameter comprises a motor sector time parameter; and
wherein the heavy load identification unit being configured to monitor the rotational speed parameter and determine whether the functional motor enters the heavy load state based on the rotational speed parameter and/or a change of the rotational speed parameter comprises the heavy load identification unit being configured to:
determine whether the motor sector time parameter is greater than or equal to a corresponding predetermined motor sector time parameter threshold during an operation of the functional motor; and
determine, in response to the motor sector time parameter being greater than or equal to the corresponding predetermined motor sector time parameter threshold, that the functional motor enters the heavy load state.

17. The electric vehicle according to claim 16, wherein the motor sector time parameter comprises motor sector time, a motor sector time difference, and a motor sector time change rate, wherein:
an electrical cycle of the functional motor comprises a plurality of sectors, and the motor sector time refers to a duration of each of the plurality of sectors;
the motor sector time difference is a difference between motor sector time corresponding to two adjacent moments; and
the motor sector time change rate characterizes a change trend of the motor sector time; and
wherein the heavy load identification unit being configured to determine whether the motor sector time parameter is greater than or equal to a corresponding predetermined motor sector time parameter threshold during an operation of the functional motor comprises: the heavy load identification unit being configured to
obtain at least one motor sector time parameter and determine whether the at least one motor sector time parameter is greater than or equal to the corresponding predetermined motor sector time parameter threshold.

18. The electric vehicle according to claim 12, wherein the heavy load identification unit being configured to select a target operating parameter from the plurality of operating parameters, and determine whether the functional motor enters a heavy load state based on the target operating parameter and/or a change of the target operating parameter comprises:
the heavy load identification unit being configured to select, in response to the electrical parameter not corresponding to the first control strategy, the electrical parameter as the target operating parameter,
wherein the heavy load identification unit is further configured to monitor the electrical parameter and determine whether the functional motor enters the heavy load state based on the electrical parameter and/or a change of the electrical parameter.

19. The electric vehicle according to claim 18, wherein the heavy load identification unit being configured to monitor the electrical parameter and determine whether the functional motor enters the heavy load state based on the electrical parameter and/or a change of the electrical parameter comprises the heavy load identification unit being configured to:
determine whether the electrical parameter is greater than or equal to a corresponding predetermined electrical parameter threshold during an operation of the functional motor; and
determine, in response to the electrical parameter being greater than or equal to the corresponding predetermined electrical parameter threshold, that the functional motor enters the heavy load state.

20. The electric vehicle according to claim 19, wherein the electrical parameter comprises a bus current parameter, wherein the bus current parameter comprises a bus current, a bus current difference, and a bus current change rate;
wherein the bus current difference is a difference in the bus current of the functional motor between two adjacent moments; and
the bus current change rate characterizes a change trend of the bus current of the functional motor at a corresponding moment; and
wherein the heavy load identification unit being configured to determine whether the electrical parameter is greater than or equal to a corresponding predetermined electrical parameter threshold during an operation of the functional motor comprises the heavy load identification unit being configured to:
obtain at least one bus current parameter, and determine whether the at least one bus current parameter is greater than or equal to the corresponding predetermined electrical parameter threshold.

21. The electric vehicle according to claim 19, wherein the electrical parameter comprises a phase current parameter, wherein the phase current parameter comprises a phase current, a phase current difference, and a phase current change rate;
wherein the phase current difference is a difference in the phase current of the functional motor between two adjacent moments; and
the phase current change rate characterizes a change trend of the phase current of the functional motor at a corresponding moment; and
wherein the heavy load identification unit being configured to determine whether the electrical parameter is greater than or equal to a corresponding predetermined electrical parameter threshold during an operation of the functional motor comprises the heavy load identification unit being configured to:
obtain at least one phase current parameter, and determine whether the at least one phase current parameter is greater than or equal to the corresponding predetermined electrical parameter threshold.

22. The electric vehicle according to claim 19, wherein the electrical parameter comprises a bus voltage parameter, wherein the bus voltage parameter comprising a bus voltage drop, a bus voltage drop difference, and a bus voltage drop change rate;
wherein the bus voltage drop is a decrease value of a bus voltage during the operation of the functional motor compared with a bus voltage before operation;
the bus voltage drop difference refers to a difference in the bus voltage drop of the functional motor between two adjacent moments; and
the bus voltage drop change rate characterizes a change trend of the bus voltage drop of the functional motor at a corresponding moment; and
wherein the heavy load identification unit being configured to determine whether the electrical parameter is greater than or equal to a corresponding predetermined electrical parameter threshold during an operation of the functional motor comprises the heavy load identification unit being configured to:
obtain at least one bus voltage parameter, and determine whether the at least one bus voltage parameter is greater than or equal to the corresponding predetermined electrical parameter threshold.

23. The electric vehicle according to claim 19, wherein the electrical parameter comprises a conducting phase voltage parameter, wherein the conducting phase voltage parameter comprises a conducting phase voltage drop, a conducting phase voltage drop difference, and a conducting phase voltage drop change rate;
wherein the conducting phase voltage drop refers to a relative value of a change in the conducting phase voltage of the functional motor within a commutation cycle;
the conducting phase voltage drop difference refers to a difference between conducting phase voltage drops corresponding to different commutation cycles of the functional motor; and
the conducting phase voltage drop change rate characterizes a change trend of the conducting phase voltage drop of the functional motor; and
wherein the heavy load identification unit being configured to determine whether the electrical parameter is greater than or equal to a corresponding predetermined electrical parameter threshold during an operation of the functional motor comprises the heavy load identification unit being configured to:
obtain at least one conducting phase voltage parameter, and determine whether the at least one conducting phase voltage parameter is greater than or equal to the corresponding predetermined electrical parameter threshold.

24. The electric vehicle according to claim 19, wherein the electrical parameter comprises a freewheeling time parameter, wherein the freewheeling time parameter comprises a freewheeling time of the functional motor during commutation, a freewheeling time difference, and a freewheeling time change rate;
wherein the freewheeling time difference is a difference between freewheeling time corresponding to different commutation cycles of the functional motor; and
the freewheeling time change rate characterizes a change trend of the freewheeling time of the functional motor; and
wherein the heavy load identification unit being configured to determine whether the electrical parameter is greater than or equal to a corresponding predetermined electrical parameter threshold during an operation of the functional motor comprises the heavy load identification unit being configured to:
obtain at least one freewheeling time parameter, and determine whether the at least one freewheeling time parameter is greater than or equal to the corresponding predetermined electrical parameter threshold.

25. The electric vehicle according to claim 12, wherein the heavy load identification unit being configured to select a target operating parameter from the plurality of operating parameters, and determine whether the functional motor enters a heavy load state based on the target operating parameter and/or a change of the target operating parameter comprises:
the heavy load identification unit being configured to select, in response to the power parameter not corresponding to the first control strategy, the power parameter as the target operating parameter,
wherein the heavy load identification unit is further configured to monitor the power parameter and determine whether the functional motor enters the heavy load state based on the power parameter and/or a change of the power parameter.

26. The electric vehicle according to claim 25, wherein the heavy load identification unit being configured to monitor the power parameter and determine whether the functional motor enters the heavy load state based on the power parameter and/or a change of the power parameter comprises he heavy load identification unit being configured to:
determine whether the power parameter is greater than or equal to a corresponding predetermined power parameter threshold during an operation of the functional motor; and
determine, in response to the power parameter being greater than or equal to the corresponding predetermined power parameter threshold, that the functional motor enters the heavy load state.

27. The electric vehicle according to claim 26, wherein the power parameter comprises motor power, a motor power difference, and a motor power change rate;
wherein the motor power difference is a difference in the motor power of the functional motor between two adjacent moments; and
the motor power change rate characterizes a change trend of the motor power of the functional motor at a corresponding moment; and
wherein the heavy load identification unit being configured to determine whether the torque parameter is greater than or equal to a corresponding predetermined torque parameter threshold during an operation of the functional motor comprises he heavy load identification unit being configured to:
obtain at least one power parameter, and determine whether the at least one power parameter is greater than or equal to the corresponding predetermined power parameter threshold.

28. The electric vehicle according to claim 12, wherein the heavy load identification unit being configured to select a target operating parameter from the plurality of operating parameters, and determine whether the functional motor enters a heavy load state based on the target operating parameter and/or a change of the target operating parameter comprises:
the heavy load identification unit being configured to select, in response to the torque parameter not corresponding to the first control strategy, the torque parameter as the target operating parameter,
wherein the heavy load identification unit is further configured to monitor the torque parameter and determine whether the functional motor enters the heavy load state based on the torque parameter and/or a change of the torque parameter.

29. The electric vehicle according to claim 28, wherein the heavy load identification unit being configured to monitor a torque parameter and determine whether the functional motor enters the heavy load state based on the torque parameter and/or a change of the torque parameter comprises the heavy load identification unit being configured to:
determine whether the torque parameter is greater than or equal to a corresponding predetermined torque parameter threshold during an operation of the functional motor; and
determine, in response to the torque parameter being greater than or equal to the corresponding predetermined torque parameter threshold, that the functional motor enters the heavy load state.

30. The electric vehicle according to claim 29, wherein the torque parameter comprises motor torque, a motor torque difference, and a motor torque change rate;
wherein the motor torque difference is a difference in the motor torque of the functional motor between two adjacent moments; and
the motor torque change rate characterizes a change trend of the motor torque of the functional motor at a corresponding moment; and
wherein the heavy load identification unit being configured to determine whether the torque parameter is greater than or equal to a corresponding predetermined torque parameter threshold during an operation of the functional motor comprises the heavy load identification unit being configured to:
obtain at least one torque parameter, and determine whether the at least one torque parameter is greater than or equal to the corresponding predetermined torque parameter threshold.

31. The electric vehicle according to claim 12, wherein the heavy load identification unit being configured to select a target operating parameter from the plurality of operating parameters, and determine whether the functional motor enters a heavy load state based on the target operating parameter and/or a change of the target operating parameter comprises:
the heavy load identification unit being configured to select, in response to the PWM duty cycle parameter not corresponding to the first control strategy, the PWM duty cycle parameter as the target operating parameter,
wherein the heavy load identification unit is further configured to monitor the PWM duty cycle parameter and determine whether the functional motor enters the heavy load state based on the PWM duty cycle parameter and/or a change of the PWM duty cycle parameter.

32. The electric vehicle according to claim 31, wherein the heavy load identification unit being configured to monitor the PWM duty cycle parameter and determine whether the functional motor enters the heavy load state based on the PWM duty cycle parameter and/or a change of the PWM duty cycle parameter comprises the heavy load identification unit being configured to:
determine whether the PWM duty cycle parameter is greater than or equal to a corresponding predetermined duty cycle parameter threshold during an operation of the functional motor; and
determine, in response to the PWM duty cycle parameter being greater than or equal to the corresponding predetermined duty cycle parameter threshold, that the functional motor enters the heavy load state.

33. The electric vehicle according to claim 32, wherein the PWM duty cycle parameter comprises a duty cycle of a corresponding control signal of the functional motor, a duty cycle difference, and a duty cycle change rate;
wherein the duty cycle difference is a difference in a duty cycle of the functional motor between two adjacent moments; and
the duty cycle change rate characterizes a change trend of the duty cycle of the functional motor at a corresponding moment; and
wherein the heavy load identification unit being configured to determine whether the duty cycle parameter is greater than or equal to a corresponding predetermined duty cycle parameter threshold during an operation of the functional motor comprises the heavy load identification unit being configured to:
obtain at least one PWM duty cycle parameter, and determine whether the at least one PWM duty cycle parameter is greater than or equal to the corresponding predetermined duty cycle parameter threshold.

34. The electric vehicle according to claim 12, wherein the heavy load identification unit being configured to select a target operating parameter from the plurality of operating parameters, and determine whether the functional motor enters a heavy load state based on the target operating parameter and/or a change of the target operating parameter comprises:
the heavy load identification unit being configured to select, in response to both the rotational speed parameter and the electrical parameter not corresponding to the first control strategy, the rotational speed parameter and the electrical parameter as target operating parameters,
wherein the heavy load identification unit is further configured to monitor the rotational speed parameter and the electrical parameter, determine a current-to-speed ratio parameter based on a ratio of the electrical parameter to the rotational speed parameter, and determine whether the functional motor enters the heavy load state based on the current-to-speed ratio parameter and/or a change of the current-to-speed ratio parameter.

35. The electric vehicle according to claim 34, wherein the rotational speed parameter comprises a motor rotational speed parameter, and the current-to-speed ratio parameter is a ratio of the electrical parameter to the motor rotational speed parameter; and
wherein the heavy load identification unit being configured to determine whether the functional motor enters the heavy load state based on the current-to-speed ratio parameter and/or a change of the current-to-speed ratio parameter comprise the heavy load identification unit being configured to:
determine whether the current-to-speed ratio parameter is greater than or equal to a corresponding predetermined current-to-speed ratio parameter threshold during an operation of the functional motor; and
determine, in response to the current-to-speed ratio parameter being greater than or equal to the corresponding predetermined current-to-speed ratio parameter threshold, that the functional motor enters the heavy load state.

36. The electric vehicle according to claim 34, wherein the rotational speed parameter comprises a motor sector time parameter, and the current-to-speed ratio parameter is a ratio of the electrical parameter to the motor sector time parameter; and
wherein the heavy load identification unit being configured to determine whether the functional motor enters the heavy load state based on the current-to-speed ratio parameter and/or a change of the current-to-speed ratio parameter comprises the heavy load identification unit being configured to:
determine whether the current-to-speed ratio parameter is less than or equal to a corresponding predetermined current-to-speed ratio parameter threshold during an operation of the functional motor; and
determine, in response to the current-to-speed ratio parameter being less than or equal to the corresponding predetermined current-to-speed ratio parameter threshold, that the functional motor enters the heavy load state.

37. The electric vehicle according to claim 35 or 36, wherein the current-to-speed ratio parameter comprises a current-to-speed ratio, a current-to-speed ratio difference, and a current-to-speed ratio change rate;
wherein the current-to-speed ratio is a ratio of the electrical parameter to the rotational speed parameter;
the current-to-speed ratio difference is a difference in the current-to-speed ratio between two adjacent moments; and
the current-to-speed ratio change rate characterizes a change trend of the current-to-speed ratio at a corresponding moment; and
wherein the heavy load identification unit being configured to determine whether the current-to-speed ratio parameter is greater than or equal to a corresponding predetermined current-to-speed ratio parameter threshold during an operation of the functional motor comprises the heavy load identification unit being configured to:
obtain at least one current-to-speed ratio parameter, and determine whether the at least one current-to-speed ratio parameter is greater than or equal to the corresponding predetermined current-to-speed ratio parameter threshold.

38. The electric vehicle according to claim 12, wherein the heavy load identification unit being configured to select a target operating parameter from the plurality of operating parameters, and determine whether the functional motor enters a heavy load state based on the target operating parameter and/or a change of the target operating parameter comprises:
the heavy load identification unit being configured to select, in response to both the rotational speed parameter and the power parameter not corresponding to the first control strategy, the rotational speed parameter and the power parameter as target operating parameters,
wherein the heavy load identification unit is further configured to monitor the rotational speed parameter and the power parameter, determine a power-to-speed ratio parameter based on a ratio of the power parameter to the rotational speed parameter, and determine whether the functional motor enters the heavy load state based on the power-to-speed ratio parameter and/or a change of the power-to-speed ratio parameter.

39. The electric vehicle according to claim 38, wherein the rotational speed parameter comprises a motor rotational speed parameter, and the power-to-speed ratio parameter is a ratio of the power parameter to the motor rotational speed parameter; and
wherein the heavy load identification unit being configured to determine whether the functional motor enters the heavy load state based on the power-to-speed ratio parameter and/or a change of the power-to-speed ratio parameter comprises the heavy load identification unit being configured to:
determine whether the power-to-speed ratio parameter is greater than or equal to a corresponding predetermined power-to-speed ratio parameter threshold during an operation of the functional motor; and
determine, in response to the power-to-speed ratio parameter being greater than or equal to the corresponding predetermined power-to-speed ratio parameter threshold, that the functional motor enters the heavy load state.

40. The electric vehicle according to claim 38, wherein the rotational speed parameter comprises a motor sector time parameter, and the power-to-speed ratio parameter is a ratio of the power parameter to the motor sector time parameter; and
wherein the heavy load identification unit being configured to determine whether the functional motor enters the heavy load state based on the power-to-speed ratio parameter and/or a change of the power-to-speed ratio parameter comprises the heavy load identification unit being configured to:
determine whether the power-to-speed ratio parameter is less than or equal to a corresponding predetermined power-to-speed ratio parameter threshold during an operation of the functional motor; and
determine, in response to the power-to-speed ratio parameter being less than or equal to the corresponding predetermined power-to-speed ratio parameter threshold, that the functional motor enters the heavy load state.

41. The electric vehicle according to claim 39 or 40, wherein the power-to-speed ratio parameter comprises a power-to-speed ratio, a power-to-speed ratio difference, and a power-to-speed ratio change rate;
wherein the power-to-speed ratio is a ratio of the power parameter to the rotational speed parameter;
the power-to-speed ratio difference is a difference in the power-to-speed ratio between two adjacent moments; and
the power-to-speed ratio change rate characterizes a change trend of the power-to-speed ratio at a corresponding moment; and
wherein the heavy load identification unit being configured to determine whether the power-to-speed ratio parameter is greater than or equal to a corresponding predetermined power-to-speed ratio parameter threshold during an operation of the functional motor comprises the heavy load identification unit being configured to:
obtain at least one power-to-speed ratio parameter, and determine whether the at least one power-to-speed ratio parameter is greater than or equal to the corresponding predetermined power-to-speed ratio parameter threshold.

42. The electric vehicle according to claim 12, wherein the heavy load identification unit being configured to select a target operating parameter from the plurality of operating parameters, and determine whether the functional motor enters a heavy load state based on the target operating parameter and/or a change of the target operating parameter comprises:
the heavy load identification unit being configured to select, in response to both the rotational speed parameter and the torque parameter not corresponding to the first control strategy, the rotational speed parameter and the torque parameter as target operating parameters,
wherein the heavy load identification unit is further configured to monitor the rotational speed parameter and the torque parameter, determine a torque-to-speed ratio parameter based on a ratio of the torque parameter to the rotational speed parameter, and determine whether the functional motor enters the heavy load state based on the torque-to-speed ratio parameter and/or a change of the torque-to-speed ratio parameter.

43. The electric vehicle according to claim 42, wherein the rotational speed parameter comprises a motor rotational speed parameter, and the torque-to-speed ratio parameter is a ratio of the torque parameter to the motor rotational speed parameter; and
wherein the heavy load identification unit being configured to determine whether the functional motor enters the heavy load state based on the torque-to-speed ratio parameter and/or a change of the torque-to-speed ratio parameter comprises the heavy load identification unit being configured to:
determine whether the torque-to-speed ratio parameter is greater than or equal to a corresponding predetermined torque-to-speed ratio parameter threshold during an operation of the functional motor; and
determine, in response to the torque-to-speed ratio parameter being greater than or equal to the corresponding predetermined torque-to-speed ratio parameter threshold, that the functional motor enters the heavy load state.

44. The electric vehicle according to claim 42, wherein the rotational speed parameter comprises a motor sector time parameter, and the torque-to-speed ratio parameter is a ratio of the torque parameter to the motor sector time parameter; and
wherein the heavy load identification unit being configured to determine whether the functional motor enters the heavy load state based on the torque-to-speed ratio parameter and/or a change of the torque-to-speed ratio parameter comprises the heavy load identification unit being configured to:
determine whether the torque-to-speed ratio parameter is less than or equal to a corresponding predetermined torque-to-speed ratio parameter threshold during an operation of the functional motor; and
determine, in response to the torque-to-speed ratio parameter being less than or equal to the corresponding predetermined torque-to-speed ratio parameter threshold, that the functional motor enters the heavy load state.

45. The electric vehicle according to claim 43 or 44, wherein the torque-to-speed ratio parameter comprises a torque-to-speed ratio, a torque-to-speed ratio difference, and a torque-to-speed ratio change rate;
wherein the torque-to-speed ratio is a ratio of the torque parameter to the rotational speed parameter;
the torque-to-speed ratio difference is a difference in the torque-to-speed ratio between two adjacent moments; and
the torque-to-speed ratio change rate characterizes a change trend of the torque-to-speed ratio at a corresponding moment; and
wherein the heavy load identification unit being configured to determine whether the torque-to-speed ratio parameter is greater than or equal to a corresponding predetermined torque-to-speed ratio parameter threshold during an operation of the functional motor comprises the heavy load identification unit being configured to:
obtain at least one torque-to-speed ratio parameter, and determine whether the at least one torque-to-speed ratio parameter is greater than or equal to the corresponding predetermined torque-to-speed ratio parameter threshold.

46. The electric vehicle according to claim 12, wherein the heavy load identification unit being configured to select a target operating parameter from the plurality of operating parameters, and determine whether the functional motor enters a heavy load state based on the target operating parameter and/or a change of the target operating parameter comprises:
the heavy load identification unit being configured to select, in response to both the rotational speed parameter and the PWM duty cycle parameter not corresponding to the first control strategy, the rotational speed parameter and the PWM duty cycle parameter as target operating parameters,
wherein the heavy load identification unit is further configured to monitor the rotational speed parameter and the PWM duty cycle parameter, determine a duty-cycle-to-speed ratio parameter based on a ratio of the PWM duty cycle parameter to the rotational speed parameter, and determine whether the functional motor enters the heavy load state based on the duty-cycle-to-speed ratio parameter and/or a change of the duty-cycle-to-speed ratio parameter.

47. The electric vehicle according to claim 46, wherein the rotational speed parameter comprises a motor rotational speed parameter, and the duty-cycle-to-speed ratio parameter is a ratio of the PWM duty cycle parameter to the motor rotational speed parameter; and
wherein the heavy load identification unit being configured to determine whether the functional motor enters the heavy load state based on the duty-cycle-to-speed ratio parameter and/or a change of the duty-cycle-to-speed ratio parameter comprises the heavy load identification unit being configured to:
determine whether the duty-cycle-to-speed ratio parameter is greater than or equal to a corresponding predetermined duty-cycle-to-speed ratio parameter threshold during an operation of the functional motor; and
determine, in response to the duty-cycle-to-speed ratio parameter being greater than or equal to the corresponding predetermined duty-cycle-to-speed ratio parameter threshold, that the functional motor enters the heavy load state.

48. The electric vehicle according to claim 46, wherein the rotational speed parameter comprises a motor sector time parameter, and the duty-cycle-to-speed ratio parameter is a ratio of the PWM duty cycle parameter to the motor sector time parameter; and
wherein the heavy load identification unit being configured to determine whether the functional motor enters the heavy load state based on the duty-cycle-to-speed ratio parameter and/or a change of the duty-cycle-to-speed ratio parameter comprises the heavy load identification unit being configured to:
determine whether the duty-cycle-to-speed ratio parameter is less than or equal to a corresponding predetermined duty-cycle-to-speed ratio parameter threshold during an operation of the functional motor; and
determine, in response to the duty-cycle-to-speed ratio parameter being less than or equal to the corresponding predetermined duty-cycle-to-speed ratio parameter threshold, that the functional motor enters the heavy load state.

49. The electric vehicle according to claim 47 or 48, wherein the duty-cycle-to-speed ratio parameter comprises a duty-cycle-to-speed ratio, a duty-cycle-to-speed ratio difference, and a duty-cycle-to-speed ratio change rate;
wherein the duty-cycle-to-speed ratio is a ratio of the PWM duty cycle parameter to the rotational speed parameter;
the duty-cycle-to-speed ratio difference is a difference in the duty-cycle-to-speed ratio between two adjacent moments; and
the duty-cycle-to-speed ratio change rate characterizes a change trend of the duty-cycle-to-speed ratio at a corresponding moment; and
wherein the heavy load identification unit being configured to determine whether the duty-cycle-to-speed ratio parameter is greater than or equal to a corresponding predetermined duty-cycle-to-speed ratio parameter threshold during an operation of the functional motor comprises the heavy load identification unit being configured to:
obtain at least one duty-cycle-to-speed ratio parameter, and determine whether the at least one duty-cycle-to-speed ratio parameter is greater than or equal to the corresponding predetermined duty-cycle-to-speed ratio parameter threshold.

50. The electric vehicle according to claim 12, wherein the heavy load identification unit being configured to select a target operating parameter from the plurality of operating parameters, and determine whether the functional motor enters a heavy load state based on the target operating parameter and/or a change of the target operating parameter comprises:
the heavy load identification unit being configured to select, in response to both the electrical parameter and the PWM duty cycle parameter not corresponding to the first control strategy, the electrical parameter and the PWM duty cycle parameter as target operating parameters,
wherein the heavy load identification unit is further configured to monitor the electrical parameter and the PWM duty cycle parameter, determine a duty-cycle-to-current ratio parameter based on a ratio of the PWM duty cycle parameter to the electrical parameter, and determine whether the functional motor enters the heavy load state based on the duty-cycle-to-current ratio parameter and/or a change of the duty-cycle-to-current ratio parameter.

51. The electric vehicle according to claim 50, wherein the heavy load identification unit being configured to determine whether the functional motor enters the heavy load state based on the duty-cycle-to-current ratio parameter and/or a change of the duty-cycle-to-current ratio parameter comprises the heavy load identification unit being configured to:
determine whether the duty-cycle-to-current ratio parameter is greater than or equal to a corresponding predetermined duty-cycle-to-current ratio parameter threshold during an operation of the functional motor; and
determine, in response to the duty-cycle-to-current ratio parameter being greater than or equal to the corresponding predetermined duty-cycle-to-current ratio parameter threshold, that the functional motor enters the heavy load state.

52. The electric vehicle according to claim 51, wherein the duty-cycle-to-current ratio parameter comprises a duty-cycle-to-current ratio, a duty-cycle-to-current ratio difference, and a duty-cycle-to-current ratio change rate;
wherein the duty-cycle-to-current ratio is a ratio of the PWM duty cycle parameter to the electrical parameter;
the duty-cycle-to-current ratio difference is a difference in the duty-cycle-to-current ratio between two adjacent moments; and
the duty-cycle-to-current ratio change rate characterizes a change trend of the duty-cycle-to-current ratio at a corresponding moment; and
wherein the heavy load identification unit being configured to determine whether the duty-cycle-to-current ratio parameter is greater than or equal to a corresponding predetermined duty-cycle-to-current ratio parameter threshold during an operation of the functional motor comprises the heavy load identification unit being configured to:
obtain at least one duty-cycle-to-current ratio parameter, and determine whether the at least one duty-cycle-to-current ratio parameter is greater than or equal to the corresponding predetermined duty-cycle-to-current ratio parameter threshold.

53. The electric vehicle according to claim 12, wherein the heavy load identification unit being configured to select a target operating parameter from the plurality of operating parameters, and determine whether the functional motor enters a heavy load state based on the target operating parameter and/or a change of the target operating parameter comprises:
the heavy load identification unit being configured to select, in response to both the power parameter and the PWM duty cycle parameter not corresponding to the first control strategy, the power parameter and the PWM duty cycle parameter as target operating parameters,
wherein the heavy load identification unit is further configured to monitor the power parameter and the PWM duty cycle parameter, determine a duty-cycle-to-power ratio parameter based on a ratio of the PWM duty cycle parameter to the power parameter, and determine whether the functional motor enters the heavy load state based on the duty-cycle-to-power ratio parameter and/or a change of the duty-cycle-to-power ratio parameter.

54. The electric vehicle according to claim 53, wherein the heavy load identification unit being configured to determine whether the functional motor enters the heavy load state based on the duty-cycle-to-power ratio parameter and/or a change of the duty-cycle-to-power ratio parameter comprises the heavy load identification unit being configured to:
determine whether the duty-cycle-to-power ratio parameter is greater than or equal to a corresponding predetermined duty-cycle-to-power ratio parameter threshold during an operation of the functional motor; and
determine, in response to the duty-cycle-to-power ratio parameter being greater than or equal to the corresponding predetermined duty-cycle-to-power ratio parameter threshold, that the functional motor enters the heavy load state.

55. The electric vehicle according to claim 54, wherein the duty-cycle-to-power ratio parameter comprises a duty-cycle-to-power ratio, a duty-cycle-to-power ratio difference, and a duty-cycle-to-power ratio change rate;
wherein the duty-cycle-to-power ratio is a ratio of the PWM duty cycle parameter to the power parameter;
the duty-cycle-to-current ratio difference is a difference in the duty-cycle-to-power ratio between two adjacent moments; and
the duty-cycle-to-power ratio change rate characterizes a change trend of the duty-cycle-to-power ratio at a corresponding moment; and
wherein the heavy load identification unit being configured to determine whether the duty-cycle-to-power ratio parameter is greater than or equal to a corresponding predetermined duty-cycle-to-power ratio parameter threshold during an operation of the functional motor comprises the heavy load identification unit being configured to:
obtain at least one duty-cycle-to-power ratio parameter, and determine whether the at least one duty-cycle-to-power ratio parameter is greater than or equal to the corresponding predetermined duty-cycle-to-power ratio parameter threshold.

56. The electric vehicle according to claim 12, wherein the heavy load identification unit being configured to select a target operating parameter from the plurality of operating parameters, and determine whether the functional motor enters a heavy load state based on the target operating parameter and/or a change of the target operating parameter comprises:
the heavy load identification unit being configured to select, in response to both the torque parameter and the PWM duty cycle parameter not corresponding to the first control strategy, the torque parameter and the PWM duty cycle parameter as target operating parameters,
wherein the heavy load identification unit is further configured to monitor the torque parameter and the PWM duty cycle parameter, determine a duty-cycle-to-torque ratio parameter based on a ratio of the PWM duty cycle parameter to the torque parameter, and determine whether the functional motor enters the heavy load state based on the duty-cycle-to-torque ratio parameter and/or a change of the duty-cycle-to-torque ratio parameter.

57. The electric vehicle according to claim 56, wherein the heavy load identification unit being configured to determine whether the functional motor enters the heavy load state based on the duty-cycle-to-torque ratio parameter and/or a change of the duty-cycle-to-torque ratio parameter comprises the heavy load identification unit being configured to:
determine whether the duty-cycle-to-torque ratio parameter is greater than or equal to a corresponding predetermined duty-cycle-to-torque ratio parameter threshold during an operation of the functional motor; and
determine, in response to the duty-cycle-to-torque ratio parameter being greater than or equal to the corresponding predetermined duty-cycle-to-torque ratio parameter threshold, that the functional motor enters the heavy load state.

58. The electric vehicle according to claim 57, wherein the duty-cycle-to-torque ratio parameter comprises a duty-cycle-to-torque ratio, a duty-cycle-to-torque ratio difference, and a duty-cycle-to-torque ratio change rate;
wherein the duty-cycle-to-torque ratio is a ratio of the PWM duty cycle parameter to the torque parameter;
the duty-cycle-to-torque ratio difference is a difference in the duty-cycle-to-torque ratio between two adjacent moments; and
the duty-cycle-to-torque ratio change rate characterizes a change trend of the duty-cycle-to-torque ratio at a corresponding moment; and
wherein the heavy load identification unit being configured to determine whether the duty-cycle-to-torque ratio parameter is greater than or equal to a corresponding predetermined duty-cycle-to-torque ratio parameter threshold during an operation of the functional motor comprises the heavy load identification unit being configured to:
obtain at least one duty-cycle-to-torque ratio parameter, and determining whether the at least one duty-cycle-to-torque ratio parameter is greater than or equal to the corresponding predetermined duty-cycle-to-torque ratio parameter threshold.

59. The electric vehicle according to claim 12, wherein the heavy load control unit being configured to control the functional motor based on the second control strategy comprises:
the heavy load control unit being configured to control, in response to the second control strategy being the same as the first control strategy, the operating parameter corresponding to the second control strategy to decrease to a target value, wherein the target value is smaller than a value of the operating parameter corresponding to the second control strategy under a normal operating state of the functional motor.

60. The electric vehicle according to claim 12, wherein the heavy load control unit being configured to control the functional motor based on the second control strategy comprises:
the heavy load control unit being configured to control, in response to the second control strategy being different from the first control strategy, the operating parameter corresponding to the second control strategy to decrease to a target value, wherein the target value is smaller than or equal to an upper limit threshold of the operating parameter corresponding to the second control strategy under a normal operating state of the functional motor.

61. An electric garden work vehicle, comprising:
a frame;
a functional mechanism attached to the frame, the functional mechanism comprising a functional motor and an output assembly configured to be driven by the functional motor to perform a function operation; and
a controller assembly configured to control an operating state of the functional motor,
wherein the functional motor has a plurality of operating parameters, and the controller assembly has a plurality of control strategies, the plurality of control strategies corresponding to the plurality of operating parameters of the functional motor,
wherein the controller assembly comprises:
a heavy load identification unit configured to select a target operating parameter from the plurality of operating parameters, and determine whether the functional motor enters a heavy load state based on the target operating parameter and/or a change of the target operating parameter, wherein the target operating parameter does not correspond to a first control strategy among the plurality of control strategies that is currently adopted by the controller assembly for the functional motor; and
a heavy load control unit configured to select, in response to determining that the functional motor enters the heavy load state, a second control strategy from the plurality of control strategies, and control the functional motor based on the second control strategy to exit the heavy load state.

62. A riding lawn mower, comprising:
a frame;
a carrying mechanism provided at the frame and configured to carry a user;
a mowing mechanism attached to the frame, the mowing mechanism comprising a mowing motor and a cutting assembly configured to be driven by the mowing motor to perform a mowing operation; and
a controller assembly configured to control an operating state of the mowing motor,
wherein the mowing motor has a plurality of operating parameters, and the controller assembly has a plurality of control strategies, the plurality of control strategies corresponding to the plurality of operating parameters of the mowing motor,
wherein the controller assembly comprises:
a heavy load identification unit configured to select a target operating parameter from the plurality of operating parameters, and determine whether the mowing motor enters a heavy load state based on the target operating parameter and/or a change of the target operating parameter, wherein the target operating parameter does not correspond to a first control strategy among the plurality of control strategies that is currently adopted by the controller assembly for the mowing motor; and
a heavy load control unit configured to select, in response to determining that the mowing motor enters the heavy load state, a second control strategy from the plurality of control strategies, and control the mowing motor based on the second control strategy to exit the heavy load state.
